(19)

**Europäisches Patentamt**
**European Patent Office**
**Office européen des brevets**

(11) **EP 1 960 932 B1**

(12) **EUROPEAN PATENT SPECIFICATION**

(45) Date of publication and mention of the grant of the patent:
**12.08.2015 Bulletin 2015/33**

(21) Application number: **06849894.8**

(22) Date of filing: **15.11.2006**

(51) Int Cl.:
*G06F 19/00* (2011.01)     *G01D 4/00* (2006.01)
*G01R 22/00* (2006.01)     *H02J 13/00* (2006.01)
*H04Q 9/00* (2006.01)

(86) International application number:
**PCT/US2006/044762**

(87) International publication number:
**WO 2007/094837 (23.08.2007 Gazette 2007/34)**

(54) **APPARATUS AND METHODS FOR MULTI-CHANNEL METERING**

VORRICHTUNG UND VERFAHREN ZUR MEHRKANALMESSUNG

APPAREILS ET PROCÉDÉS POUR UNE MESURE MULTIVOIE DE LA CONSOMMATION ÉLECTRIQUE

(84) Designated Contracting States:
**AT BE BG CH CY CZ DE DK EE ES FI FR GB GR HU IE IS IT LI LT LU LV MC NL PL PT RO SE SI SK TR**

(30) Priority: **15.11.2005 US 737580 P**
**23.11.2005 US 739375 P**
**09.05.2006 US 431849**
**15.06.2006 US 813901 P**

(43) Date of publication of application:
**27.08.2008 Bulletin 2008/35**

(73) Proprietor: **Quadlogic Controls Corporation**
**Long Island City, NY 11101 (US)**

(72) Inventors:
• **SWARZTRAUBER, Sayre, A.**
**New York, NY 10010 (US)**

• **SHAFRIR, Doron**
**Suffern, NY 10901 (US)**
• **MALIK, Siddharth**
**New York, NY 10028 (US)**
• **HAYWARD, Robert**
**Belleville, ON KBN 2L1 (CA)**

(74) Representative: **Dunlop, Hugh Christopher et al**
**RGC Jenkins & Co.**
**26 Caxton Street**
**London SW1H 0RJ (GB)**

(56) References cited:
EP-A1- 1 379 012     US-A- 5 696 501
US-A- 5 995 601     US-A1- 2003 001 754
US-A1- 2004 083 066     US-A1- 2004 257 005
US-A1- 2005 137 813     US-B1- 6 177 884

EP 1 960 932 B1

## Description

### Related Applications

This application claims the priority of U.S. Provisional Patent Application No. 60/737,580, filed November 15, 2005, U.S. Provisional Patent Application No. 60/739,375, filed November 23, 2005, and U.S. Provisional Application No. 60/813,901, filed June 15, 2006, and is a continuation-in-part of U.S. Pat. App. No. 11/431,849, filed May 9, 2006, which is a divisional of U.S. Pat App. No. 11/030,417, filed January 6,2005 (now U.S. Pat. No. 7,054,770), which is a divisional of U.S. Pat. App. No. 09/795,838, filed February 28, 2001 (now U.S. Pat. No. 6,947,854).

US 5696501 relates to an electrical metering device and a method therefor. The apparatus has a common node and a number of electrical metering devices connected to the node. The metering devices measure power consumption and transmit a signal indicative thereof to the node. The node calculates the power consumed and stores the results in a register.

EP 1379012 relates to an automated and integrated meter reading procedure and transfer of obtained digital data to a remote computer system and an apparatus therefor. The apparatus measures power, gas, and water usage, processes the measured data, and transmits the data to a utility company substation.

US 2005/0137813 relates to a system and method for on-line monitoring and billing of power consumption. The system has a metering device connected to a power line and a transponder connected to the metering device. The transponder receives and transmits data from and to the metering device via the power line, and receives and transmits data from and to a remotely located computer.

### Background and Summary

In accordance with the invention, there is provided an apparatus for multi-channel metering of electricity as recited in claim 1.

One embodiment of the present invention comprises a metering device that is related to the Quadlogic ASIC-based family of meters (see U.S. Pat. No. 6,947,854, and U.S. Pat. App. Pub. No. 20060036388). Specifically, this embodiment (referred to herein for convenience as "Energy Guard") is a multi-channel meter that preferably is capable of providing much of the functionality of the above-mentioned family of meters, and further provides the improvements, features, and components listed below.

Used in at least one embodiment, a MiniCloset is a 24-channel metering device that can measure electric usage for up to 24 single-phase customers, 12 two-phase customer, or 8 three-phase customers. Preferably connected to the MiniCloset are one or more Load Control Modules (LCMs), discussed below.

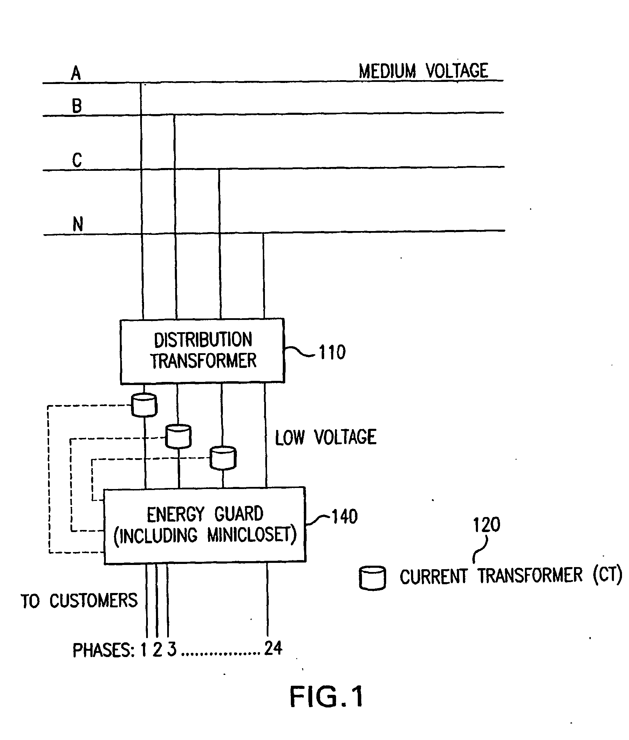

Energy Guard preferably comprises a MiniCloset meter head module and two LCMs mounted into a steel box. Relays that allow for an electricity customer to be remotely disconnected and reconnected, along with current transformers, also are mounted into the box. See FIG. 1.

Upon installation, an electricity customer's electricity supply line is tapped off the main electric feeder, passed through the Energy Guard apparatus, and run directly to the customer's home. The construction and usage of the Energy Guard will be

apparent to those skilled in the art upon review of the description below and related figures. Source code is supplied in the attached Appendix.

Energy Guard meters preferably are operable to provide:

(A) Remote Disconnect/Reconnect: The meter supports full duplex (bidirectional) communication via power line communication ("PLC") and may be equipped with remotely operated relays (60 amp, 100 amp, or 200 amp) that allow for disconnect and reconnect of electric users remotely.

(B) Theft Prevention: The system is designed with three specific features to prevent theft. First, an Energy Guard apparatus preferably is installed on a utility pole above the medium-tension lines, making it difficult for customers to reach and tamper with. Second, because there are no additional signal wires with the system (i.e., all communication is via the power line), any severed communication wires are immediately detectable. That is, if a communication wire is cut, service is cut, which is readily apparent. A third theft prevention feature is that the meter may be used to measure the transformer energy in order to validate the measured totals of individual clients. Discrepancies can indicate theft of power.

(C) Tamper Detection: The Energy Guard preferably provides two modes of optical tamper detection. Each unit contains a light that reflects against a small mirror-like adhesive sticker. The absence of this reflective light indicates that the box has been opened. This detection will automatically disconnect all clients measured by that Energy Guard unit. In addition, if the Energy Guard enclosure is opened and ambient light enters, this will also automatically disconnect all clients measured by that Energy Guard unit. These two modes of tamper detection are continuously engaged and alternate multiple times per second for maximum security.

(D) Reverse Voltage Detection: In some cases, a utility company can disconnect power to an individual client and that client is able to obtain power via an alternative feed. If the utility were to reconnect power under these conditions, damage could occur to the metering equipment and/or the distribution system. Energy Guard preferably is able to detect this fault condition. The Energy Guard can detect any voltage that feeds back into the open disconnect through the lines that connect to the customers' premises. If voltage is detected, the firmware of the Energy Guard will automatically prevent the reconnection.

(E) Pre-Payment: Pre-payment for energy can be done via phone, electronic transaction, or in person. The amount of kWh purchased is transmitted to the meter and stored in its memory. The meter will count down, showing how much energy is still available before reaching zero and disconnecting. As long as the customer continues to purchase energy, there will be no interruption in service, and the utility company will have a daily activity report.

(F) Load Limiting: As an alternative to disconnection for nonpayment or part of a pre-payment system, Energy Guard meters can allow the utility to remotely limit the power delivered to a set level, disconnecting when that load is exceeded. If the customer exceeds that load and is disconnected, the customer can reset a button on the optional remote display unit to restore load as long as the connected load is less than the pre-set limit. Alternatively, clients can call an electric utility service line by telephone to have the service restored. This feature allows electric utilities to provide electricity for critical systems even, for example, in the case of a non-paying customer.

(G) Monthly Consumption Limiting: Some customers benefit from subsidized rates and are given a maximum total consumption per month. The Energy Guard firmware is capable of shutting down power when a certain consumption level is reached. However, this type of program is best implemented when advanced notification to customers is provided. This can be achieved either with a display in the home whereby a message or series of messages notifies customers that their rate of consumption is approaching the projected consumption for the month. Alternatively (or in conjunction) timed service interruptions can be programmed so that as the limit is approaching, power is disconnected for periods of time with longer and longer increments to notify the residents. These planned interruptions in service act as a warning to customers that their limit is nearing so that they have time to alter their consumption patterns.

(H) Meter Validation: The integrated module of the system preferably is removable. This permits easy laboratory re-validation of meter accuracy in the event of client billing disputes.

(I) Operational Benefits for Utility: The Energy Guard has extensive onboard event logs and diagnostic functions, providing field technicians with a wealth of data for commissioning and trouble shooting the electrical and communication systems. Non billing parameters include: amps, volts, temperature, total harmonic distortion, frequency, instantaneous values of watts, vars and volt-amperes, V2 hrs, 12 hrs, power factor, and phase angle.

These features and others will be apparent to those skilled in the art after reviewing the attached descriptions, software code, and schematics.

In one aspect, the invention comprises a device for measuring electricity usage, comprising: means for remote disconnection via power line communication; means for detection of electricity theft; means for tamper detection; and means for reverse voltage detection.

In another aspect, the invention comprises an apparatus for multi-channel metering of electricity, comprising: (a) a meter head operable to measure electricity usage for a plurality of electricity consumer lines; (b) a transponder in communication with the meter head and operable to transmit data received from the meter head via power line communication to a remotely located computer, and to transmit data received via power line communication from the remotely located computer to the meter head; and (c) a load control module in communication with the meter head and operable to actuate connection and disconnection of each of a plurality of relays, each relay of the plurality of relays corresponding to one of the plurality of electricity consumer lines.

In various embodiments: (1) the apparatus further comprises a tamper detector in communication with the meter head; (2) the tamper detector comprises a light and a reflective surface, and the meter head is operable to instruct the load control module to disconnect all of the customer lines if the tamper detector provides notification that the light is not detected reflecting from the reflective surface; (3) the apparatus further comprises a box containing the meter head, the load control module, and the relays, and wherein the tamper detector comprises a detector of ambient light entering the box; (4) the apparatus further comprises a box containing the meter head, the load control module, and the relays, and wherein the box is installed on a utility pole; (5) the apparatus further comprises means for comparing transformer energy to total energy used by the consumer lines; (6) the apparatus further comprises means for detecting reverse voltage flow through the consumer lines; (7) the apparatus further comprises a computer readable memory in communication with the meter head and a counter in communication with the meter head, the counter corresponding to a customer line and operable to count down an amount of energy stored in the memory, and the meter head operable to send a disconnect signal to the load control module to disconnect the customer line when the counter reaches zero; (8) the apparatus further comprises a computer readable memory in communication with the meter head, the memory operable to store a load limit for a customer line, and the meter head operable to send a disconnect signal to the load control module to disconnect the customer line when the load limit is exceeded; (9) the apparatus further comprises a computer readable memory in communication with the meter head, the memory operable to store a usage limit for a customer line, and the meter head operable to send a disconnect signal to the load control module to disconnect the customer line when the usage limit is exceeded; (10) the transponder is operable to communicate with the remotely located computer over medium tension power lines; (11) the apparatus further comprises a display unit in communication with the meter head and operable to display data received from the meter head; (12) the display unit is operable to display information regarding a customer's energy consumption; (13) the display unit is operable to display warnings regarding a customer's energy usage or suspected theft of energy; and (14) the display unit is operable to transmit to said meter head information entered by a customer.

**Brief Description of the Drawings**

FIG. 1 is a block/wiring diagram showing connection of preferred embodiments.

FIG. 2 is a block diagram showing physical configuration of preferred embodiments.

FIGS. 3A-3B are schematic diagrams of a preferred CPU board of a Scan Transponder and MiniCloset.

FIG. 4 is a schematic diagram of a preferred Scan Transponder power supply.

FIG. 5 is a schematic diagram of a preferred MiniCloset power supply.

FIG. 6 is a schematic diagram of a preferred circuit board for returning current transformer information to a MiniCloset meter head.

FIGS. 7A-7C are schematic diagrams of a preferred Load Control Module circuit board.

FIGS. 8A-8D are schematic diagrams of a preferred power supply board that provides for optical tamper detection.

FIGS. 9A-9C are schematic diagrams of a preferred Energy Guard connection board.

FIG. 10 is a schematic diagram for a control circuitry board operable to provide relay control.

FIG. 11 is a diagram of preferred Energy Guard base assembly. FIGS. 12 and 13 are diagrams of preferred phase bus bars and construction of same.

FIG. 14 is a diagram depicting preferred neutral bar frame construction and assembly.

FIG. 15 depicts preferred transition bars; FIG. 16 depicts preferred placement of transition bars.

FIGS. 17 and depict preferred acceptor module constructiono.

FIG. 19 depicts a preferred integrated current sensing and relay module. FIG. 20 depicts an exploded view of a preferred integrated current sensing and relay module.

FIG. 21 shows exploded views of preferred metering modules.

FIG. 22 shows the metering modules placed in an EG frame assembly and acceptor module.

FIG. 23 shows an exploded view a preferred embodiment of Energy Guard. FIG. 24 shows an exploded view of a preferred EG assembly and base assembly.

FIG. 25 shows a preferred EG layout.

FIGS. 26 and 27 are preferred metering module schematics.

FIG. 28 has preferred schematics for a back place board.

FIG. 29 has preferred schematics for a power board.

FIG. 30 has preferred schematics for an I/O extension board.

FIG. 31 has preferred schematics for a CPU board.

FIG. 32 has preferred schematics for a control module.

FIG. 33 has preferred schematics for metering and power supply circuitry for a customer display module; FIG. 34 has preferred schematics for a display board for the CDM.

FIG. 35 is a block diagram of a preferred analog front end for metering. FIGS. 36 and 37 depict preferred DSP implementations.

FIG. 38 illustrates preferred in-phase filter frequency and implulse response characteristics.

FIG. 39 illustrates injecting PLC signals at half-odd harmonics of 60 Hz. FIG. 40 depicts 12 possible ways in which an FFT frame received by a meter can be out of phase with a scan transponded FFT frame.

FIG. 41 illustrates preferred FIR filter specifications.

FIG. 42 depicts voltage and current resulting from a preferred FFT.

## Detailed Description of Preferred Embodiments

In one embodiment, an Energy Guard metering apparatus comprises a MiniCloset (that is, a metering apparatus operable to meter a plurality of customer lines); a Scan Transponder; one or more relays operable to disconnect service to selected customers; a Load Control Module; and optical tamper detection means.

The MiniCloset and Scan Transponder referred to herein are largely the same as described in U.S. Pat. No. 6,947,854. That is, although each has been improved over the years, the functionality and structure relevant to this description may be taken to be the same as described in that patent.

One aspect of the invention comprises taking existing multichannel metering functionality found in the MiniCloset and adding remote connect and disconnect via PLC. Providing such additional functionality required adding new hardware and software. The added hardware comprises a Load Control Module (LCM) and

connect/disconnect relays. Also added was support circuitry to route signal traces to and from the main meter processor- the MiniCloset5 Meter Head. The software additions include code modules that communicate with the added hardware, as described in the tables below.

FIG. 1 is a block diagram of connections of a preferred embodiment. Medium voltage power lines A, B, C, and N (neutral) feed into Distribution Transformer 110. Low voltage lines connect (via current transformers 120) Distribution Transformer 110 to Energy Guard unit 140. Energy Guard unit 140 monitors current transformers 120, and feeds single phase customer lines 1-24.

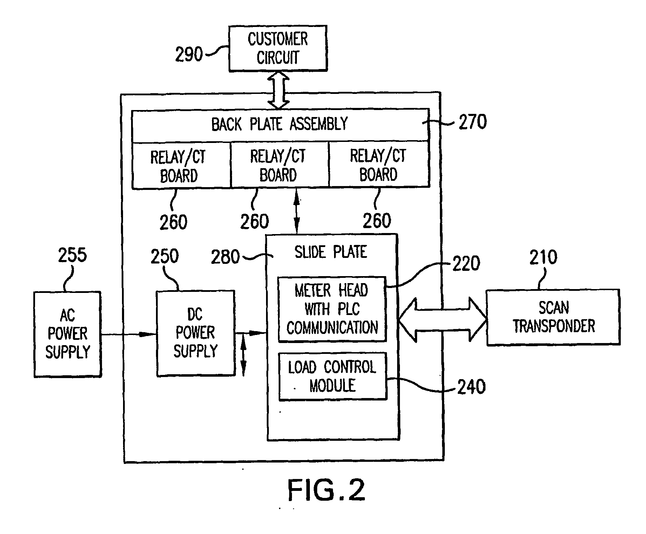

FIG. 2 is a block diagram of preferred structure of an Energy Guard unit 140.

Scan Transponder 210 is the preferred data collector for the unit 140, may be located external to or inside the MiniCloset, and may be the main data collector for more than one MiniCloset at a time. The Scan Transponder 210 preferably : (a) verifies data (each communication preferably begins with clock and meter identity verification to ensure data integrity); (b) collects data (periodically it collects a data block from each meter unit, with each block containing previously collected meter readings, interval readings, and event logs); (c) stores data (preferably the data is stored in non-volatile memory for a specified period (e.g., 40 days)); and (d) reports data (either via PLC, telephone modem, RS-232 connection, or other means).

The slide plate 280 comprises a Minicloset meter head and a load control module 240 that provides the control signals to activate the relays. All of the electronics preferably is powered up by power supply 250. The back plate assembly 270 comprises multiple (e.g., 24) Current Transformers and relays - grouped, in this example, as three sets of 8 CTs and relays. Customer cables are wired through the CTs and connect to the circuit on customer premises 290. The remotely located Scan Transponder 210 accesses the Energy Guard meter head and bi-directionally communicates using power line carrier communication.

The signal flow shown in FIGS. 1 and 2 preferably is accomplished by implementing different software code modules that work concurrently to enable remote connect/disconnect ability in the Minicloset. These software modules, provided in the Appendix below, are:

| Code Module | Location | Function |
|---|---|---|
| lcm.def and pic.def | Load Control Module | Actuate connect and disconnect of relays. |
| pulse.c and pulse.h | Meter Head | Establish communication with LCM. |
| picend.def and picvars.def | Meter Head | Provide control signals to LCM. |
| pulselink.def and pulseoutm.c | Meter Head | Provides LCM with pulses to be used for connecting and disconnecting relays. |

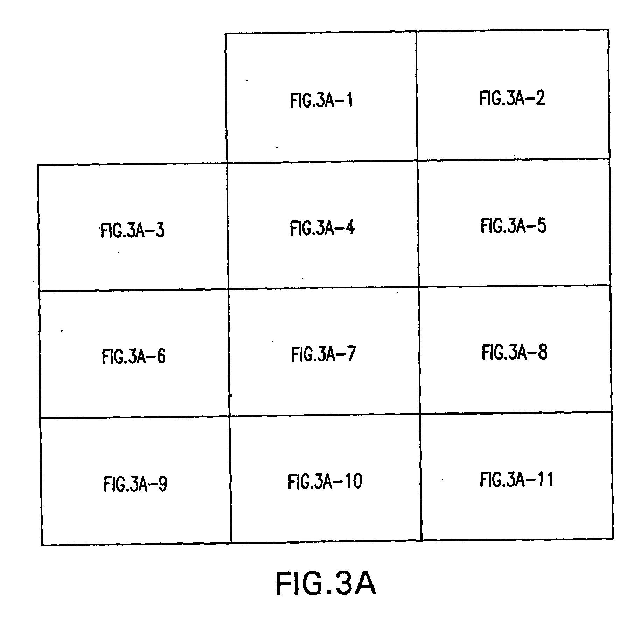

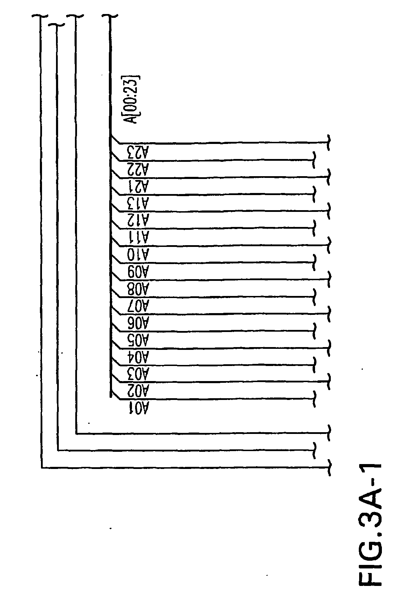

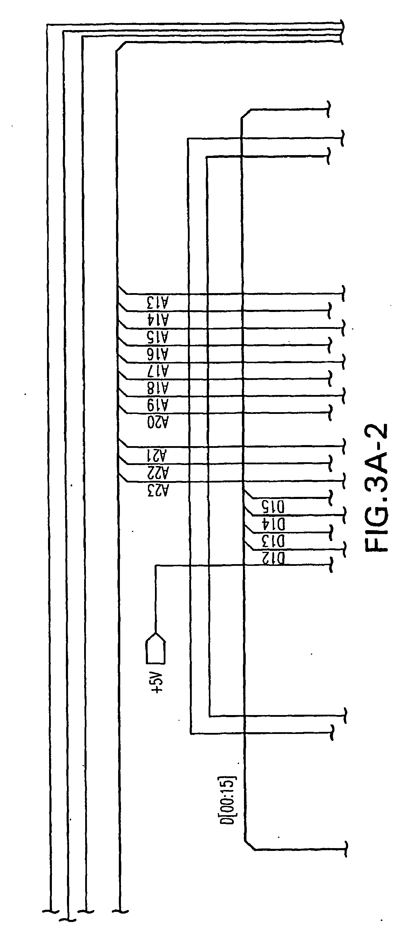

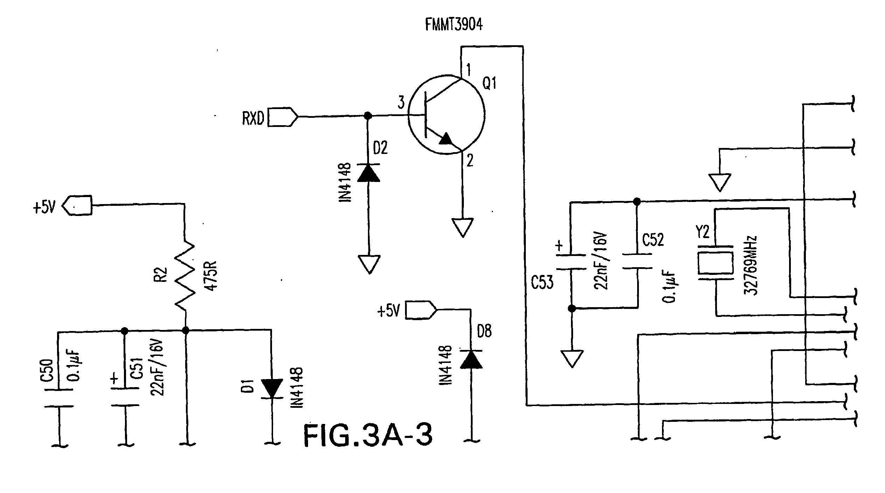

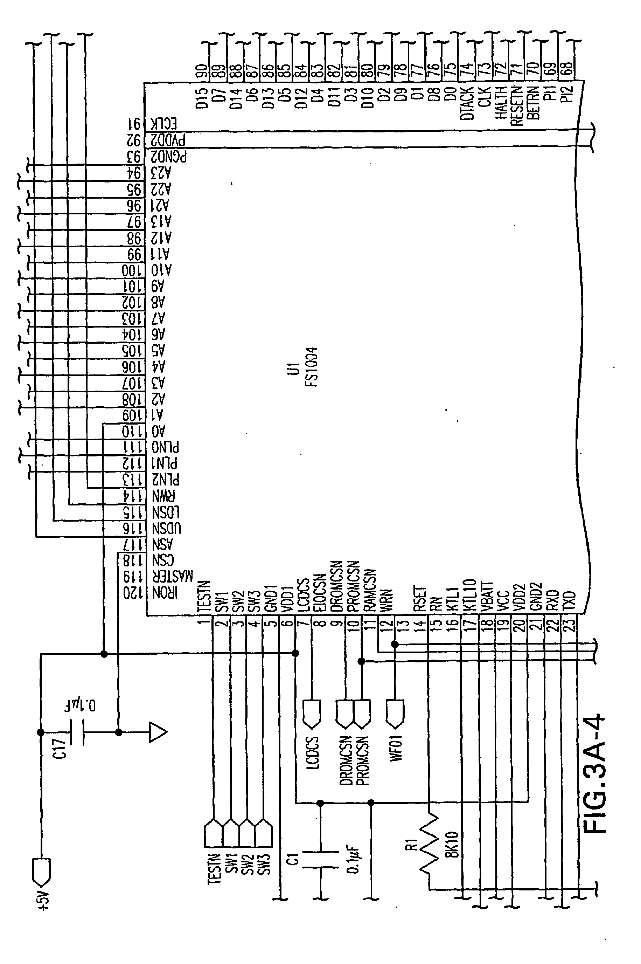

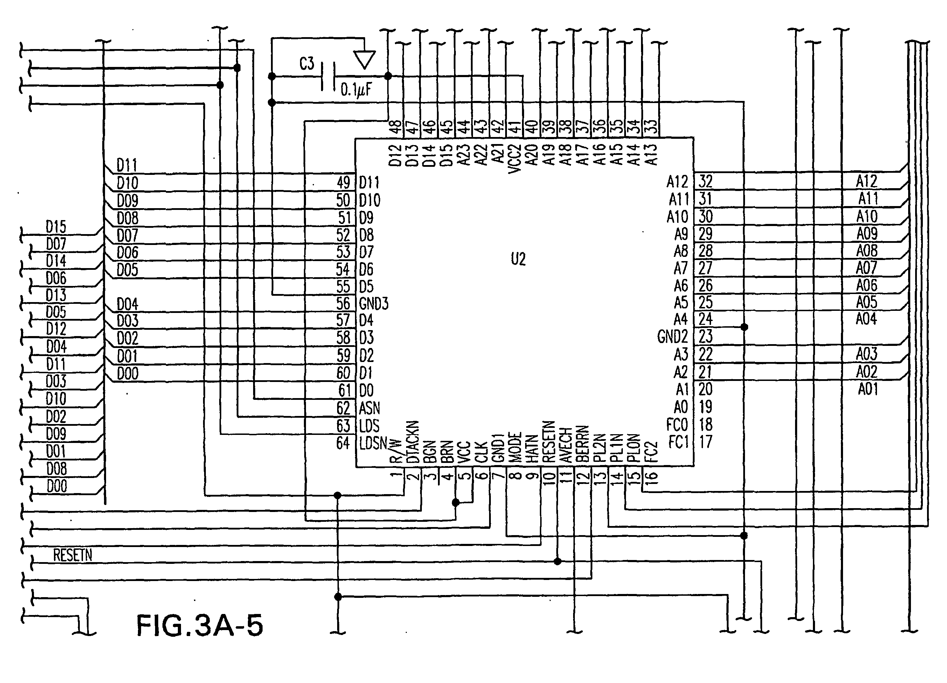

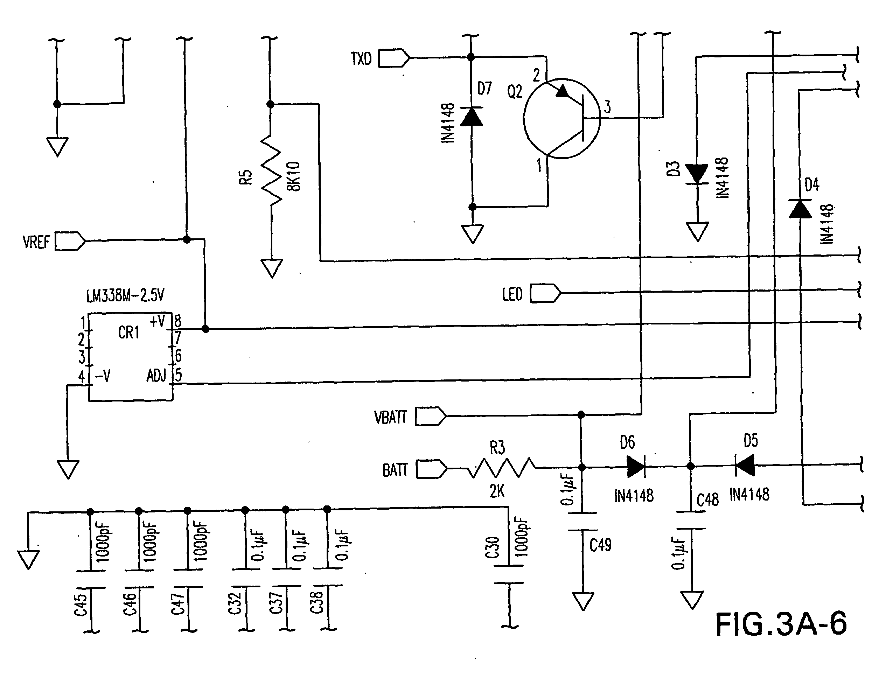

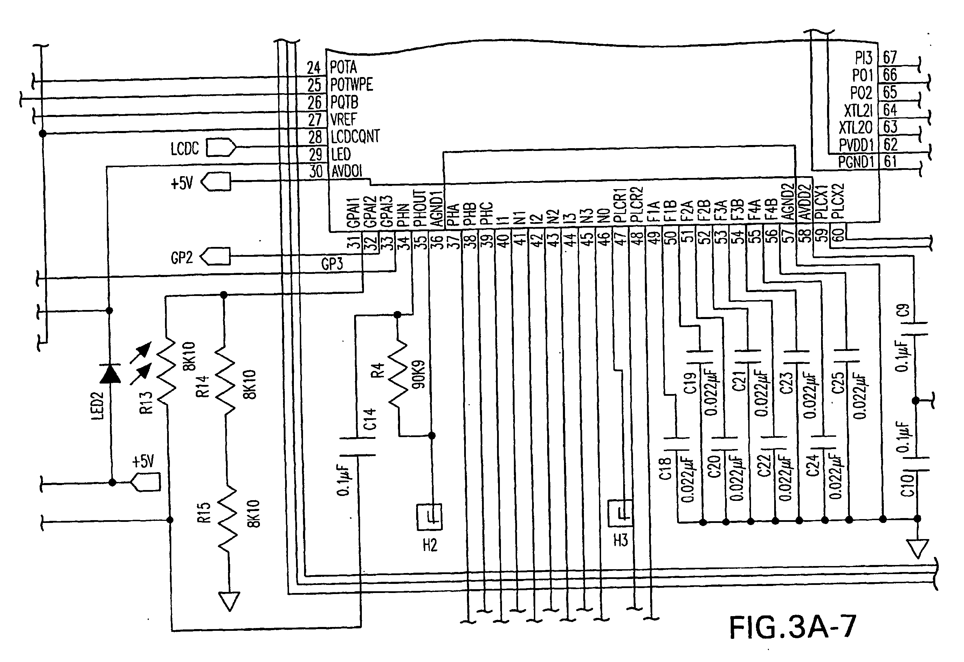

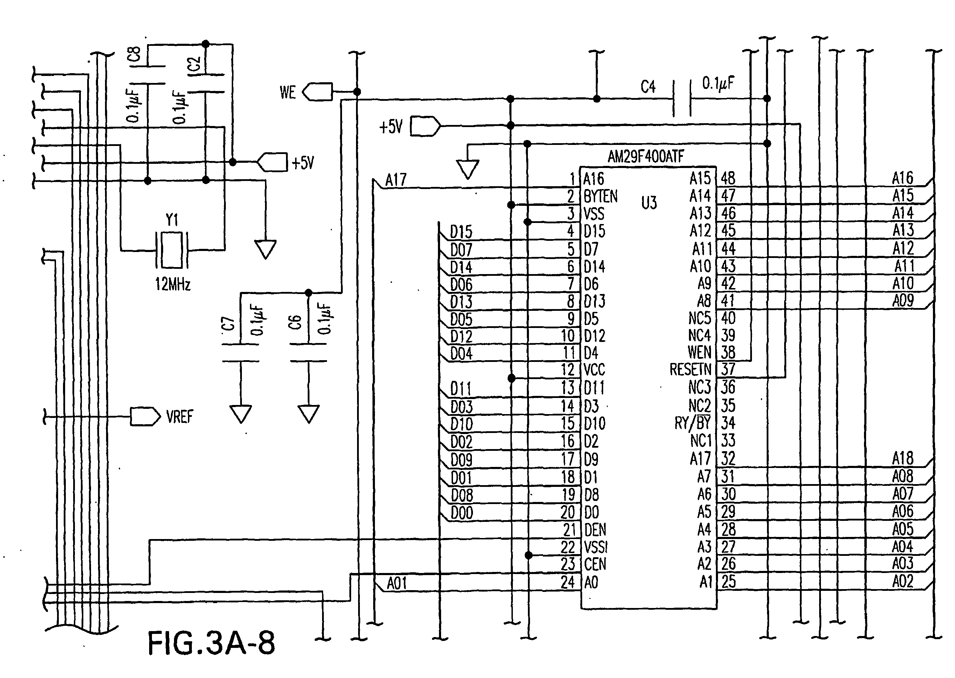

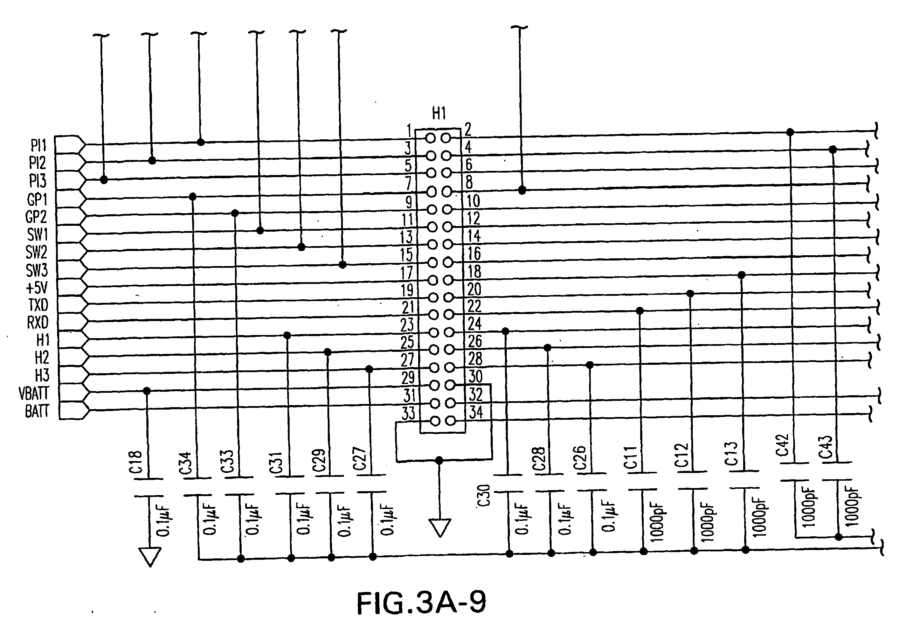

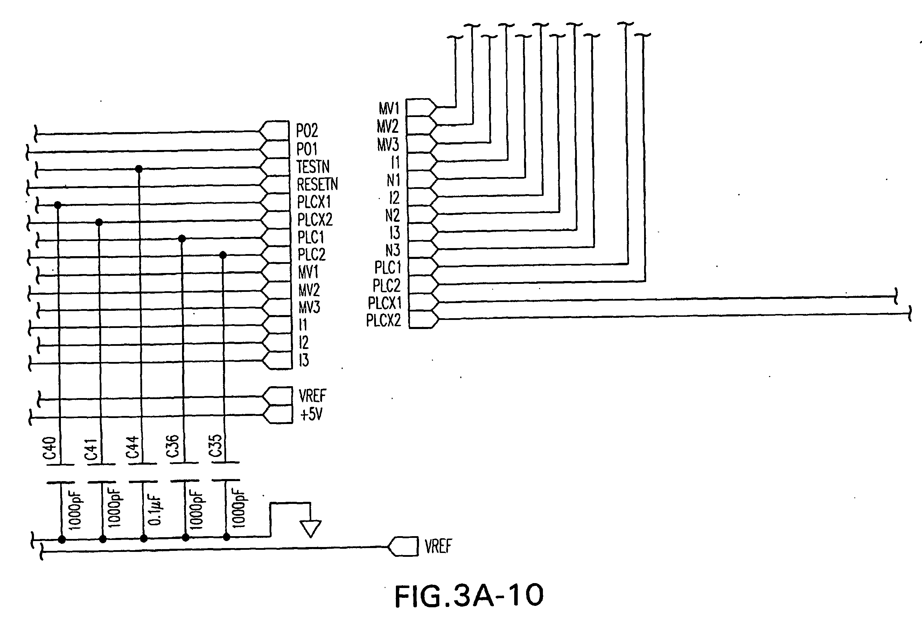

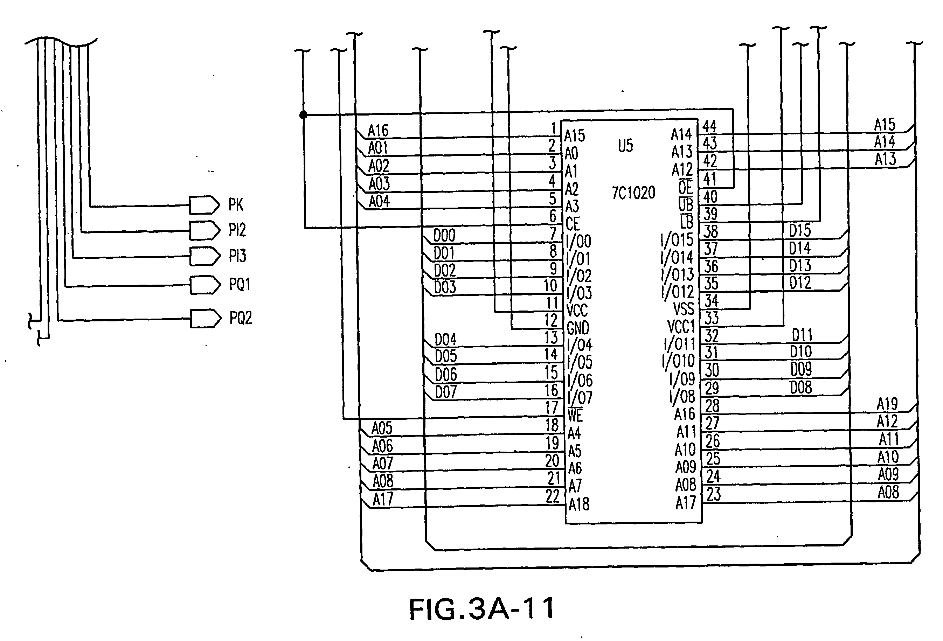

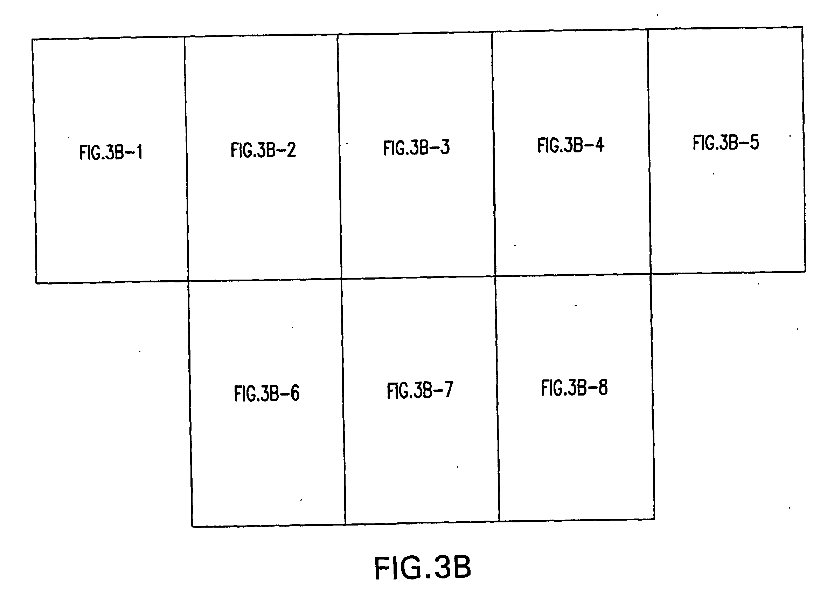

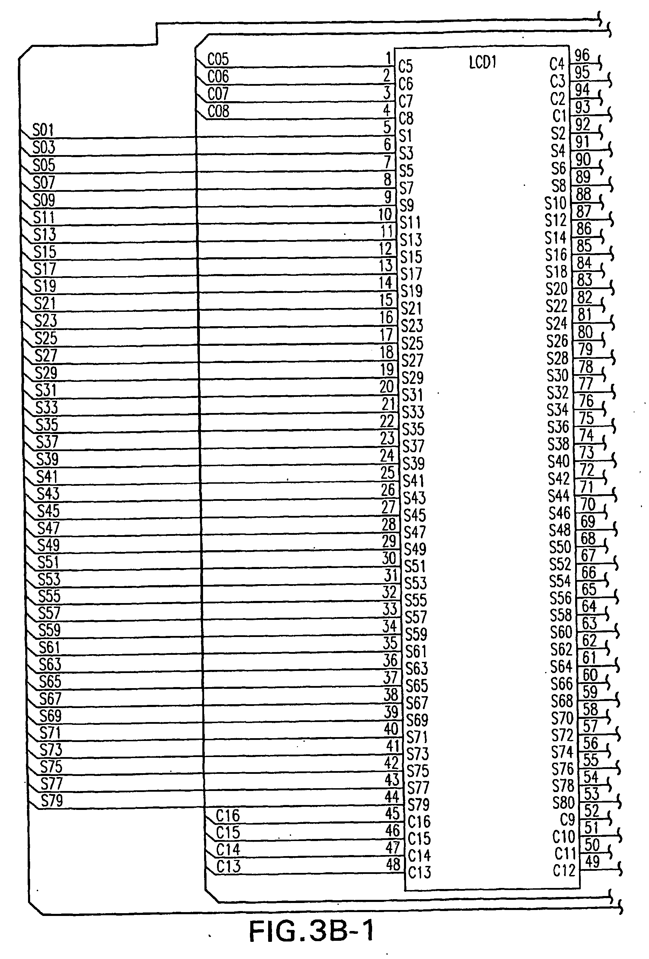

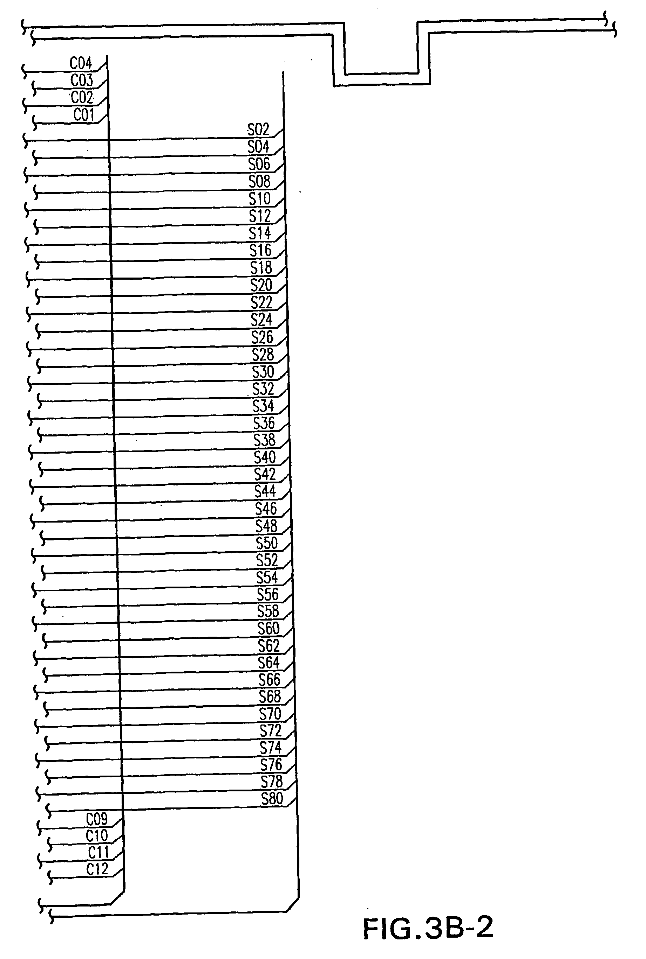

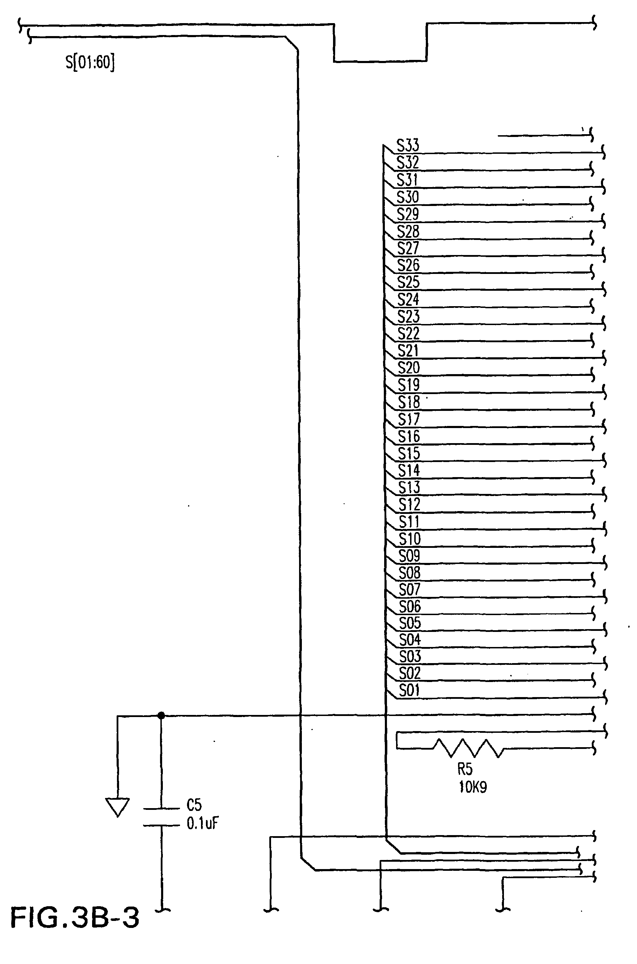

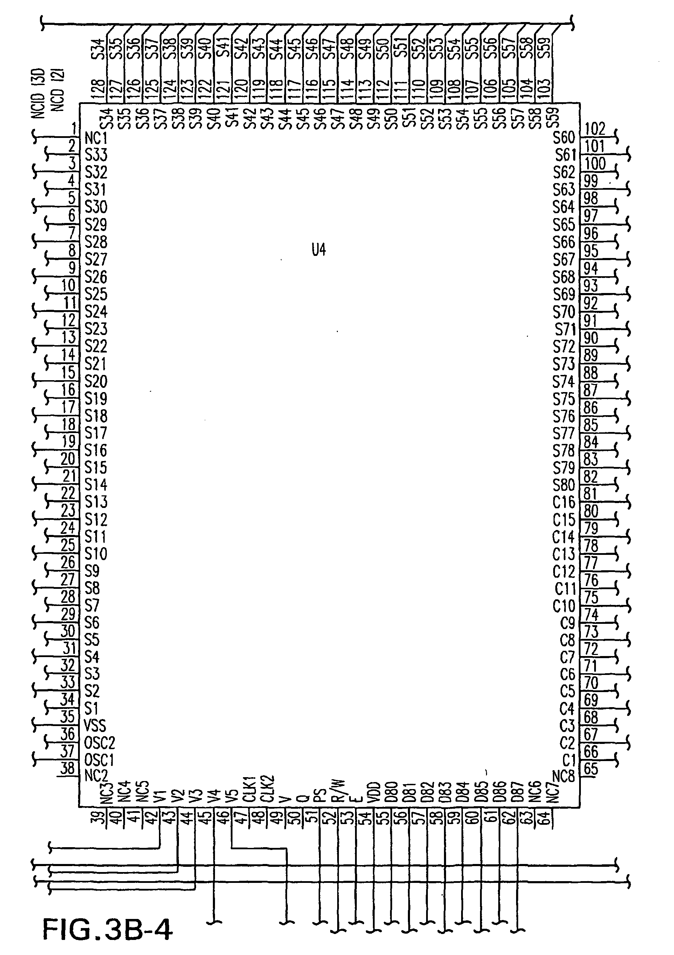

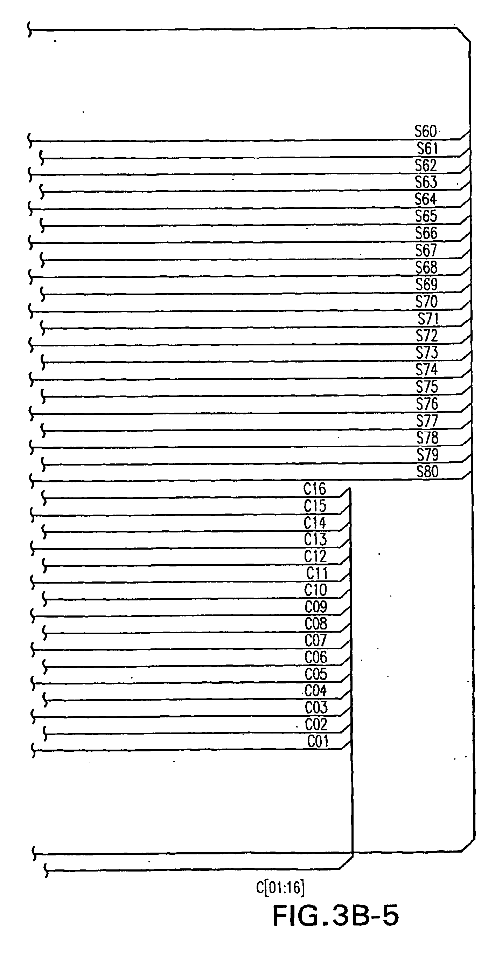

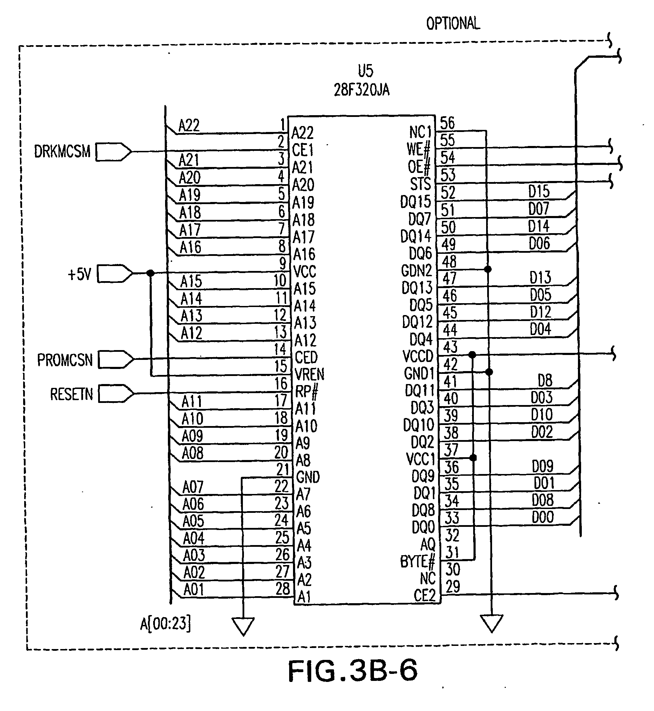

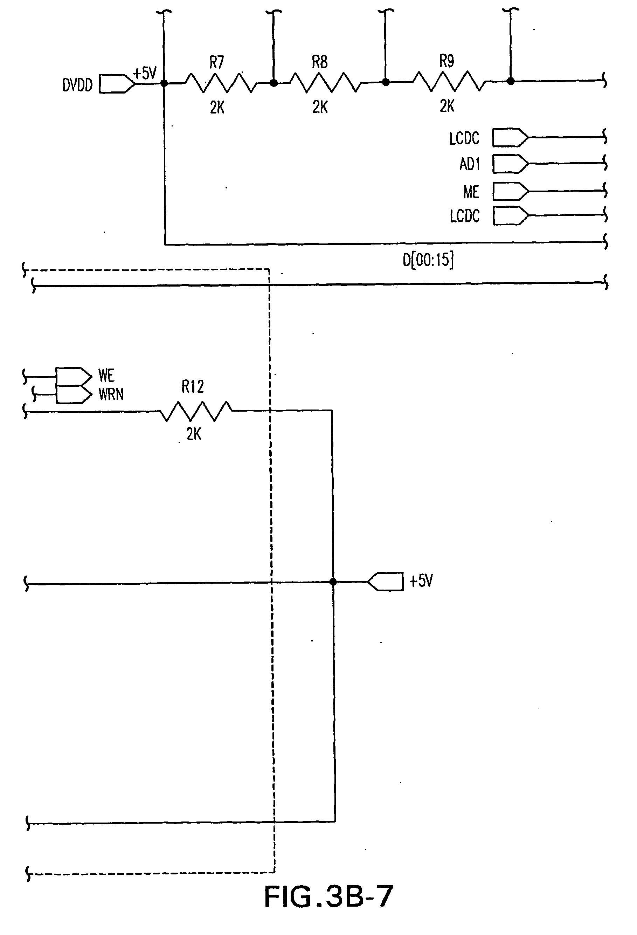

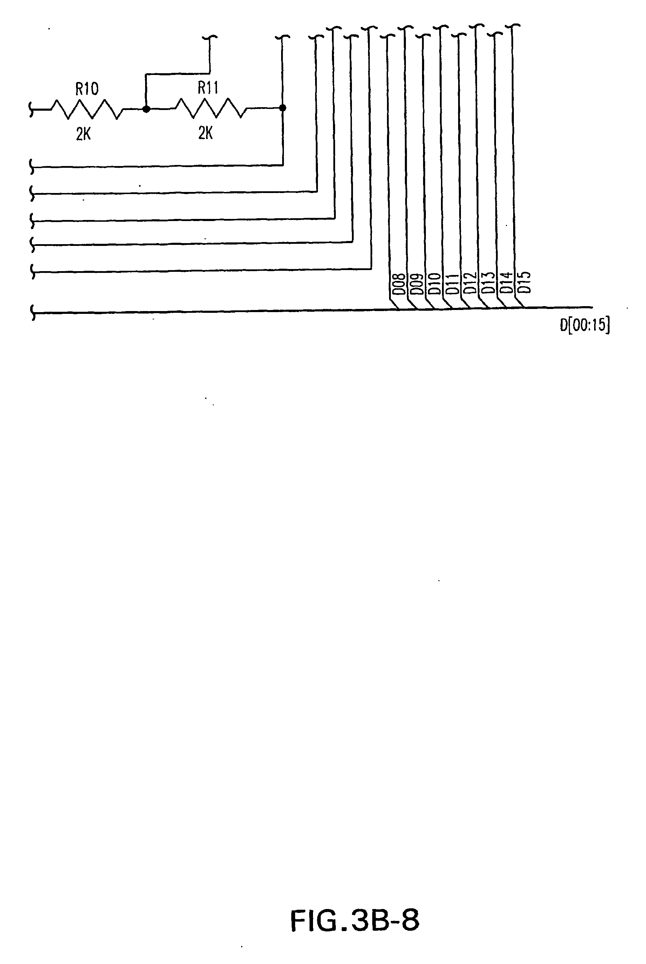

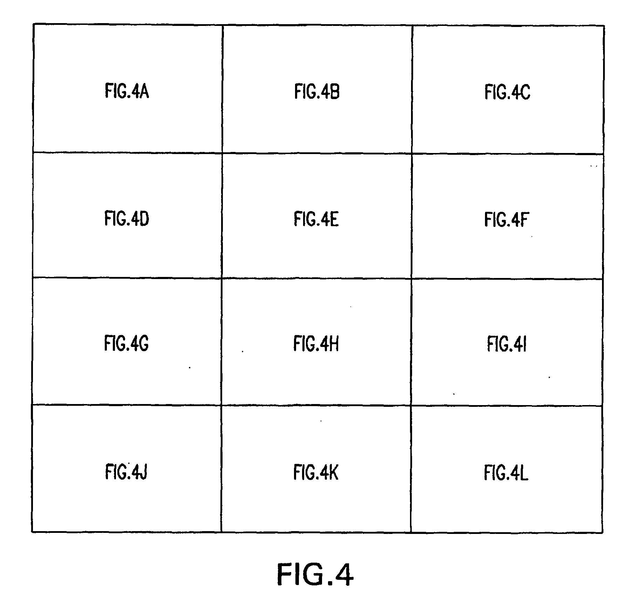

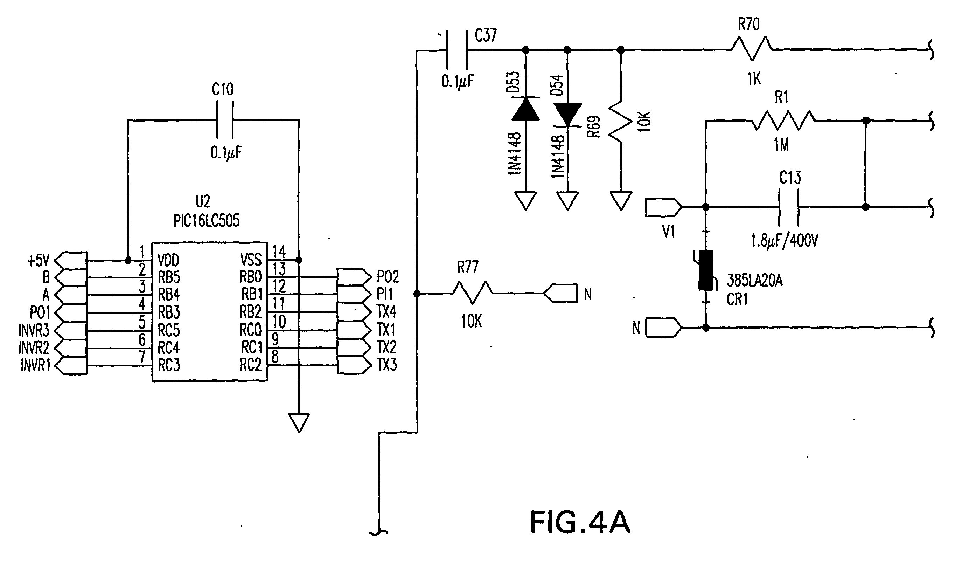

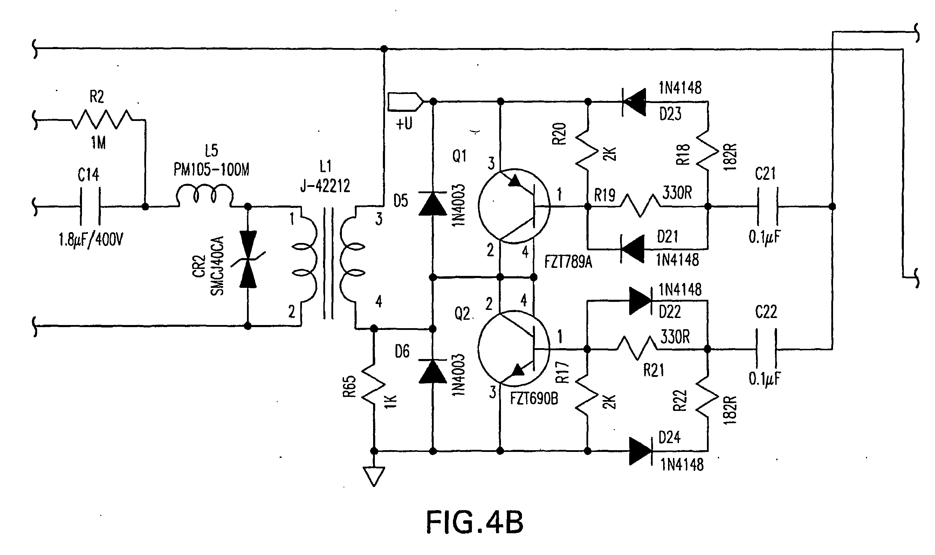

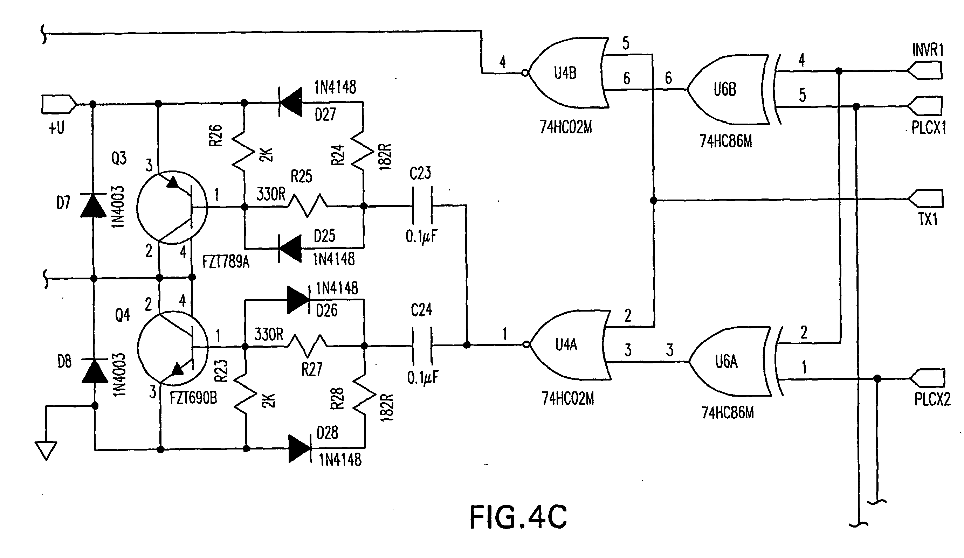

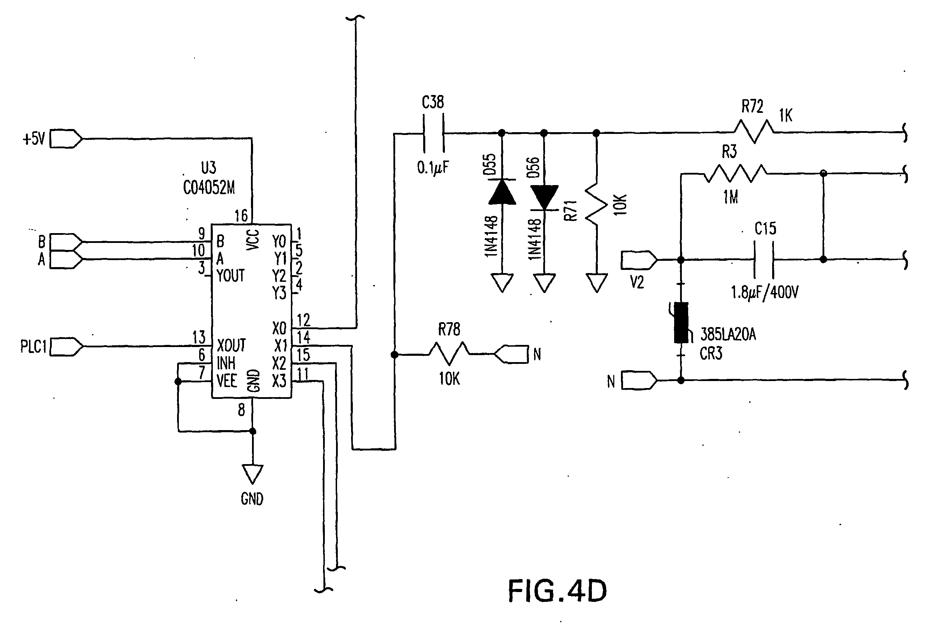

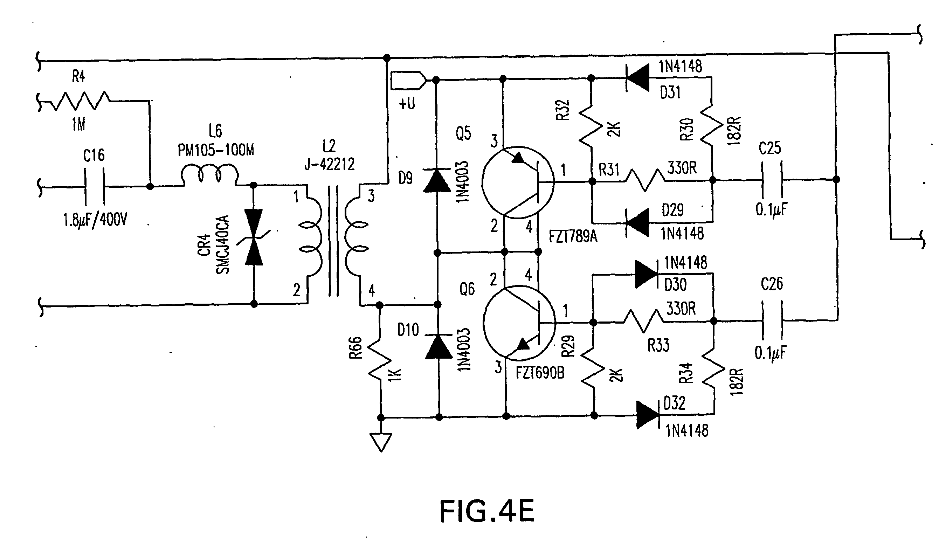

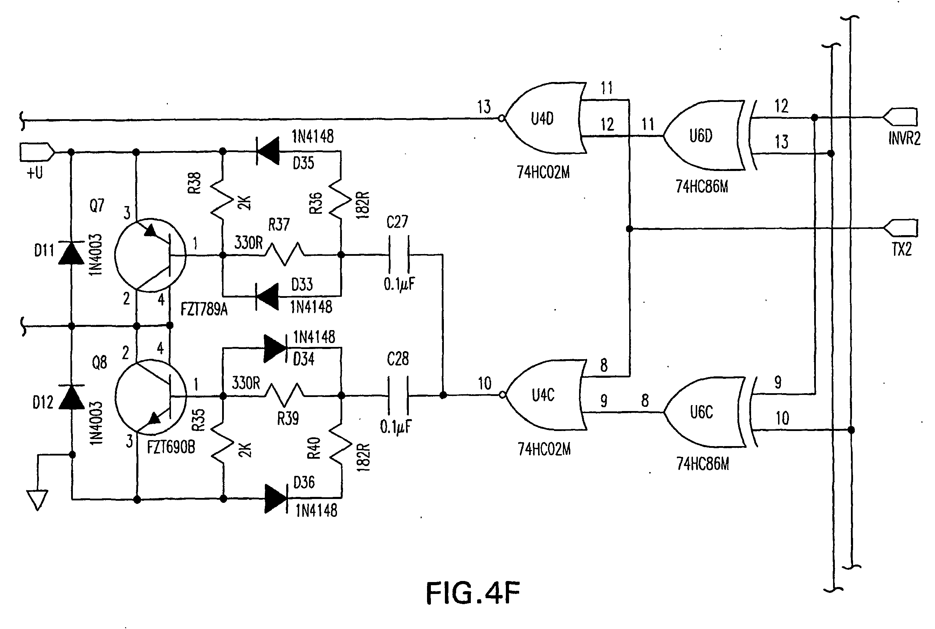

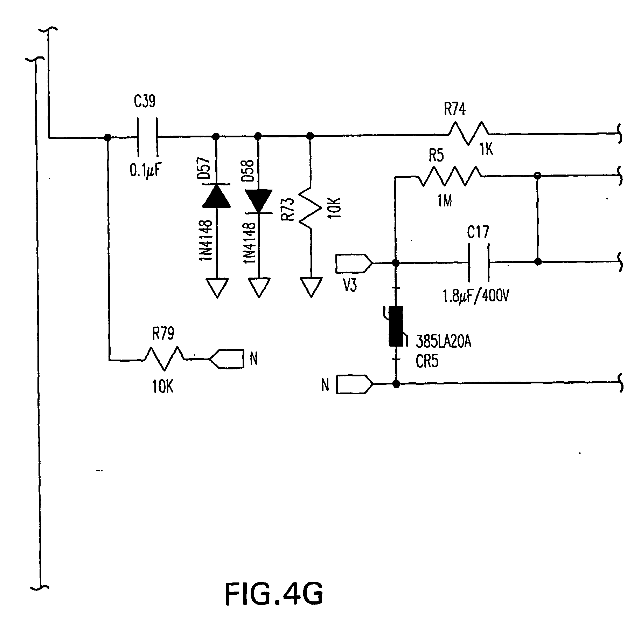

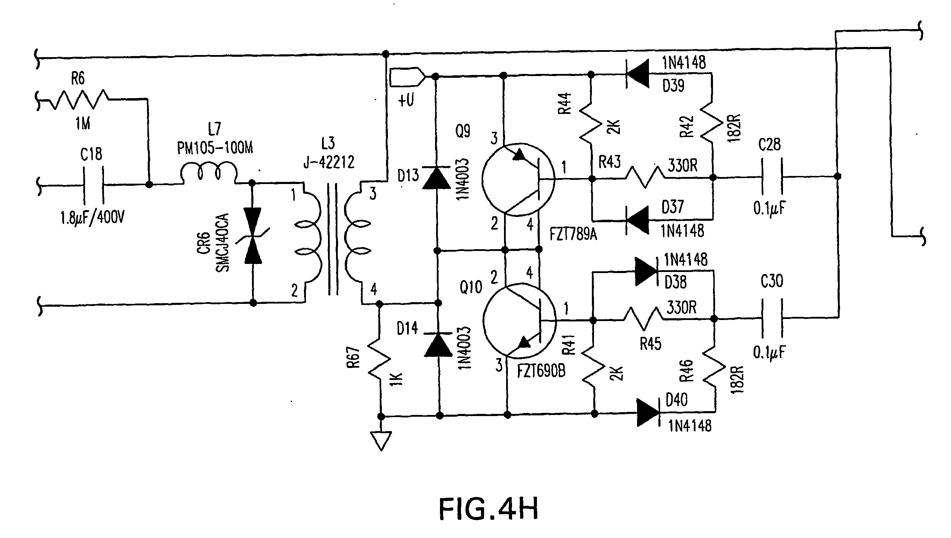

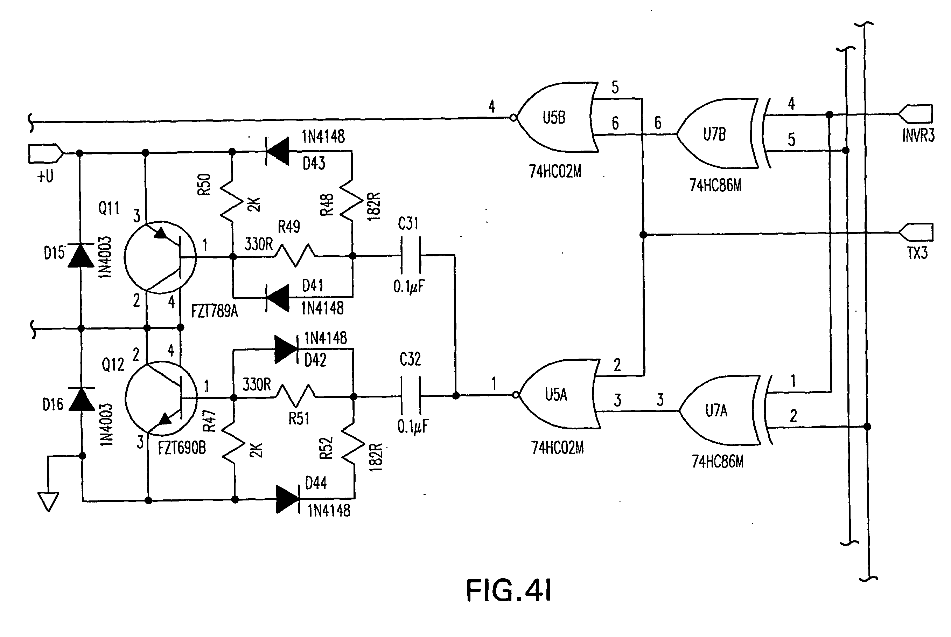

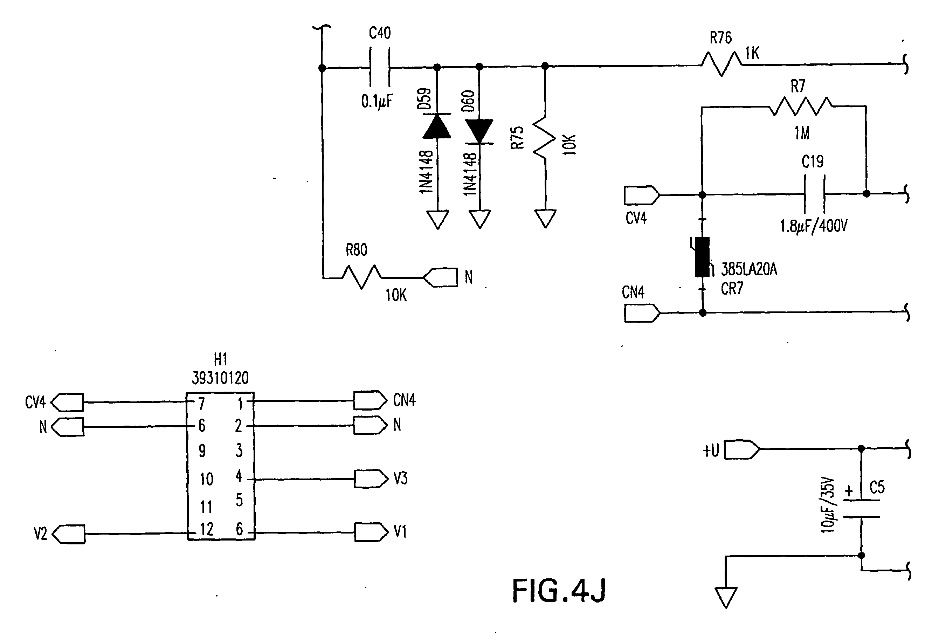

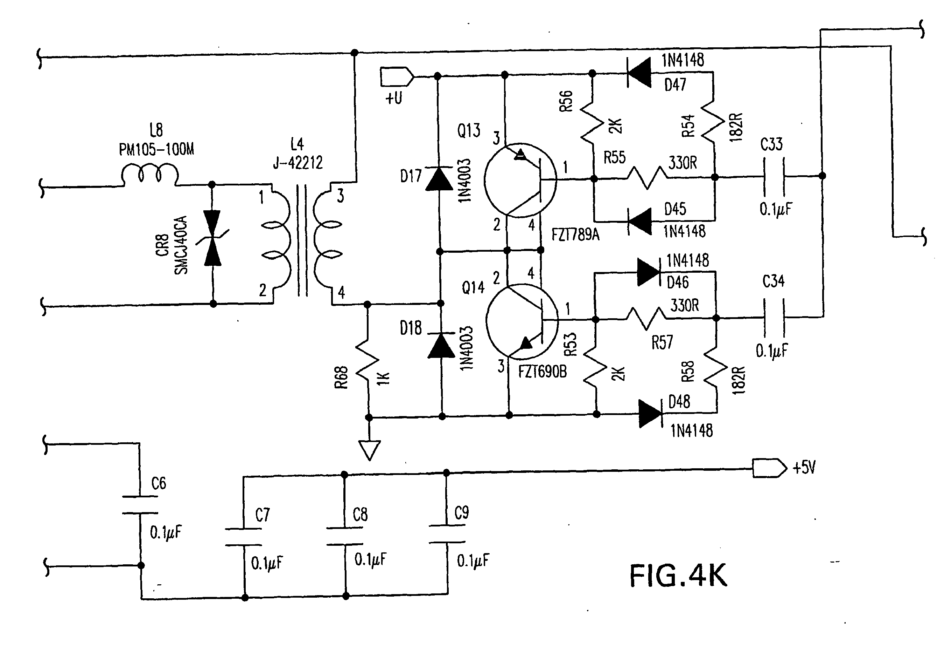

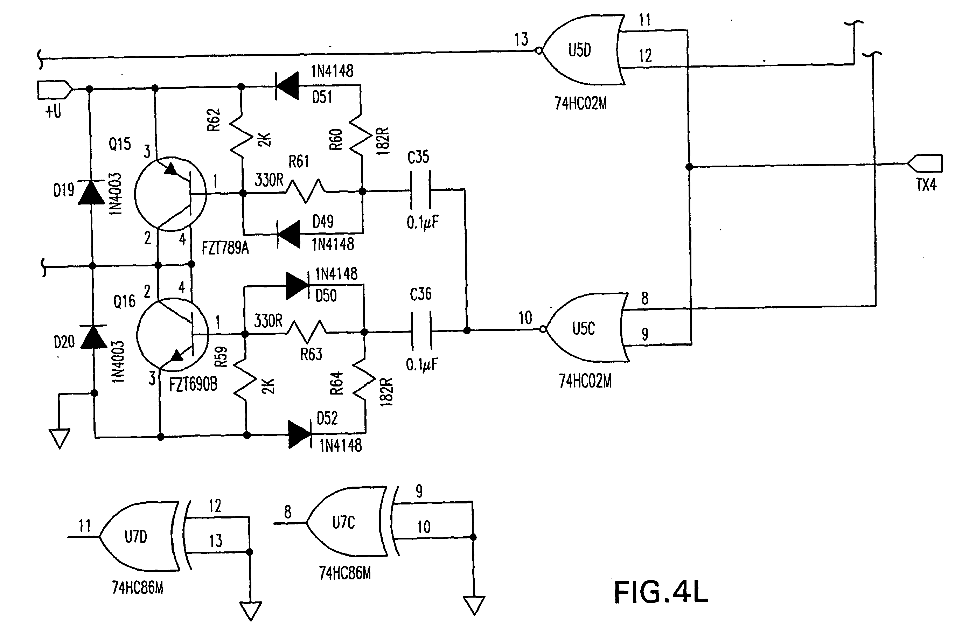

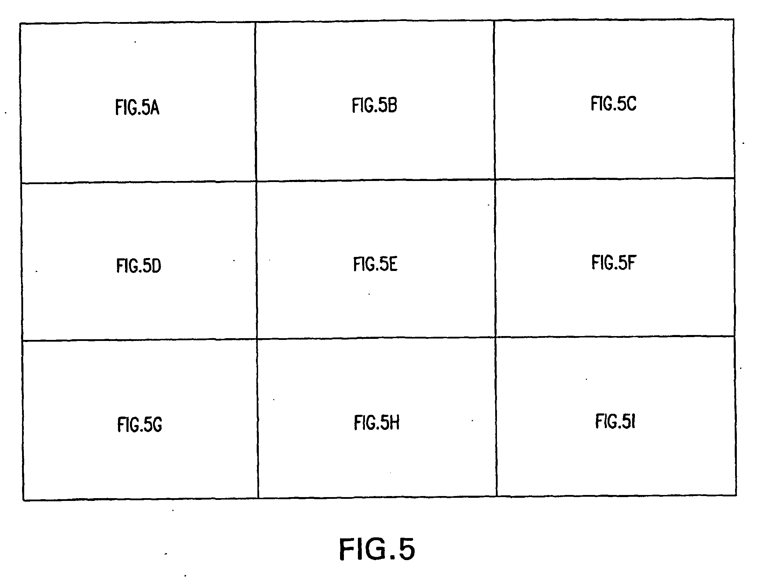

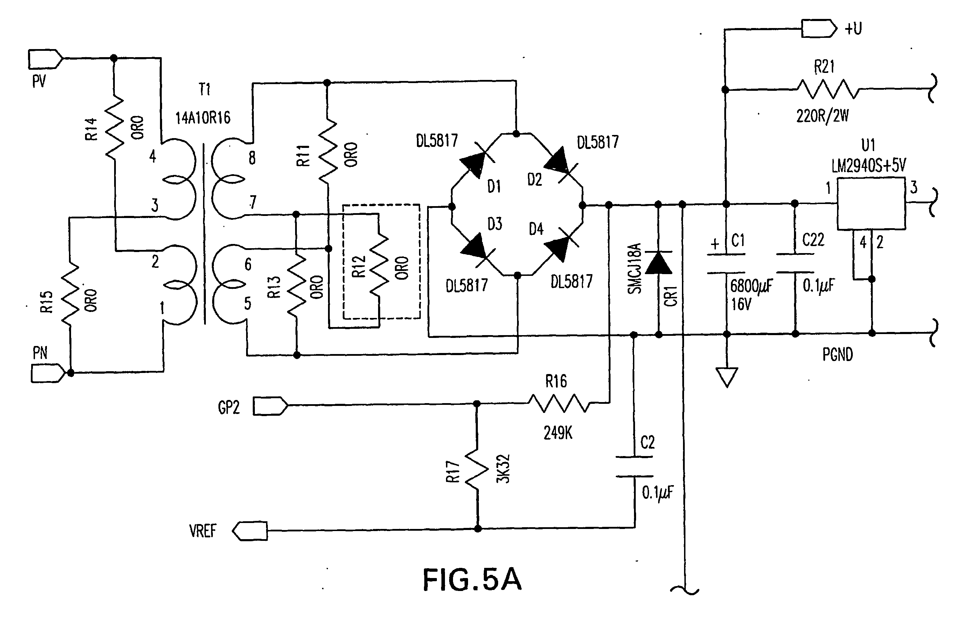

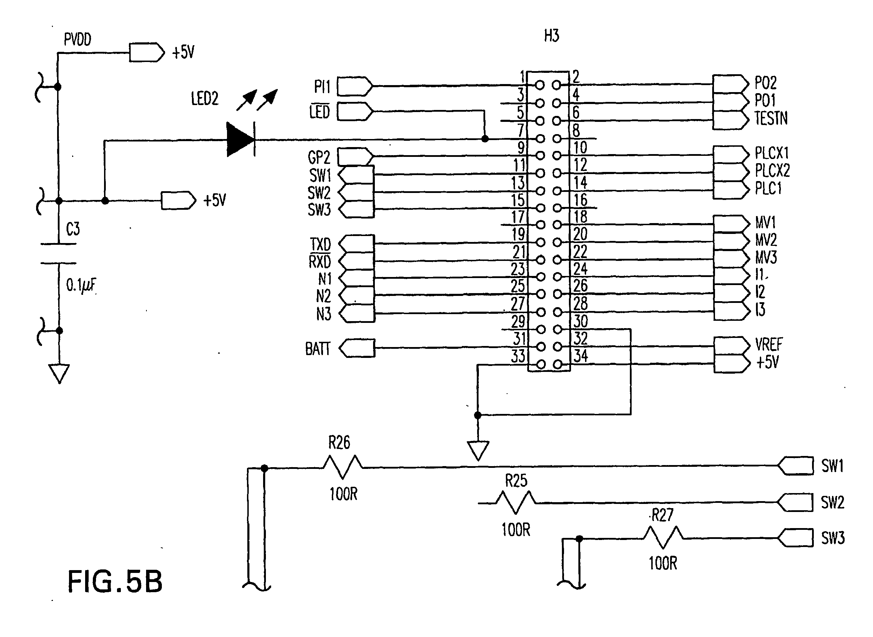

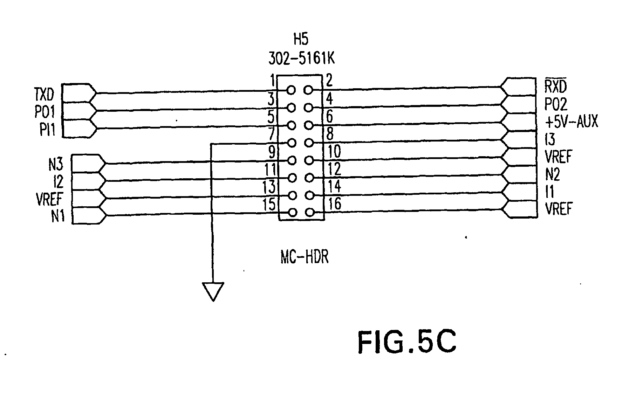

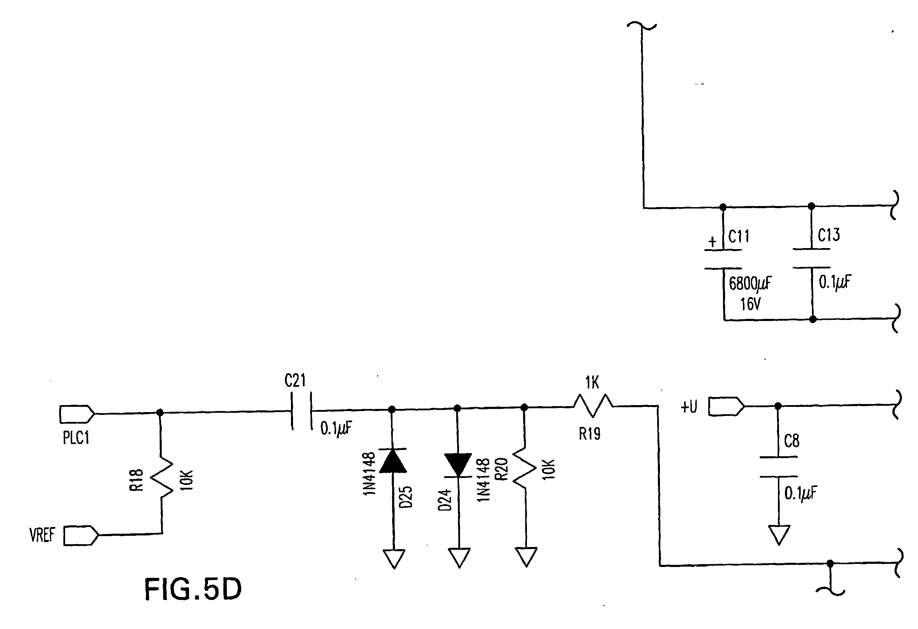

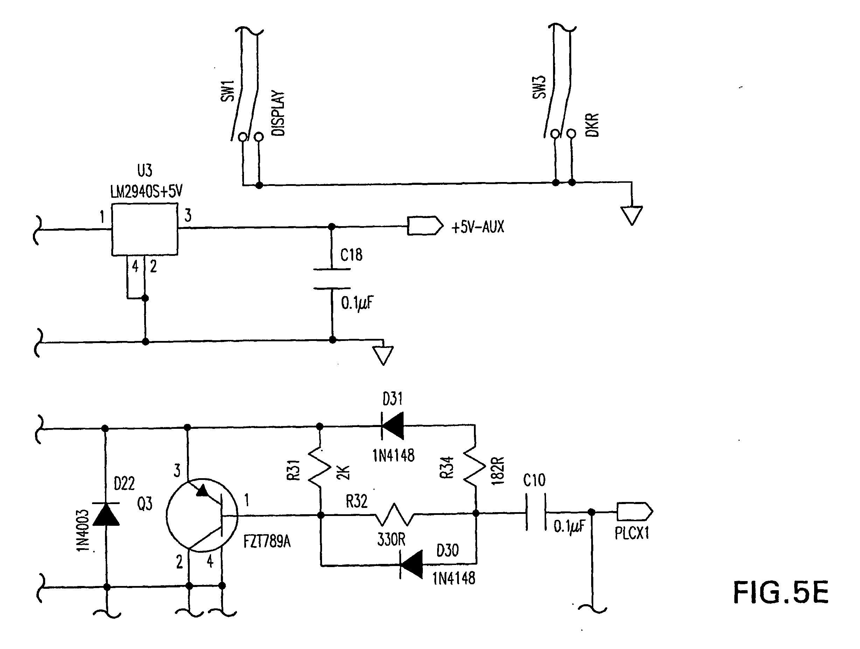

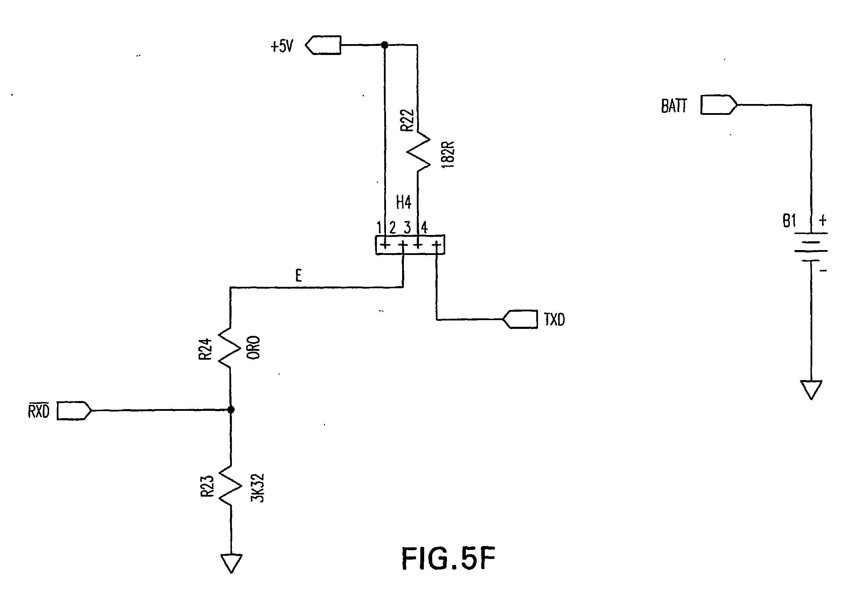

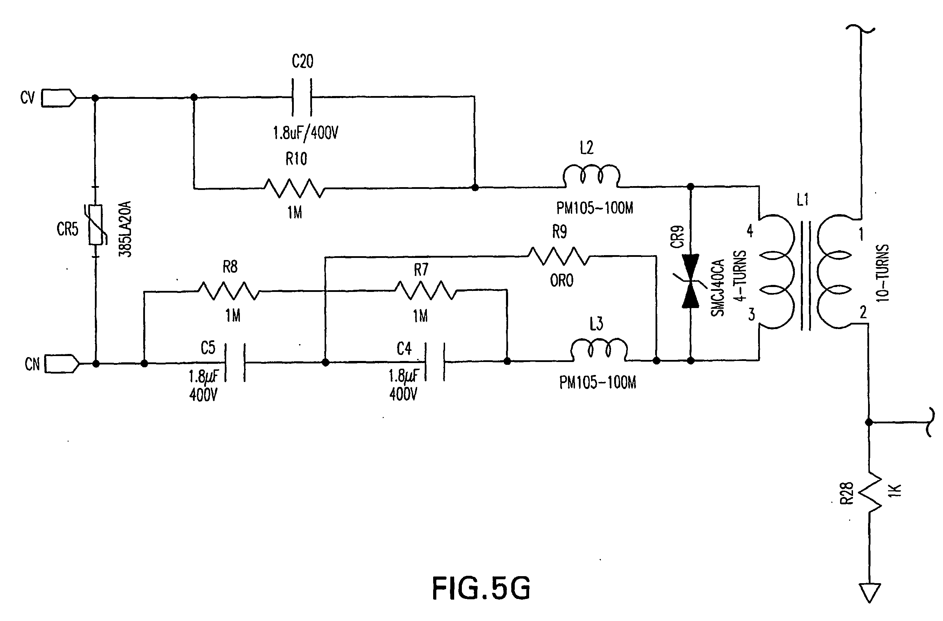

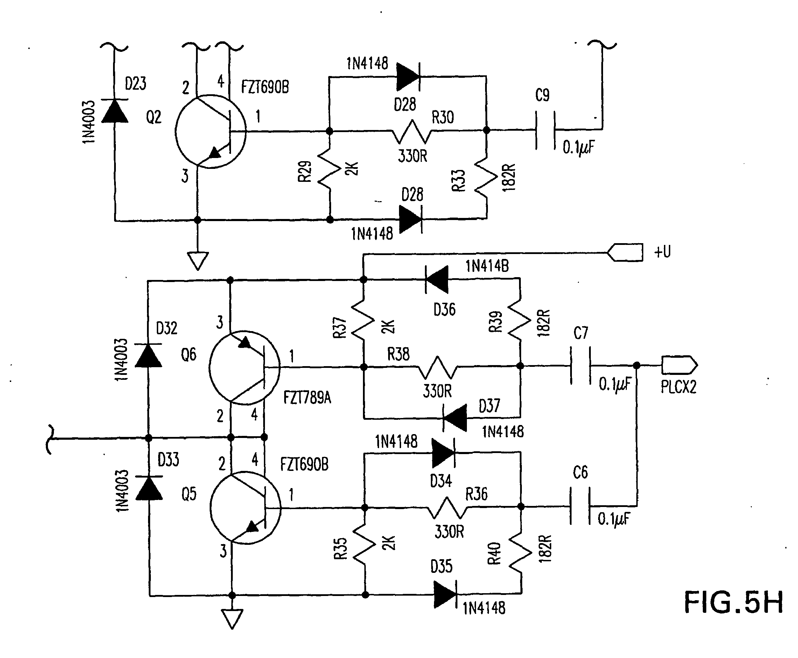

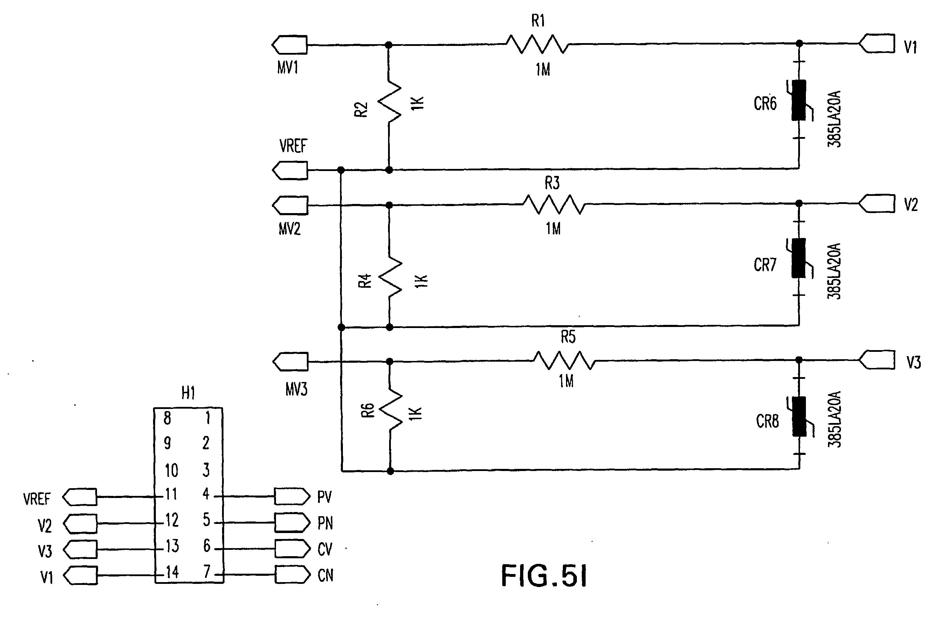

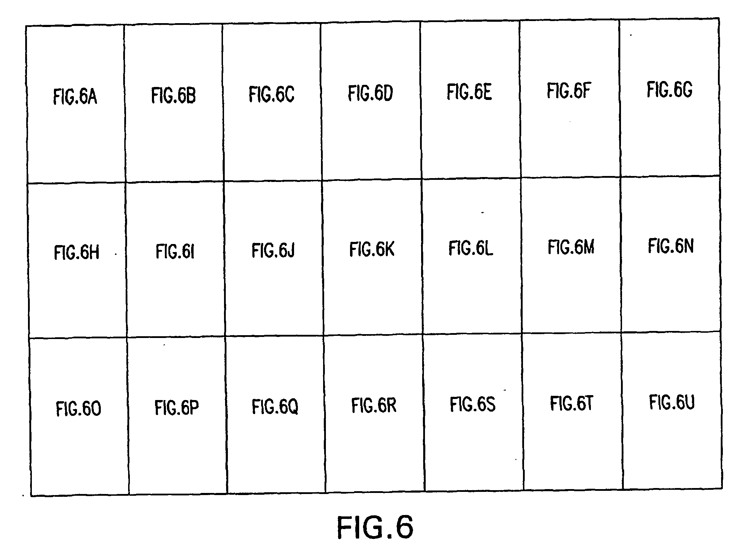

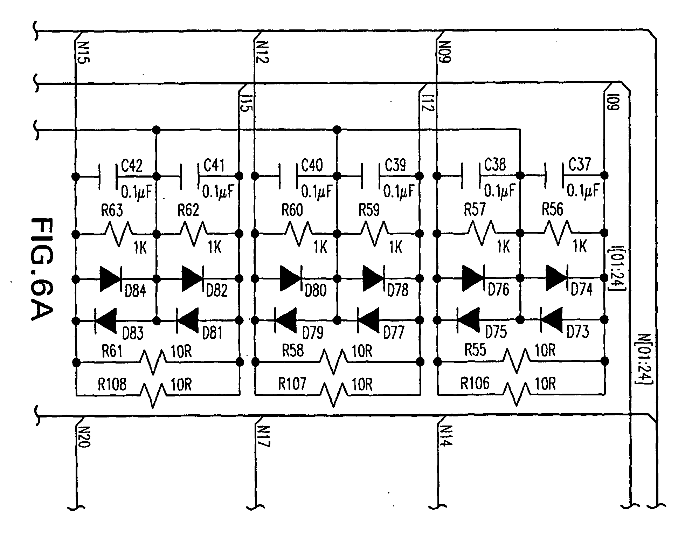

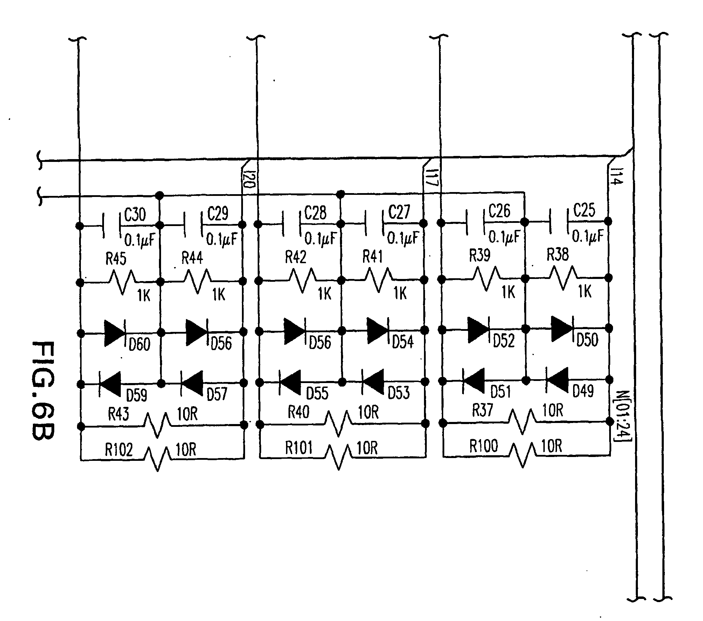

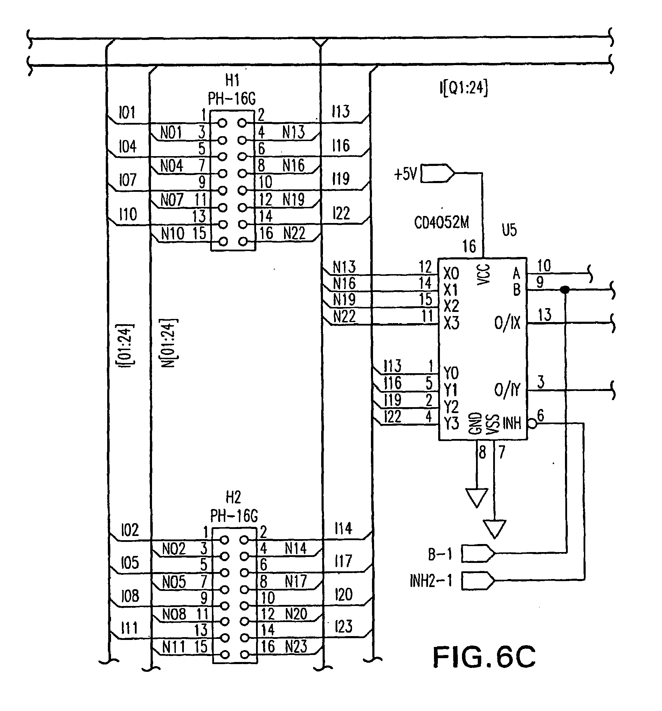

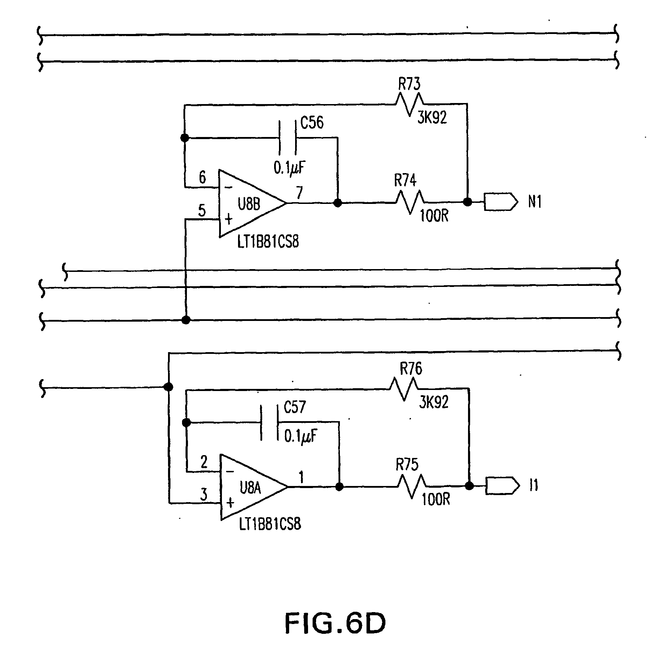

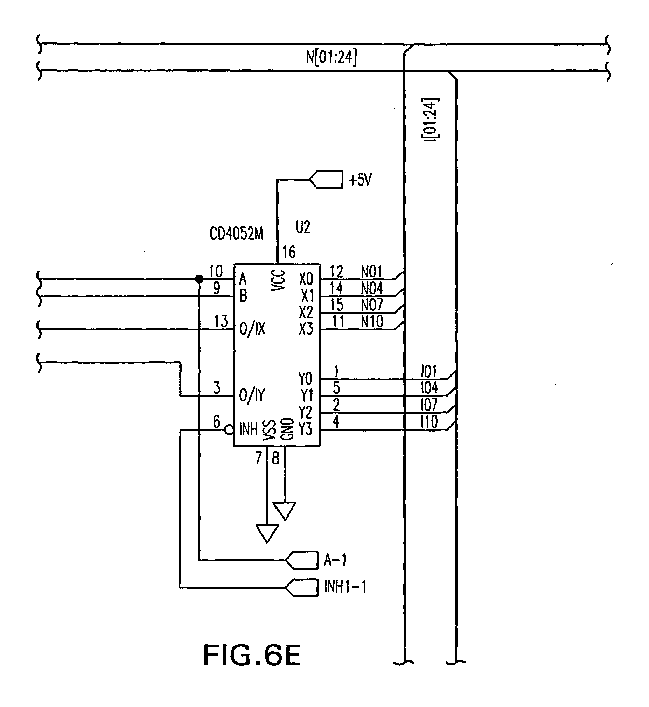

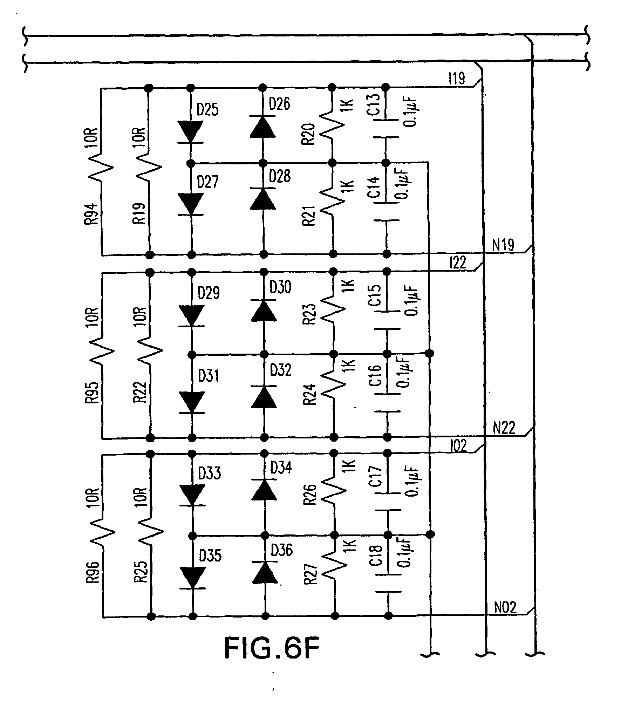

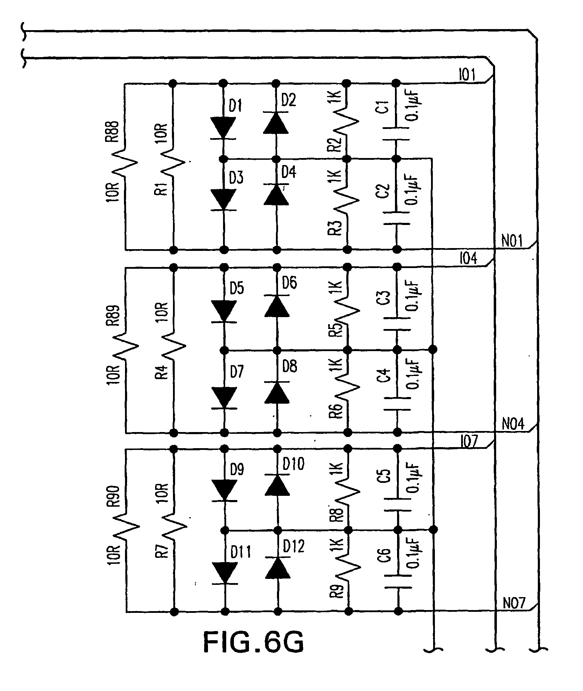

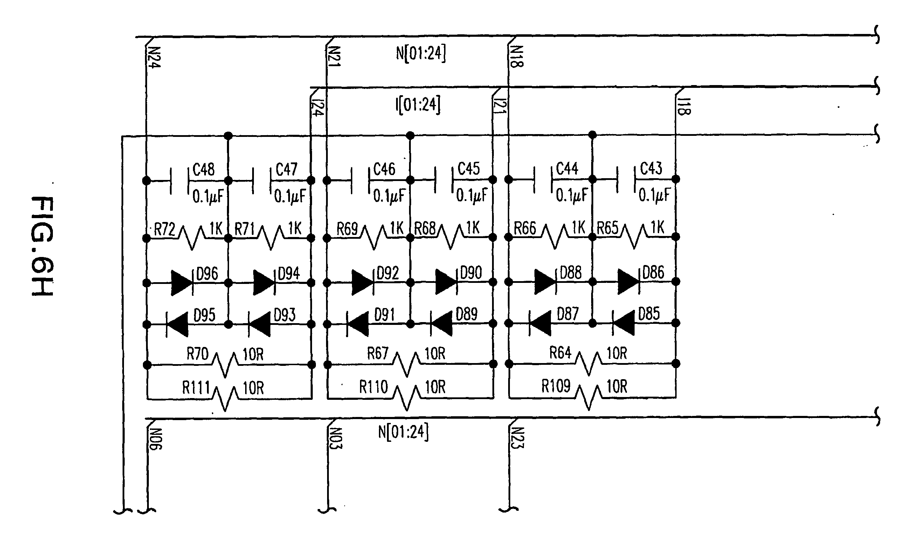

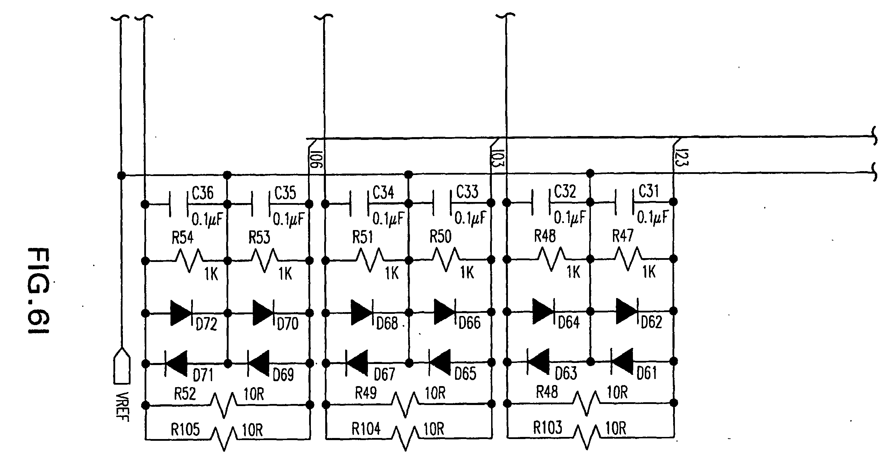

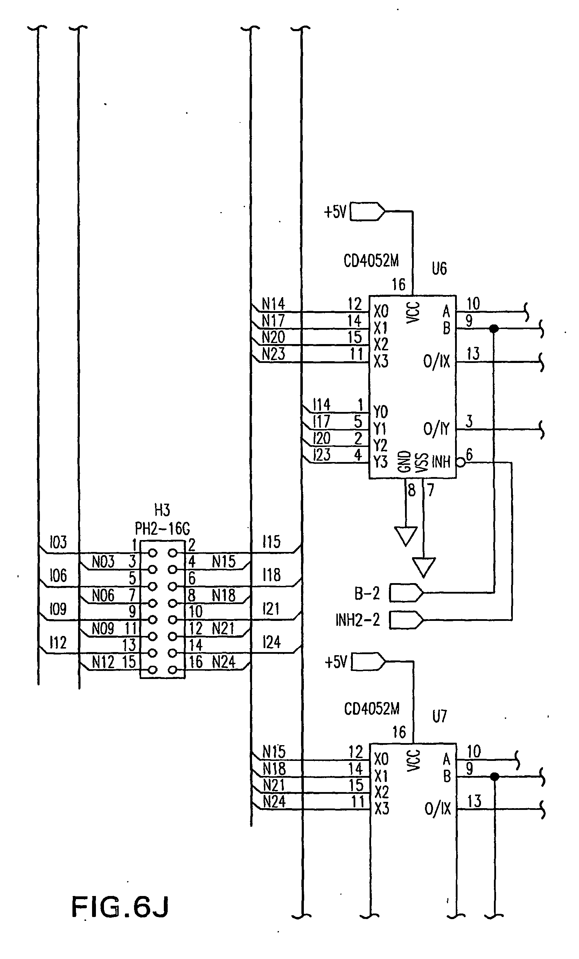

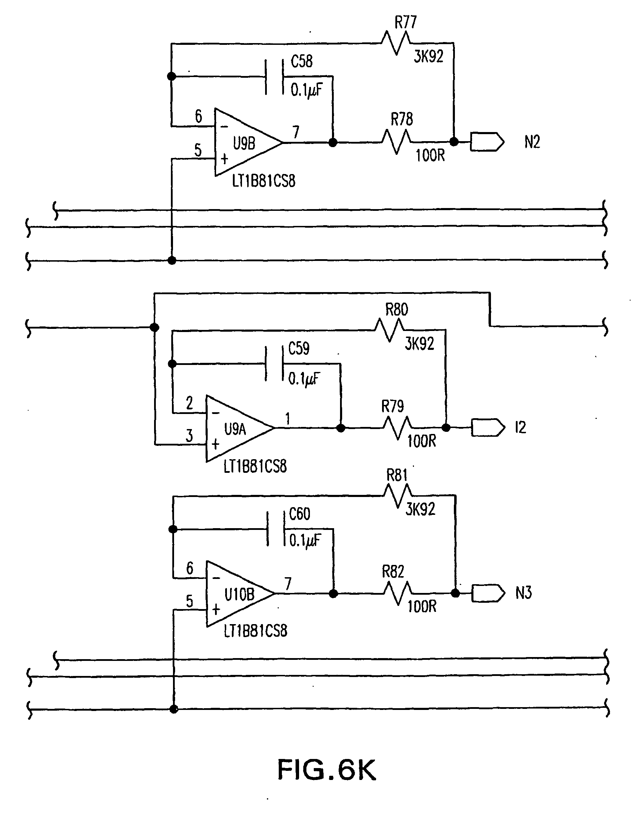

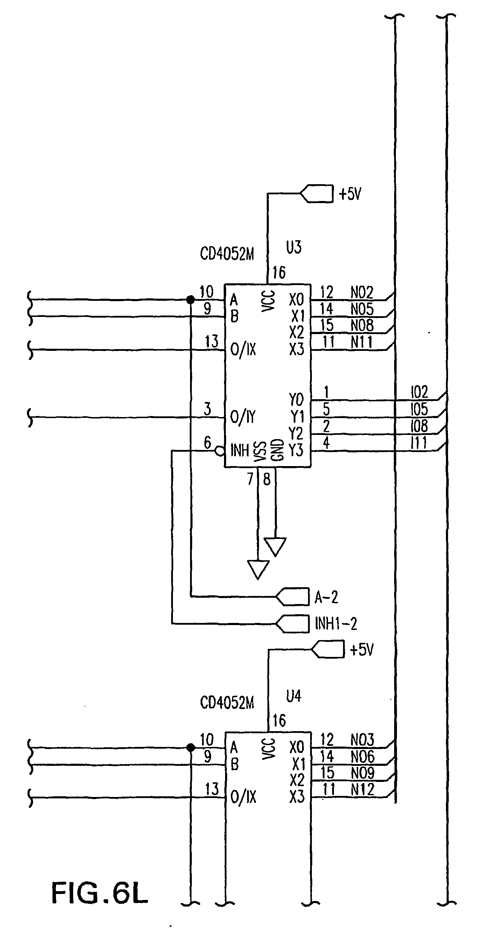

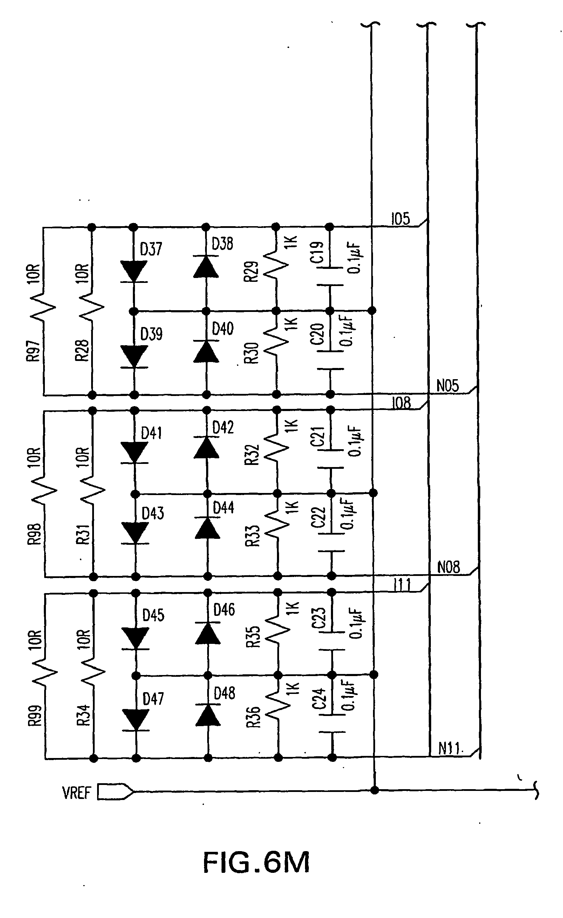

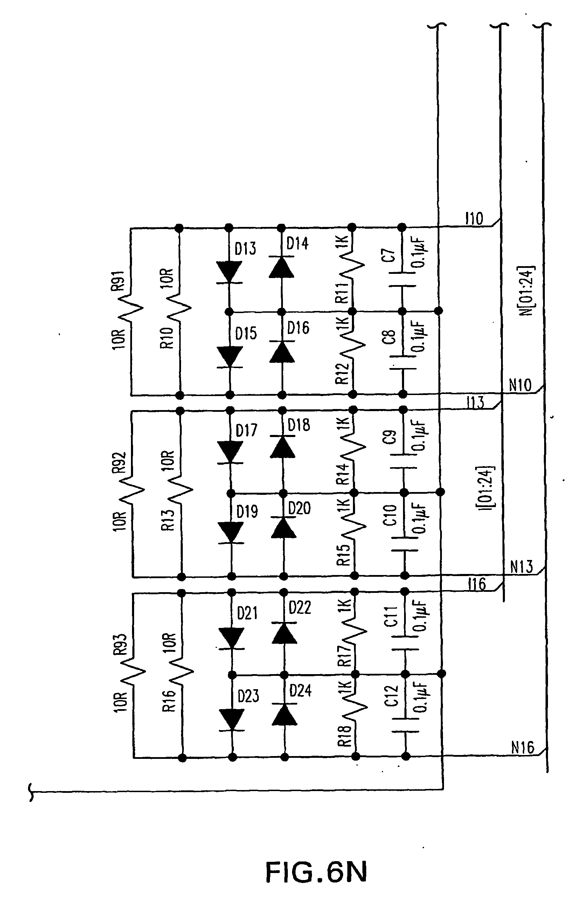

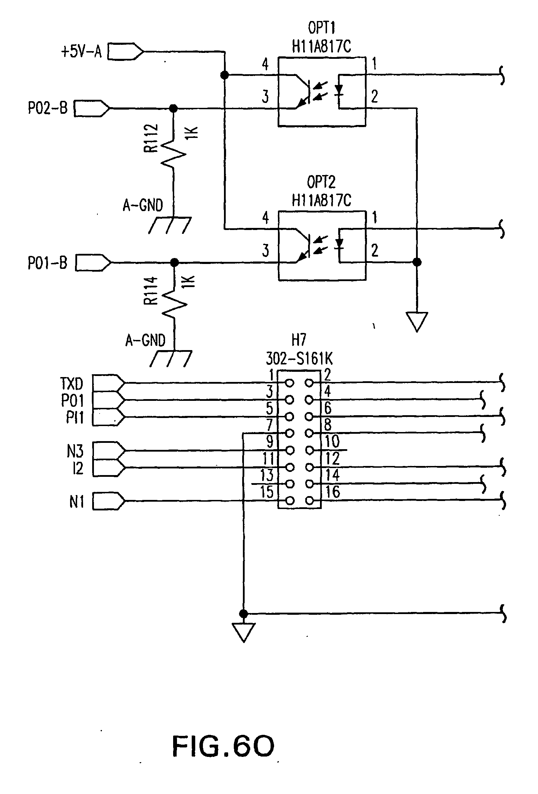

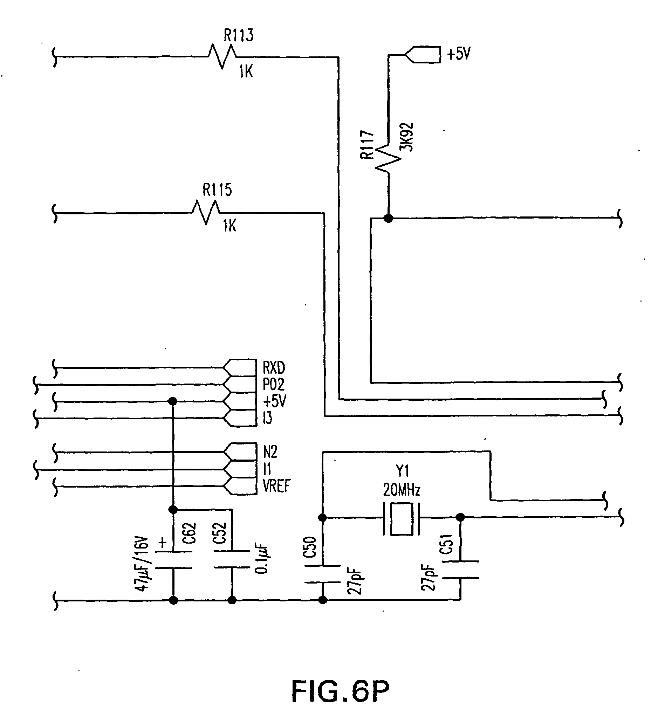

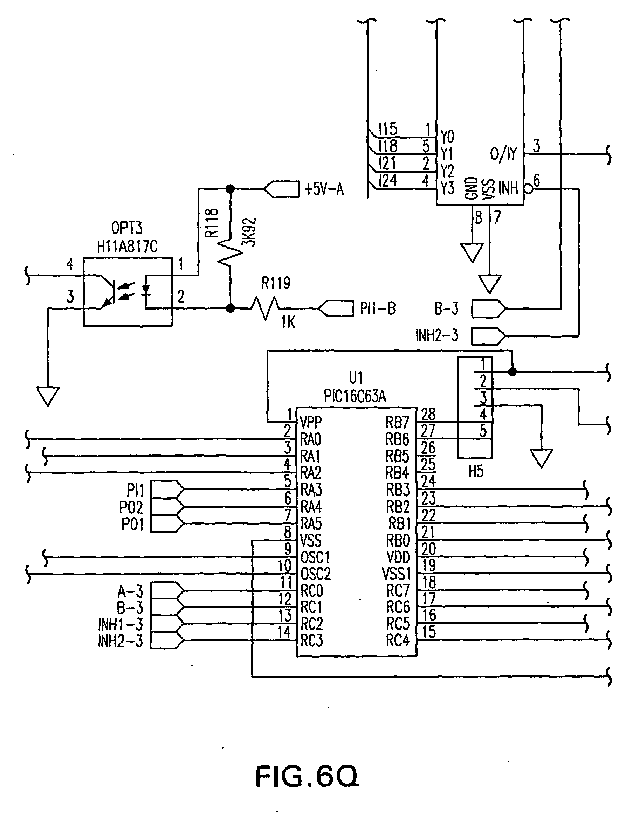

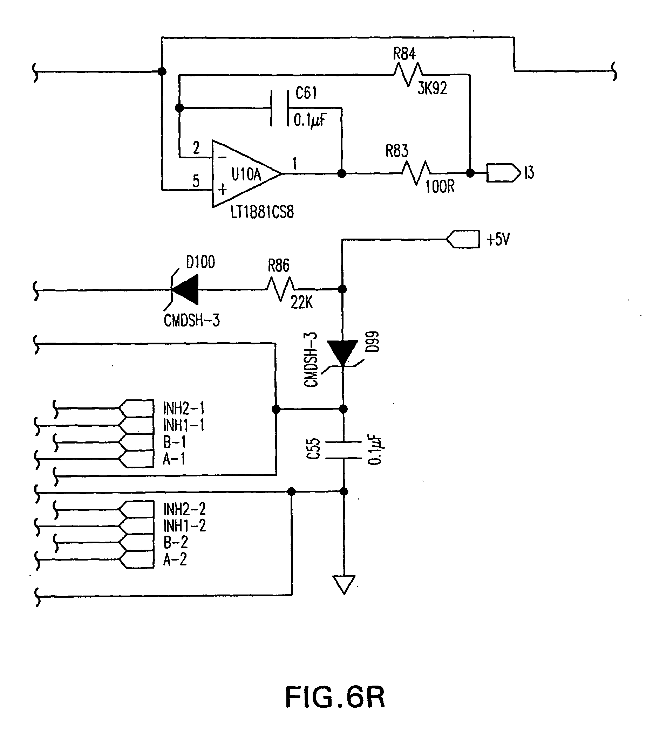

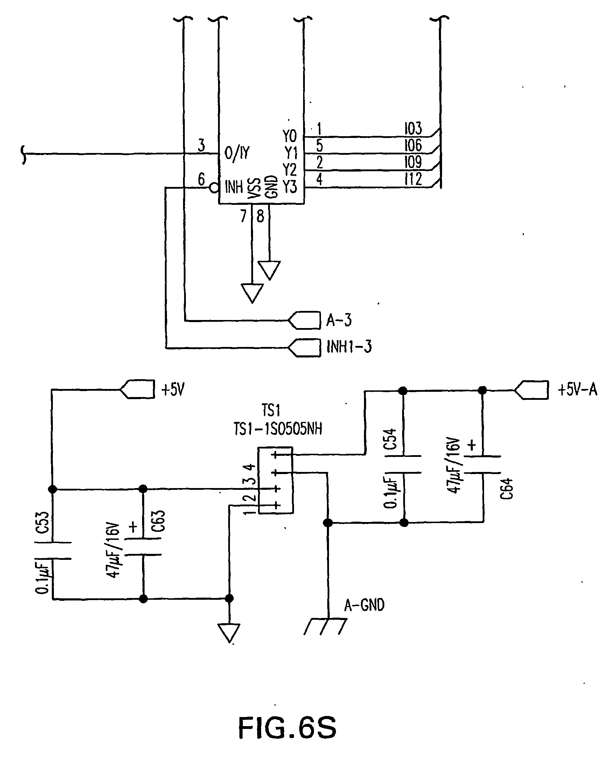

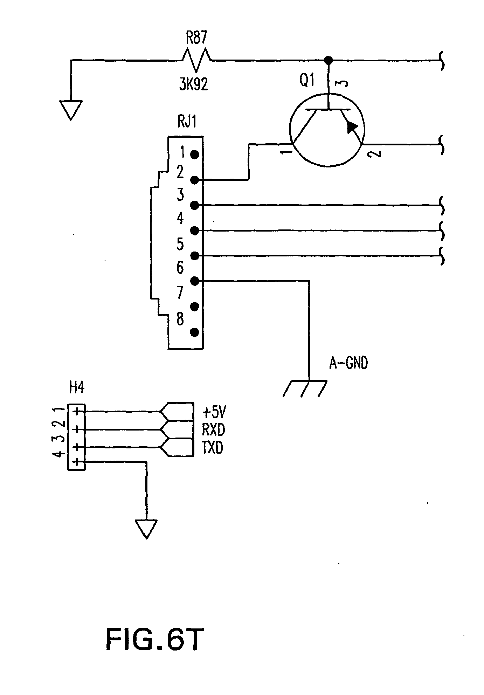

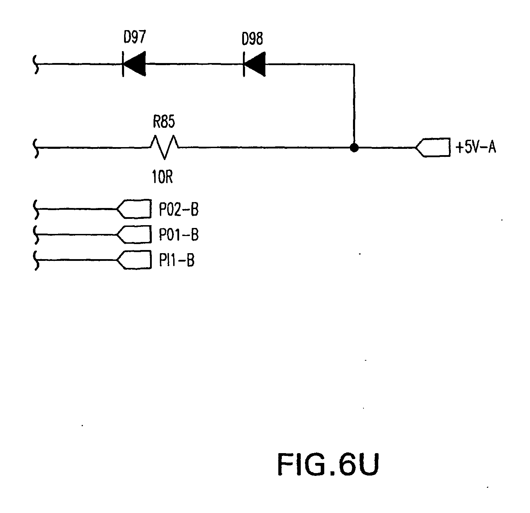

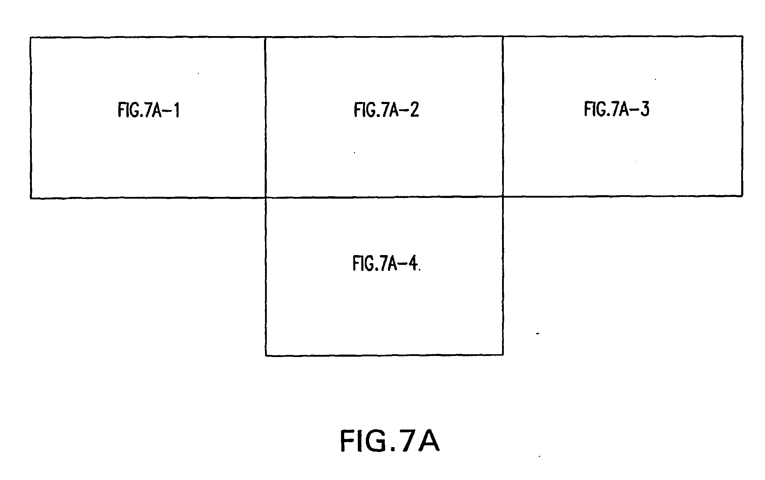

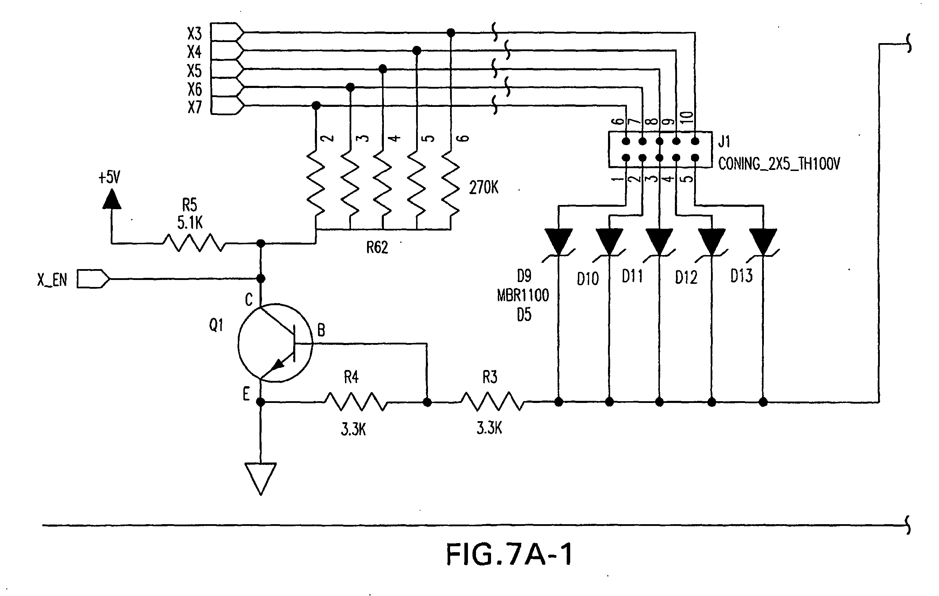

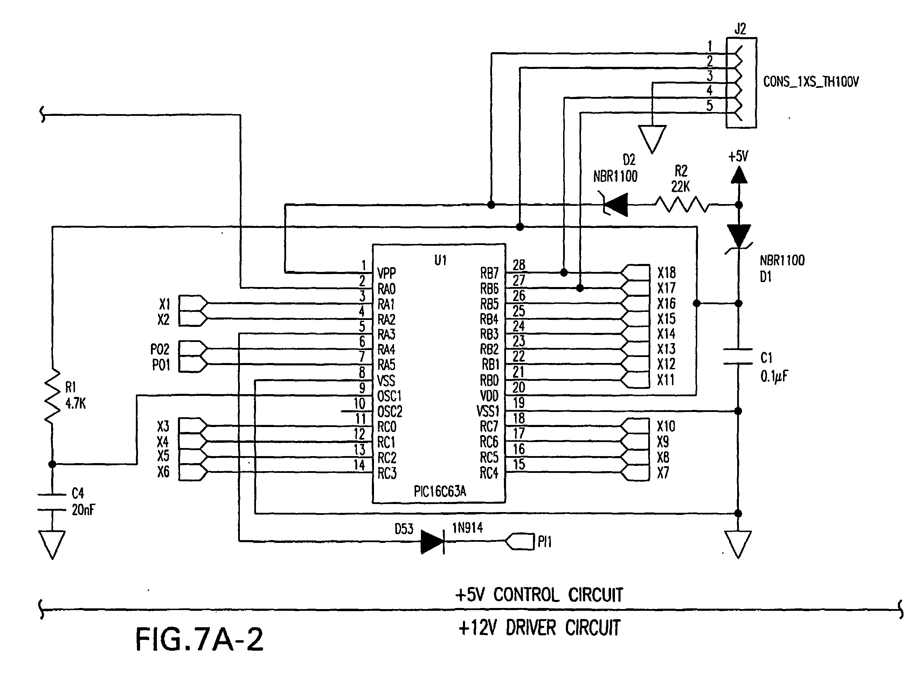

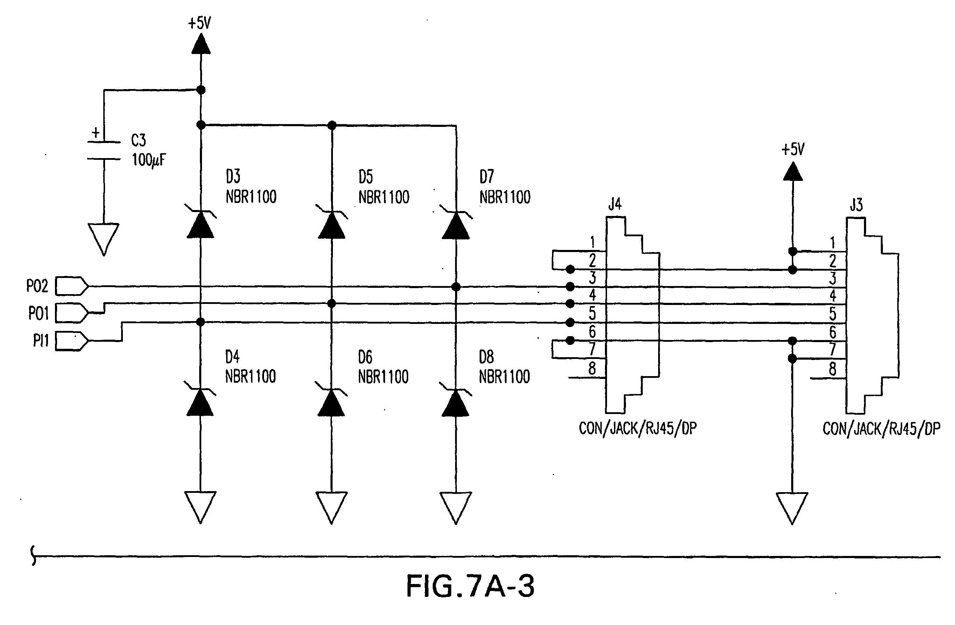

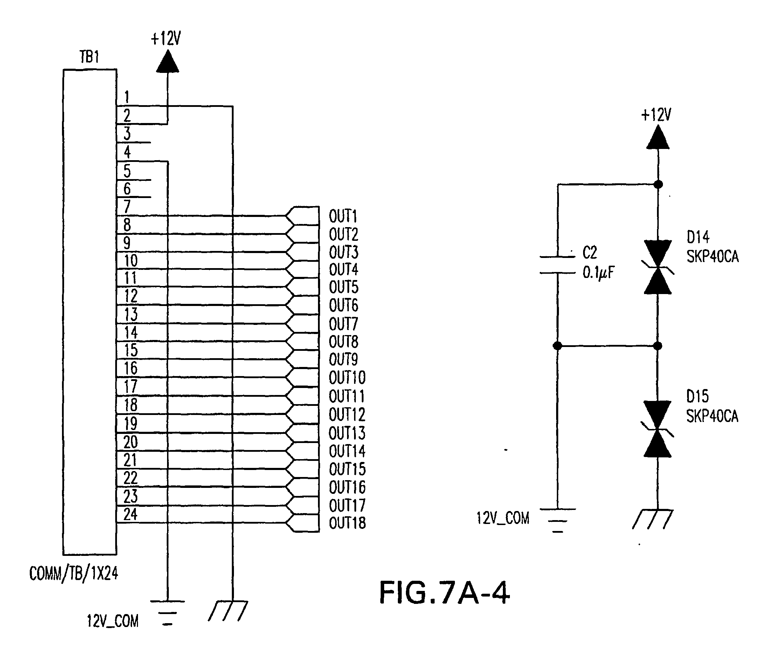

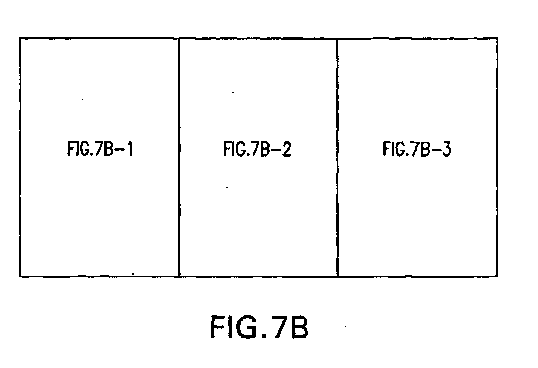

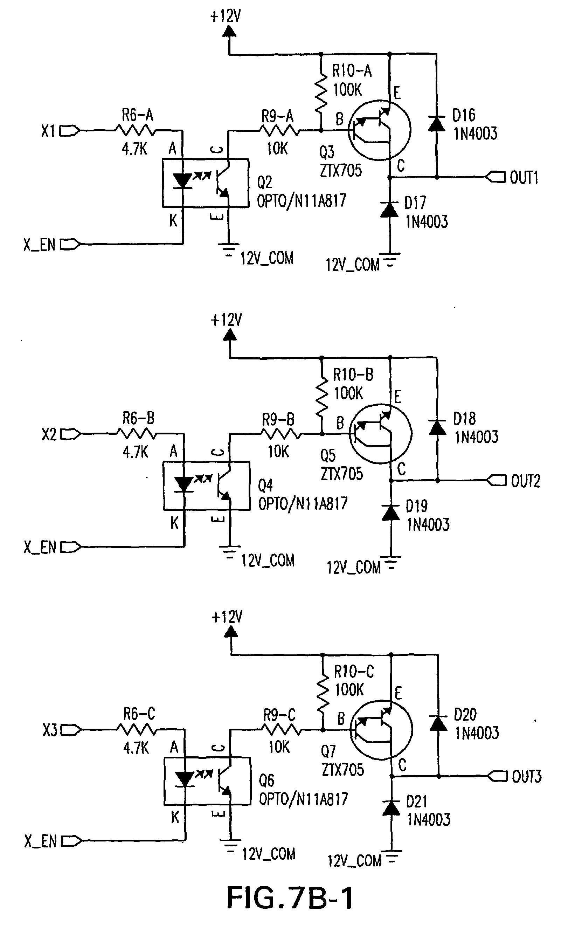

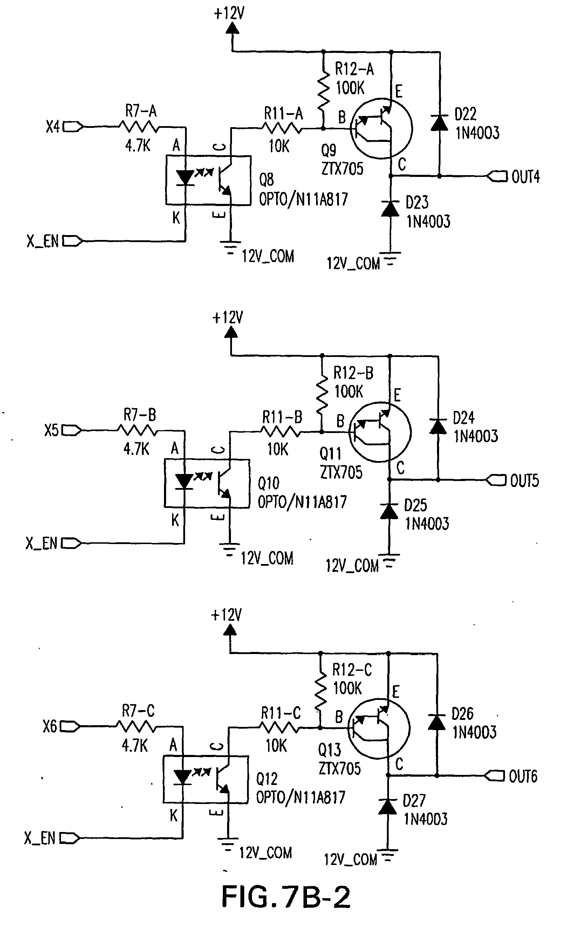

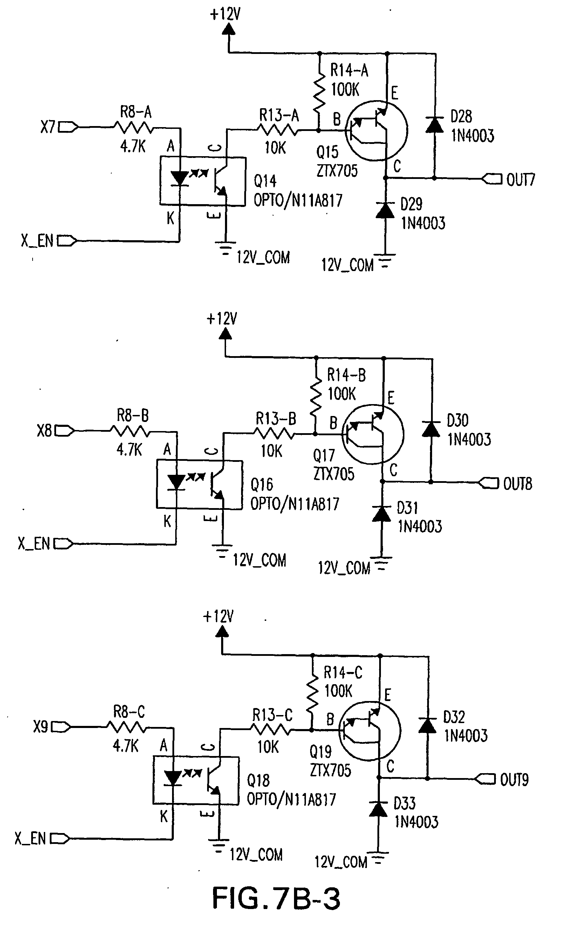

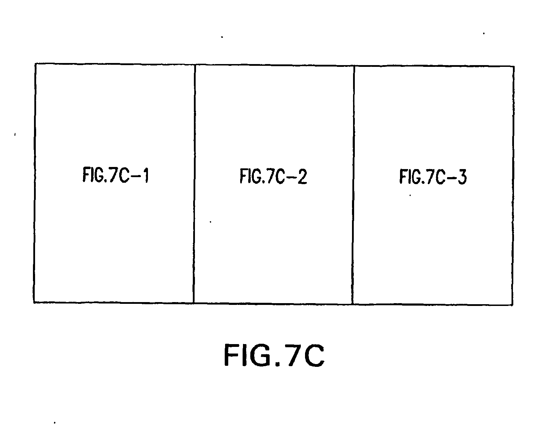

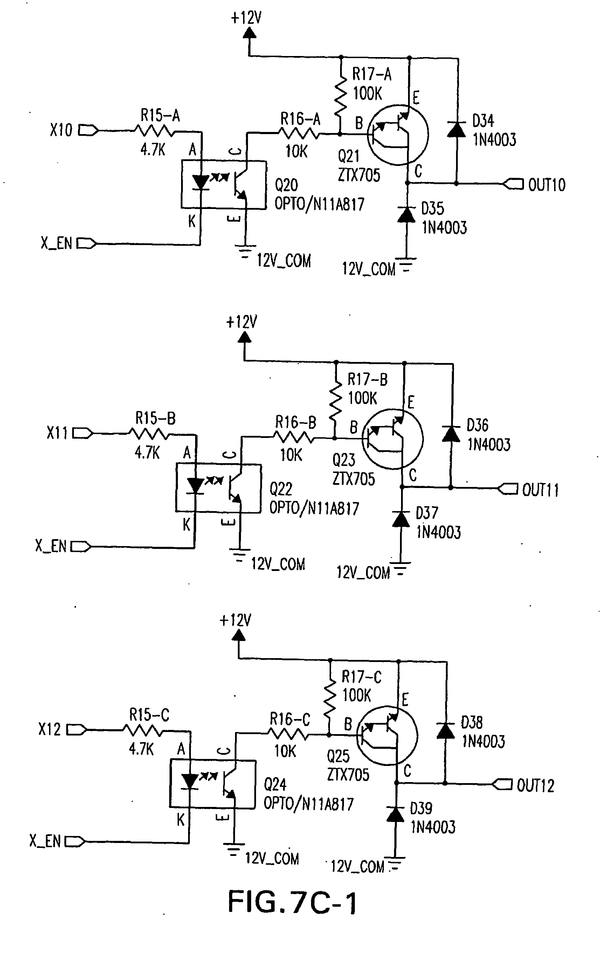

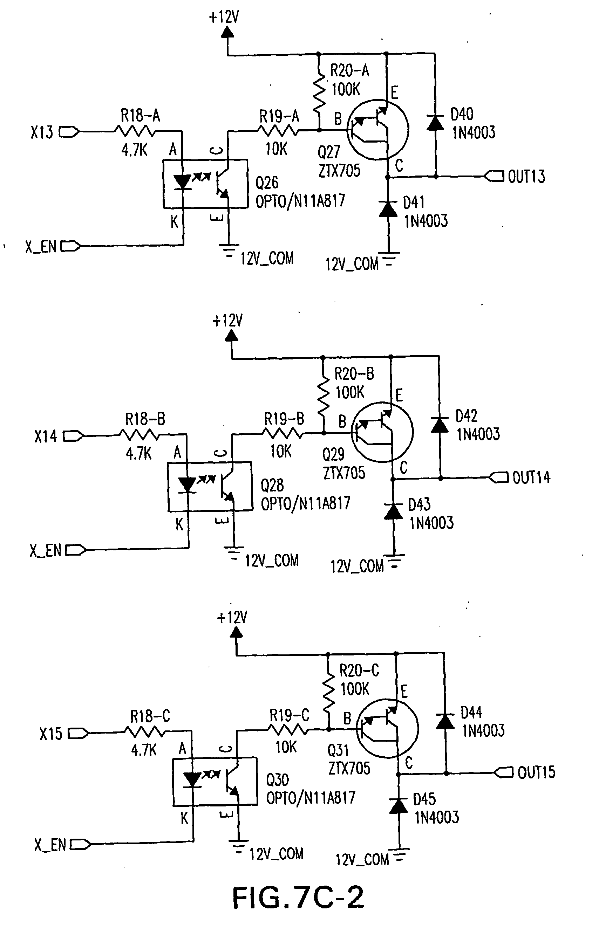

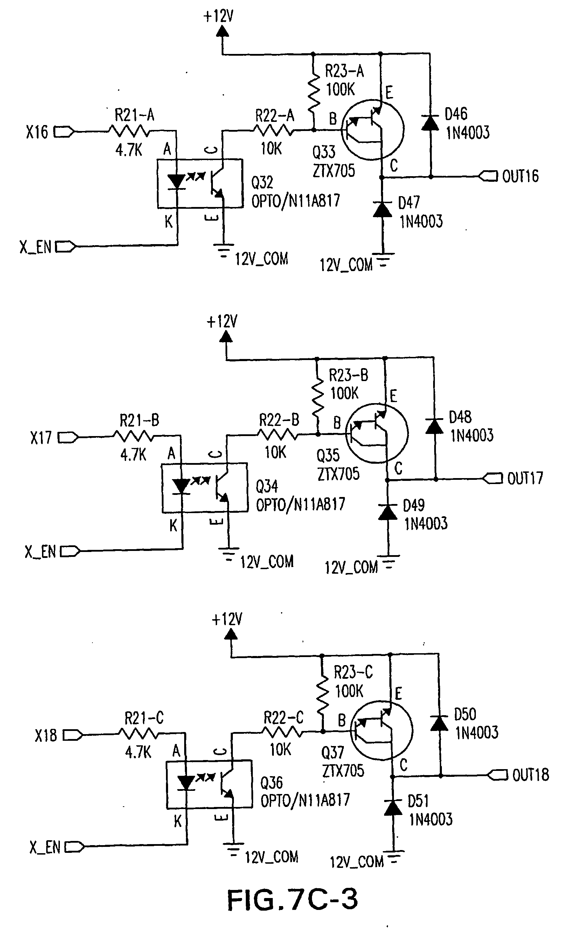

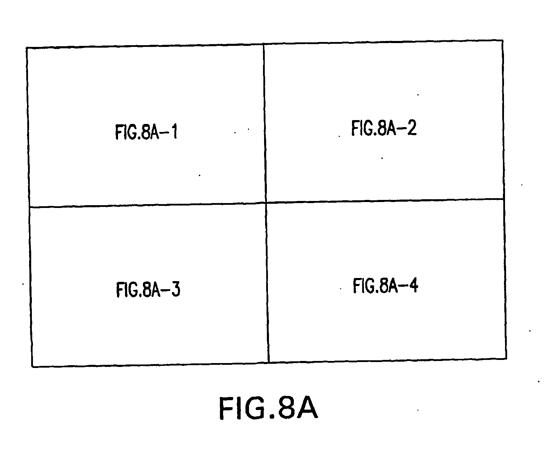

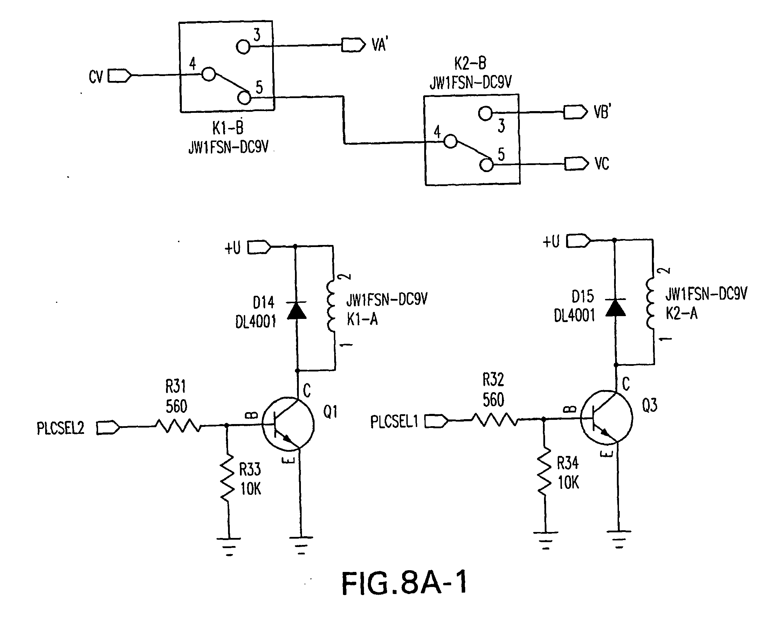

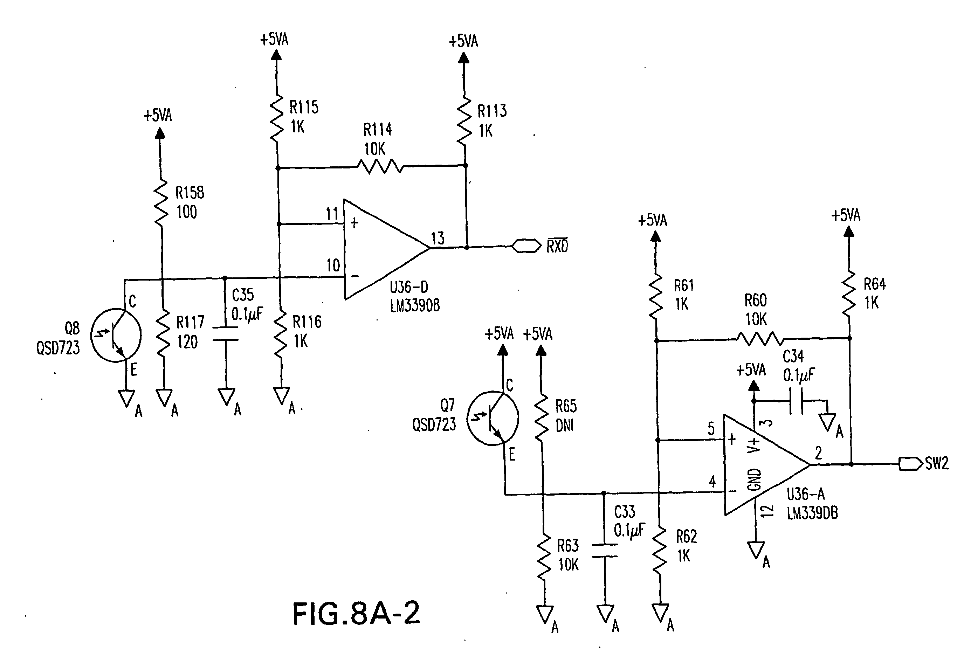

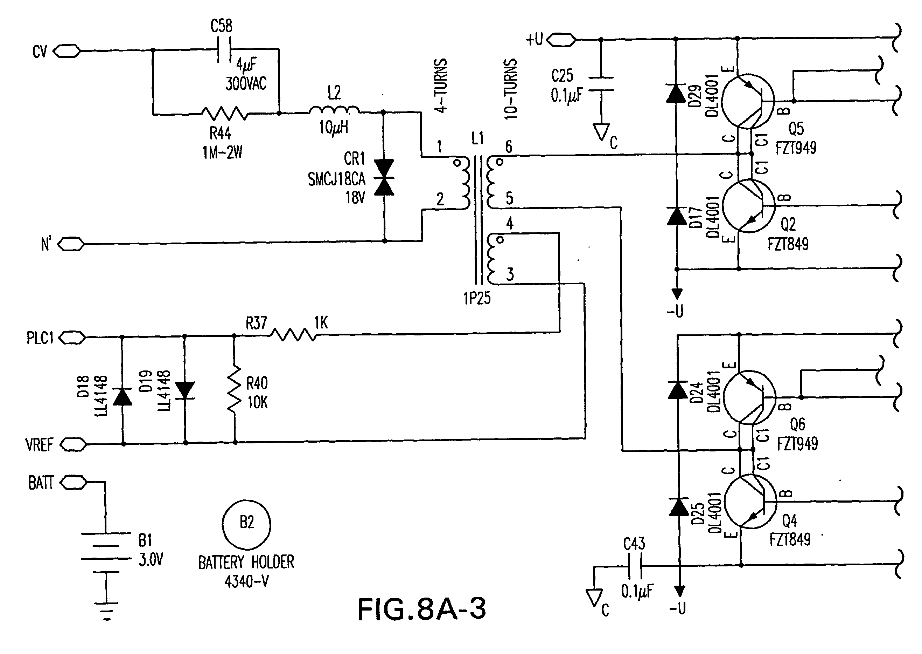

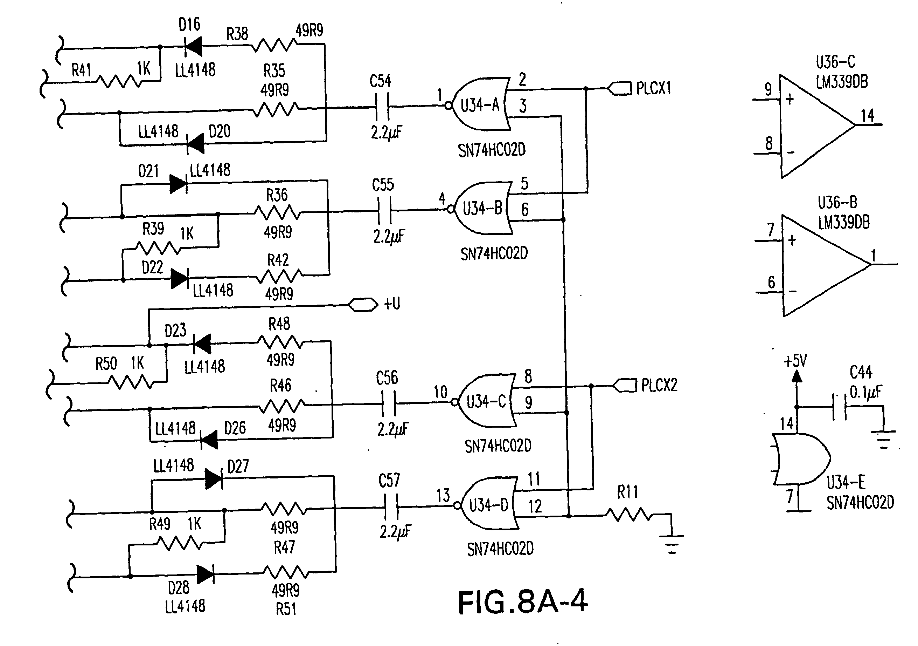

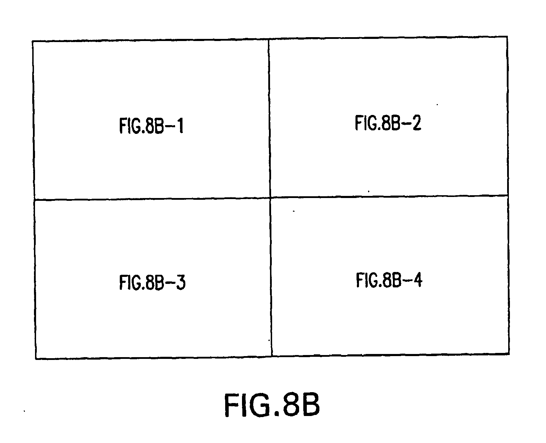

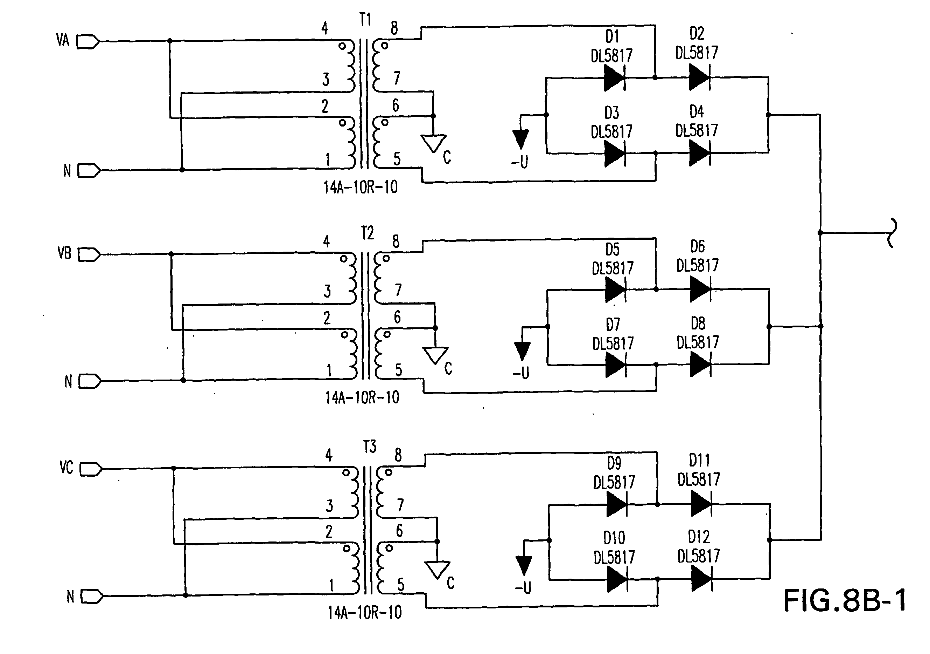

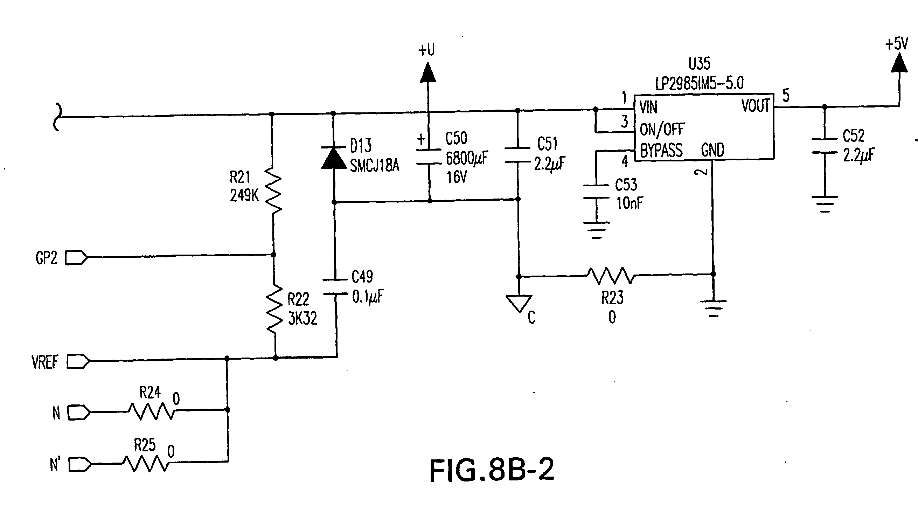

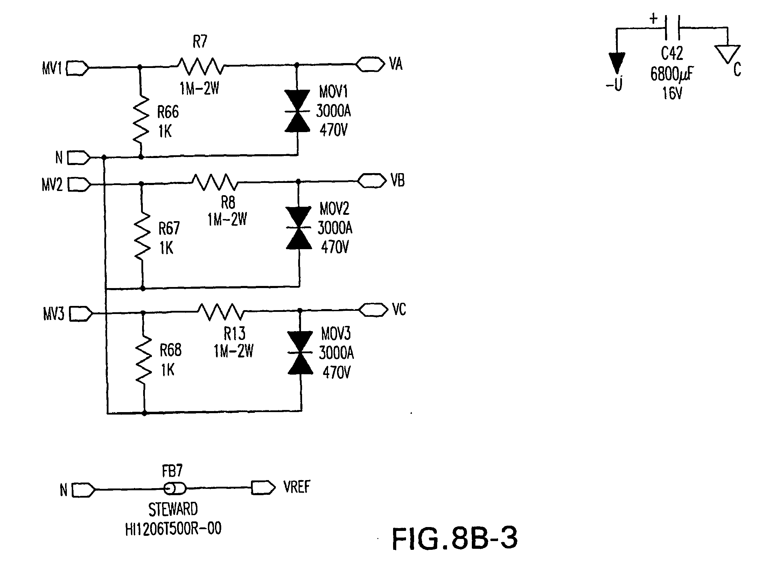

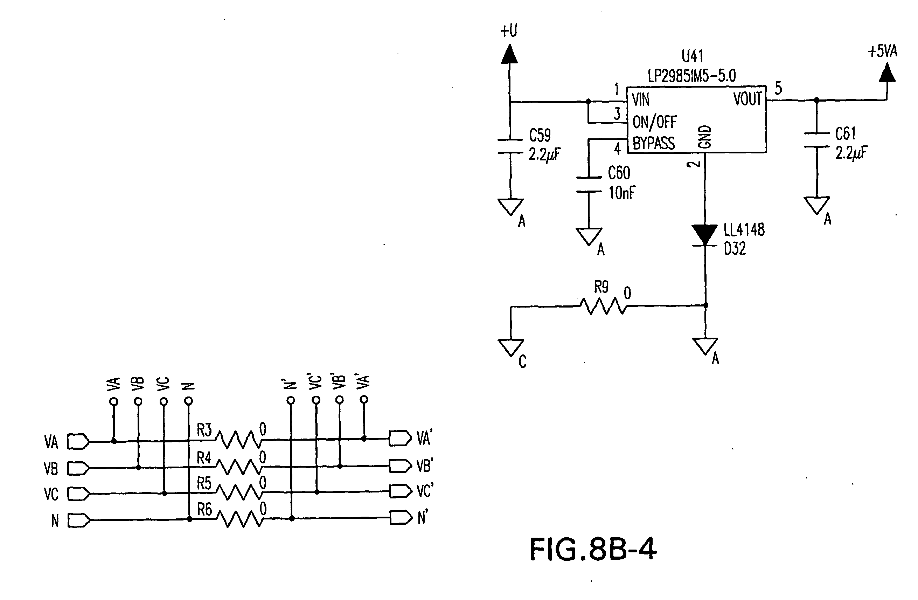

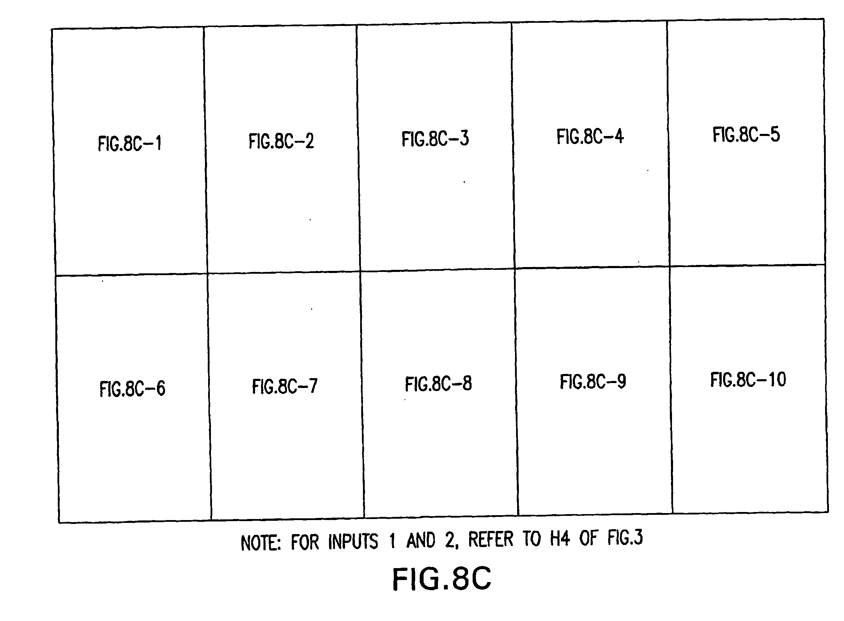

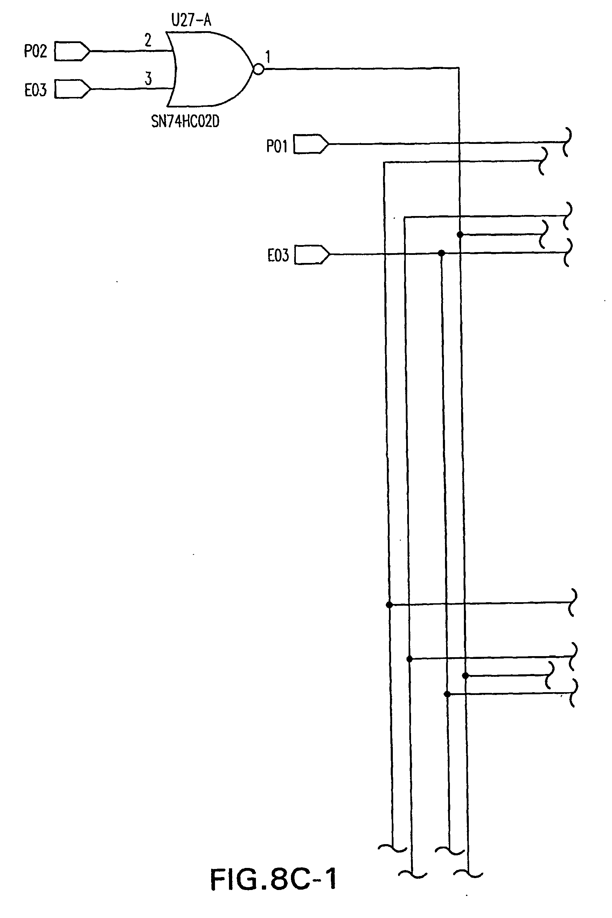

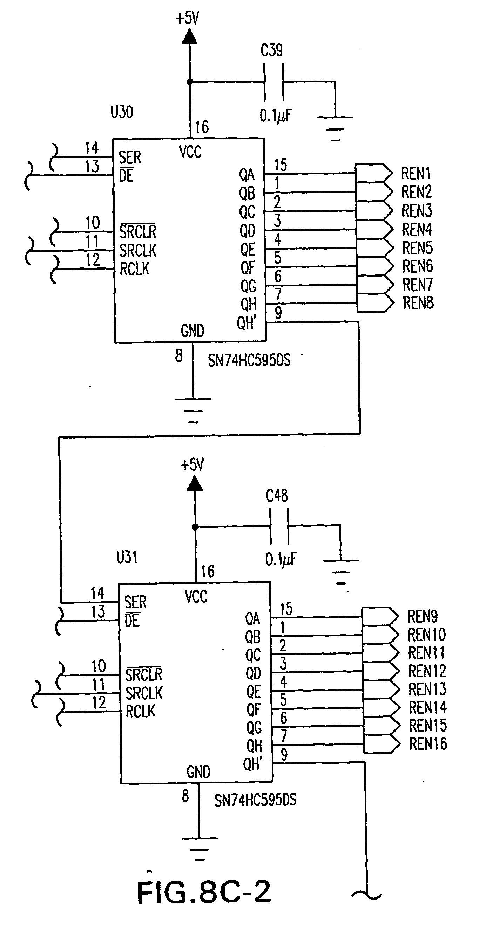

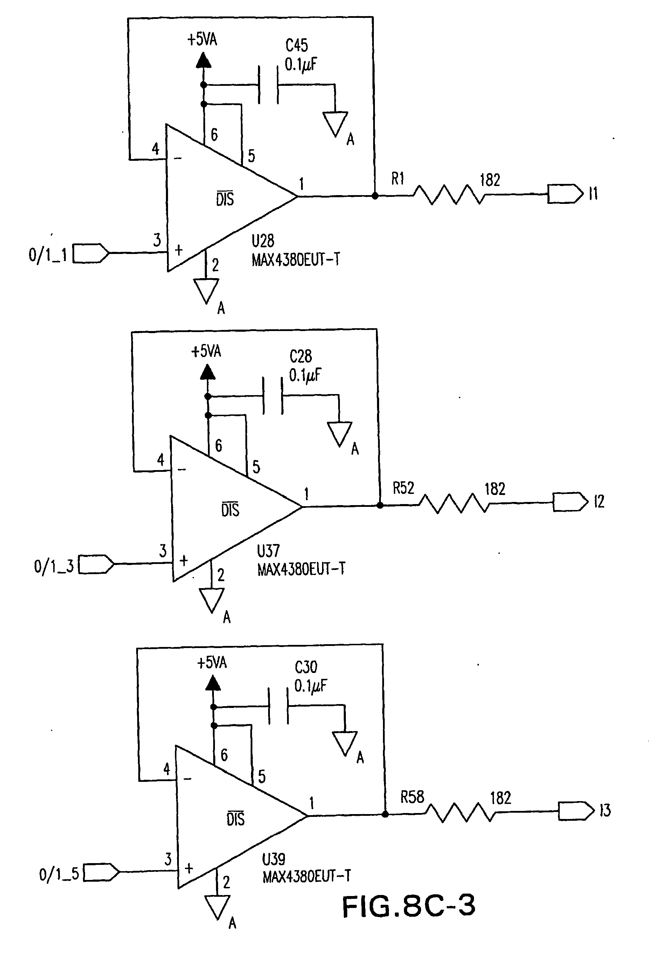

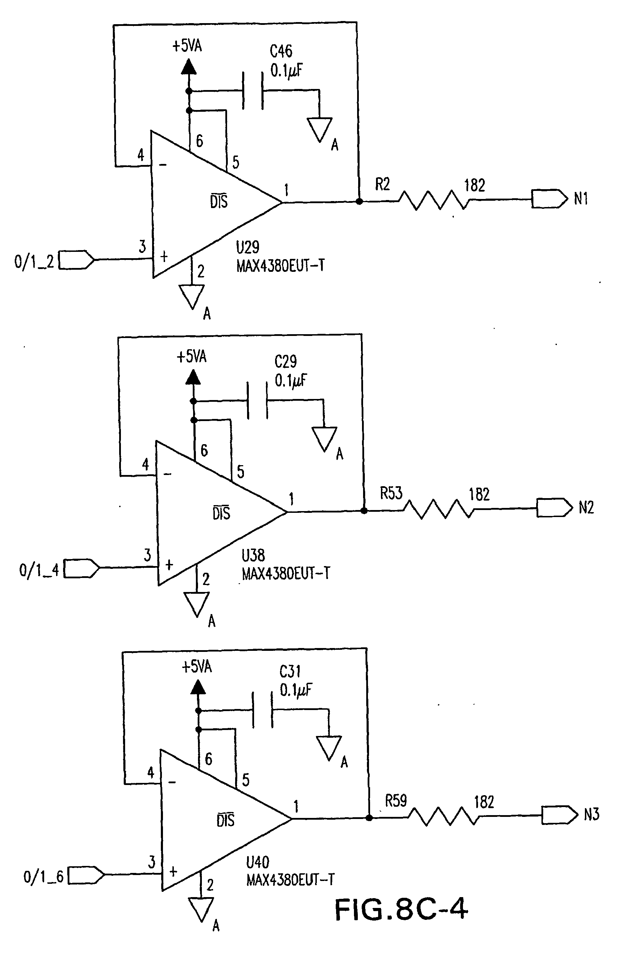

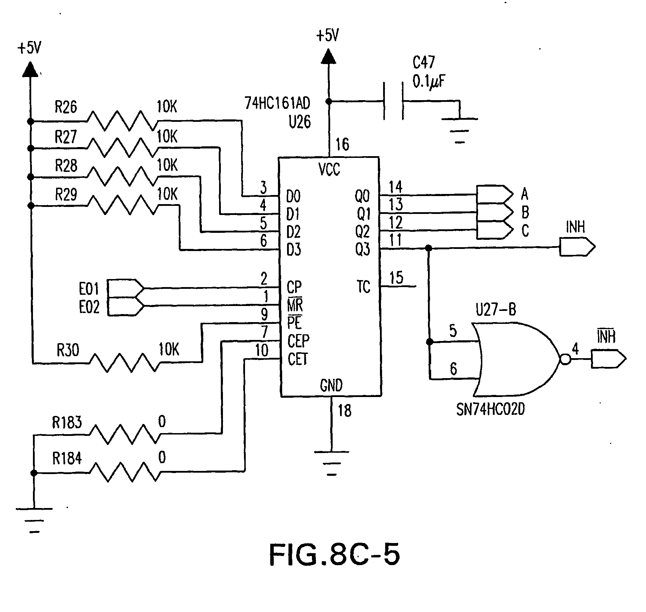

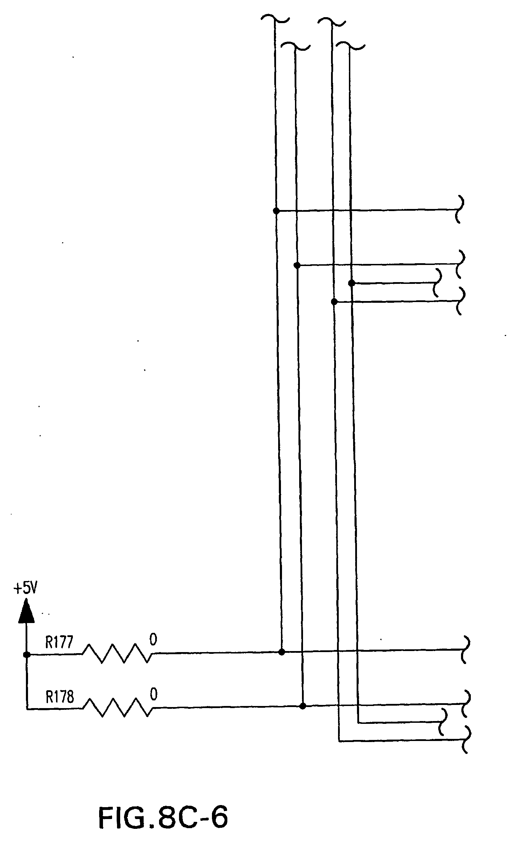

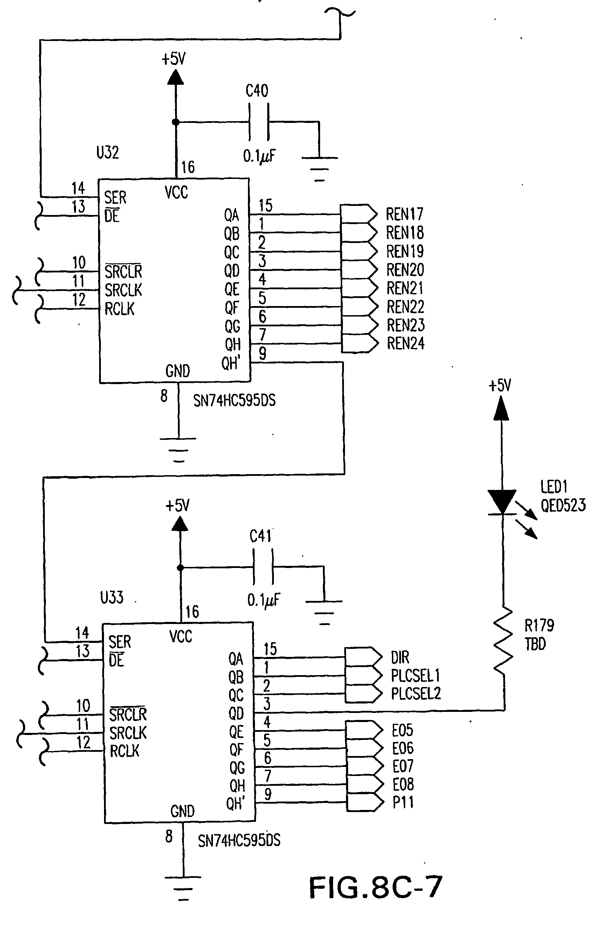

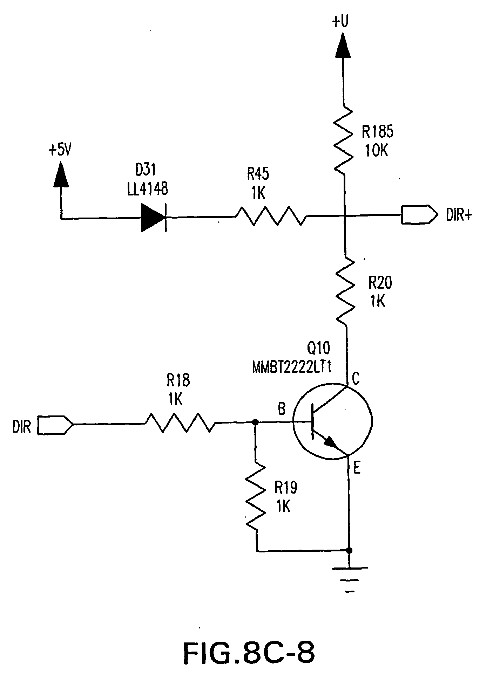

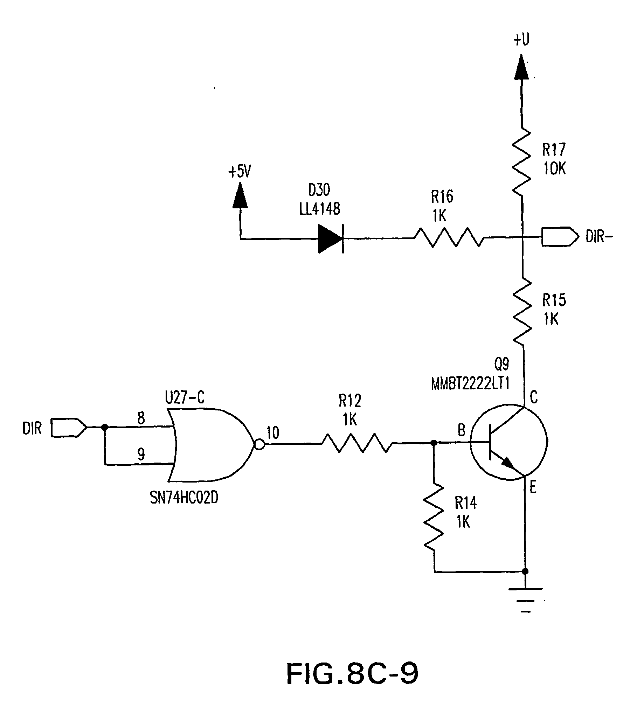

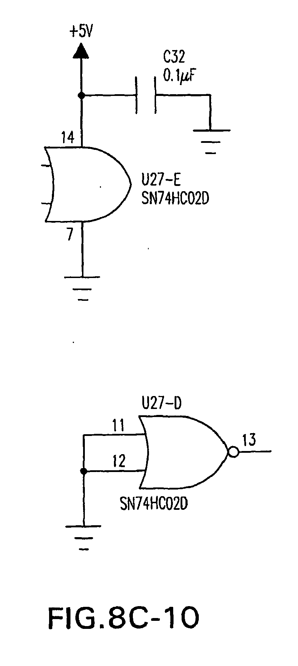

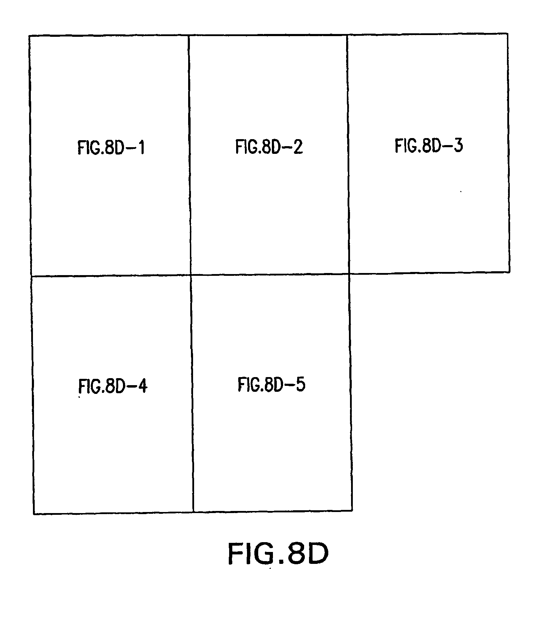

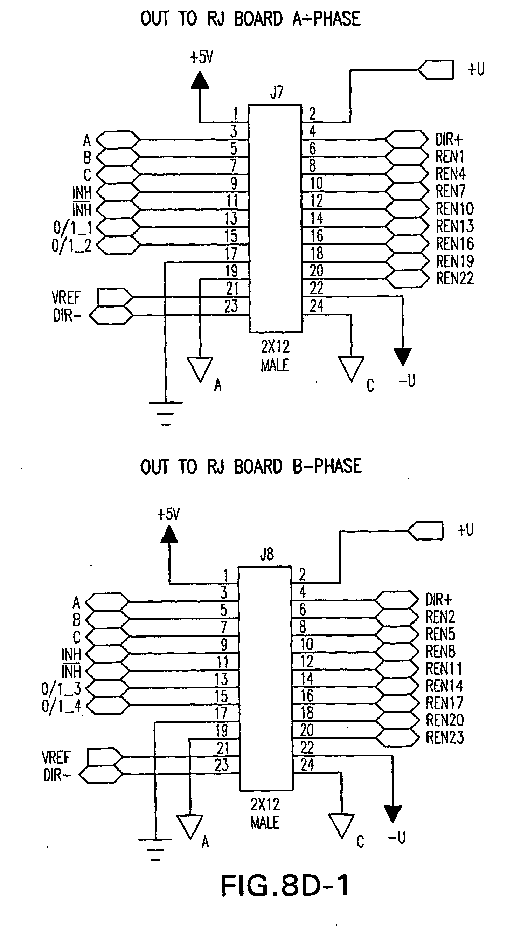

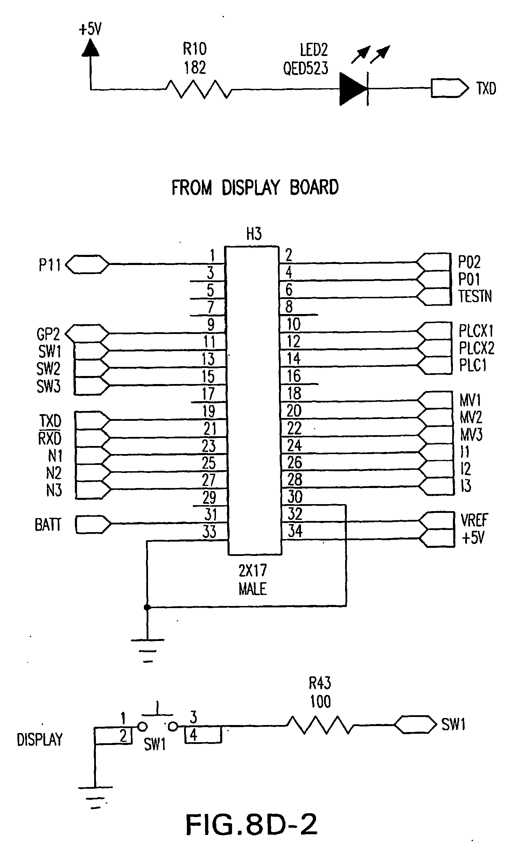

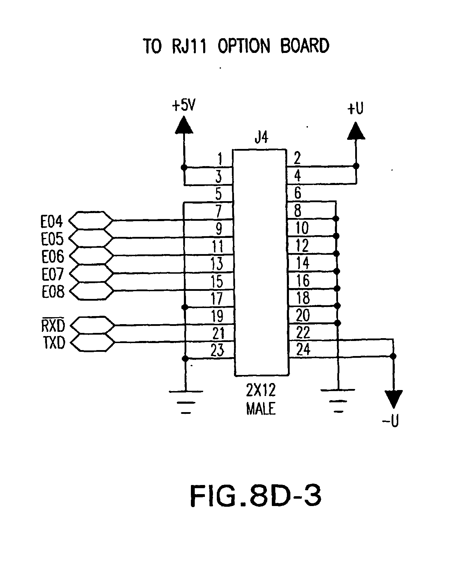

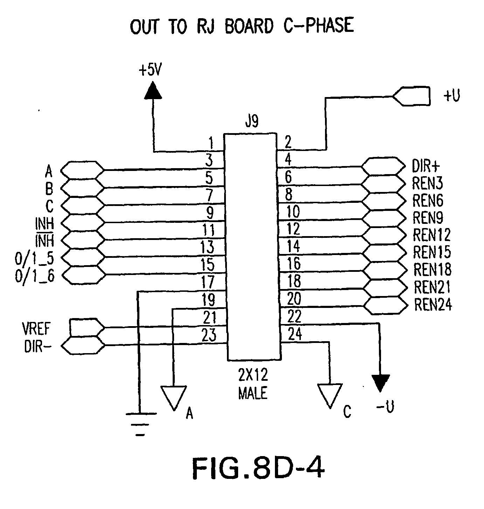

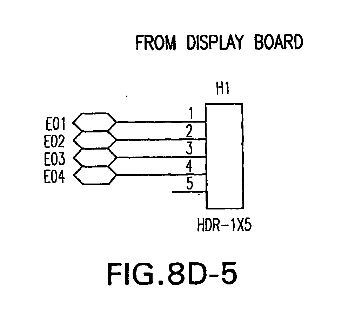

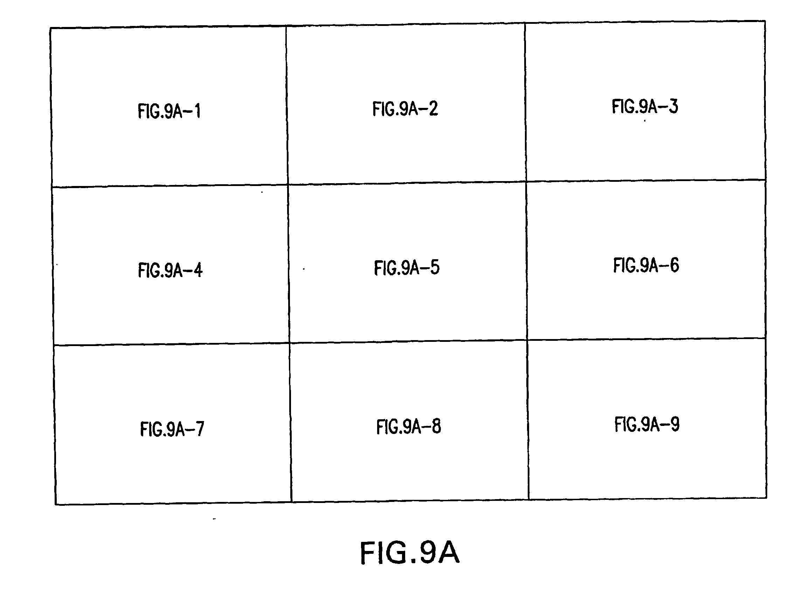

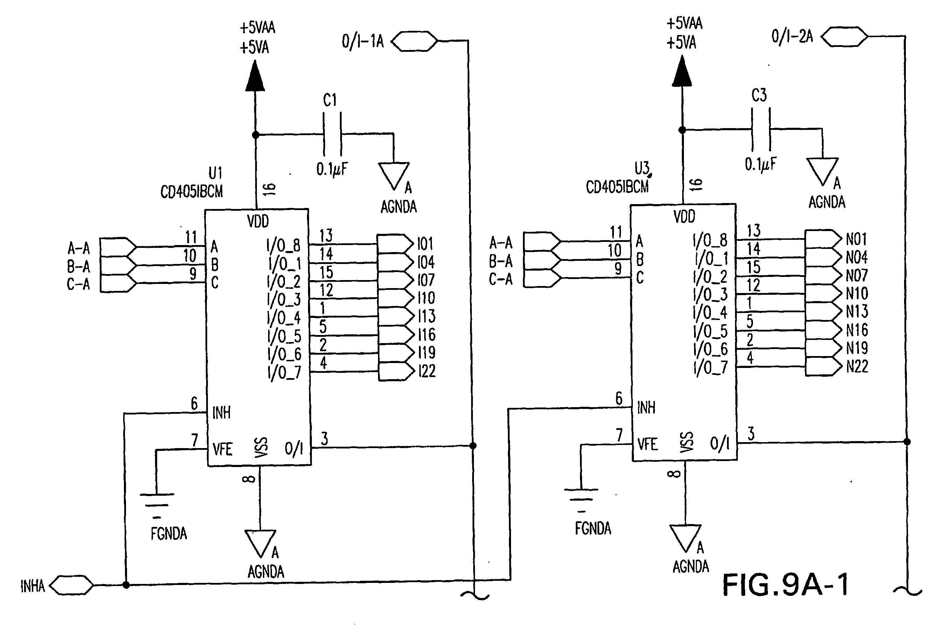

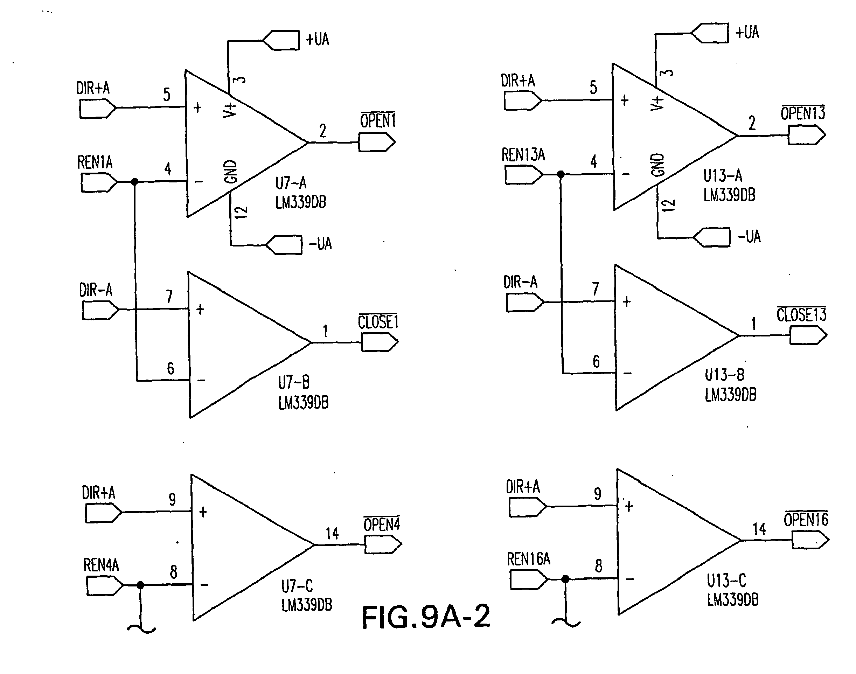

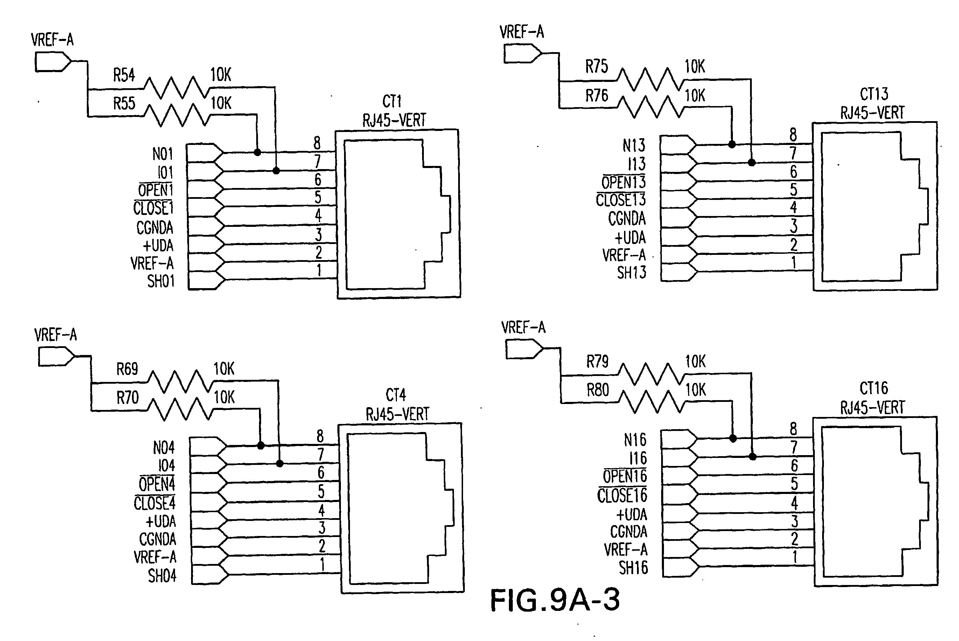

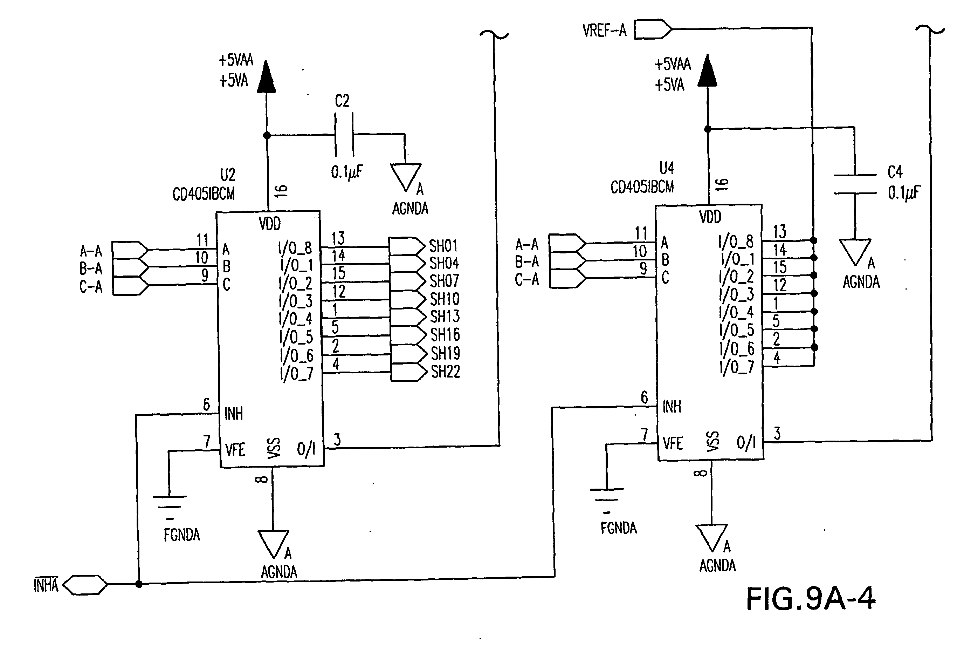

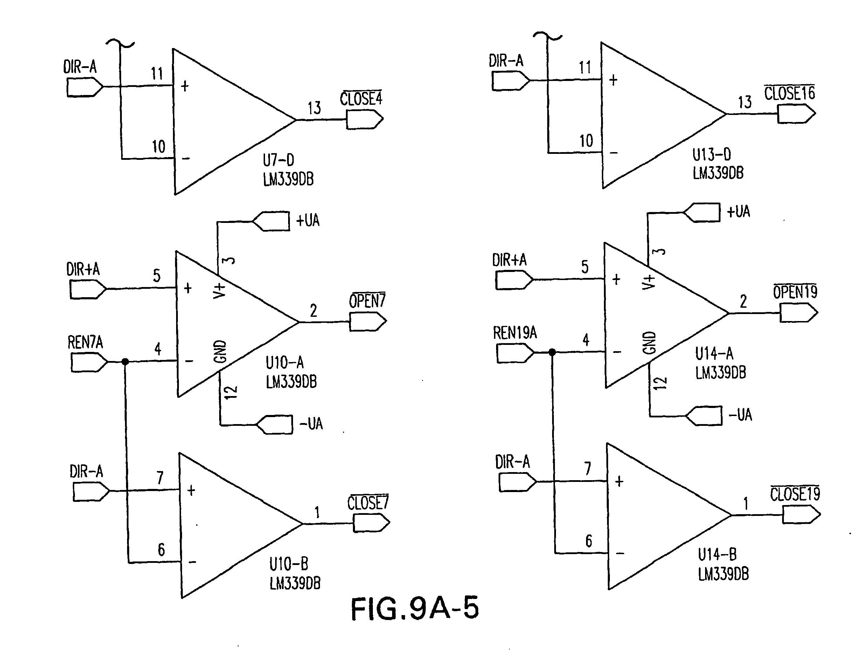

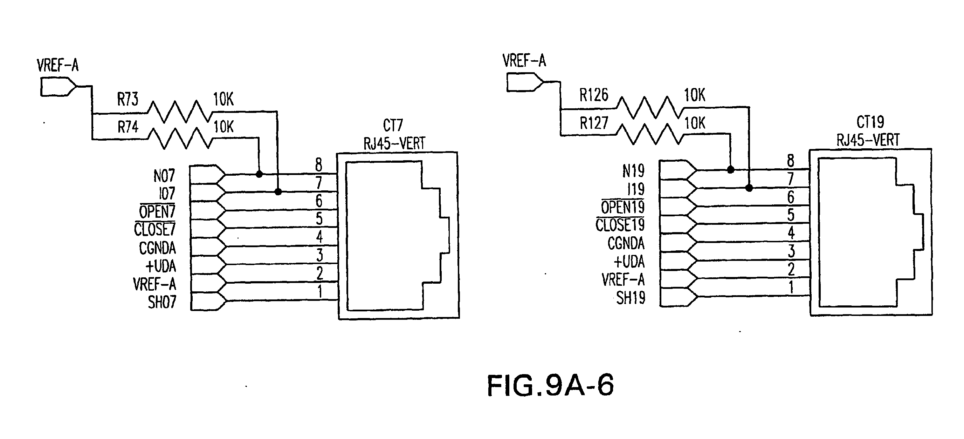

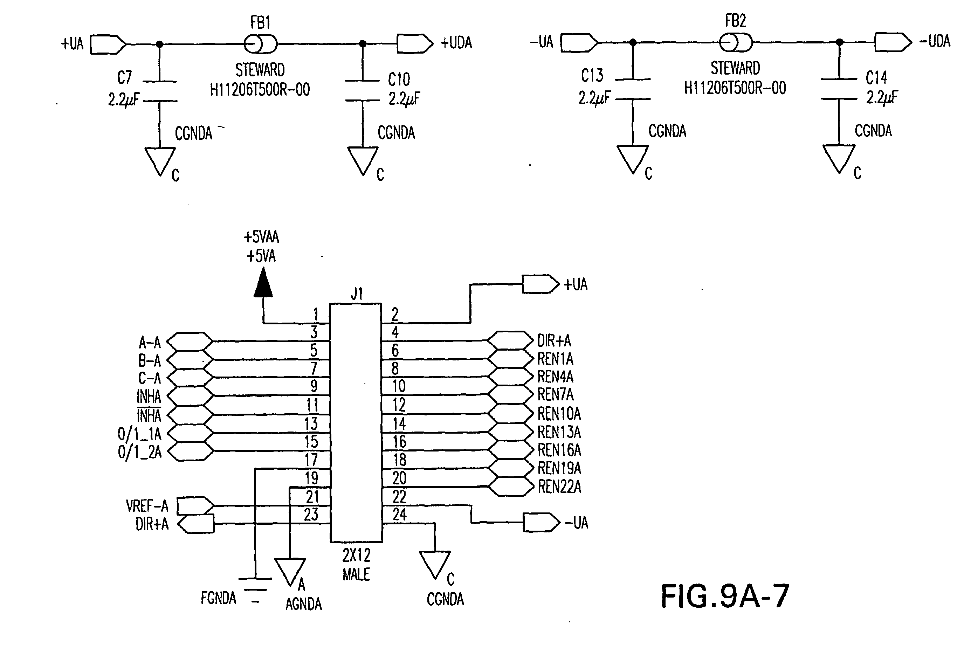

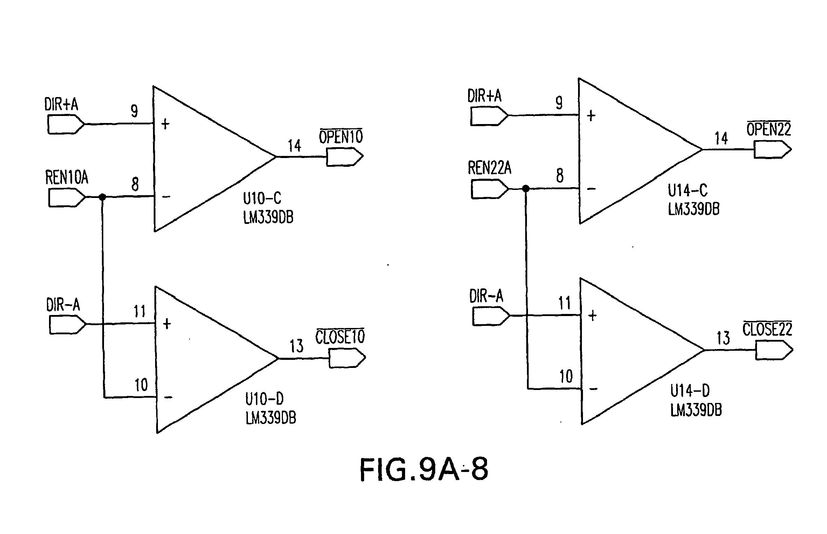

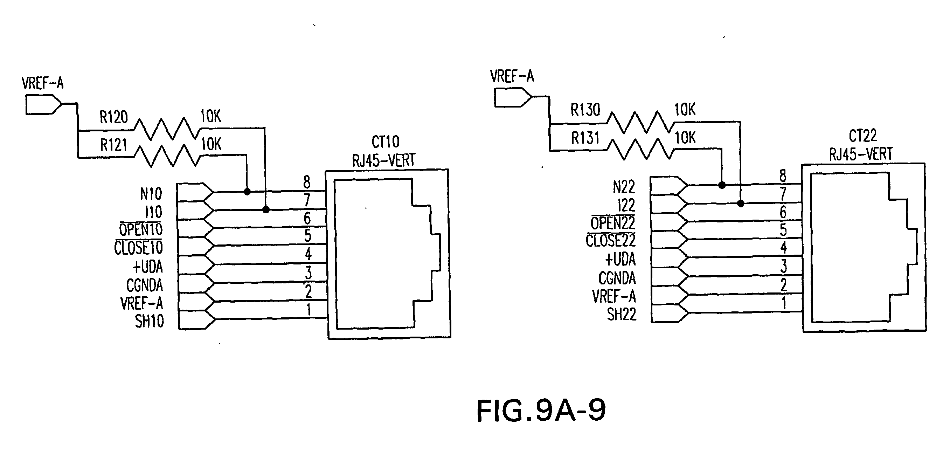

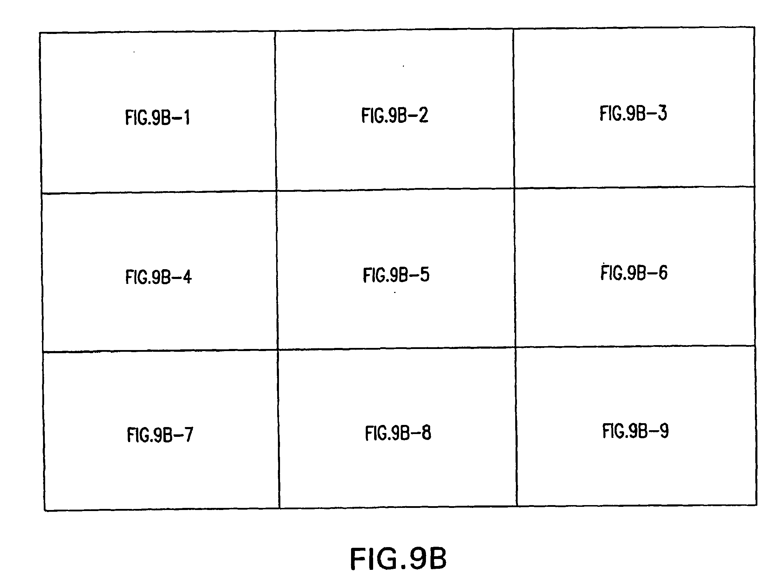

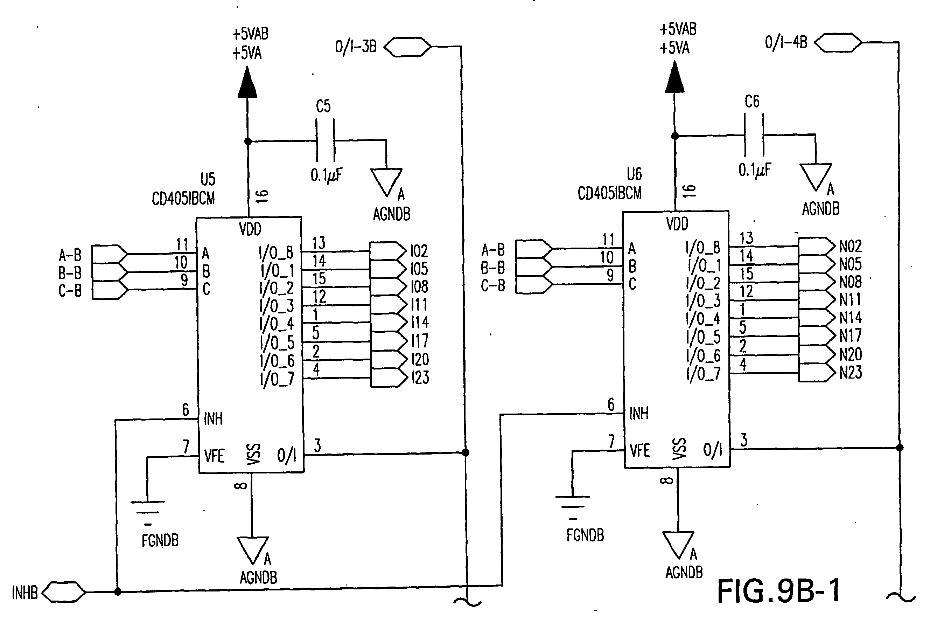

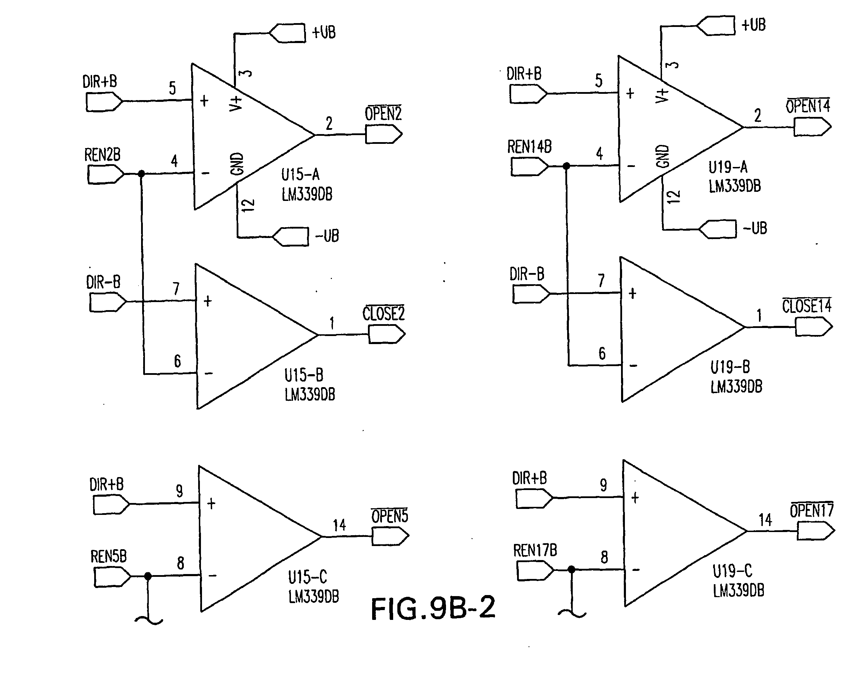

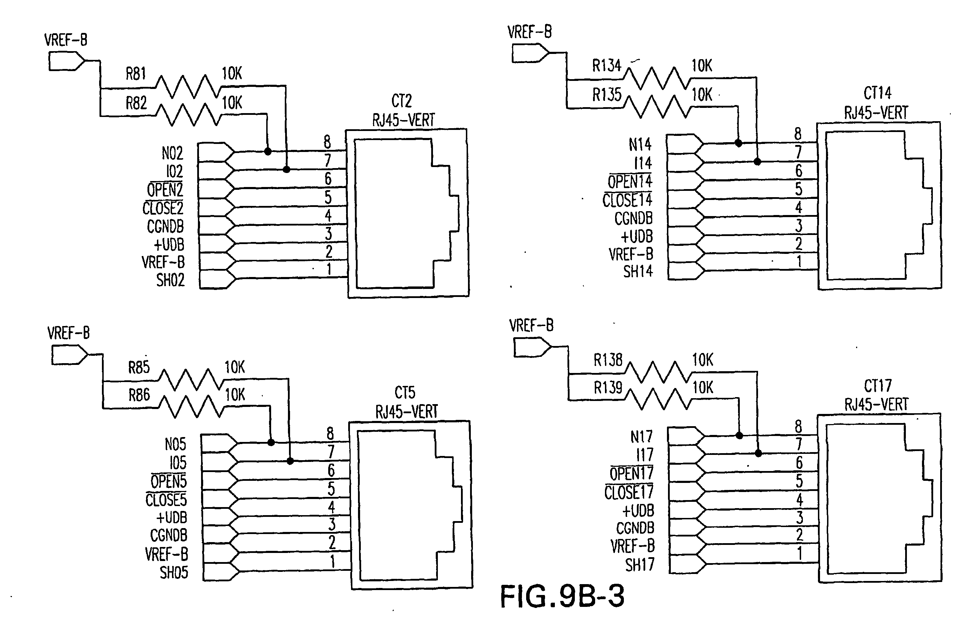

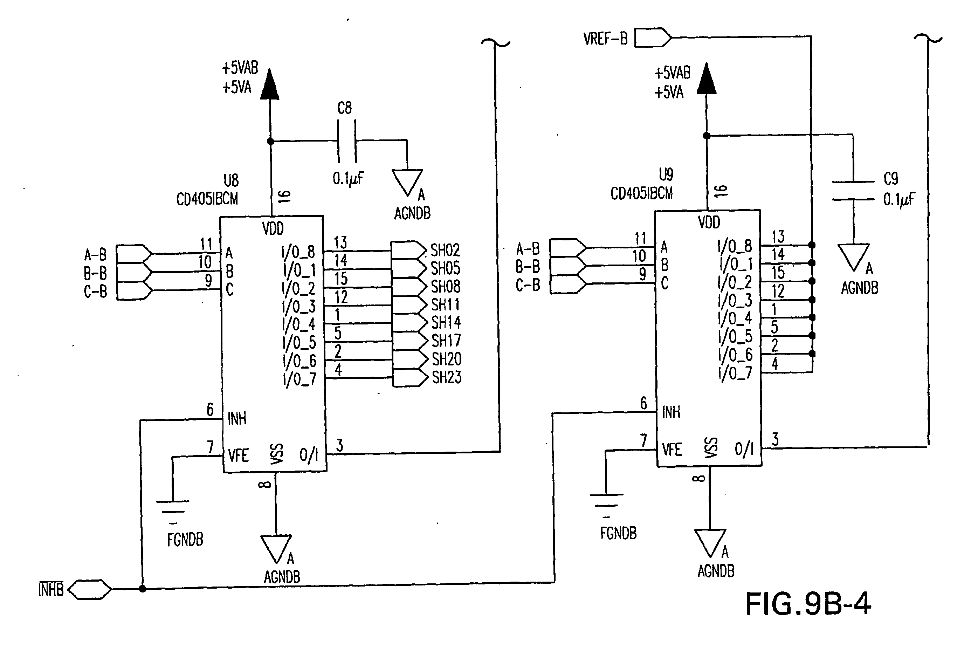

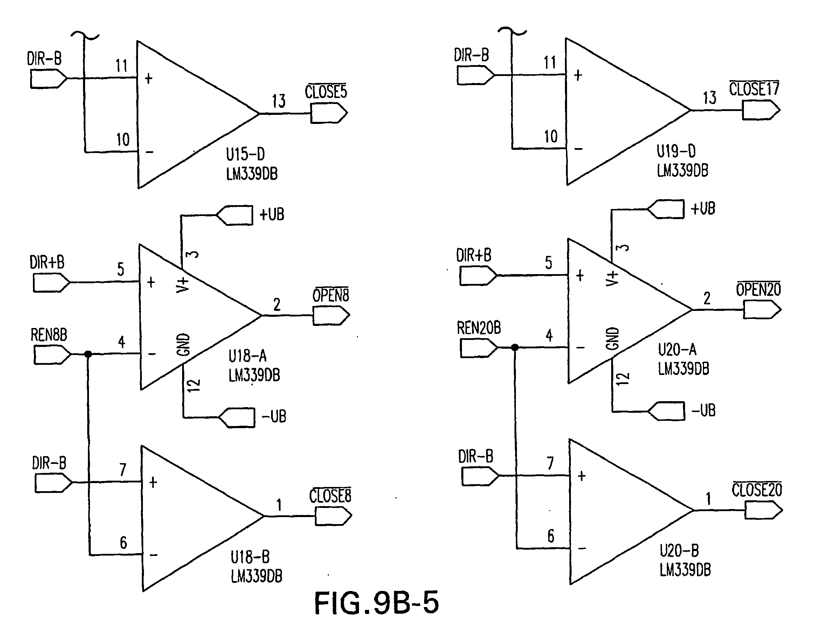

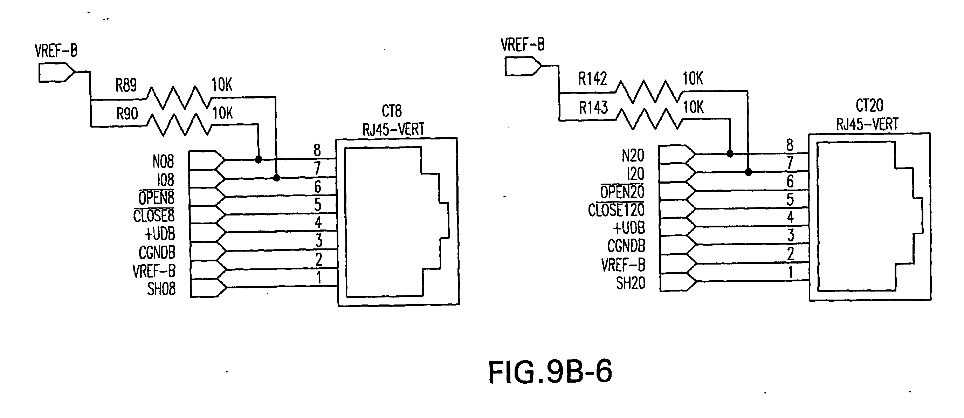

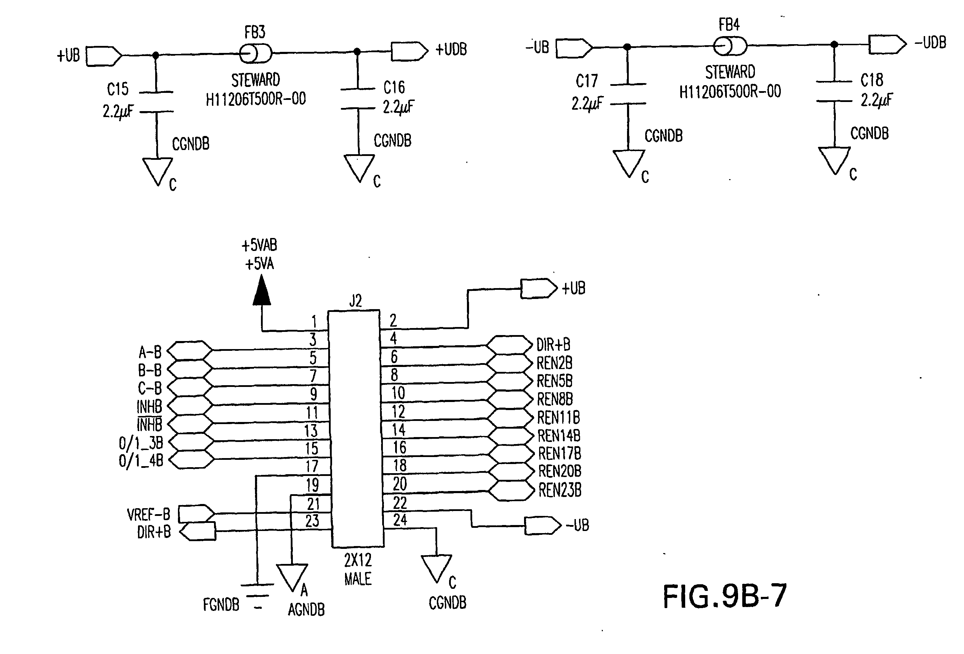

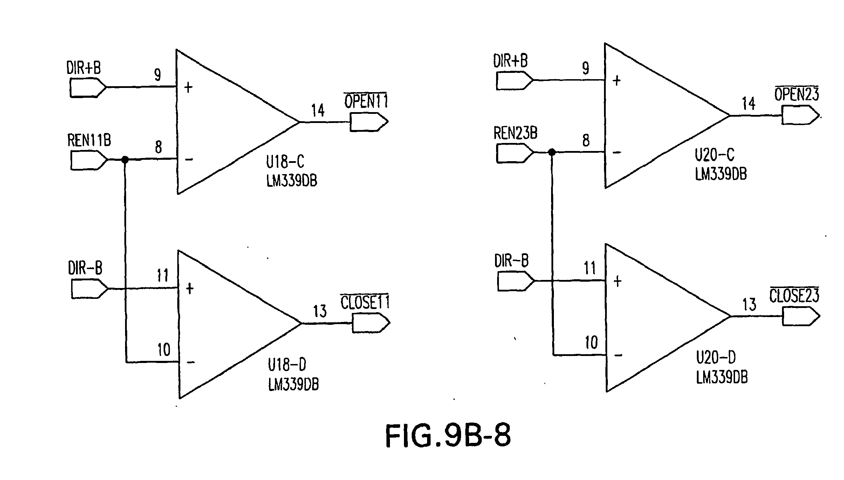

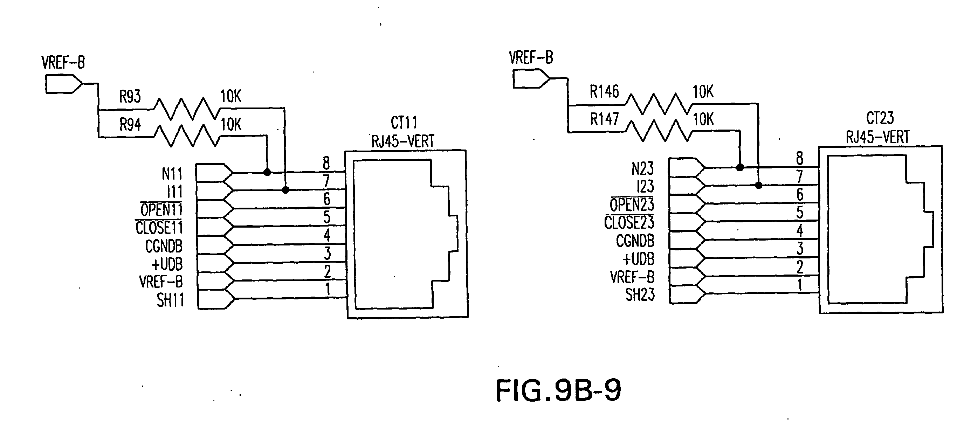

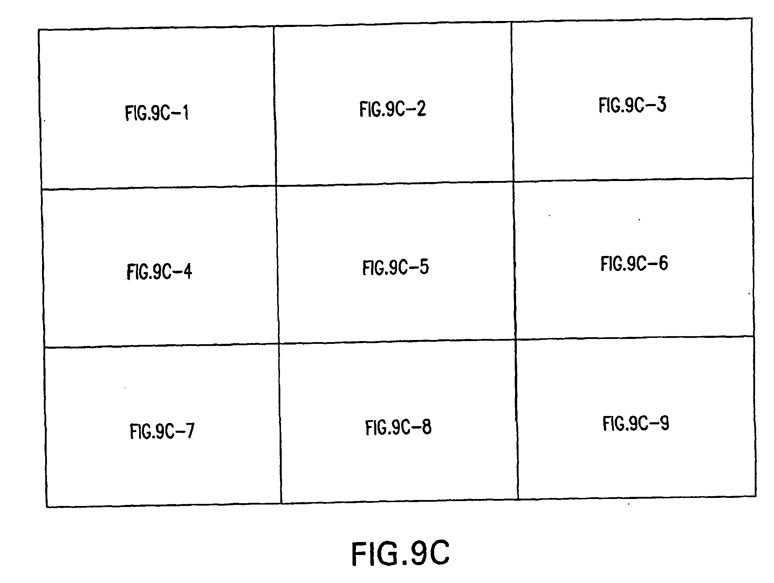

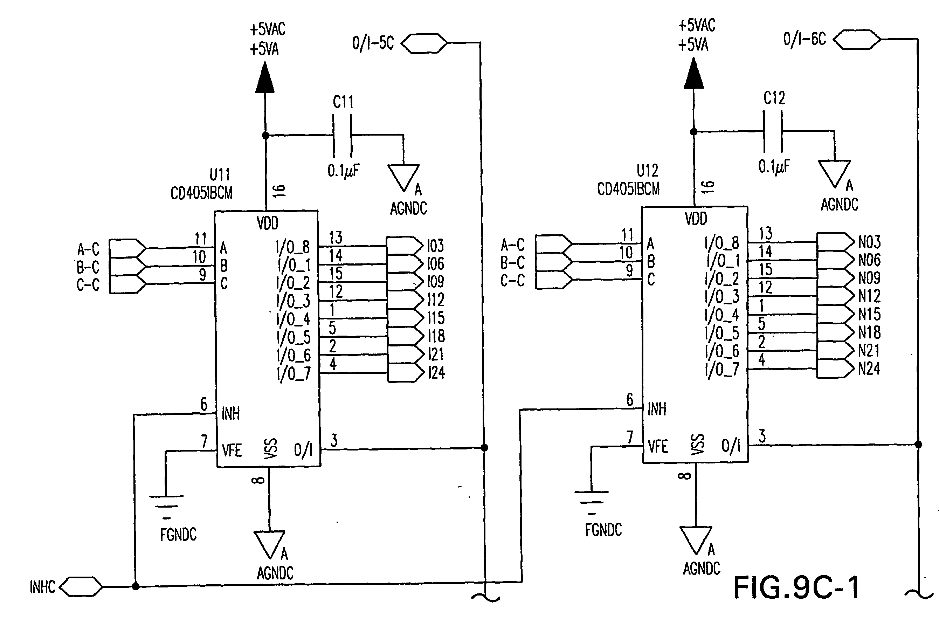

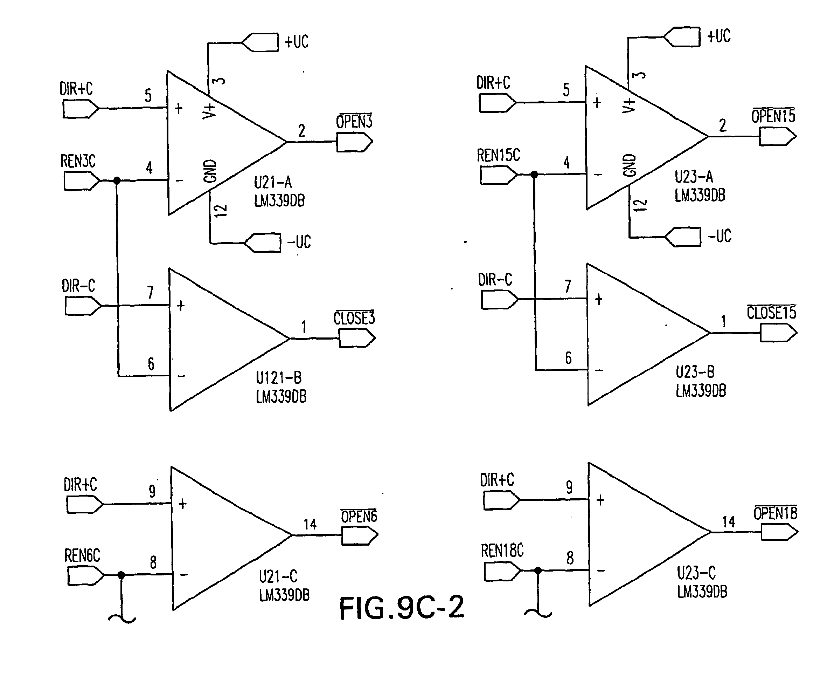

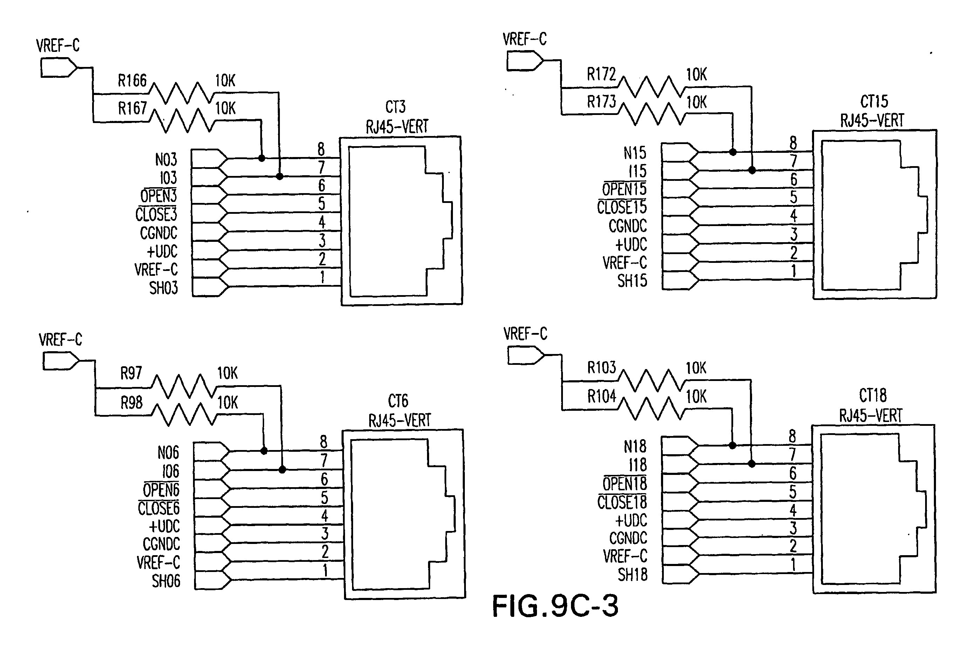

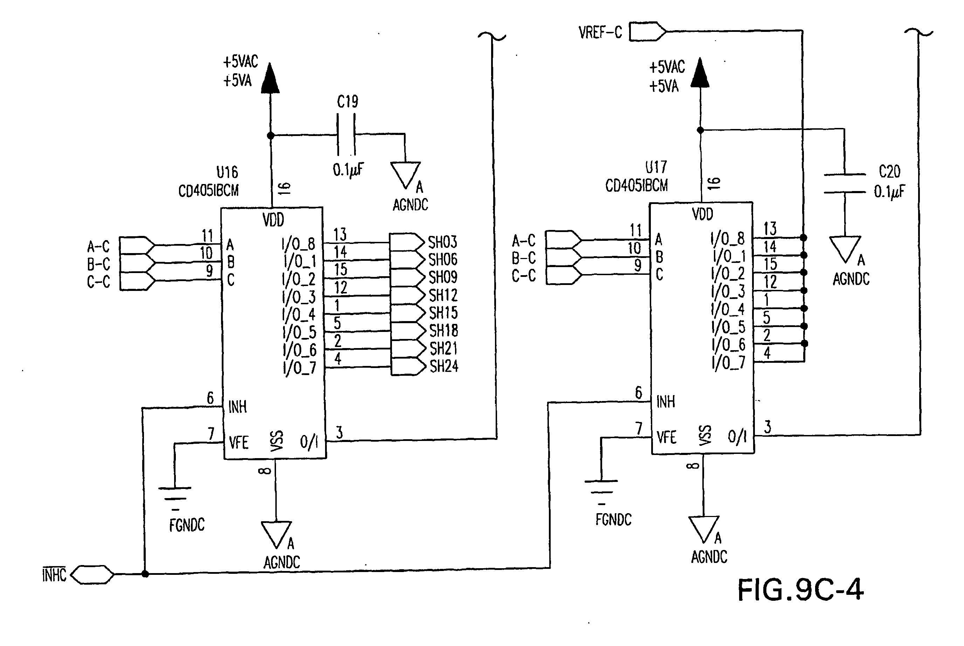

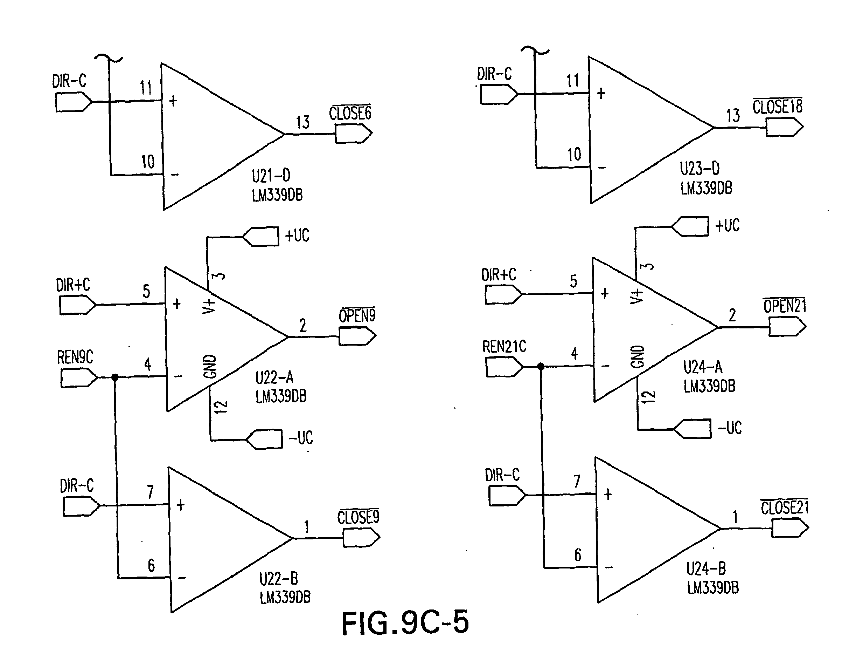

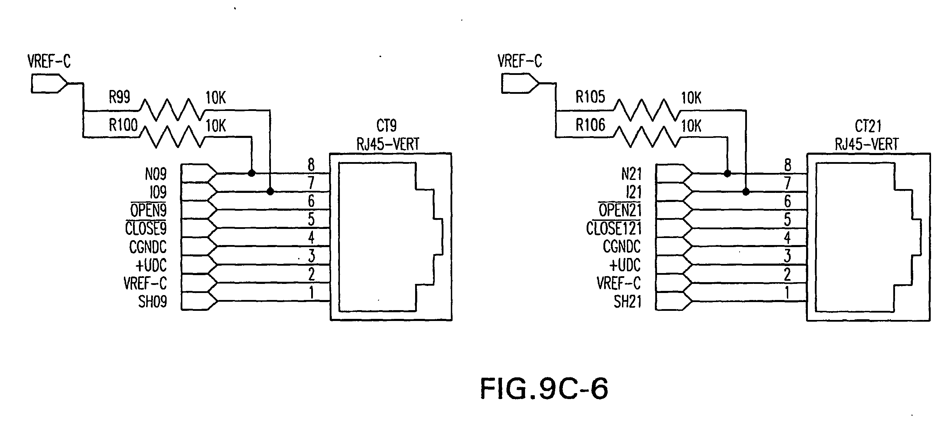

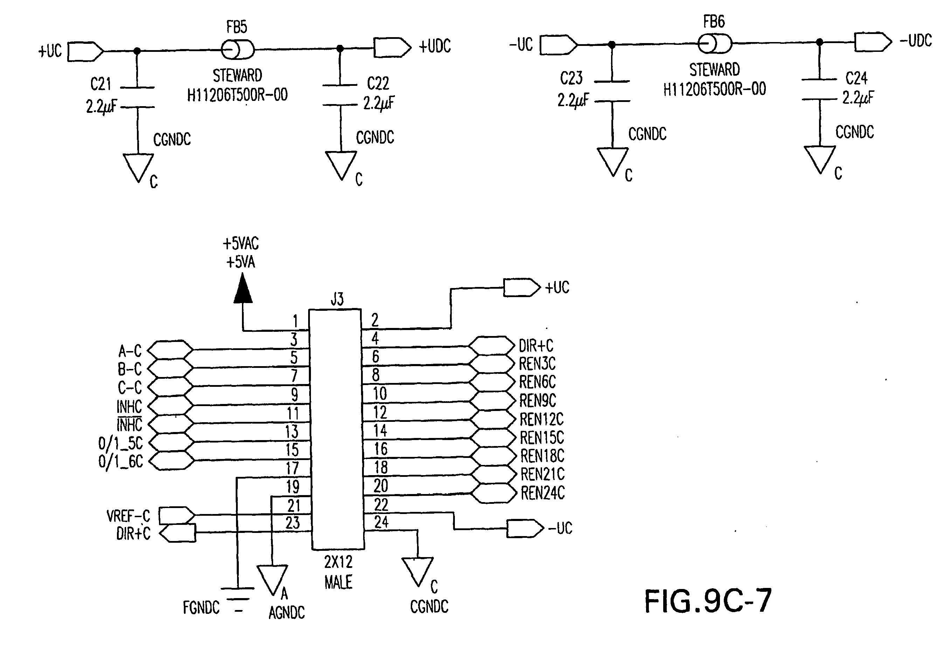

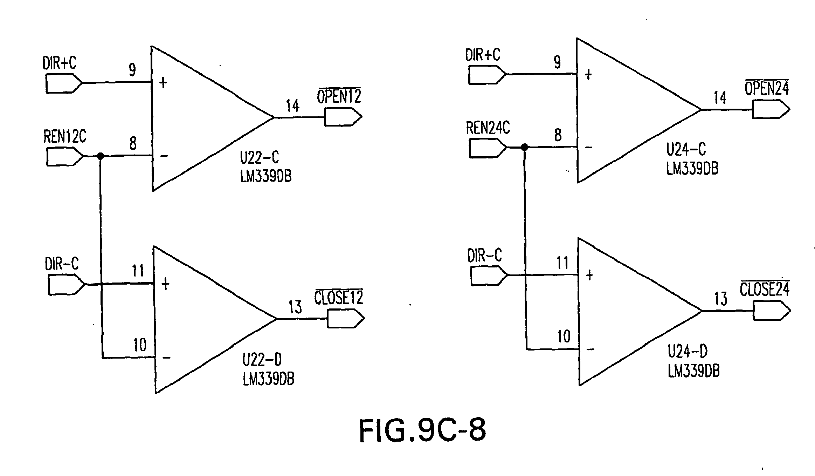

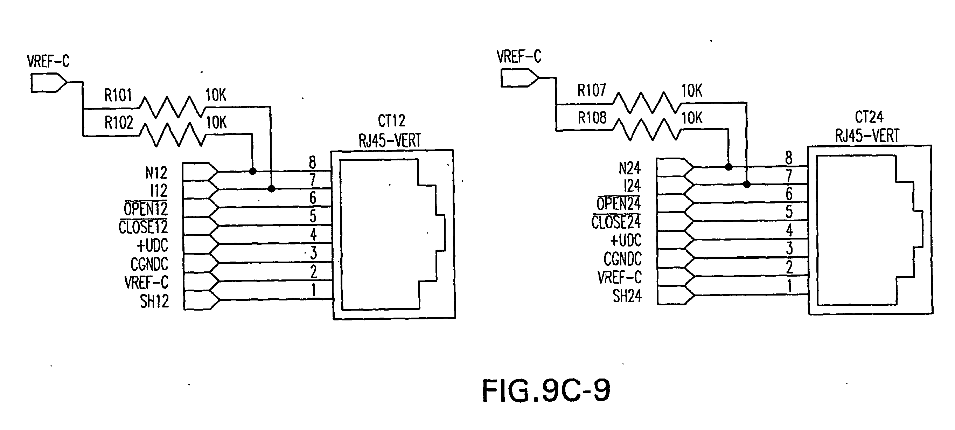

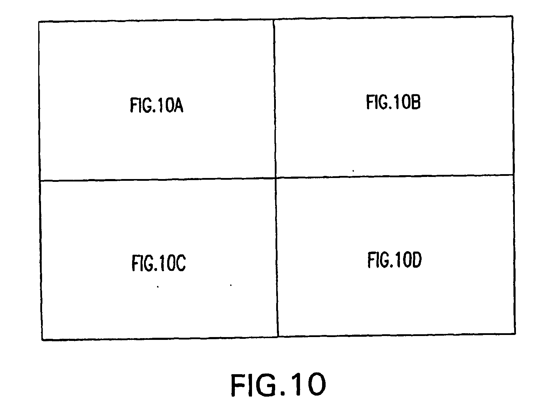

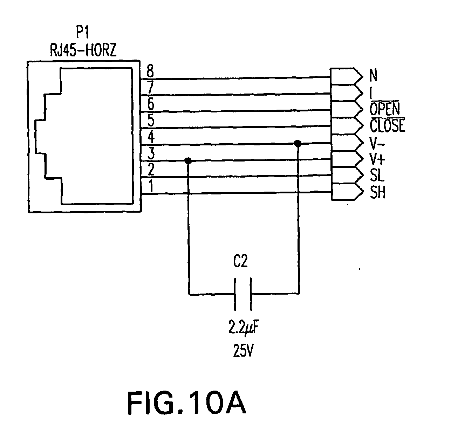

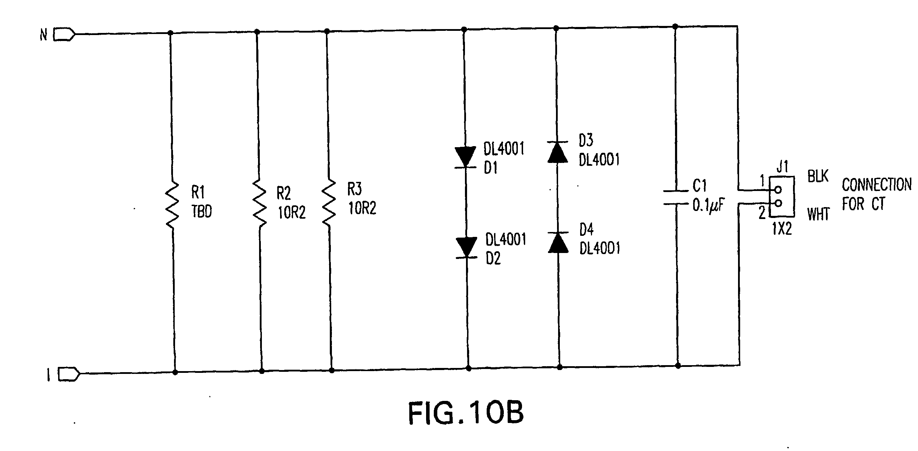

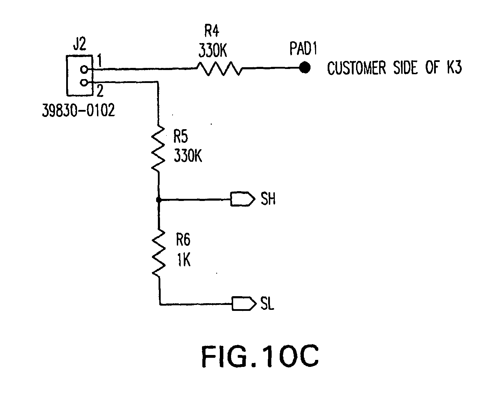

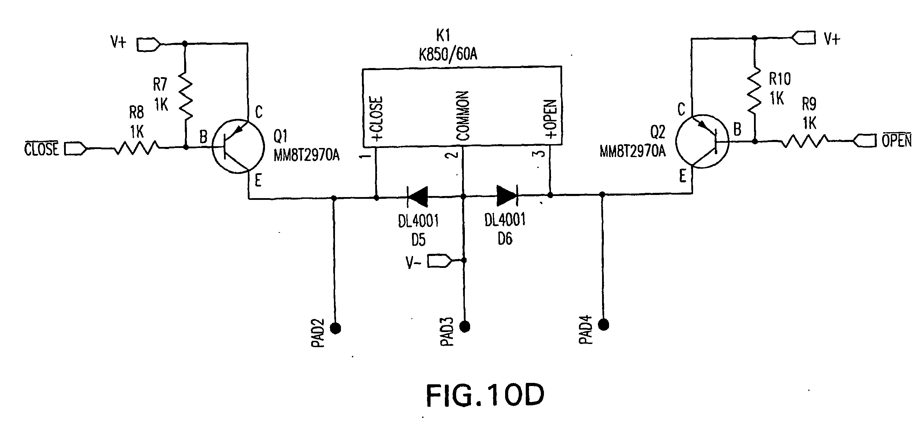

FIGS. 3-10 are schematics of preferred components, as described below. The preferred connect/disconnect relays are series K850 KG relays, but those skilled in the art will recognize that other relays may be used without departing from the scope of the invention.

| Figure | Schematic | Detail |
|---|---|---|
| 3 | PCB 107D | CPU board of the Scan Transponder and MiniCloset |
| 4 | PCB 135C | Power Supply for Scan Transponder. |
| 5 | PCB 144C | Power Supply for MiniCloset |
| 6 | PCB 146C | This board brings back the Current Transformer information back to MiniCloset meter head. |
| 7 | PCB 160A | Board for Load Control Module. |
| 8 | PCB 170 | EG power supply board that adds capability for optical tamper detection. |
| 9 | PCB 171 | EG Connection board. A board with traces to route the signal. |
| 10 | PCB 172 | Control circuitry board for Relay control. |

In another embodiment, the implementation of Energy Guard takes advantage of the similarity of architecture of traditional circuit breaker panels, with the multichannel metering environment. In a circuit breaker panel, electricity is fed to the panel and distributed among various customer circuits via circuit breakers that provide the ability to connect or disconnect the customer circuits.

In the MiniCloset/Energy Guard, multiple current transformers measure the current in customer circuits and bring this data back to a central processing unit where the metering quantities are calculated. However, the MiniCloset/Energy Guard has several key differences with a circuit breaker panel. For example, whereas circuit breakers are found near customer premises, the Energy Guard typically is installed near the utility distribution transformer. The advantages offered by this alternate embodiment will be apparent to those skilled in the art. For example, this embodiment offers improved dimensions and overall size over the embodiments discussed above. Space is always a constraint when equipment additions are made to existing electrical installations. This version of the Energy Guard ("EG"), with preferred dimensions of 28" X 22" X 11" provides a substantial advantage in situations where volumetric constraints exist.

The following description includes preferred construction details, detailed schematics, and software descriptions. As with the embodiments discussed above, this embodiment is operable to providing remote disconnect/connect operations, preventing theft, detecting tampering, detecting reverse voltage, performing pre-payment and limiting load, and performing meter validation.

Preferred EG Construction Details

In this embodiment, primary components of the EG are :

1. Energy Guard Base Assembly
2. Energy Guard Assembly

    a. Phase Bus Bars and Neutral Bars
    b. Transition Bars
    c. Acceptor Module

3. Energy Guard Metering Modules

    a. Metering Modules

        i. Integrated Current Sensing and Relay Modules

4. Energy Guard Electronics

    a. PCB 203
    b. PCB 204
    c. PCB 234
    d. PCB 235
    e. PCB 202
    f. PCB 210
    g. PCB 230
    h. PCB 206

EG Base Assembly

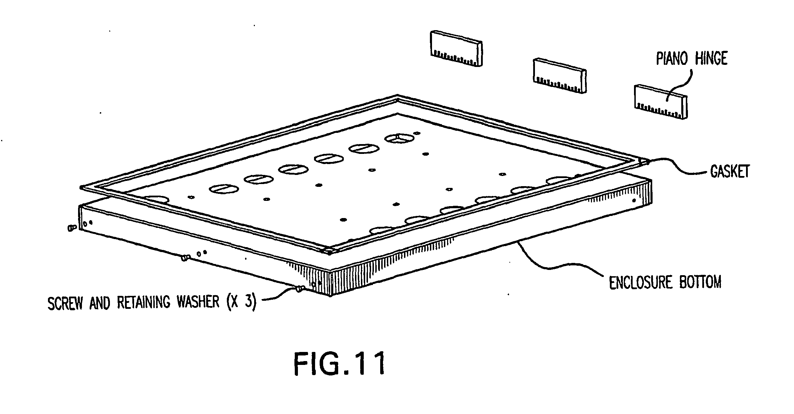

The EG base comprises an enclosure bottom with screws and retaining washers as a locking mechanism for the top cover of EG, which is connected on one side by piano hinges. See FIG. 11. The enclosure bottom provides routing for the customer cables.

EG Assembly- Phase Bus Bars

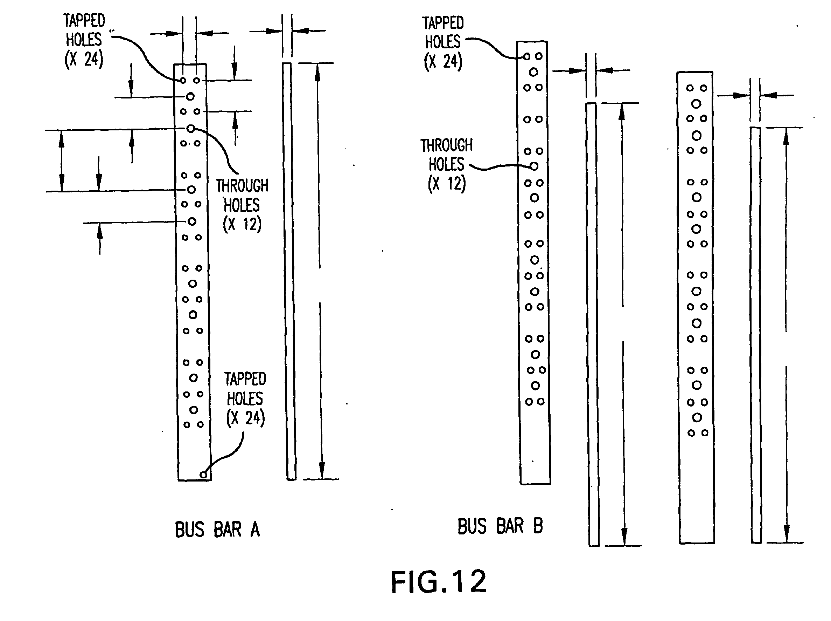

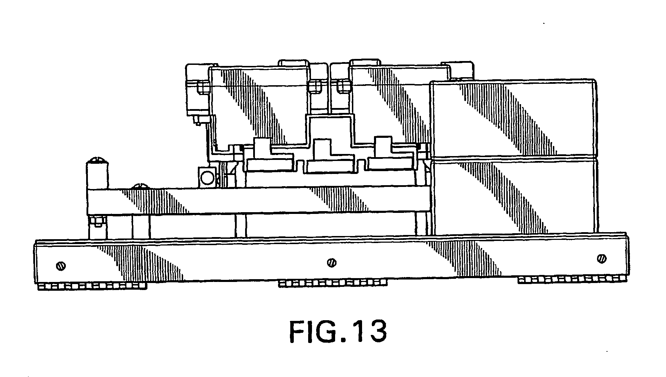

Three aluminum phase bus bars are placed towards the center of the Energy Guard assembly and staggered. See FIGS. 12 and 13. These provide connection to the customer metering modules by the use of transition bars. A staggered bus bar layout is depicted in FIG. 13. Bus bars are shown in black.

Neutral Bars

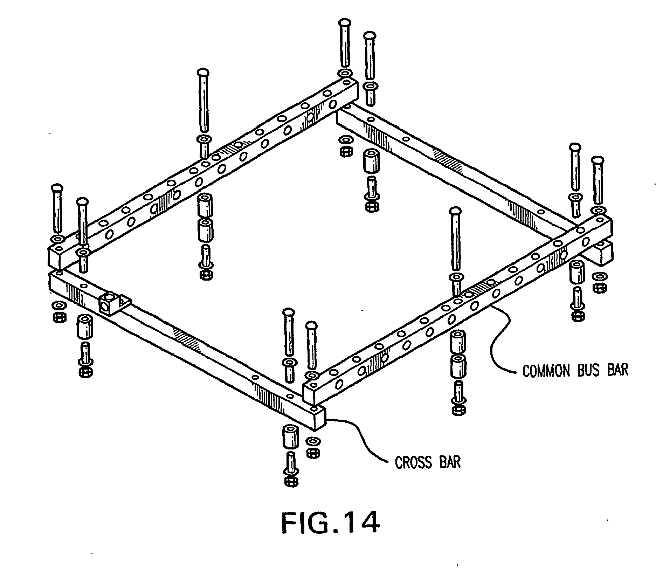

The EG preferably comprises 4 neutral bars that form a frame for EG assembly, thereby providing a path for the neutral current. This is shown in FIG. 14. The lug on the cross bar provides the neutral feed from the utility distribution transformer. Also, there are 2 mother board neutral bars that carry the neutral current to the control module.

Transition Bars

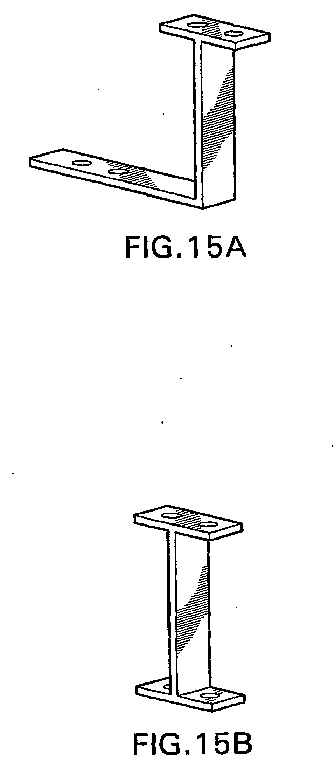

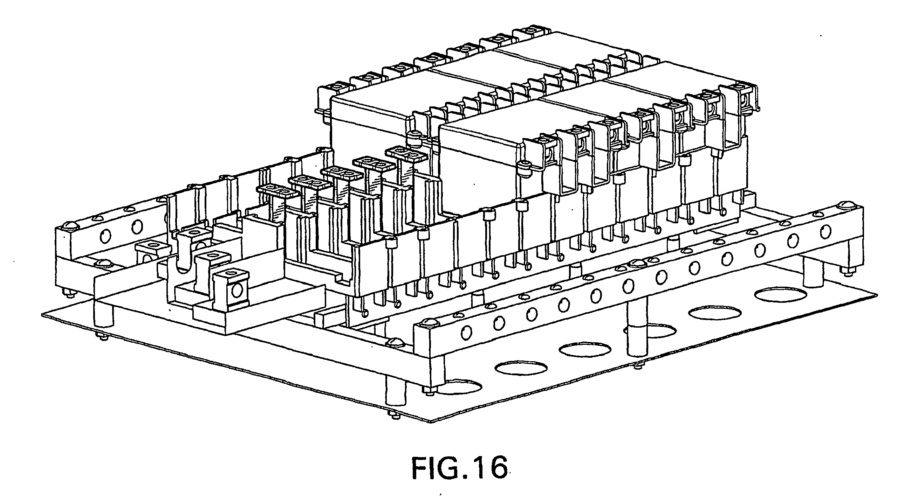

The transition bars complete the mechanical and electrical connection between the customer metering modules and the phase bus bars. See FIG. 15. A transition bar for phase A and C is shown in FIG. 15A; a transition bar for phase B is shown in FIG. 15B. FIG. 16 shows the transition bars in black.

Acceptor Module

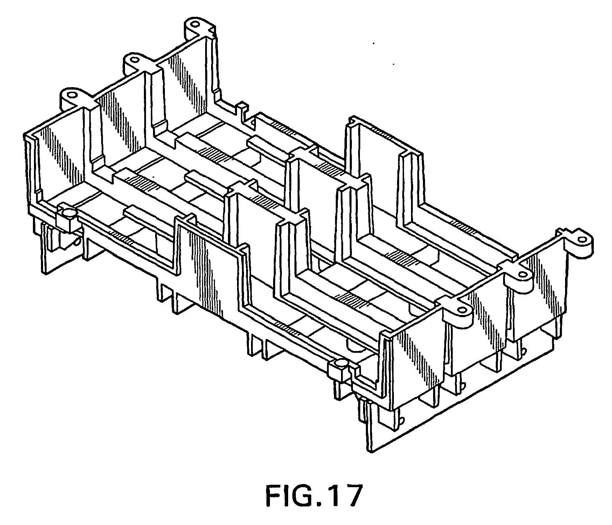

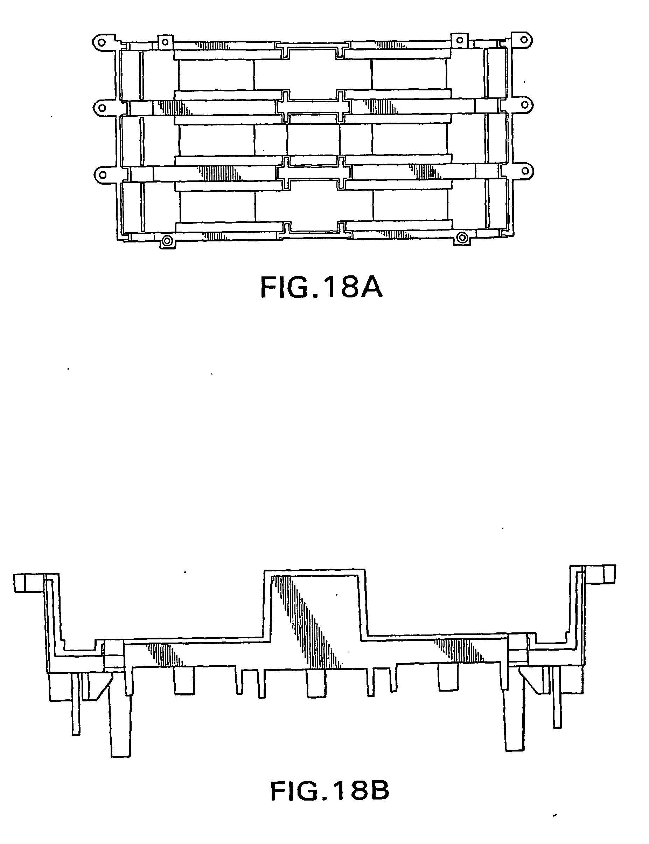

An acceptor module preferably is made of plastic and mechanically accepts the metering modules that can be easily fitted in the EG assembly. Each EG has 4 acceptor modules that are stacked together and can accommodate either 12 two-phase or 8 three-phase metering modules. See FIG. 17. The acceptor module also provides a mechanical route for the motherboard neutral bar which connects to the control module. See FIG. 18.

Customer Metering Modules

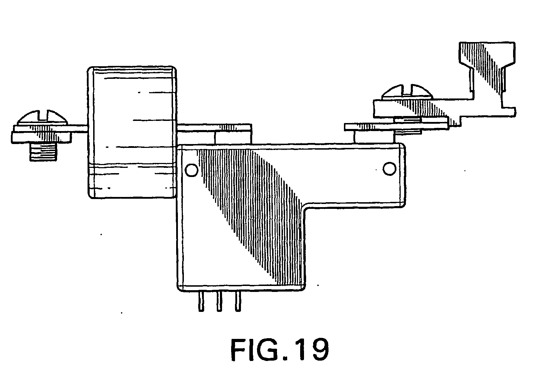

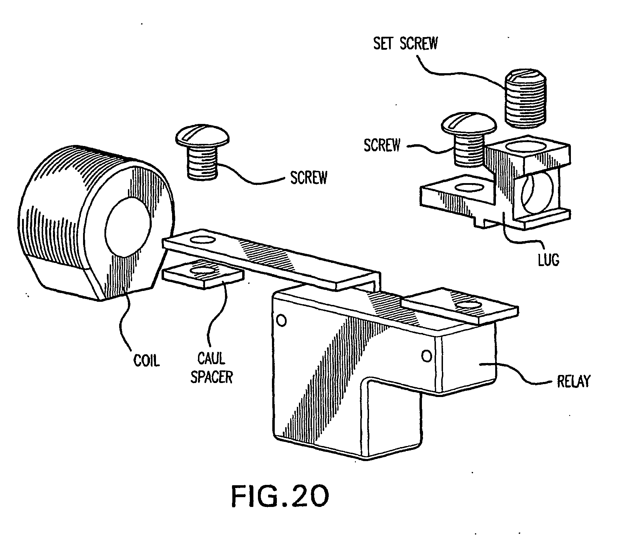

Preferred customer metering modules provide metrology required to measure the consumption for a single phase, two phase, or three phase customer. An individual module functions as a complete stand-alone meter that can be tested and evaluated as a separate metering unit. Each module preferably comprises an integrated current sensing and relay module and metrology electronics, and provides a connection between the customer circuit and the phase bus bars. FIG. 19 depicts a preferred integrated current sensing and relay module. FIG. 20 depicts an exploded view of a preferred integrated current sensing and relay module.

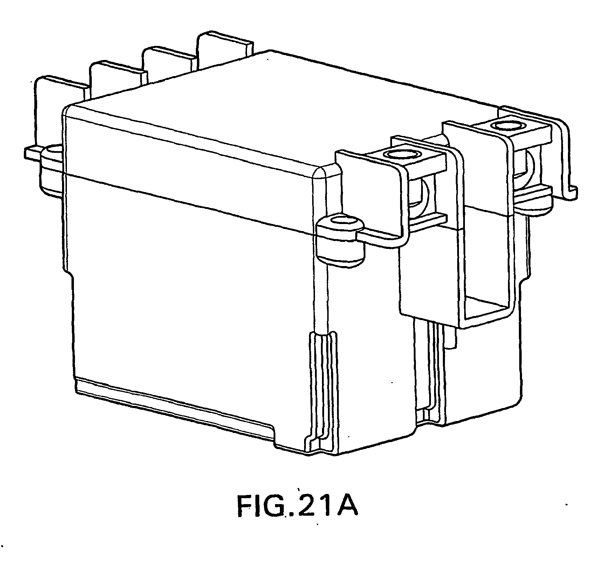

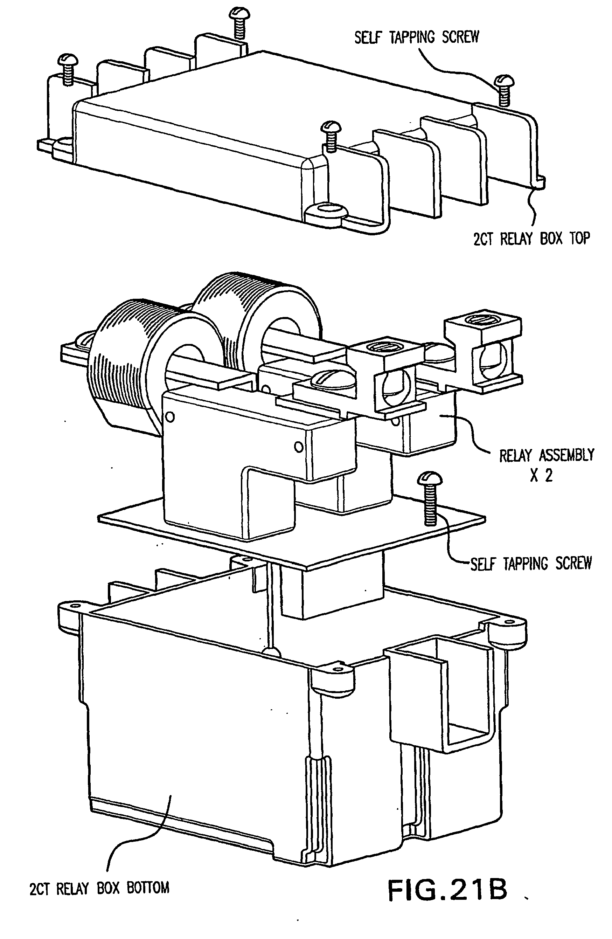

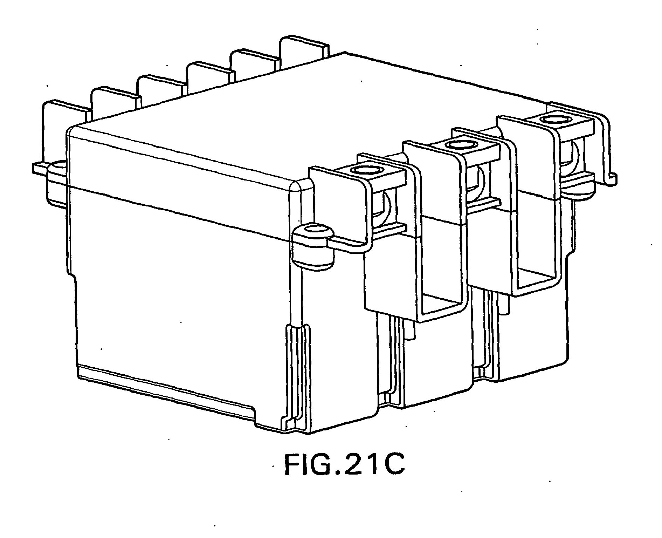

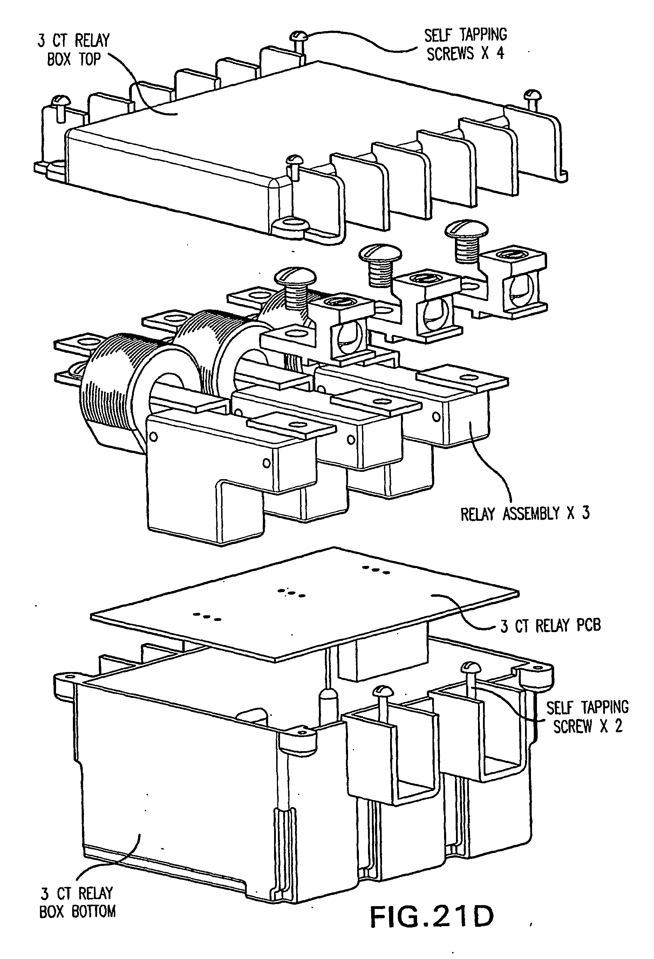

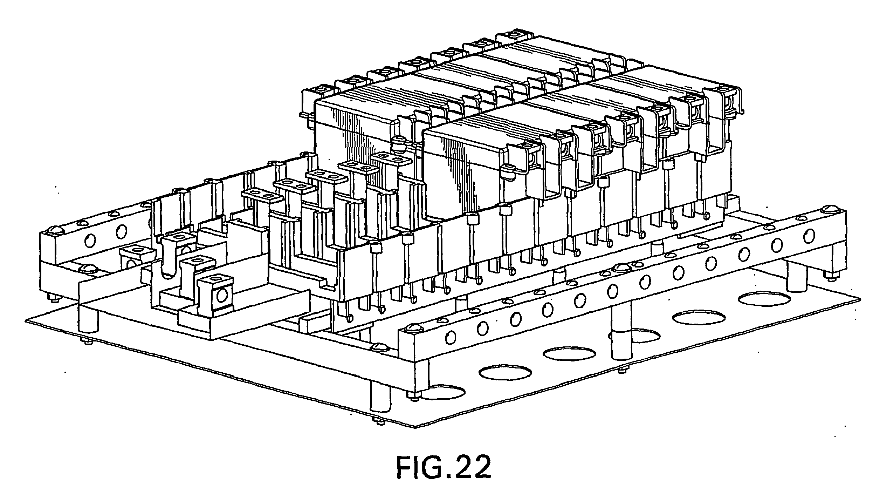

FIG. 21 shows exploded views of preferred metering modules. FIG. 22 shows the metering modules (shown in black) placed in the EG frame assembly and acceptor module.

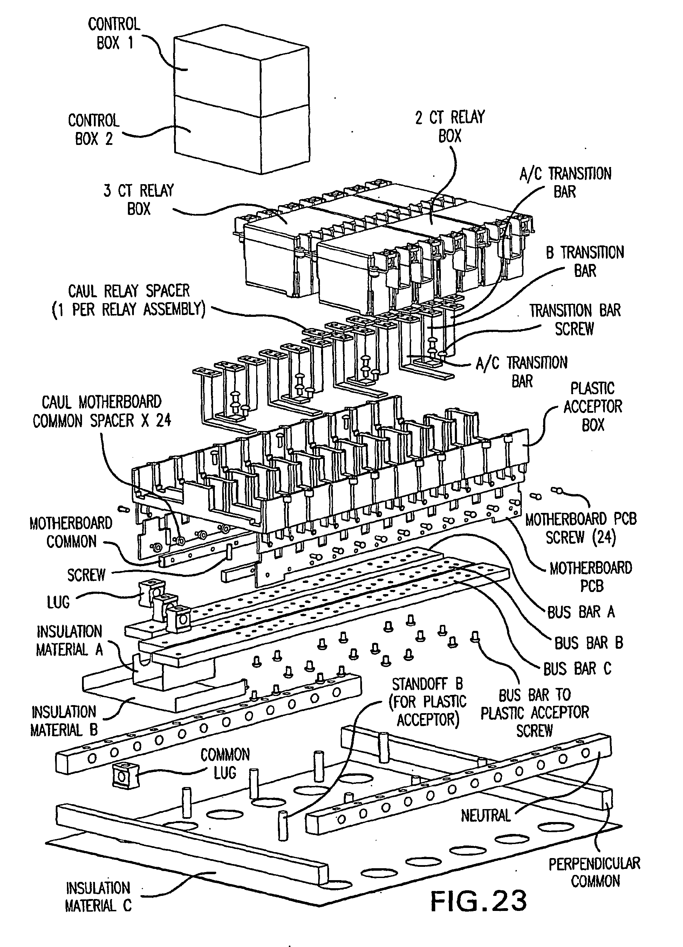

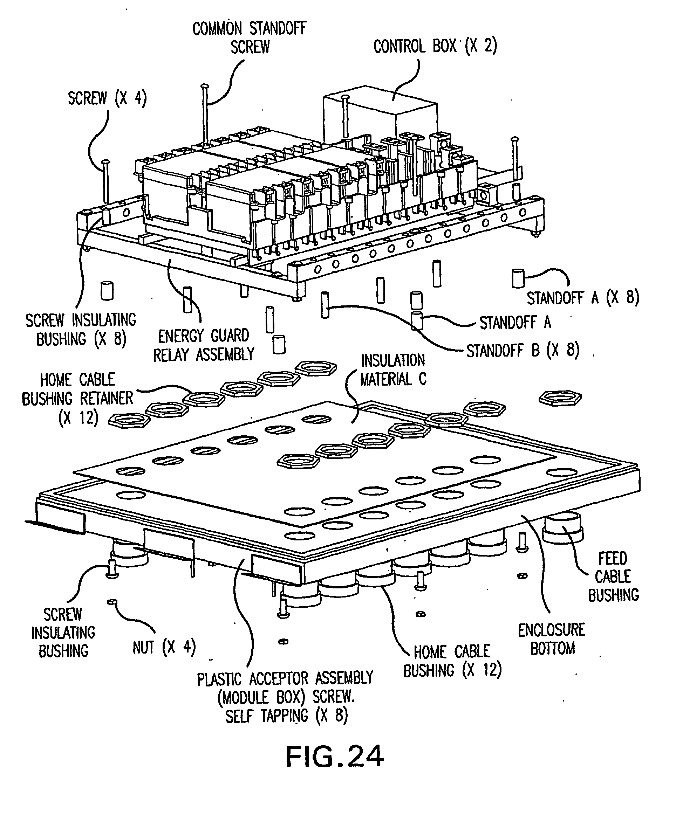

FIG. 23 shows an exploded view of Energy Guard, and FIG. 24 shows an exploded view of a preferred EG Assembly and EG Base Assembly.

Electronics

The Control Module boxes preferably comprise various PCBs that work concurrently to collect metering data from the individual metering modules and communicate over power lines to transmit this data to a master device, such as a Scan Transponder ("ST").

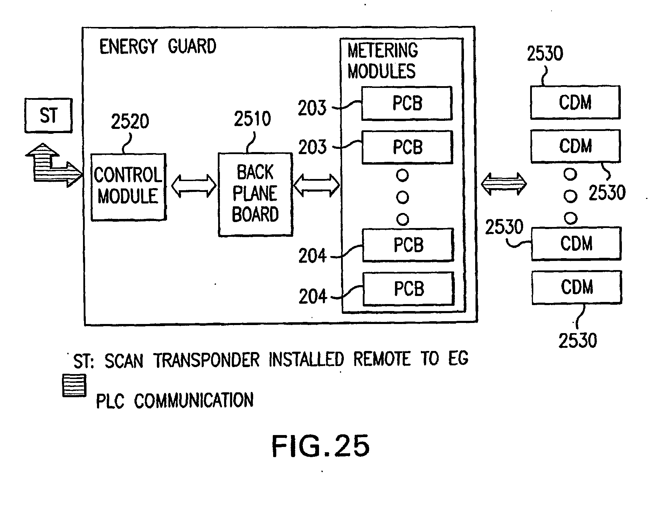

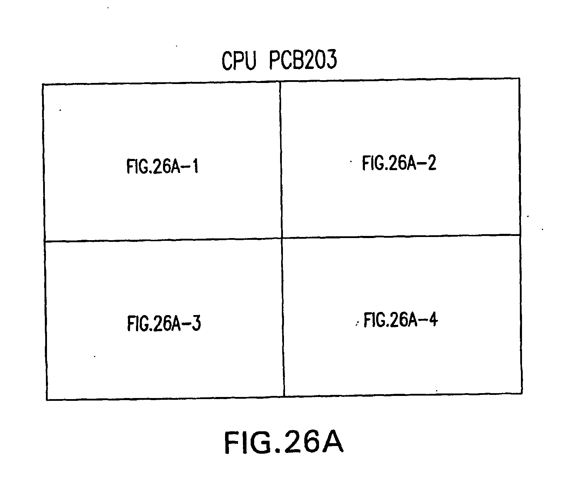

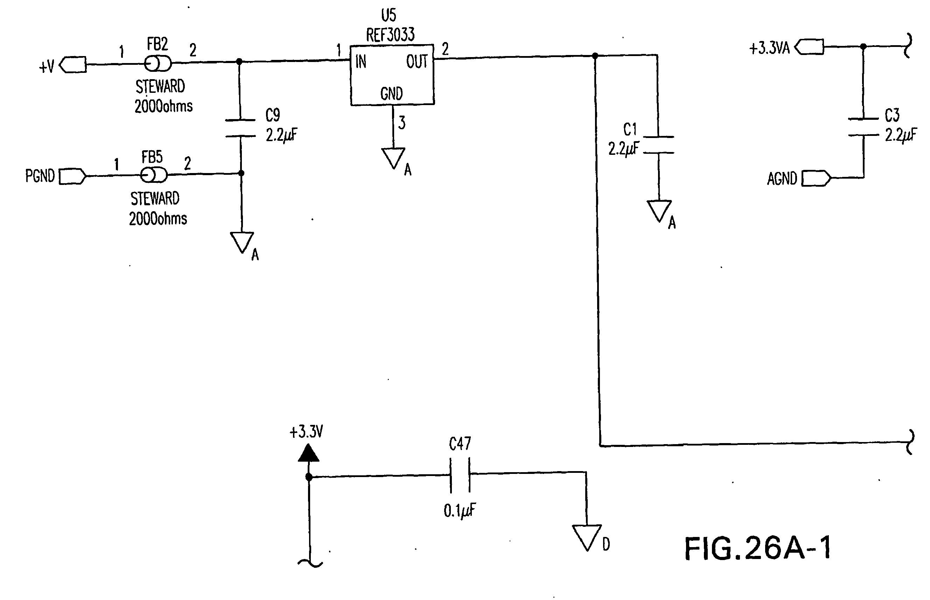

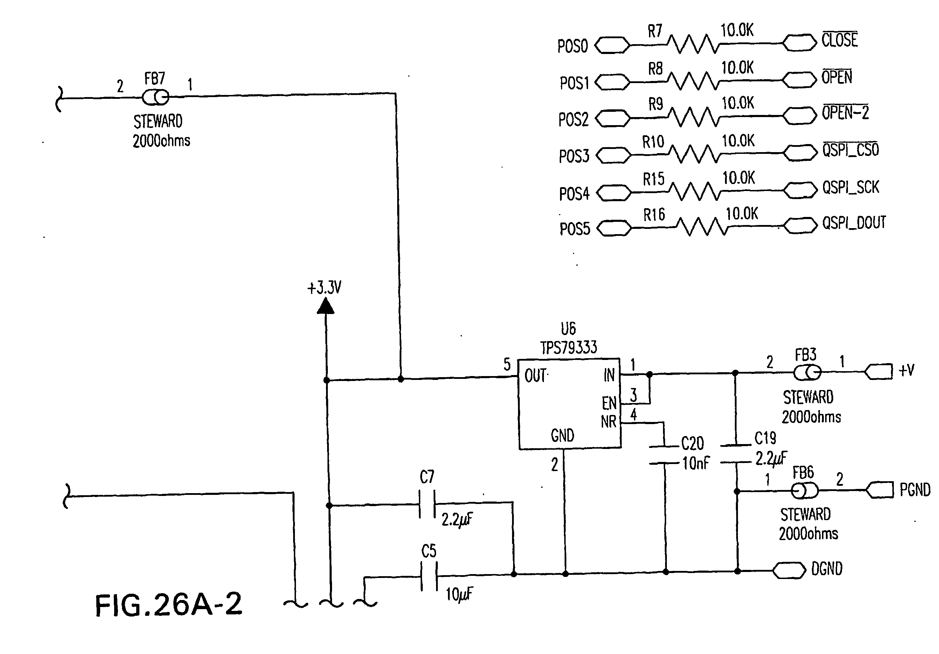

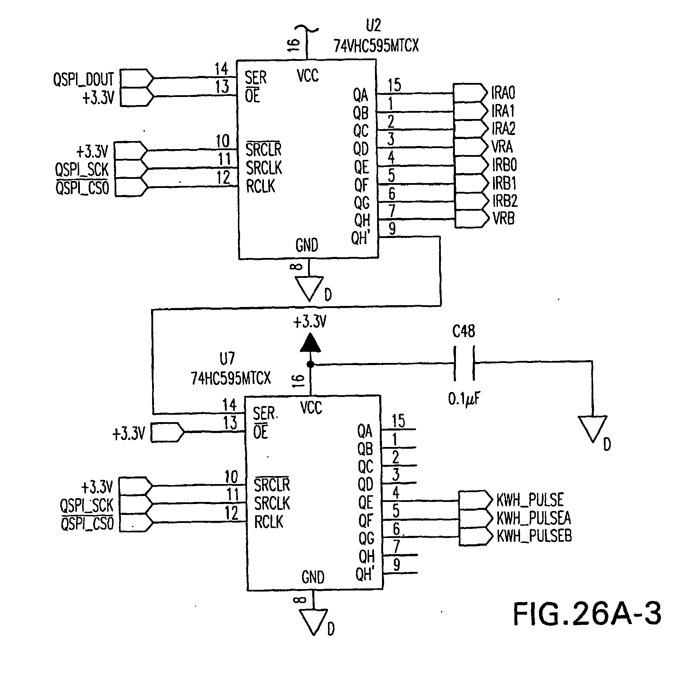

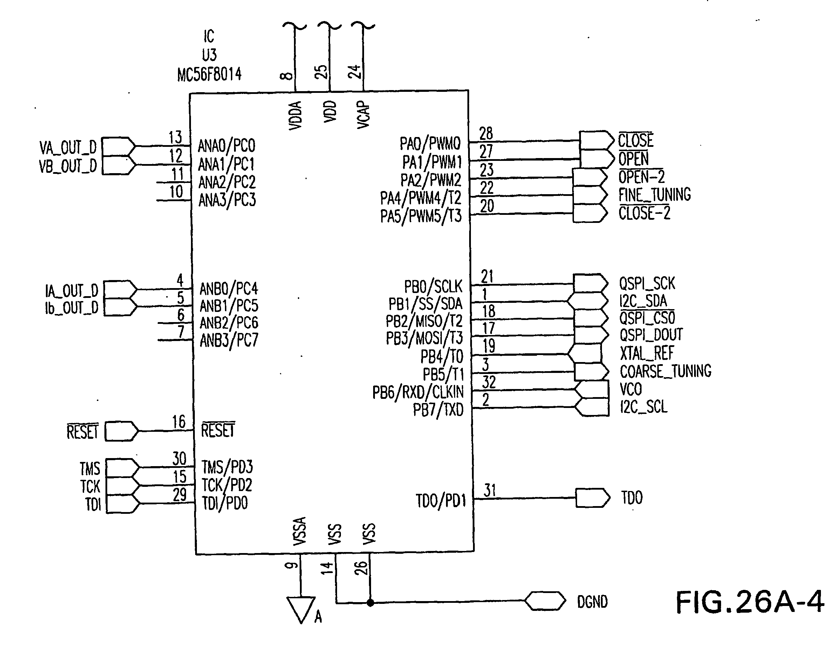

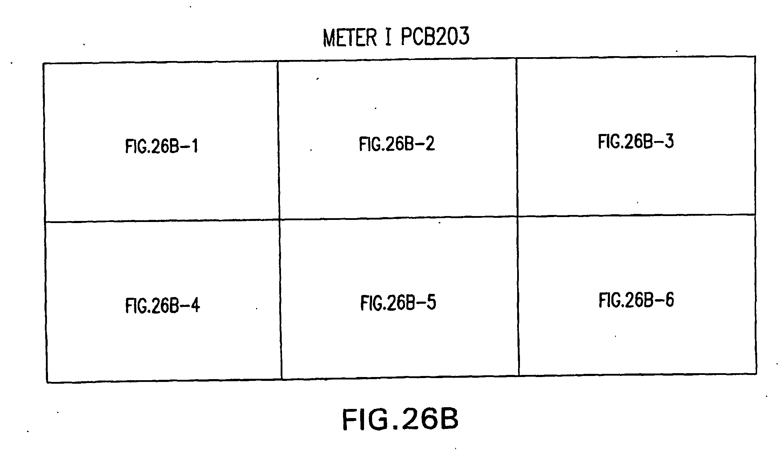

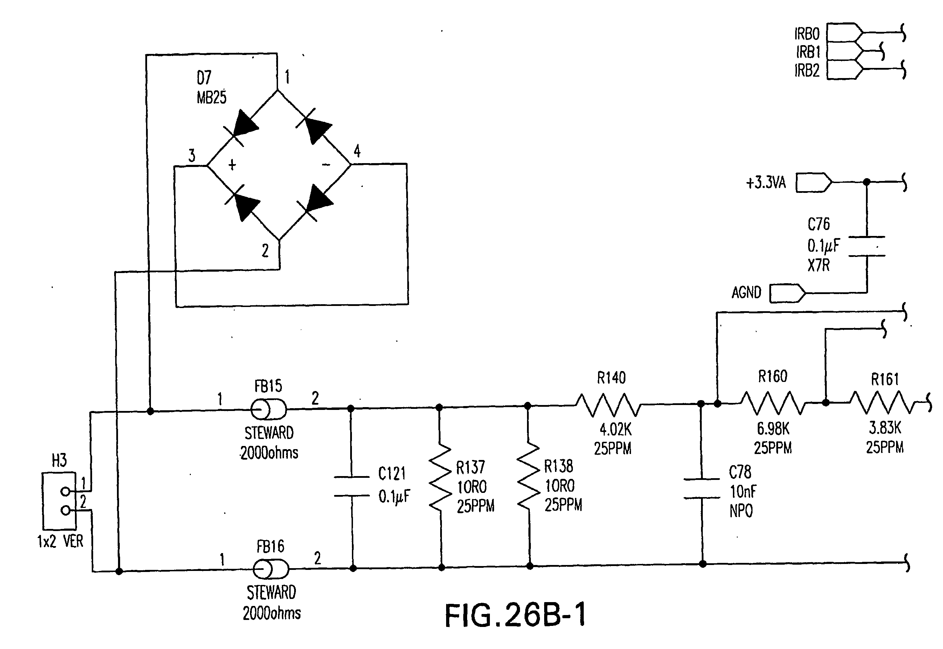

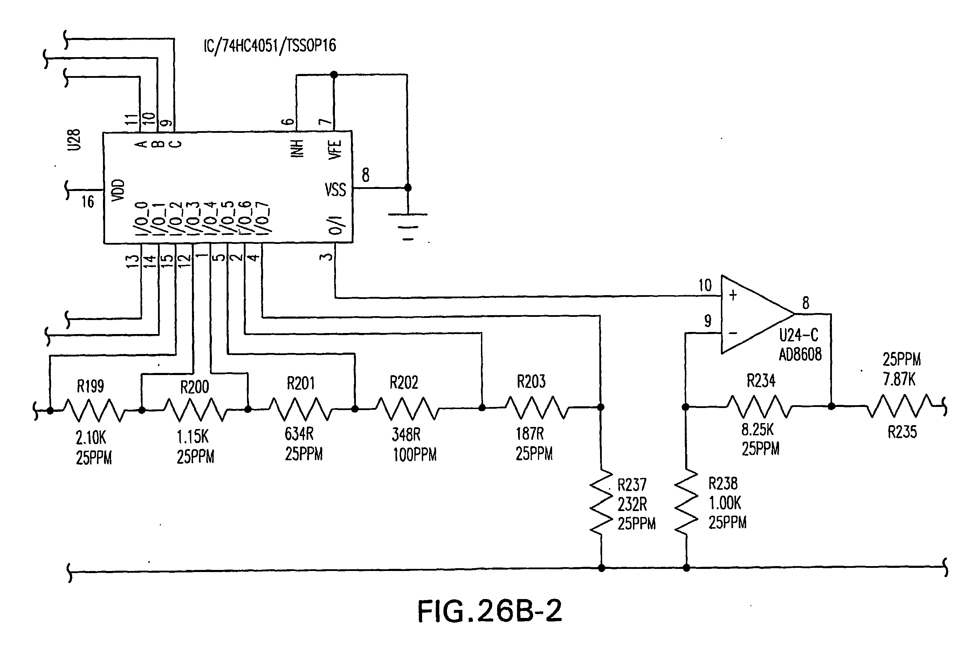

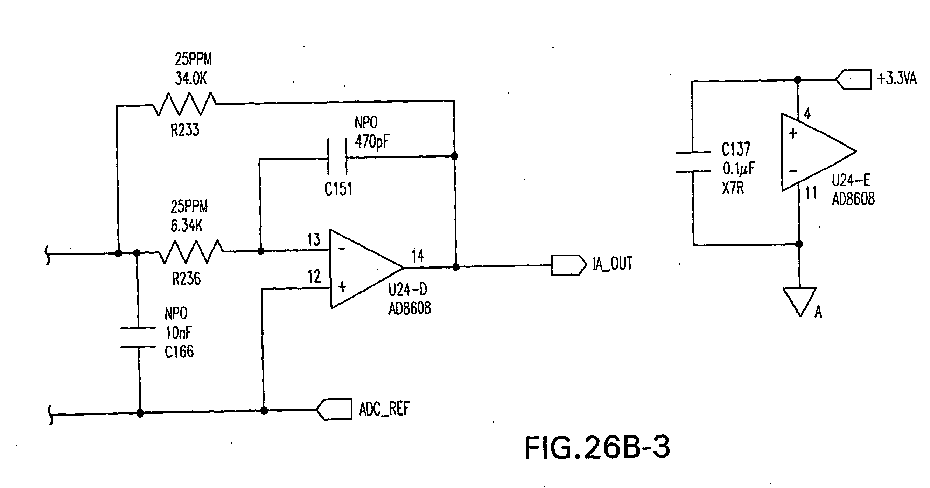

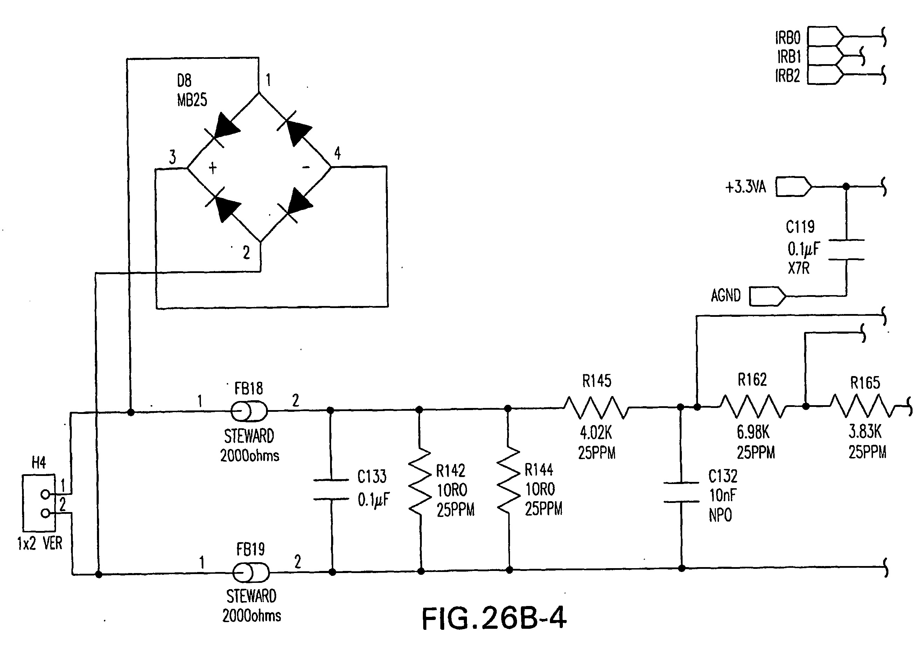

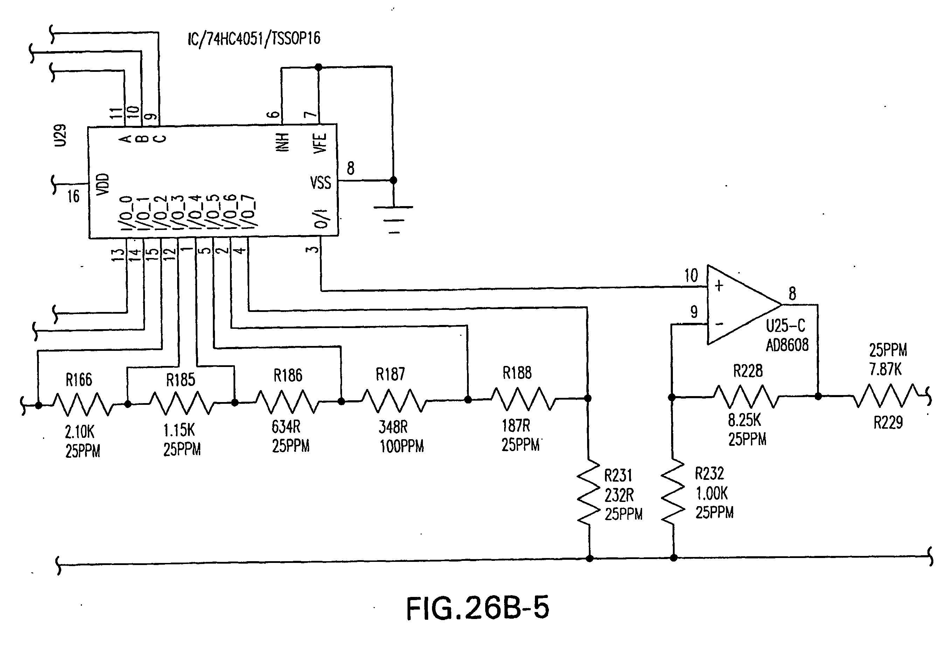

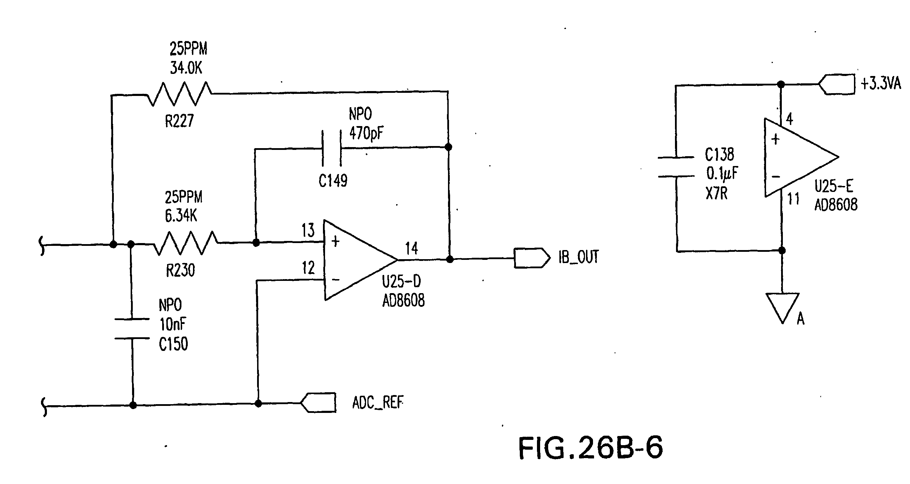

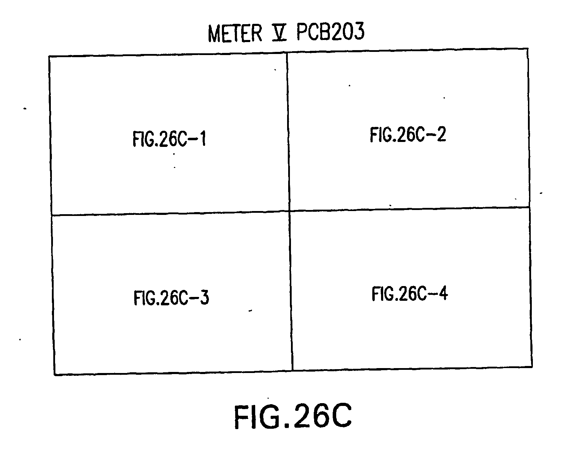

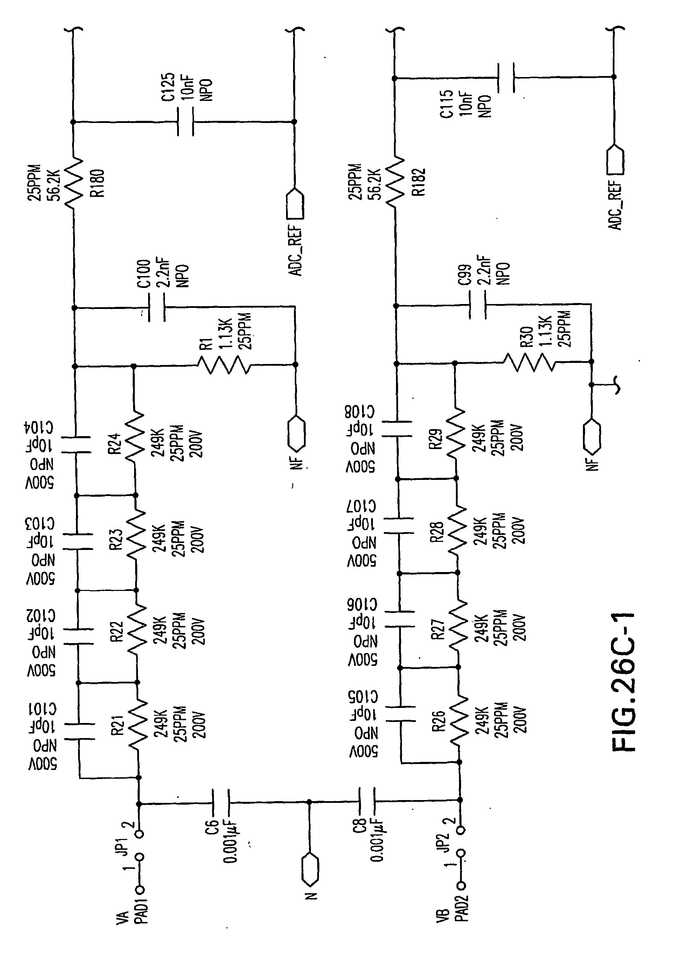

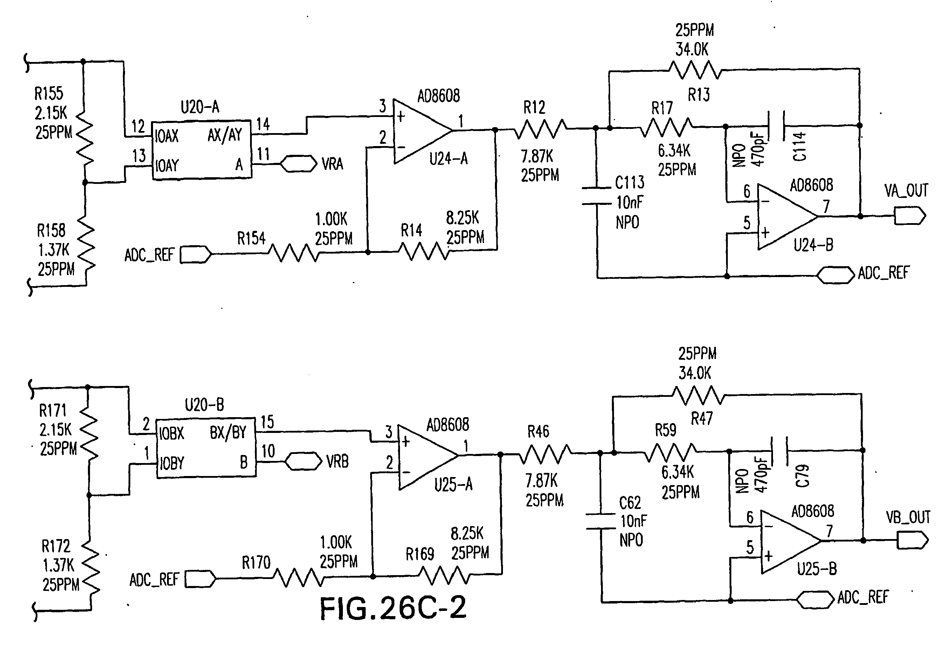

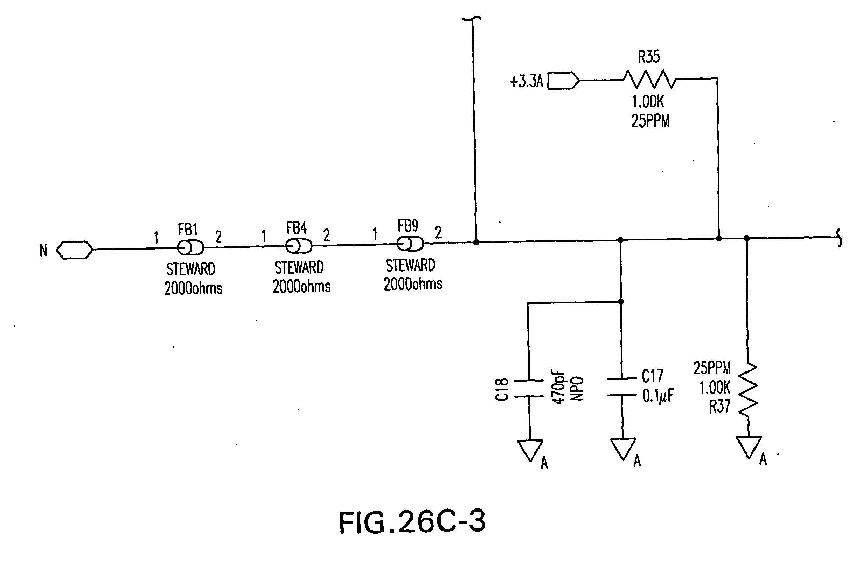

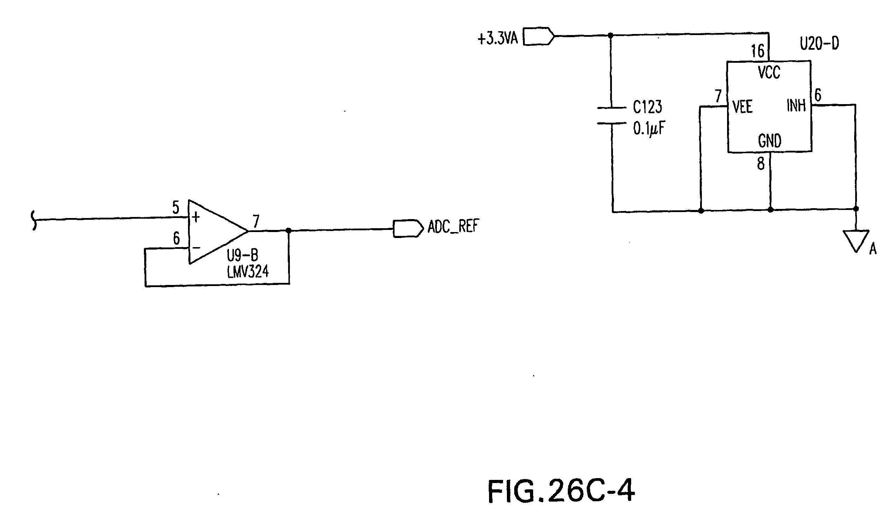

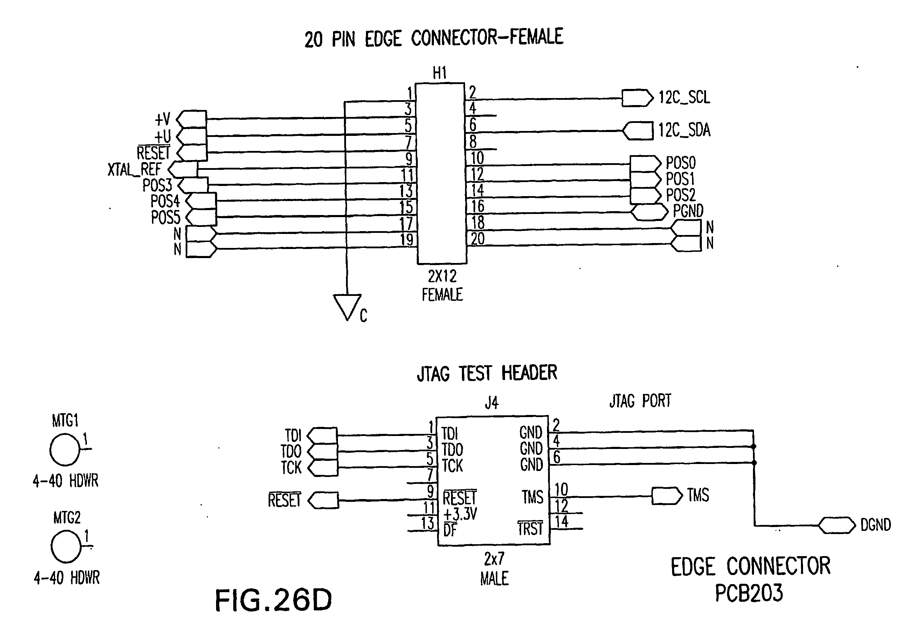

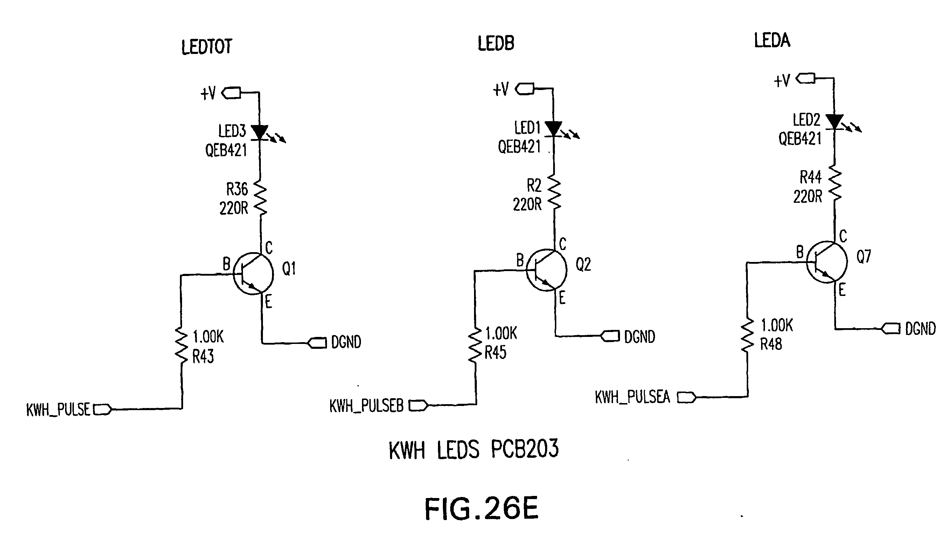

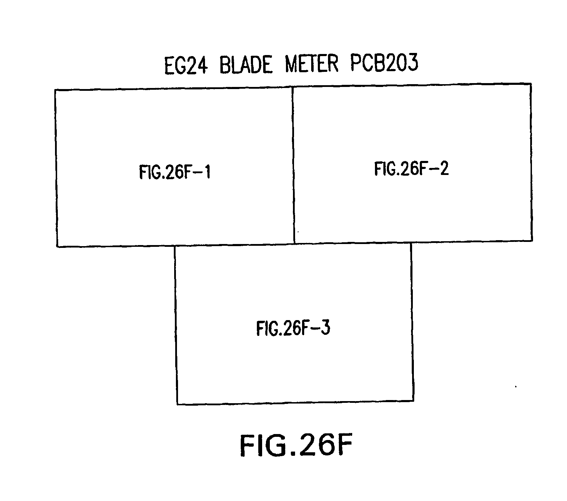

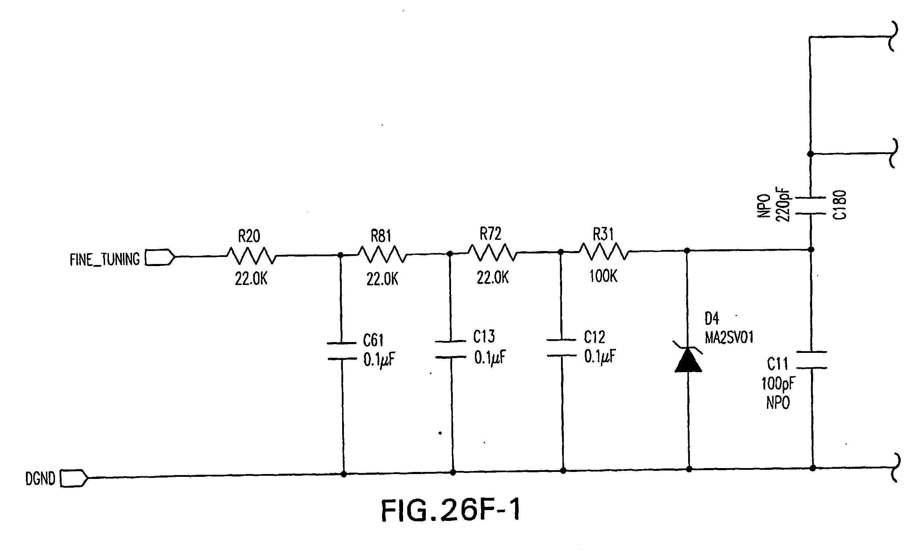

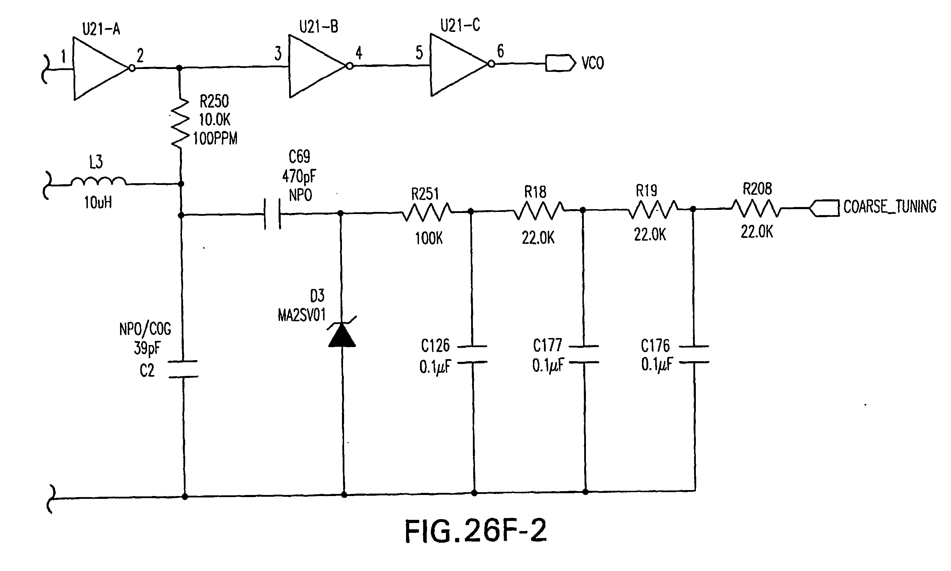

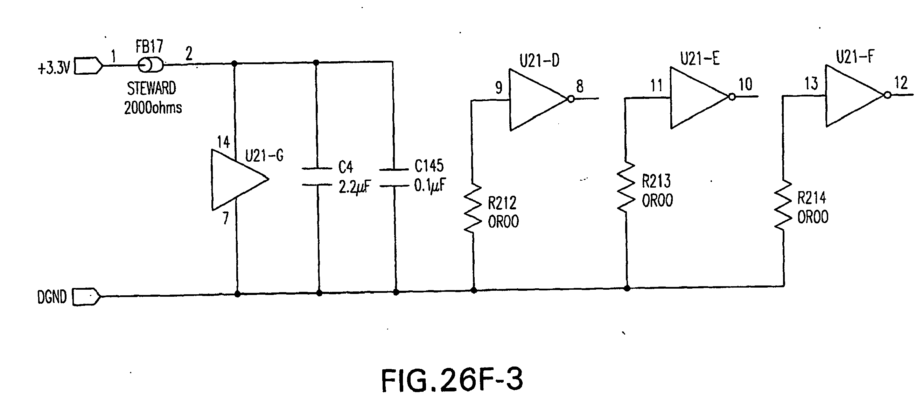

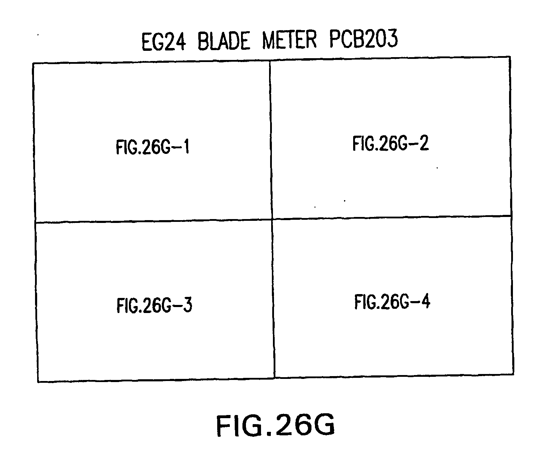

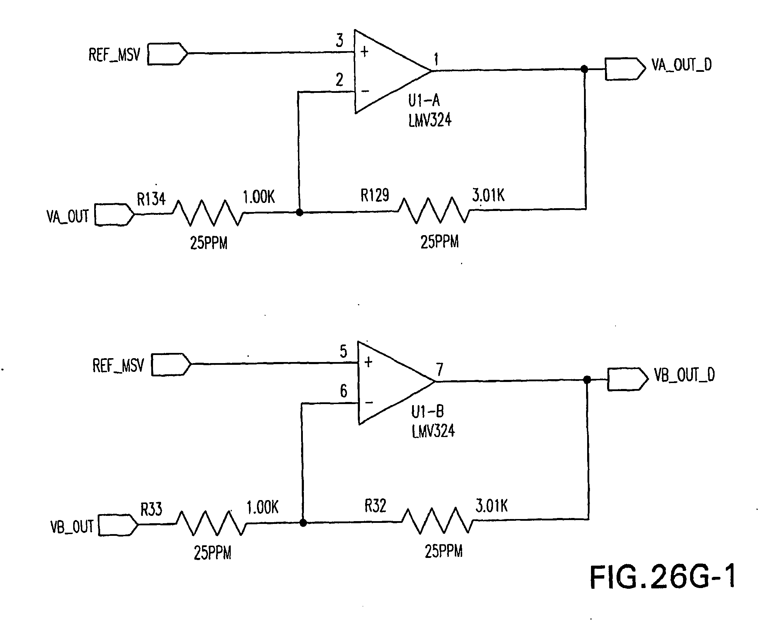

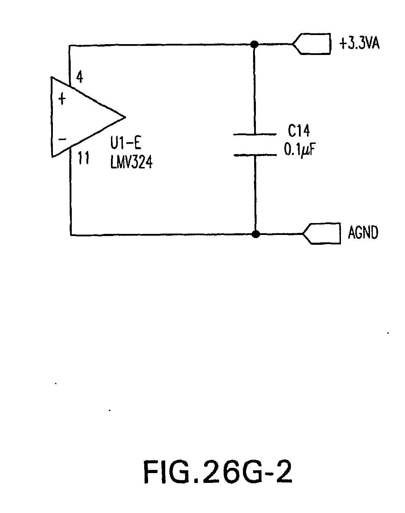

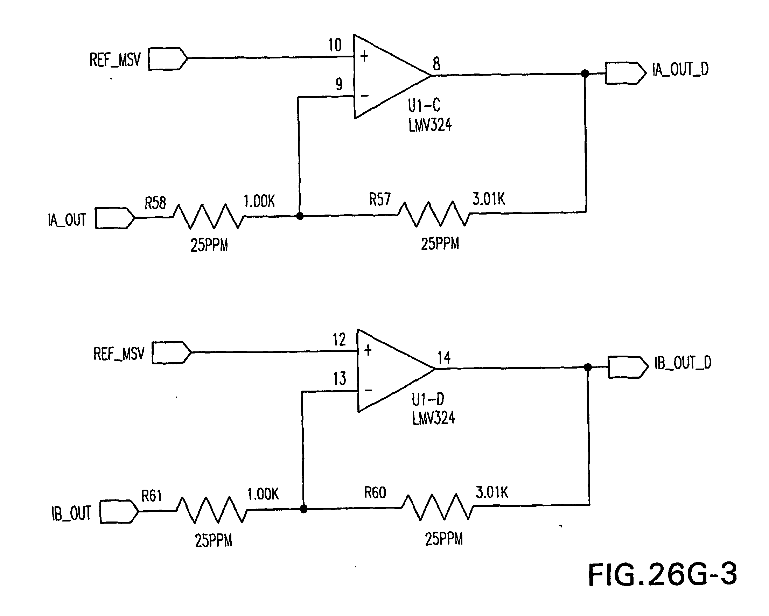

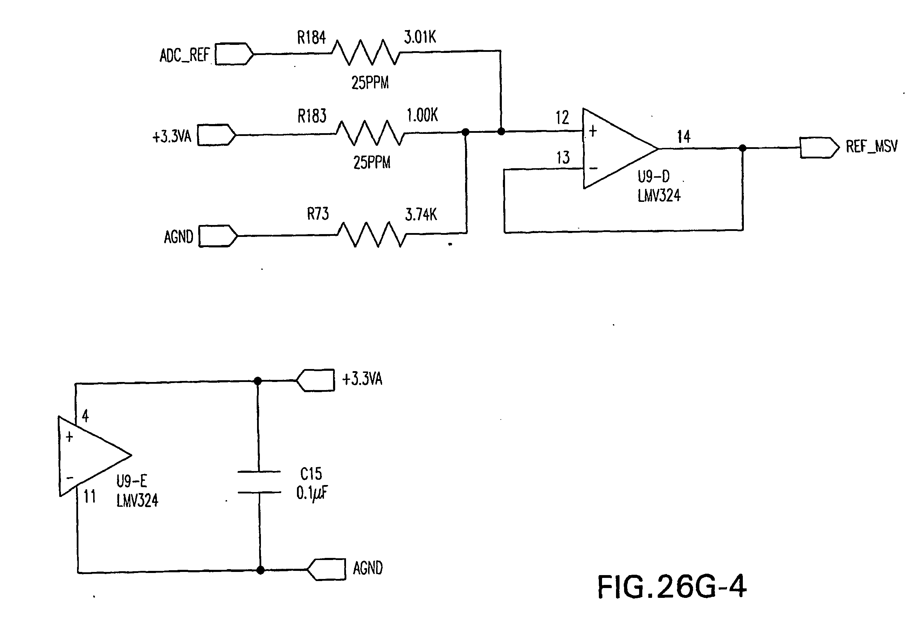

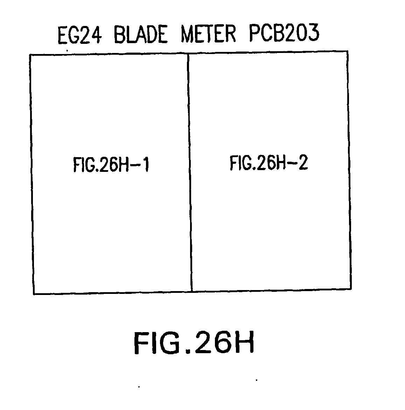

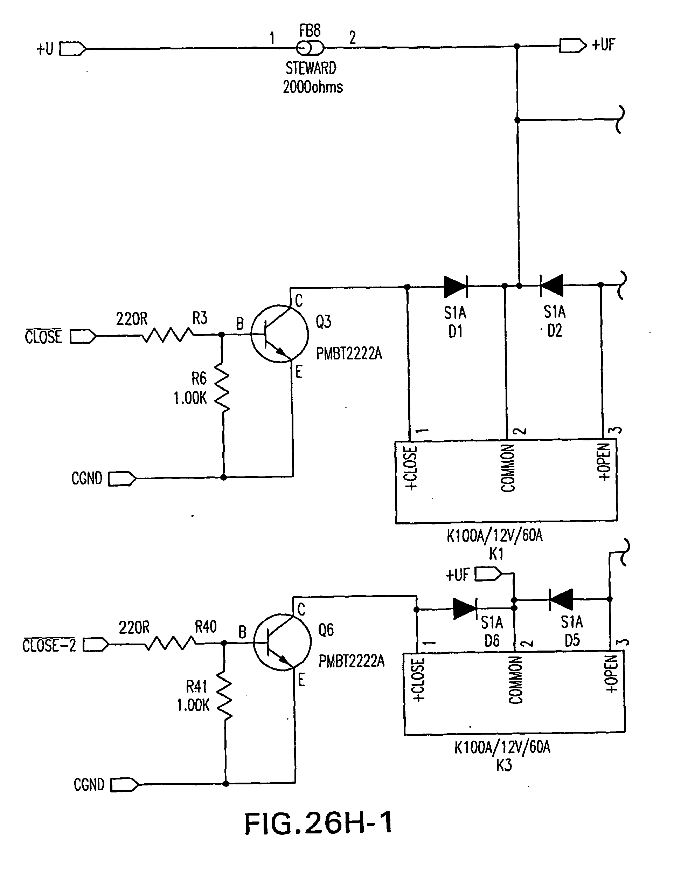

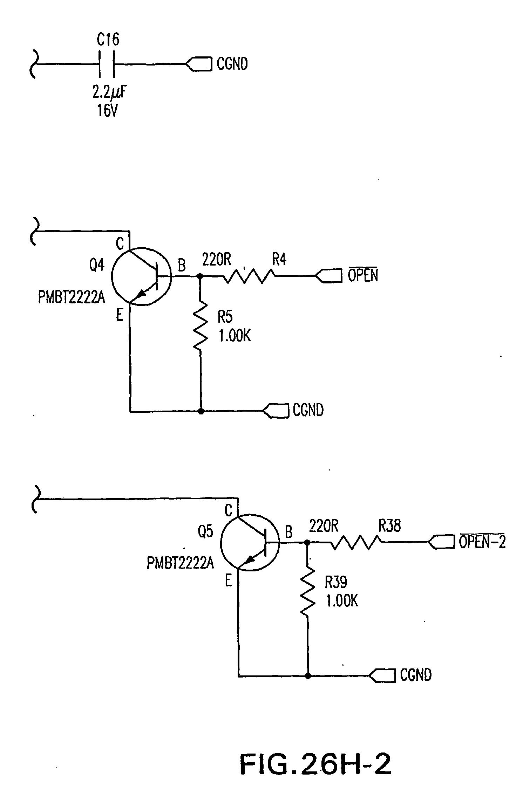

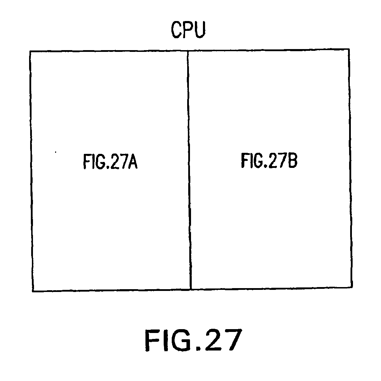

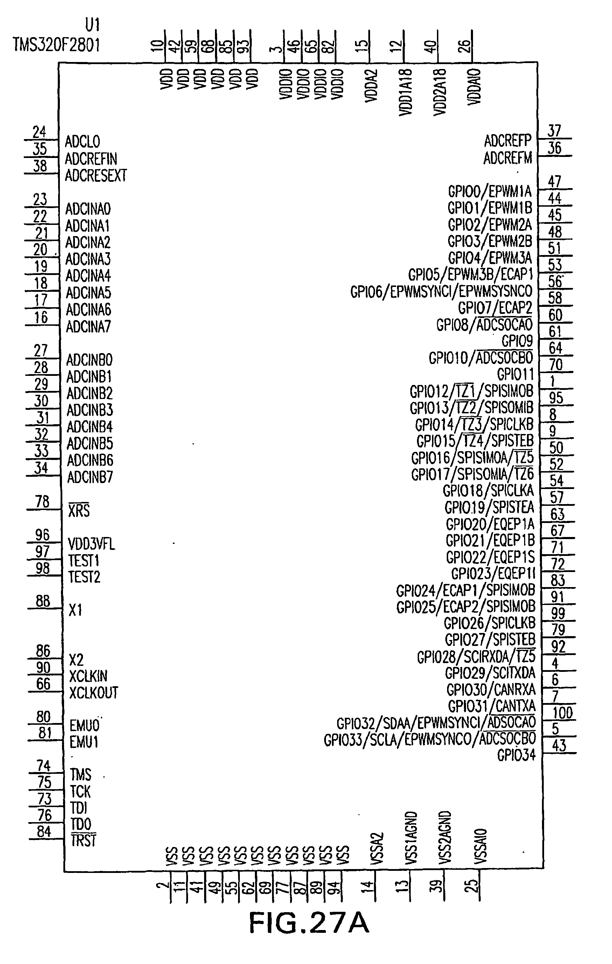

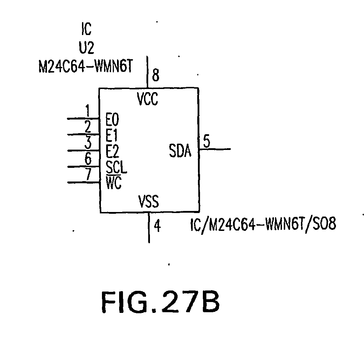

FIG. 25 shows a preferred Energy Guard layout for this embodiment. Each customer line has a corresponding Metering Module (PCB 203 and PCB 204, discussed below) (schematics shown in FIGS. 26 and 27).

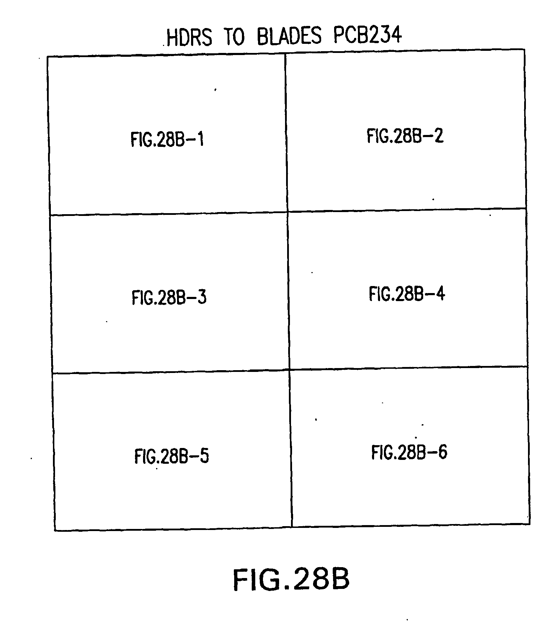

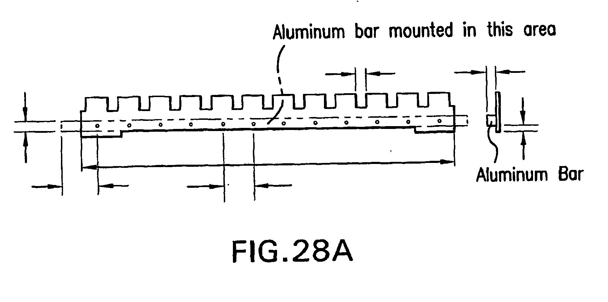

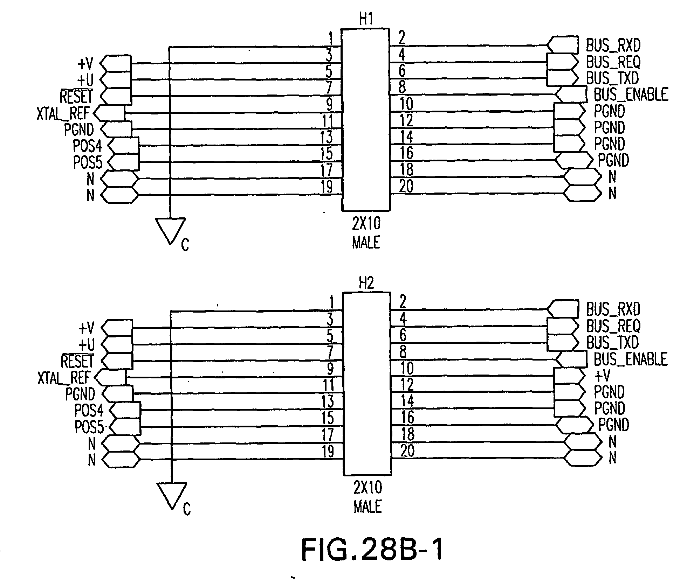

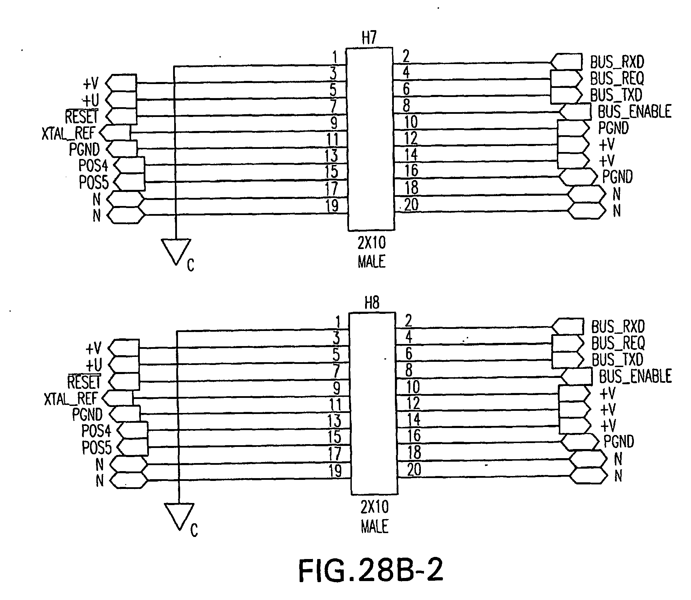

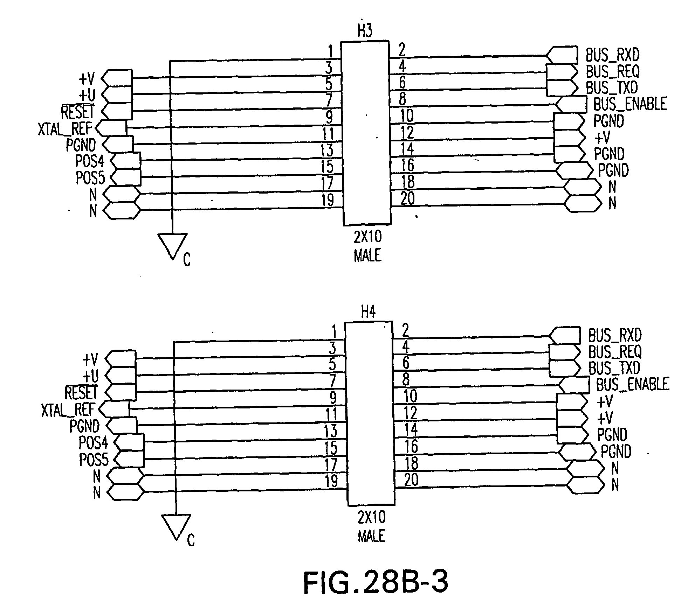

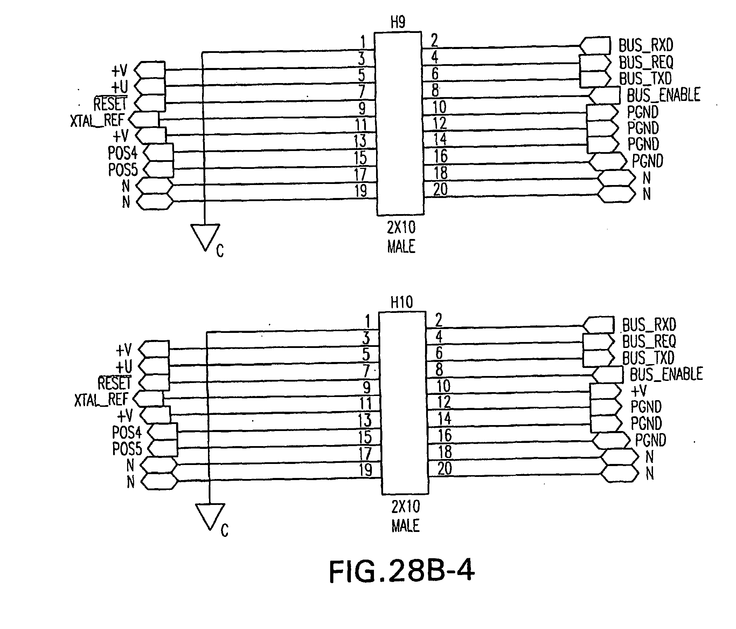

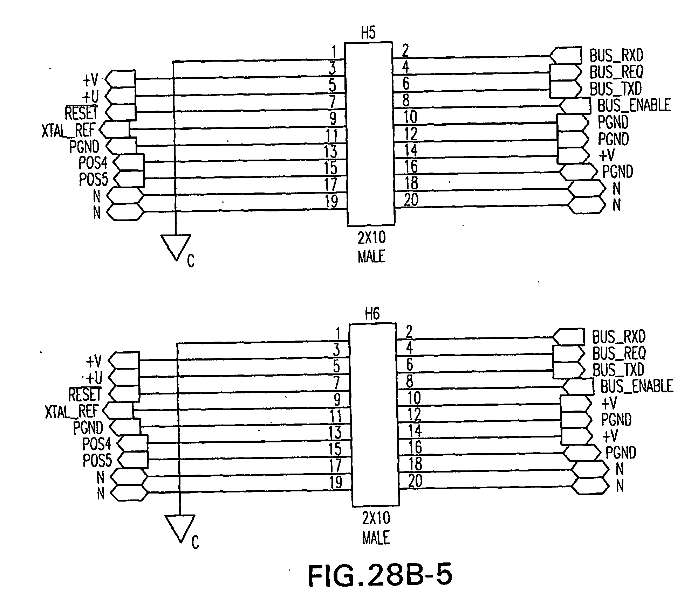

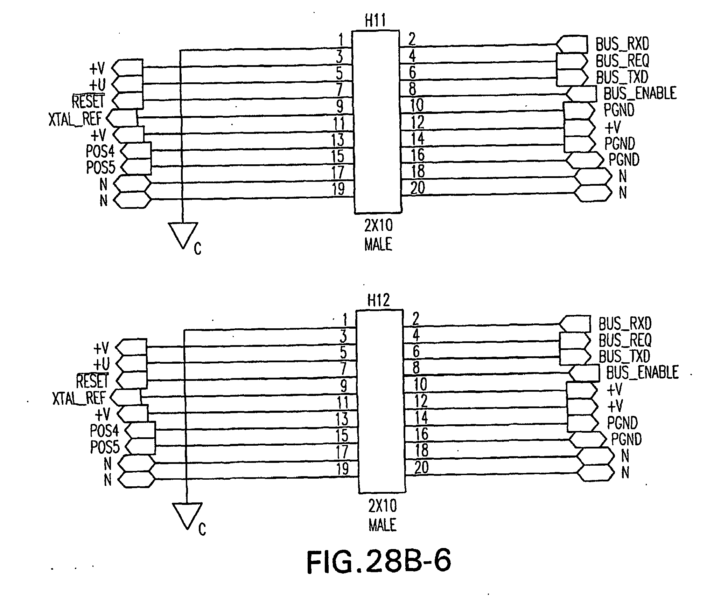

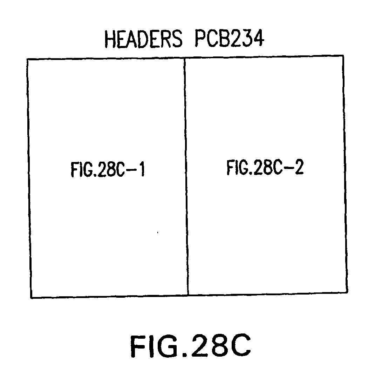

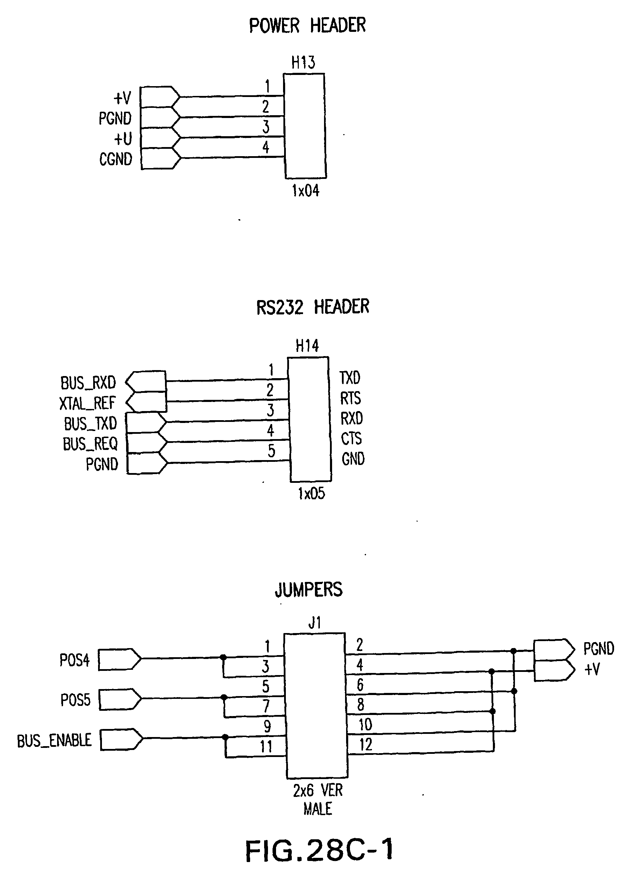

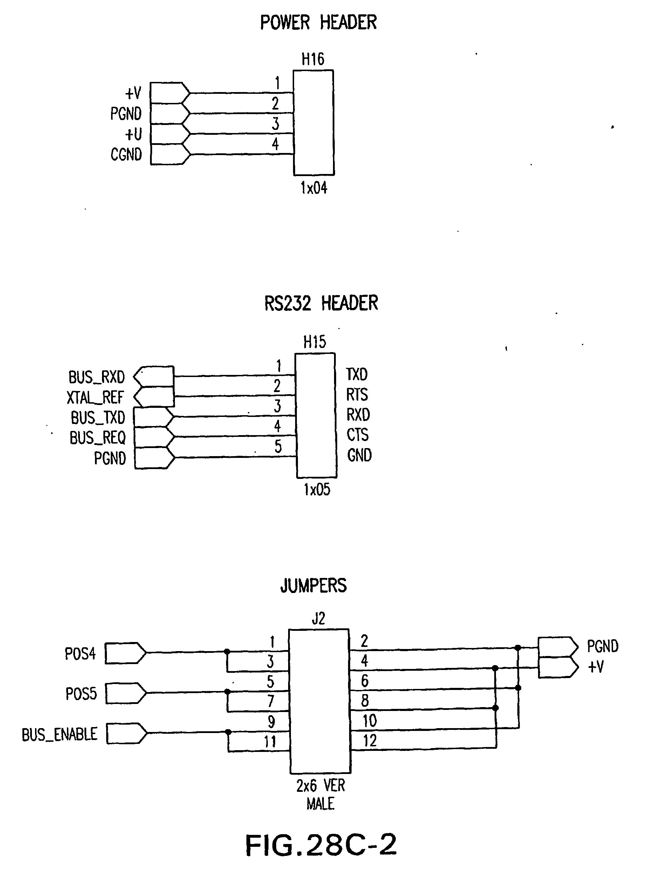

A Back Place Board 2510 shown in FIG. 25 (PCB 234; see FIG. 28 for construction diagram and schematic) is the common bus that routes signals within the EG. There are two kinds of communication options on the Back Place Board 2510 to enable data transfer from Control Module 2520 to individual Metering Modules PCB 203. This can be done either using the 2 wire I2C option or the 1 wire serial option.

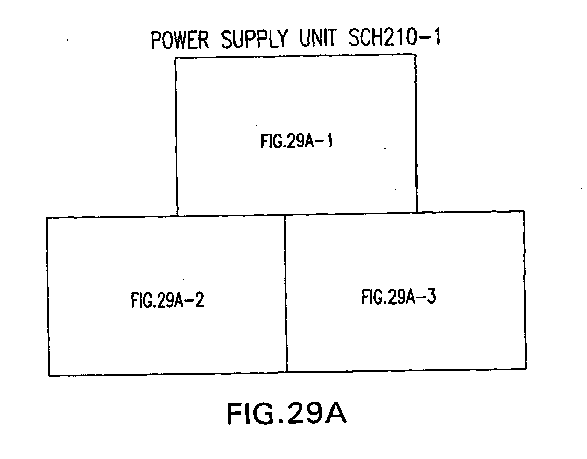

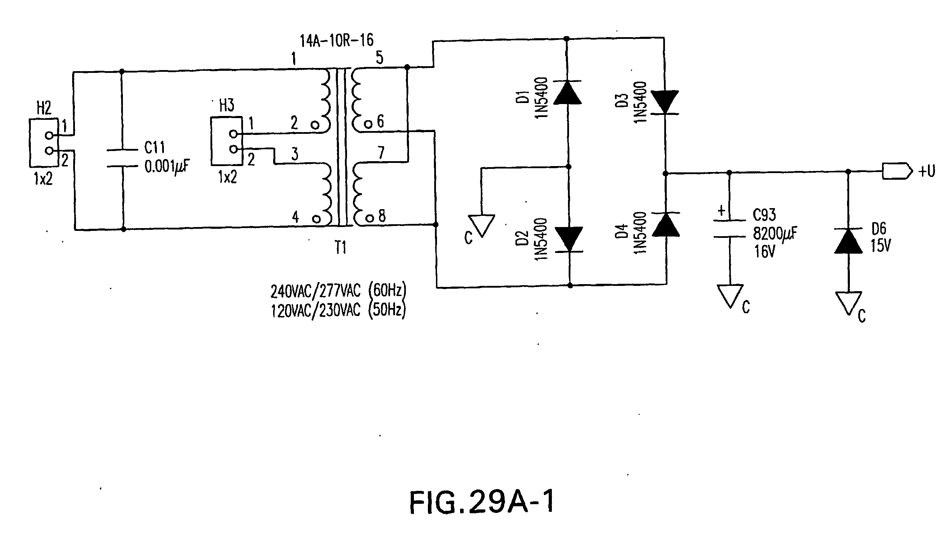

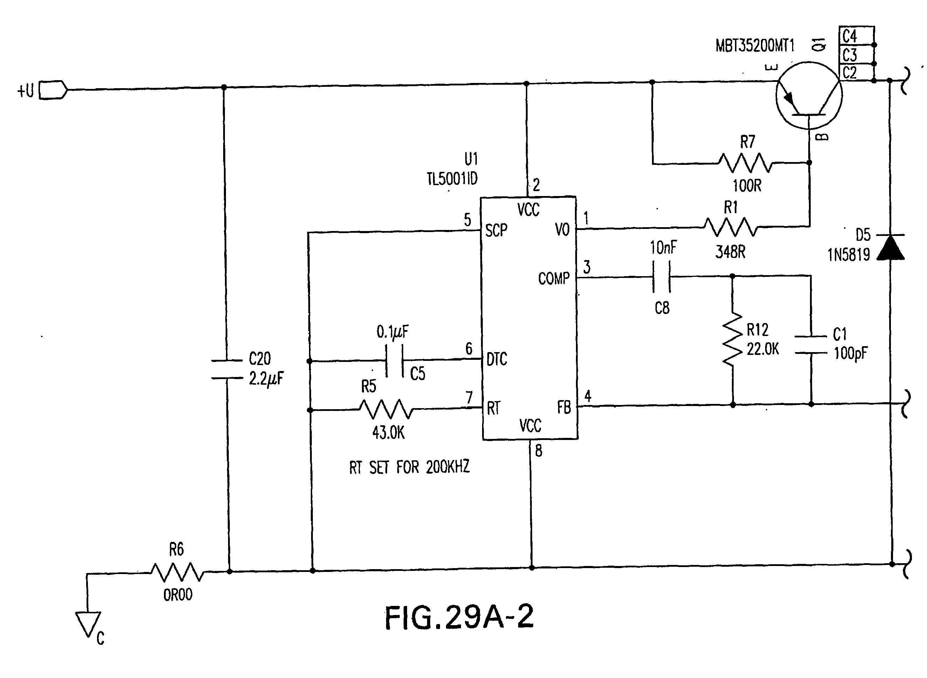

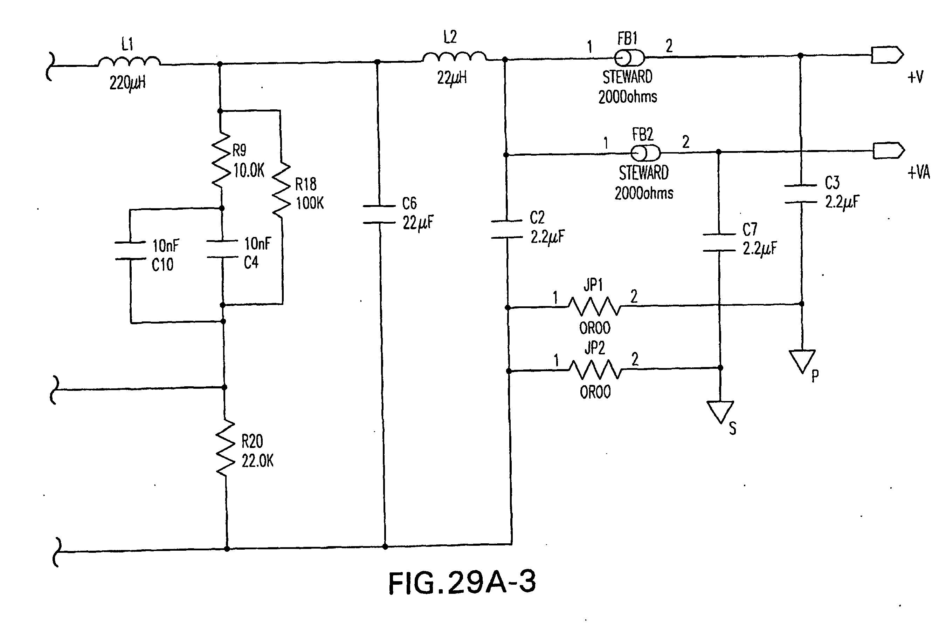

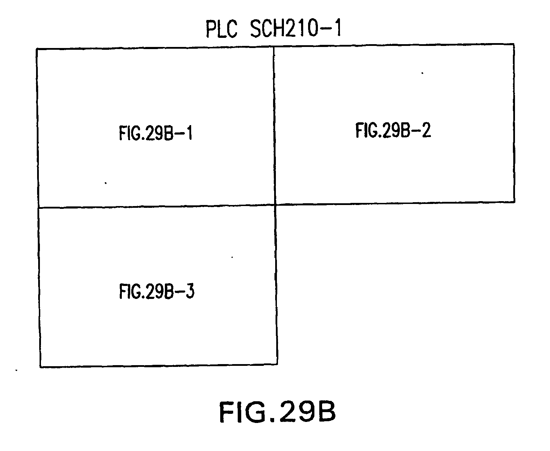

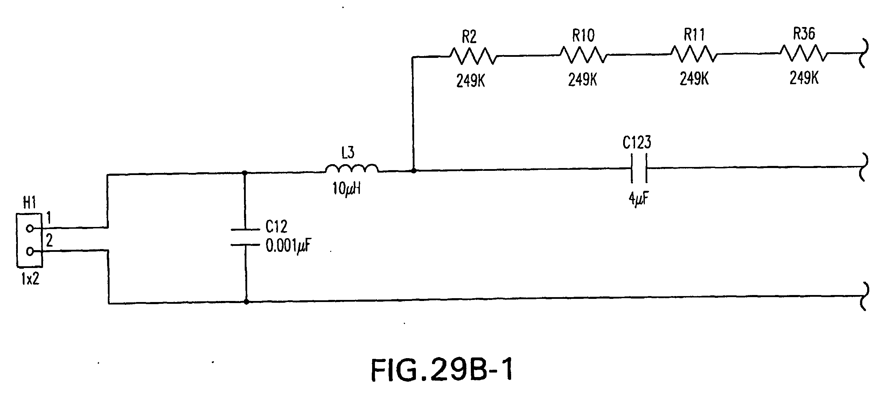

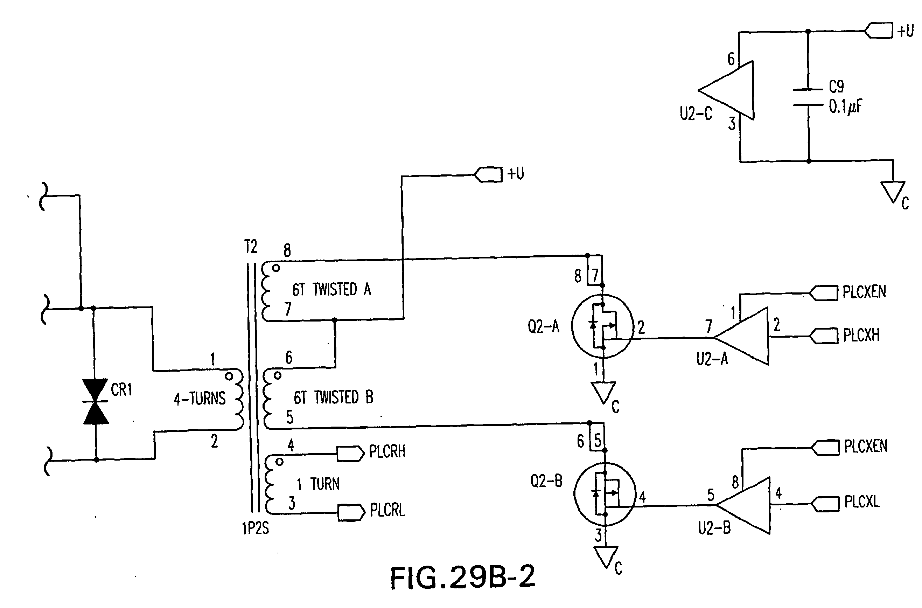

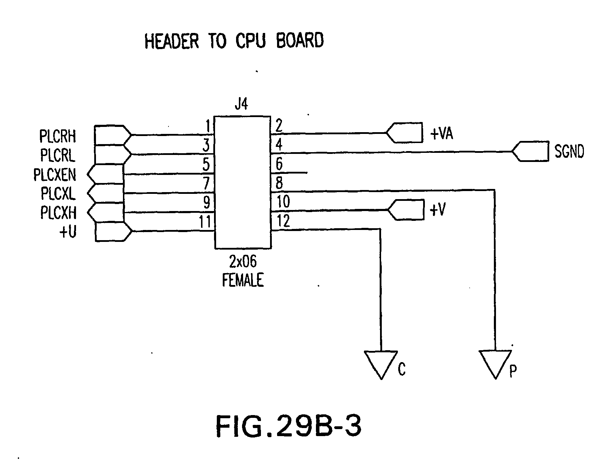

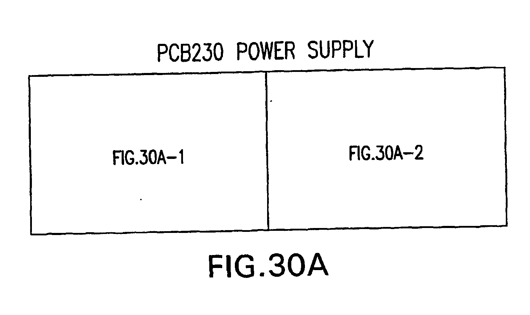

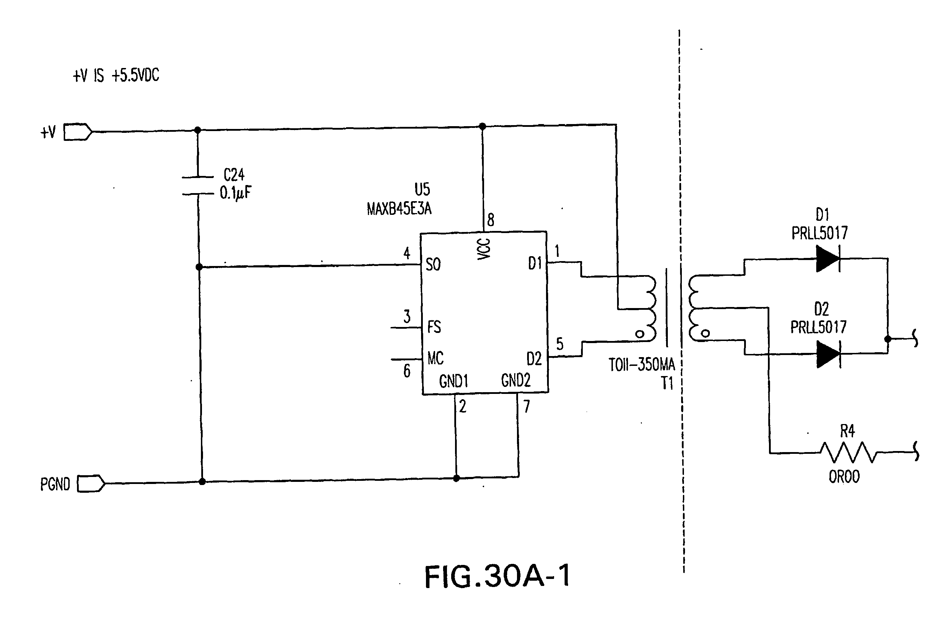

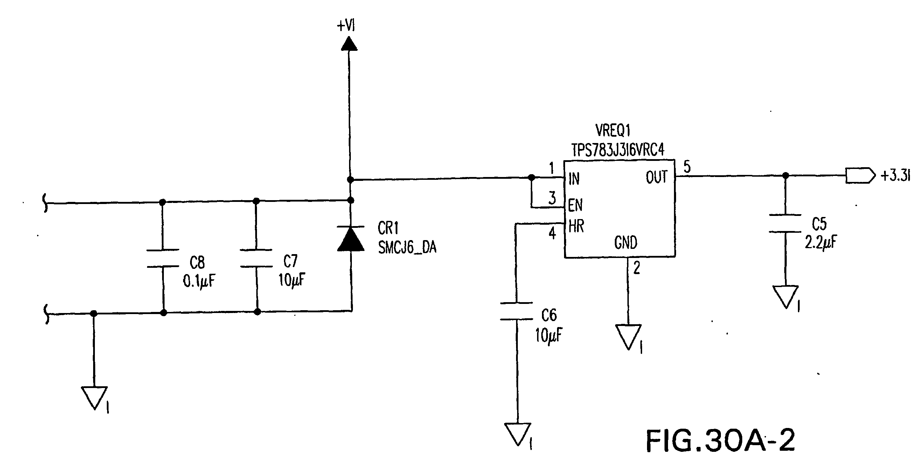

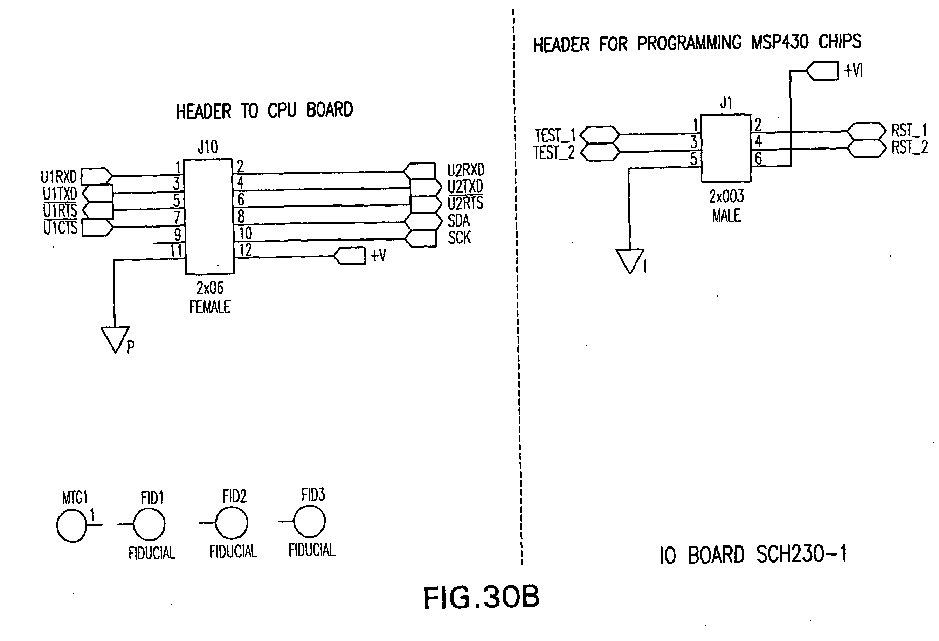

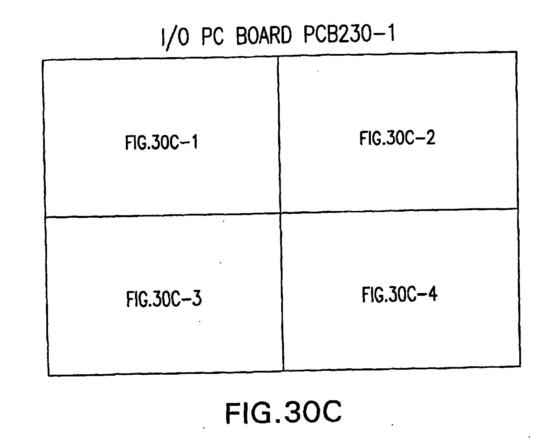

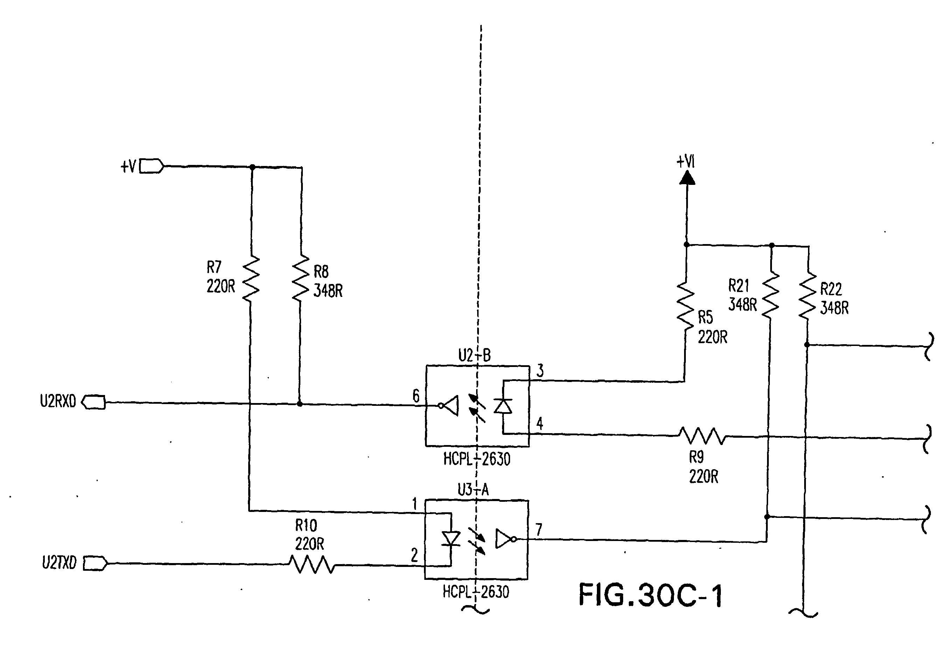

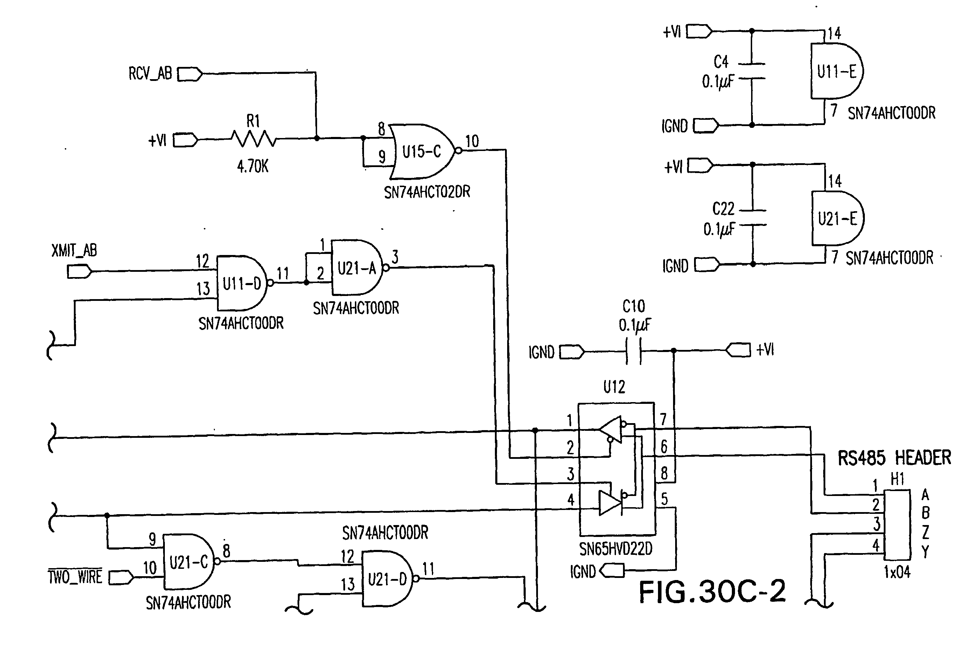

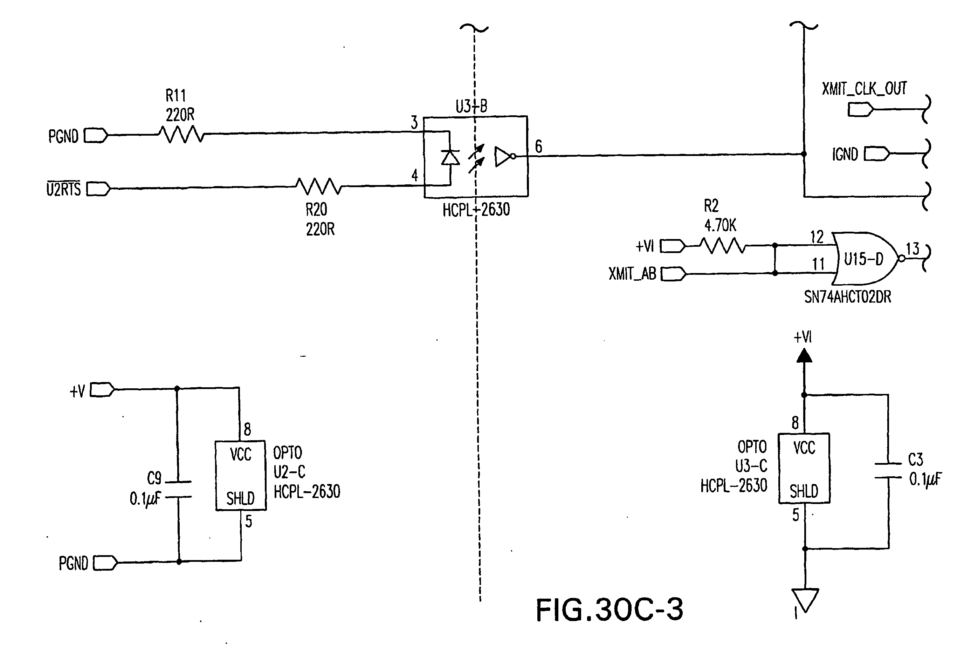

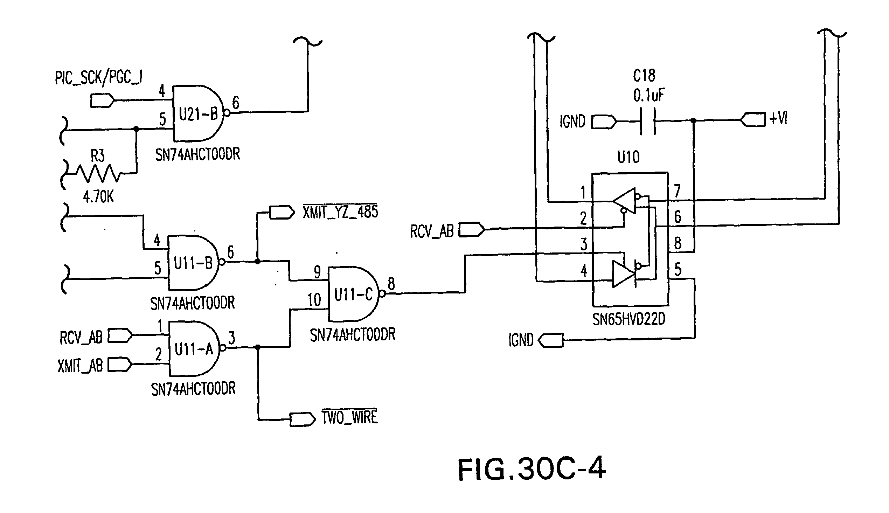

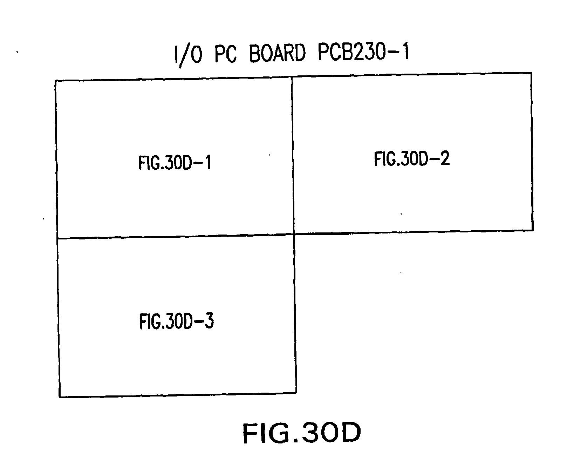

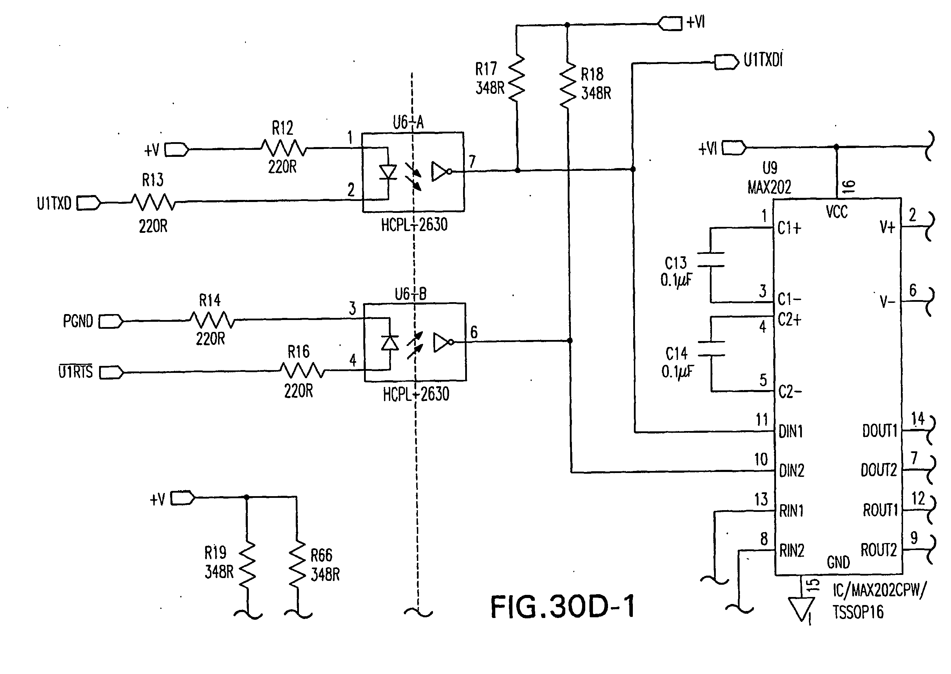

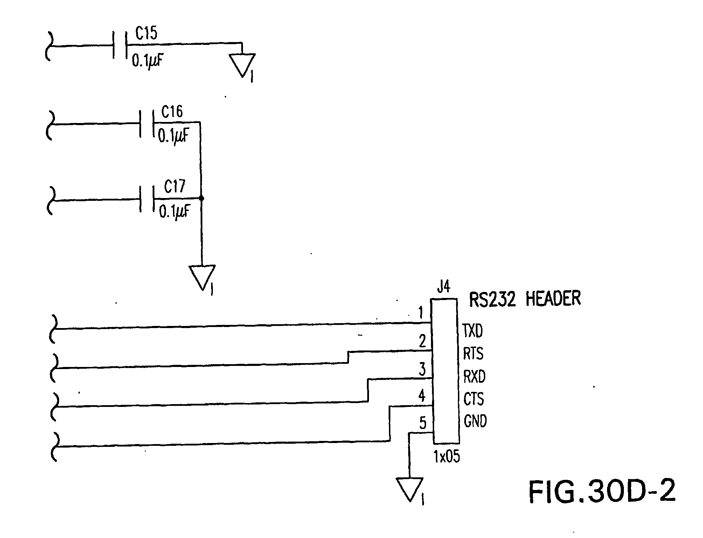

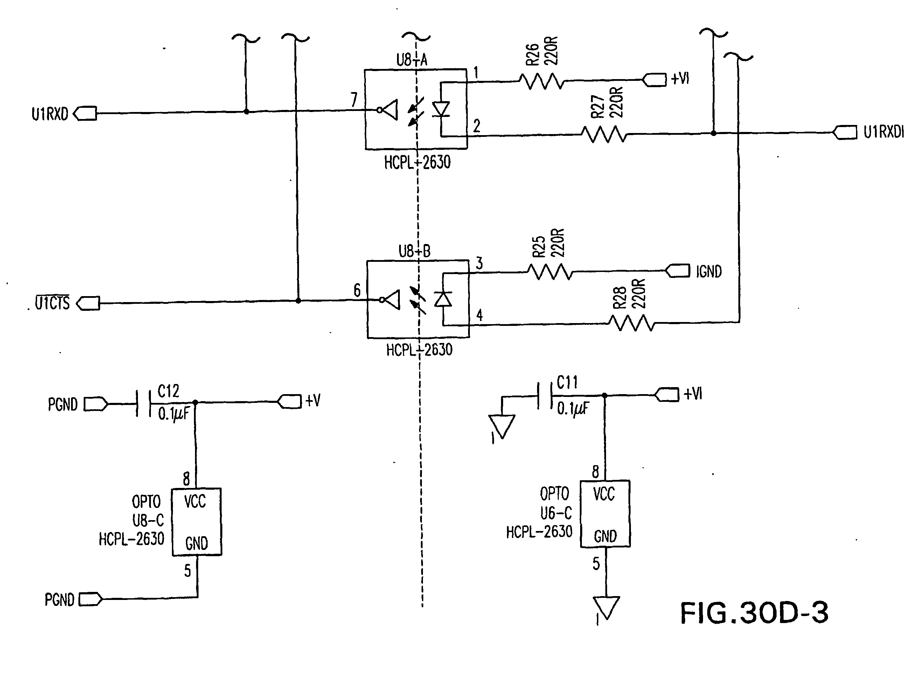

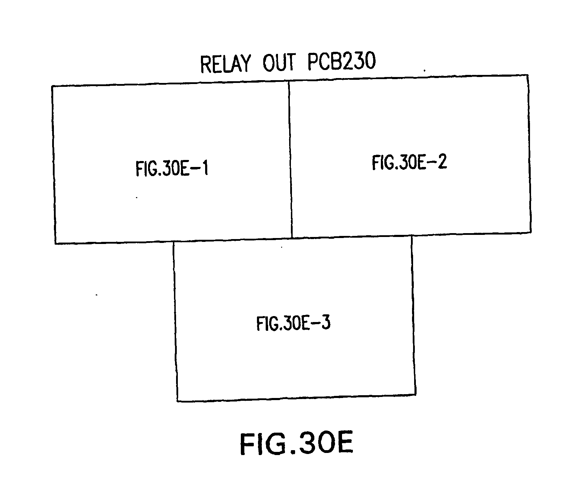

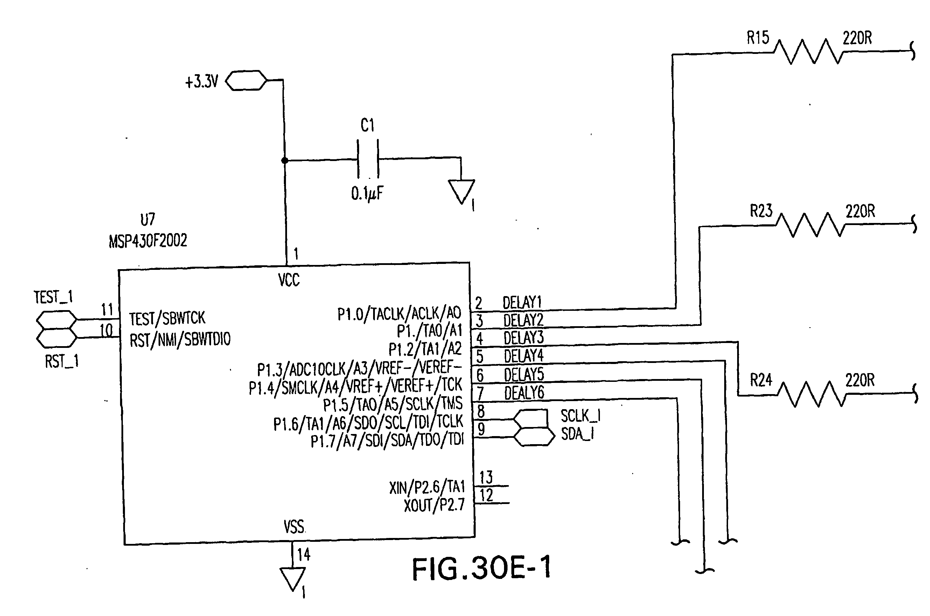

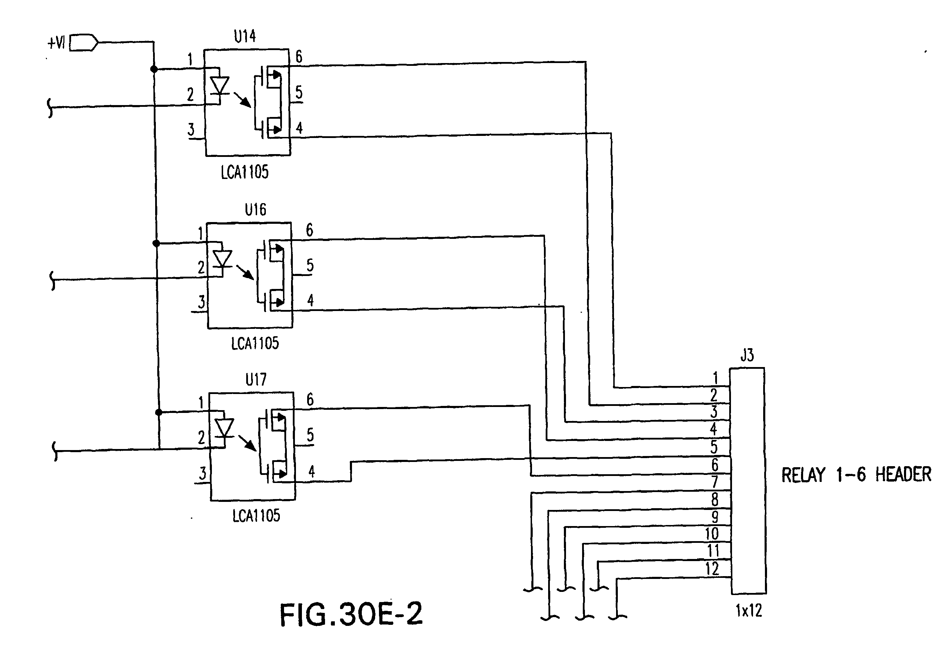

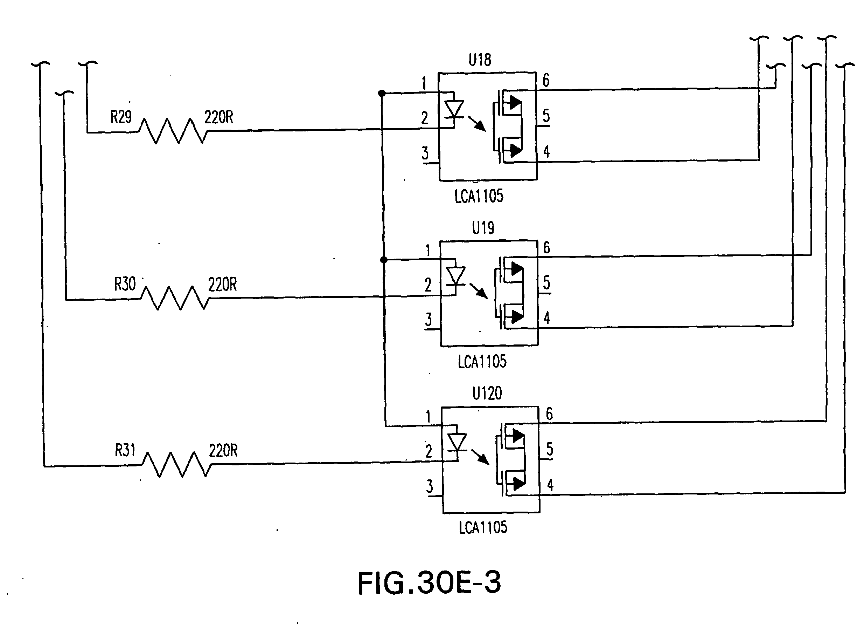

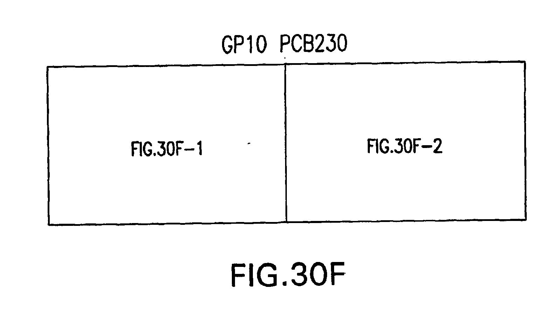

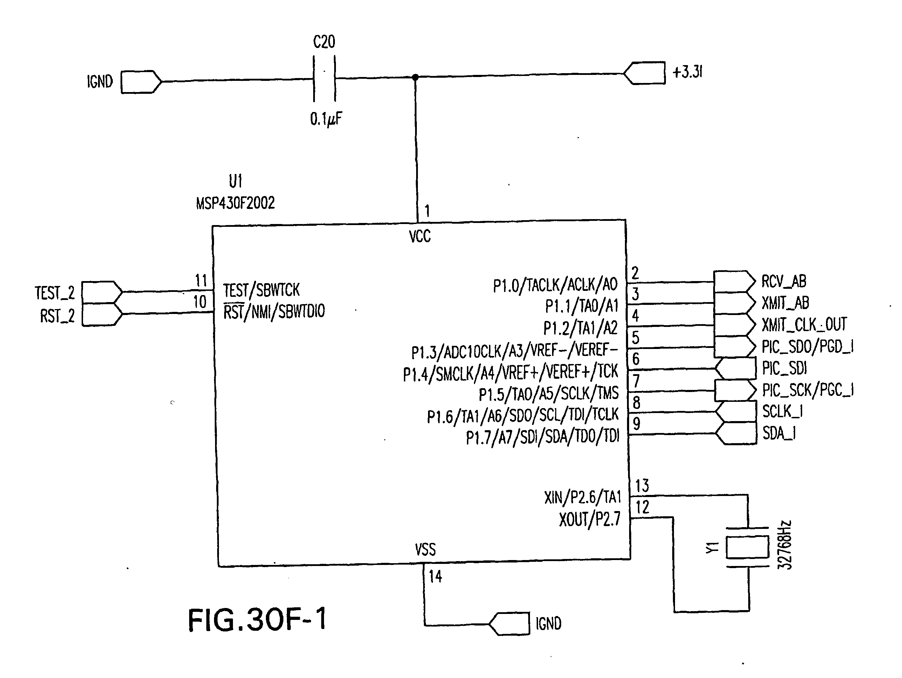

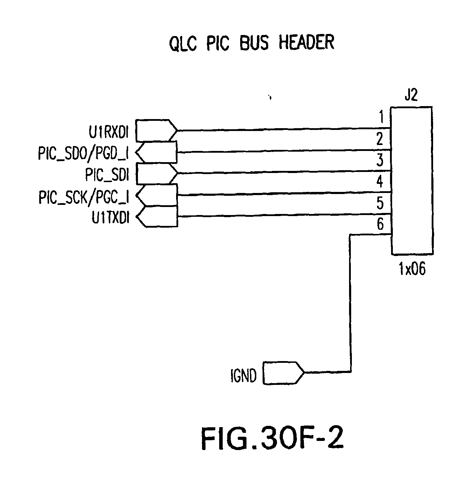

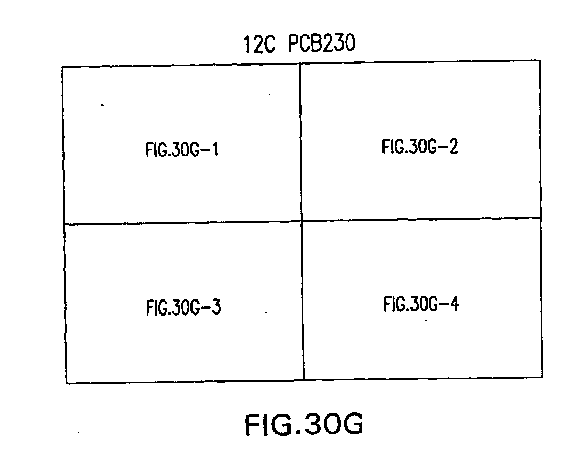

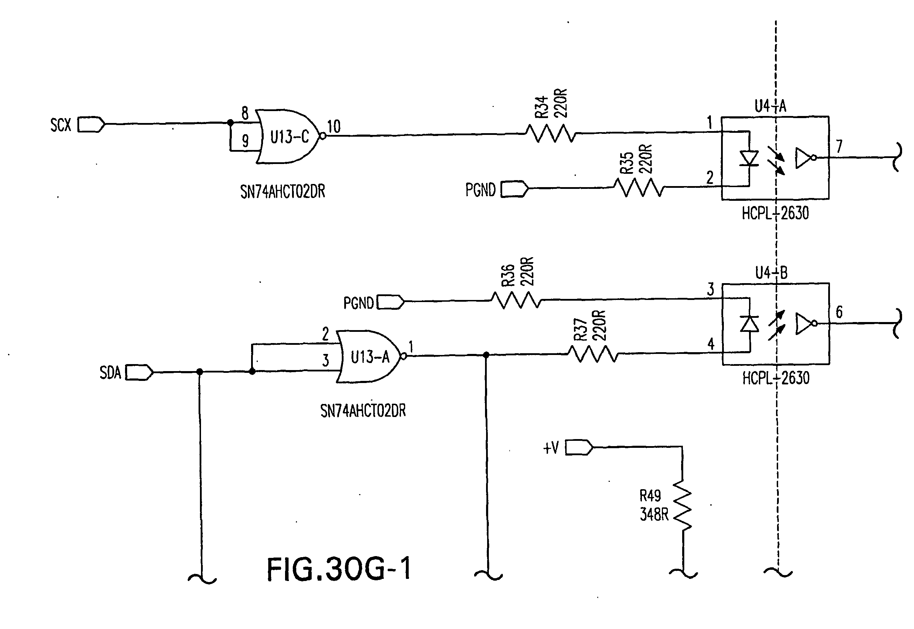

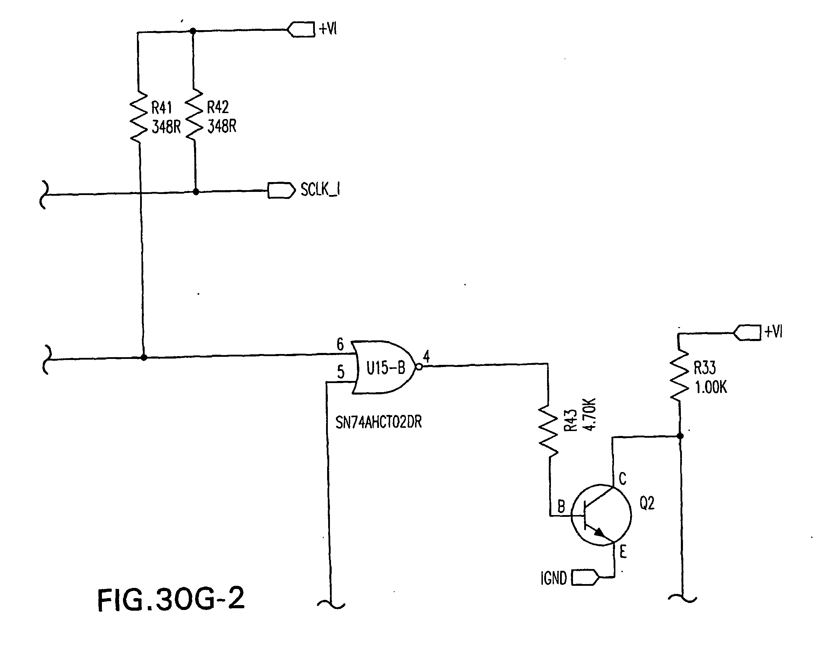

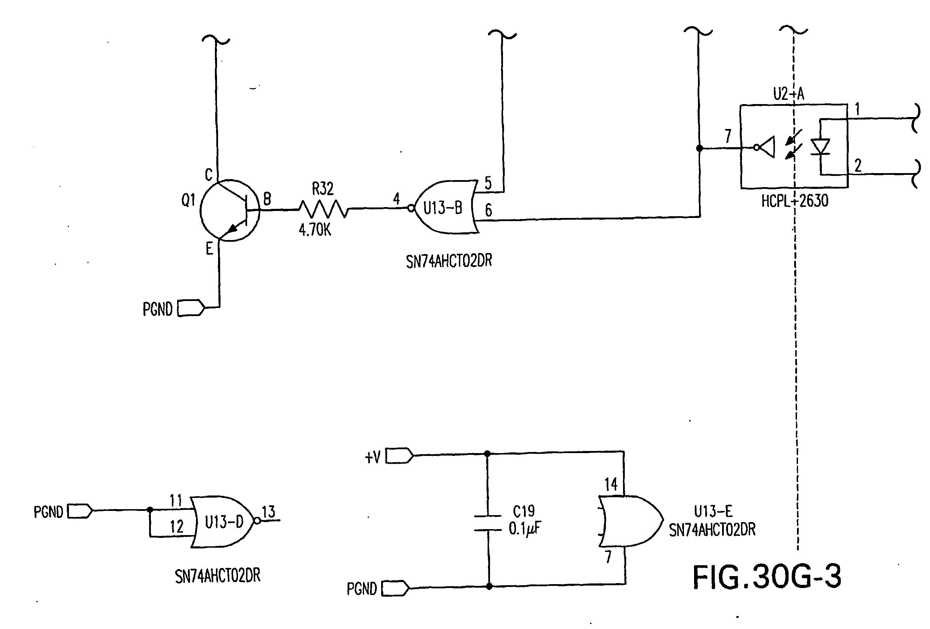

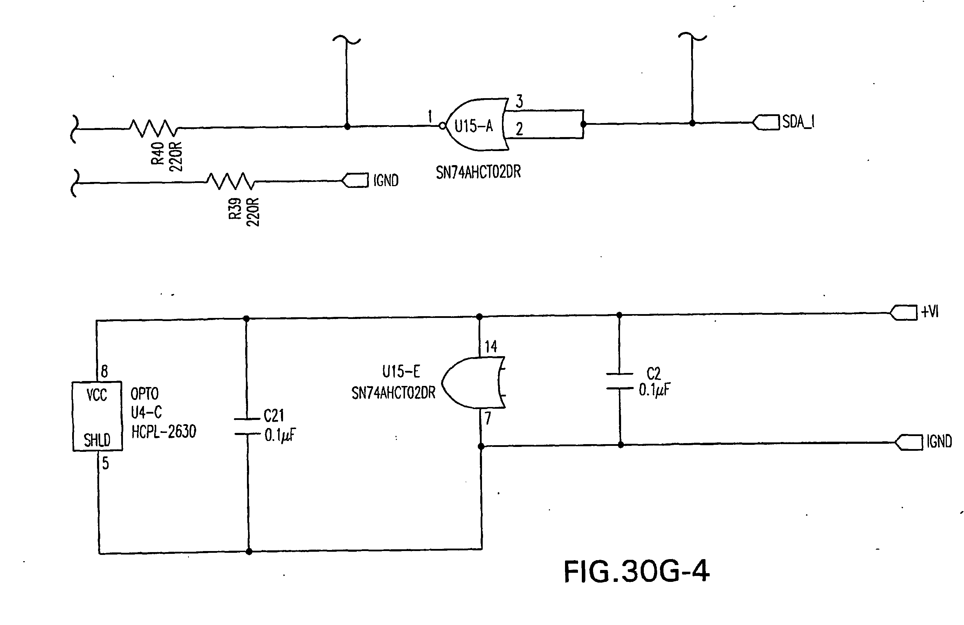

The Control Module 2520 comprises a Power Board (PCB 210; see FIG. 29 for schematic) is the power supply board that also has the PLC transmit and receive circuitry on it. The Power Board provides power to the CPU board and the electronics of 203 boards. The Control Module 2520 also comprises an I/O Extension Board (PCB 230; see FIG. 30 for schematic) is a board with several I/O extension options that enable communication from Metering Modules to the CPU board.

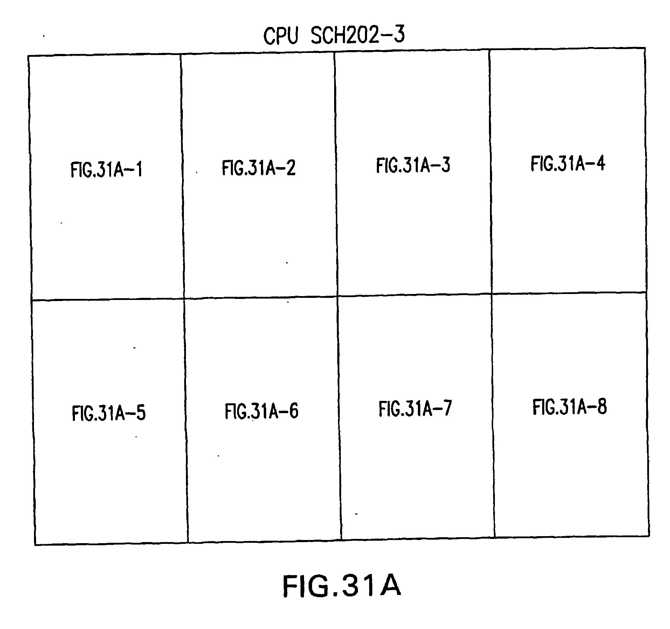

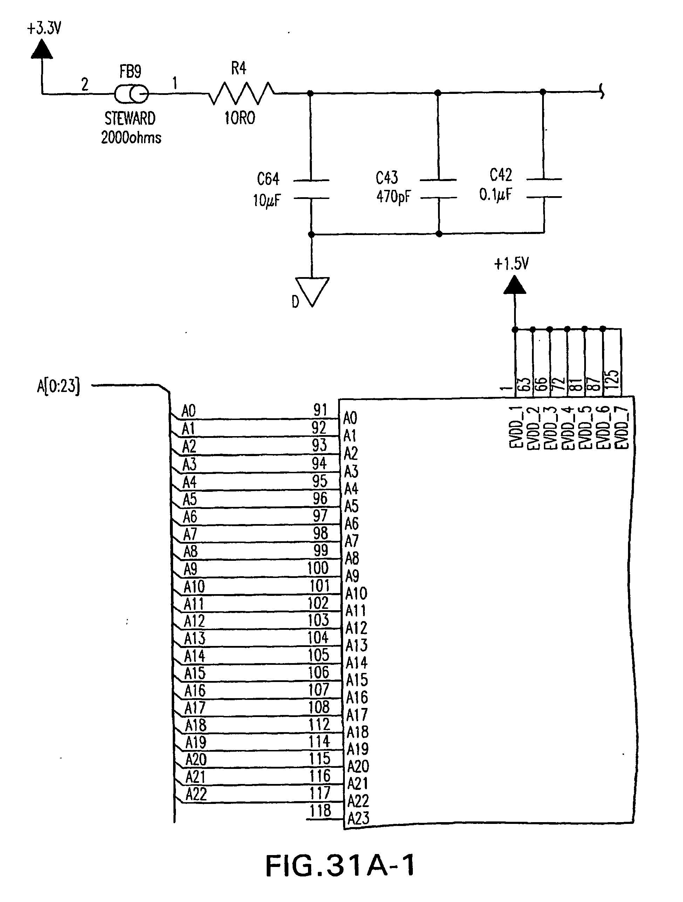

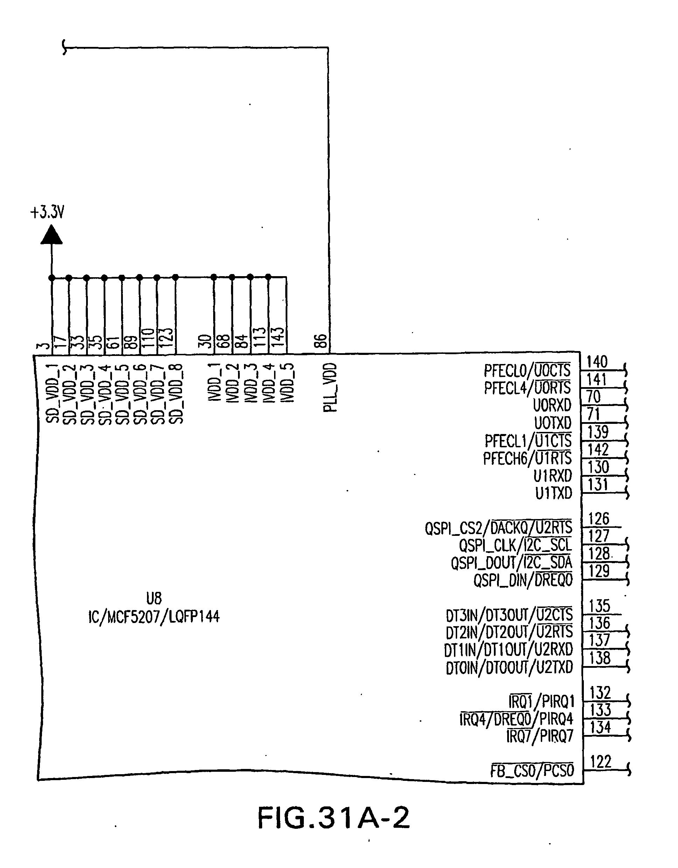

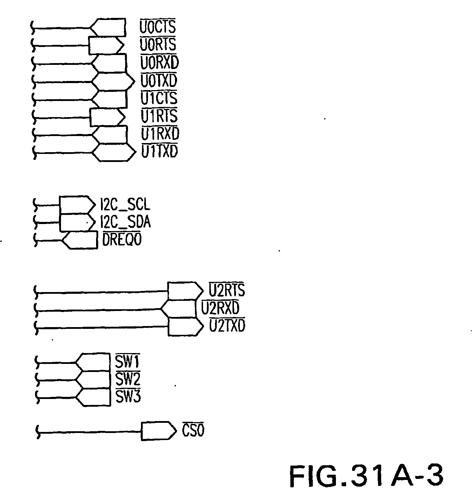

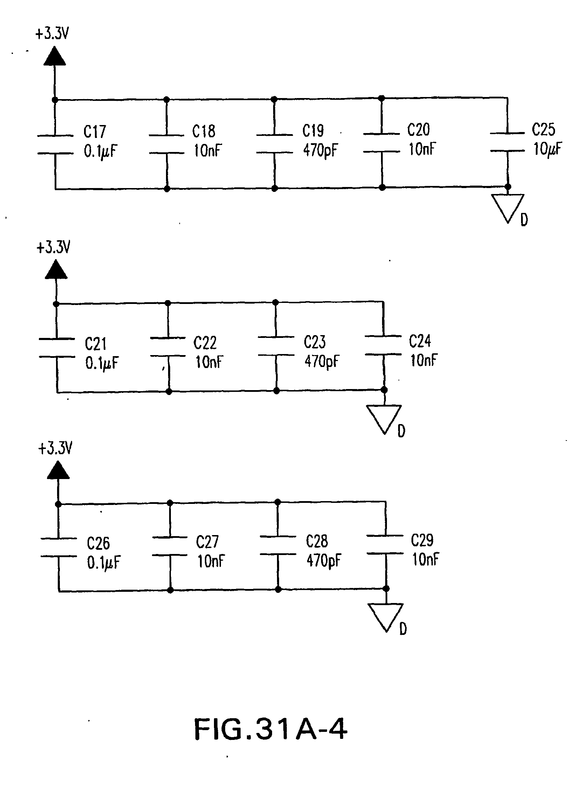

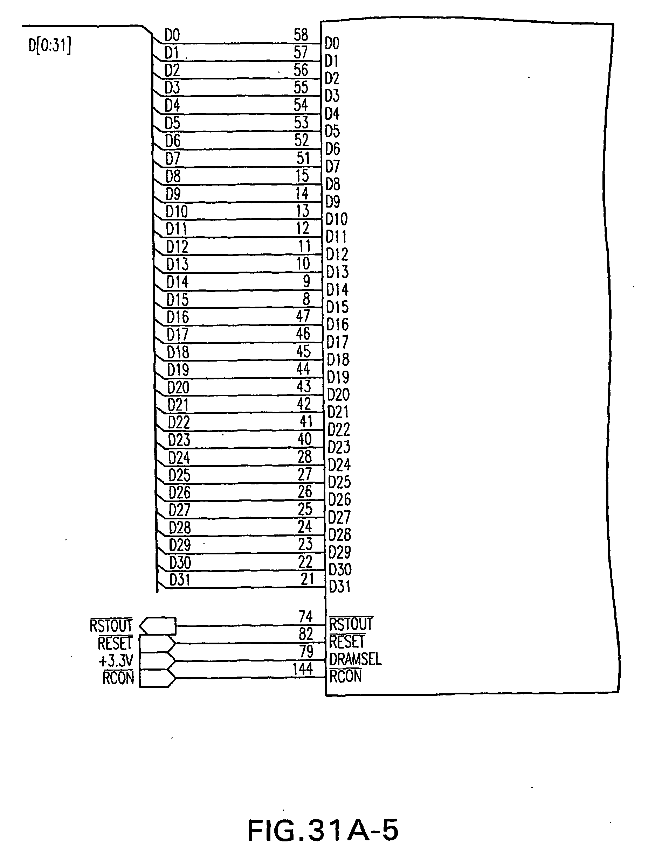

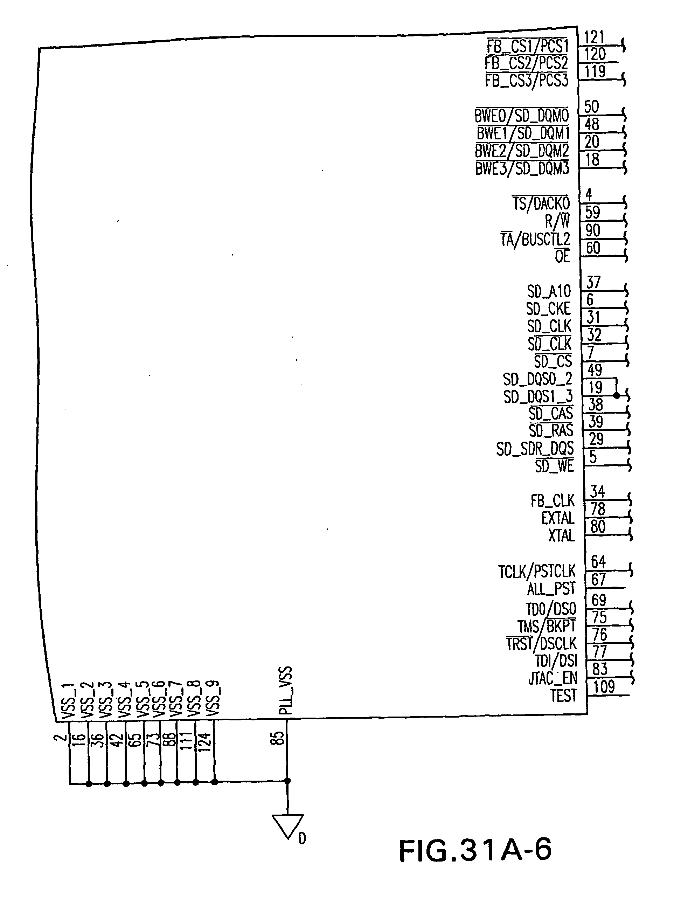

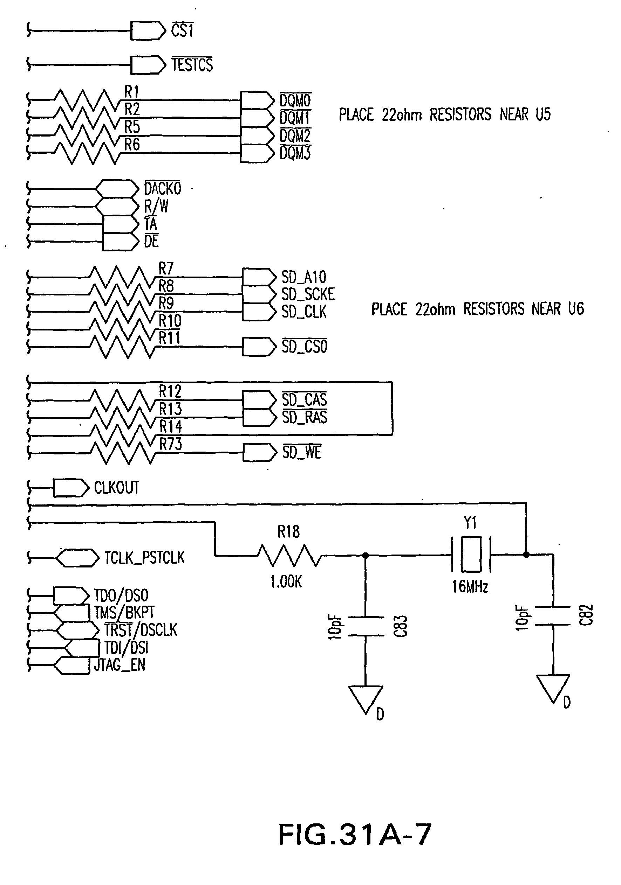

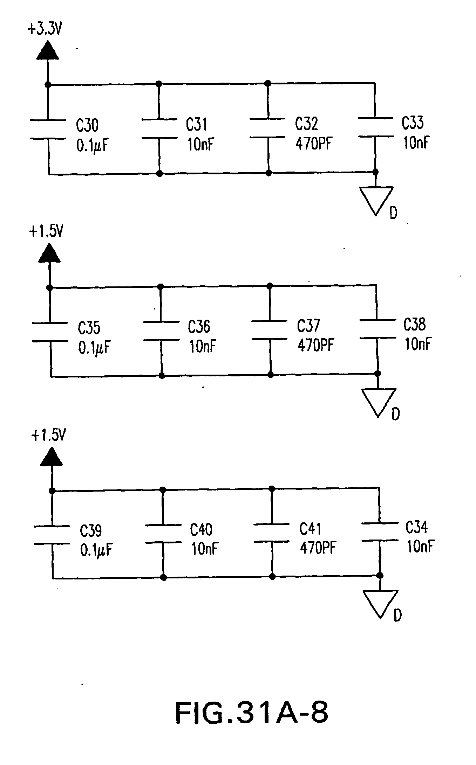

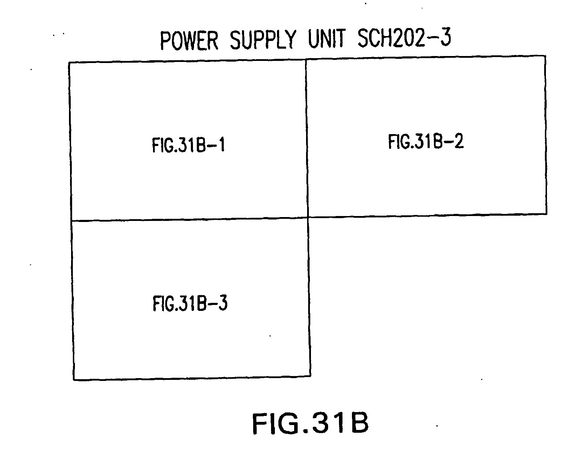

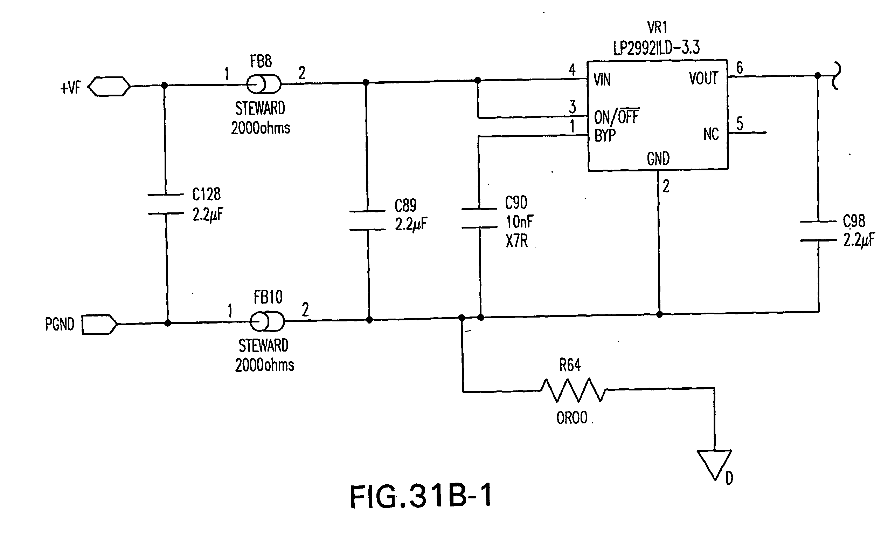

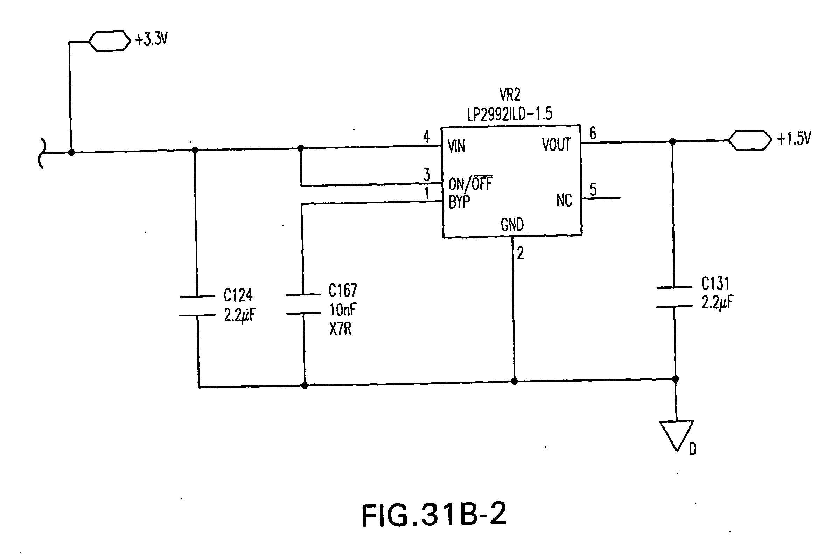

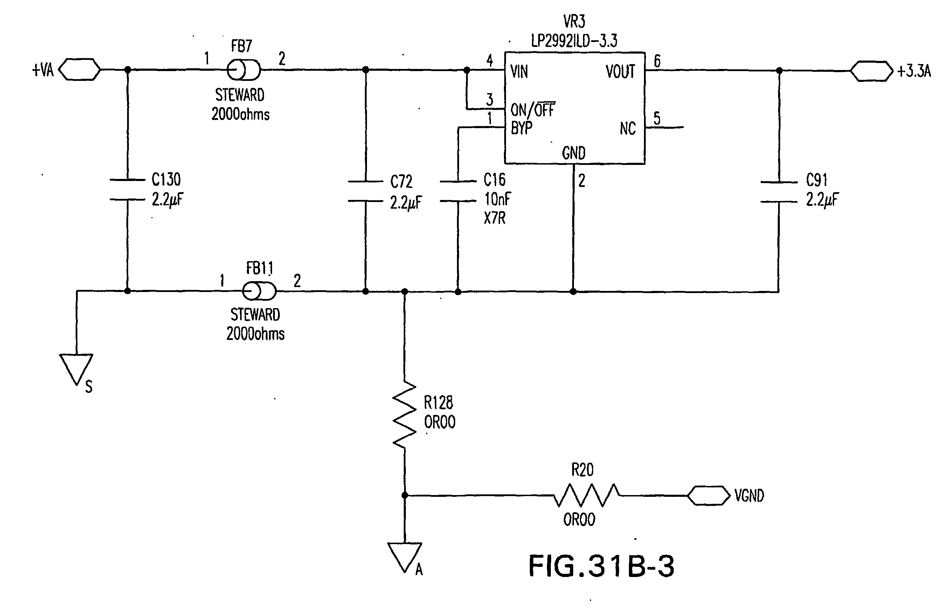

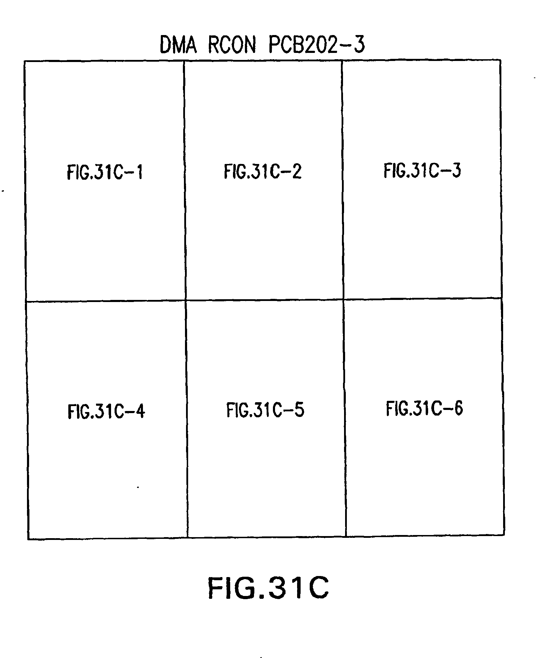

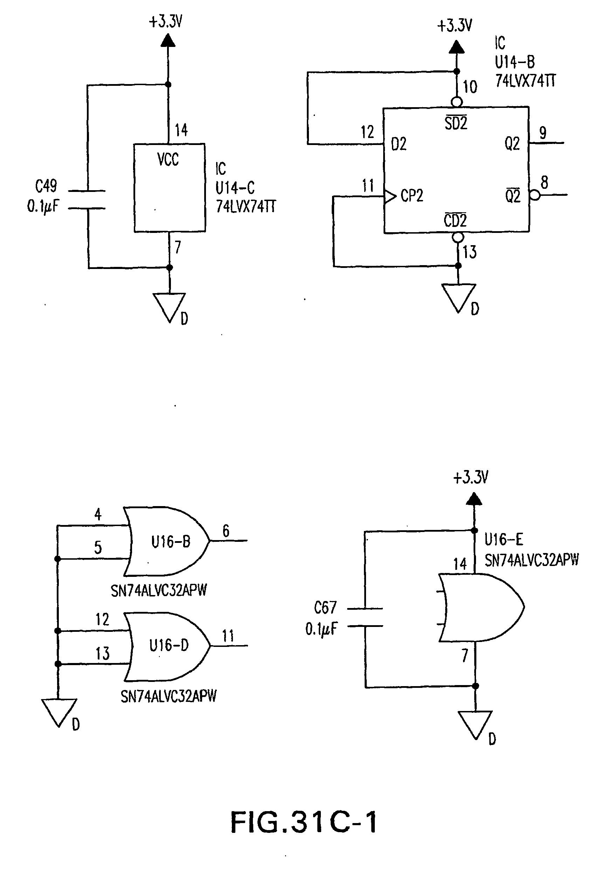

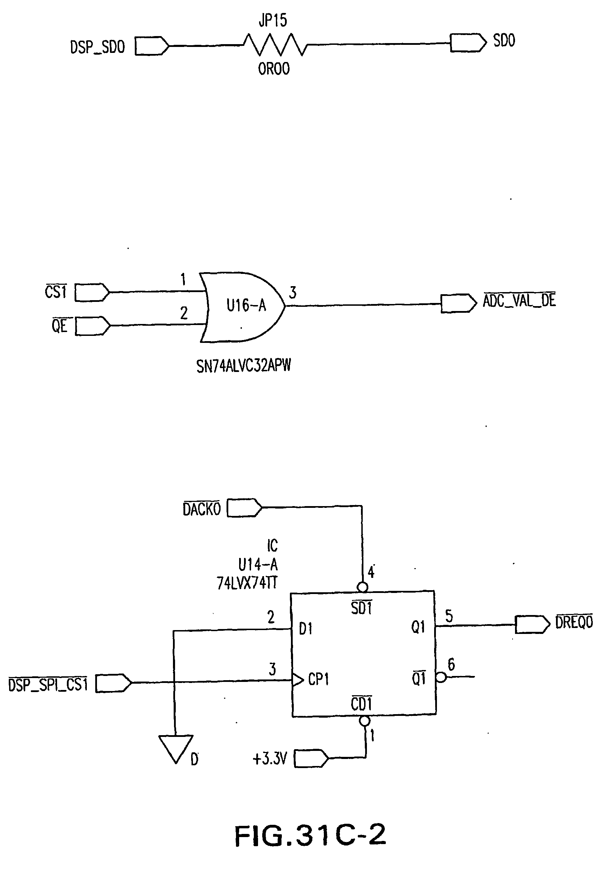

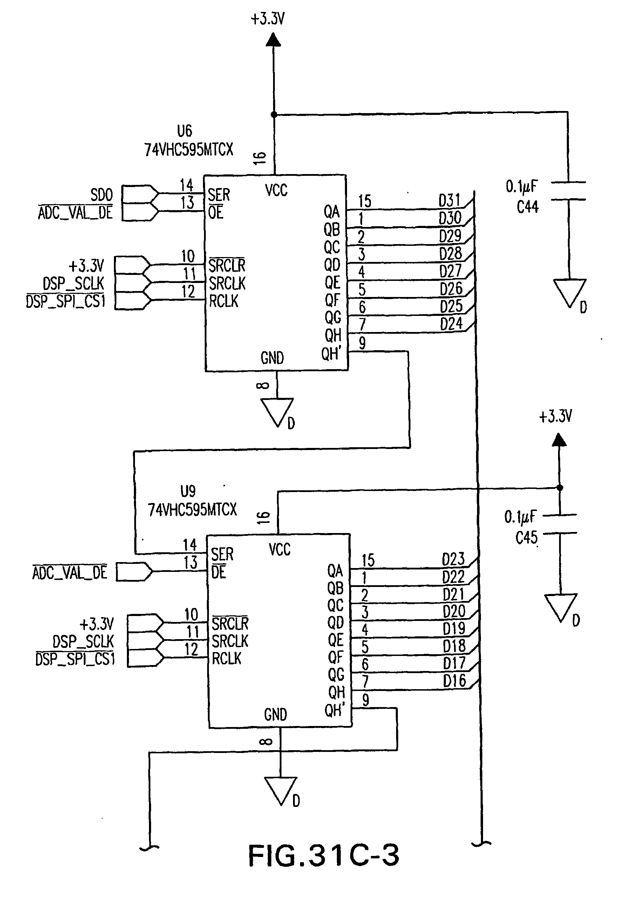

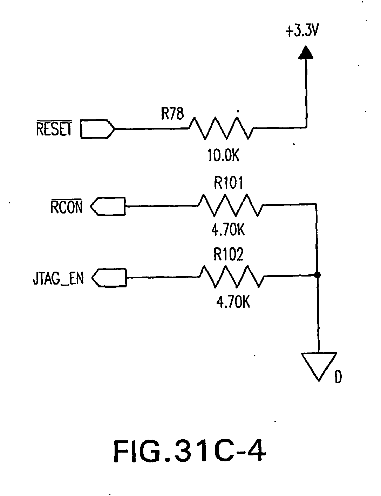

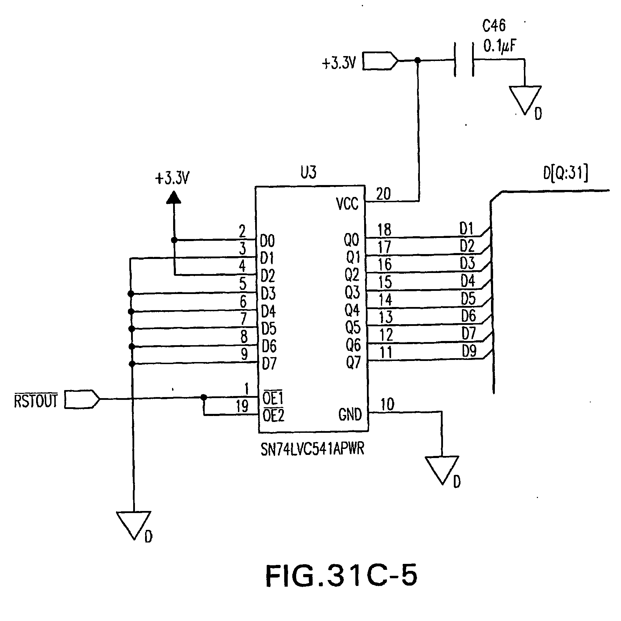

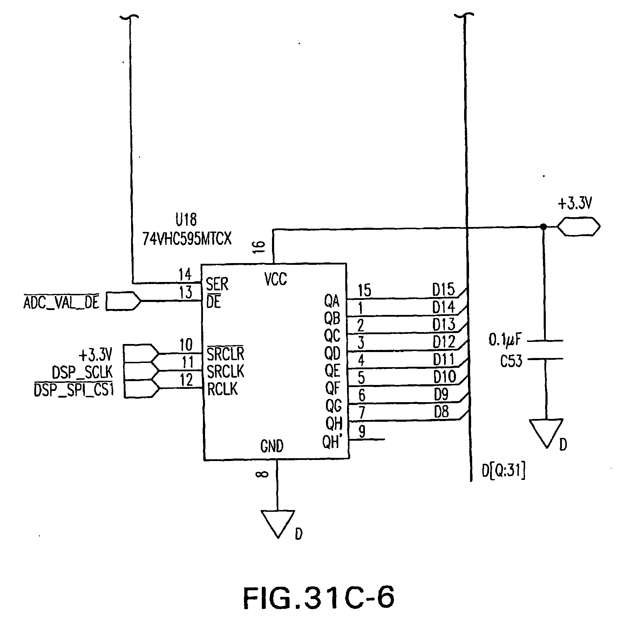

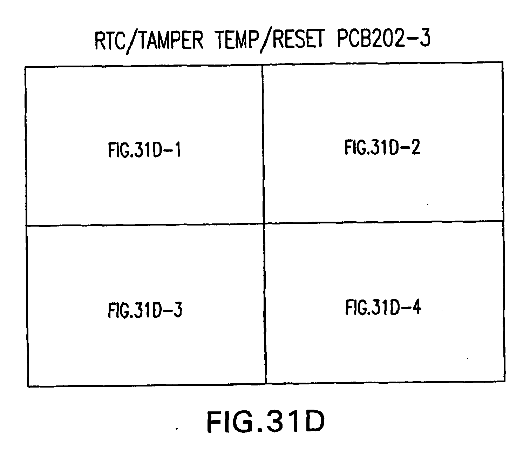

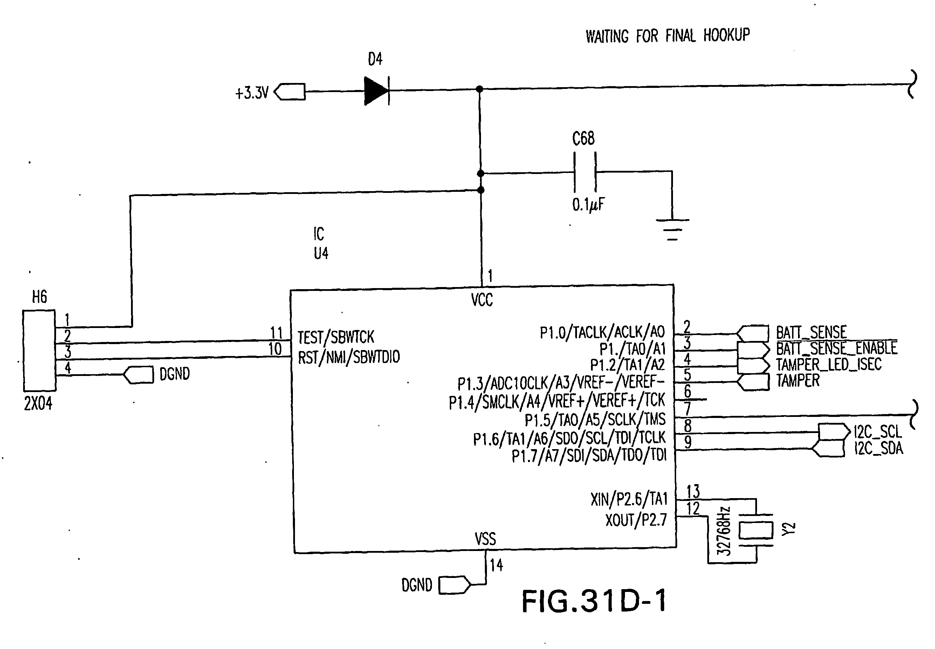

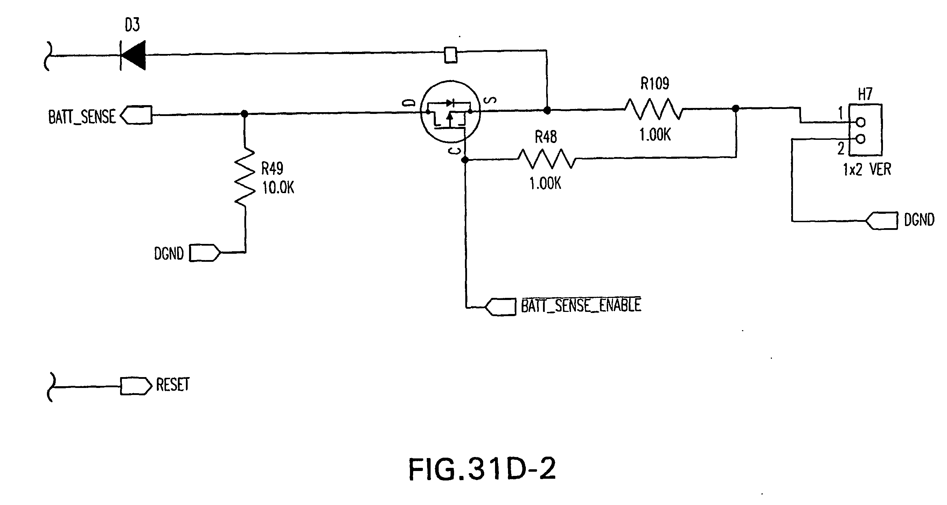

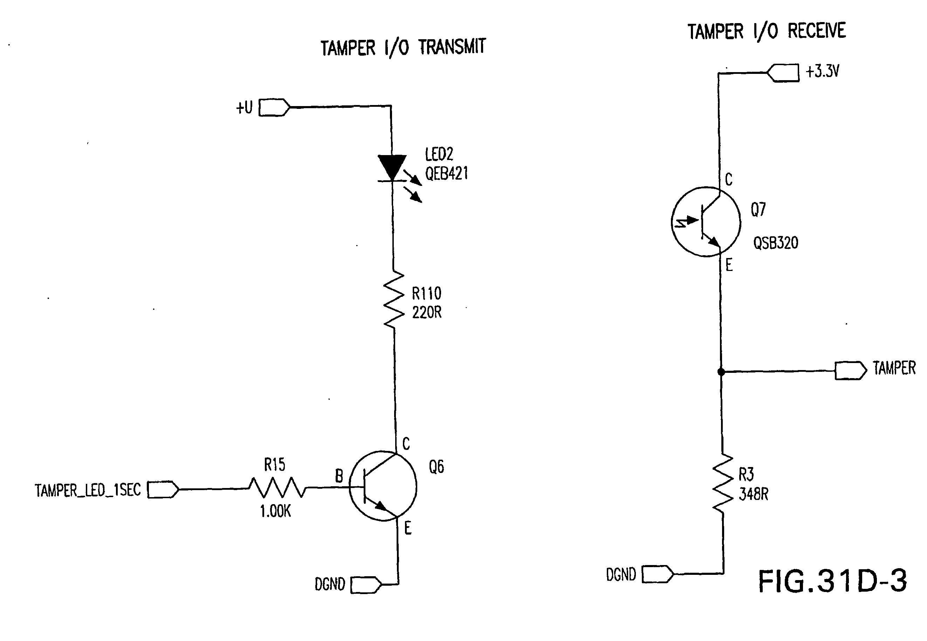

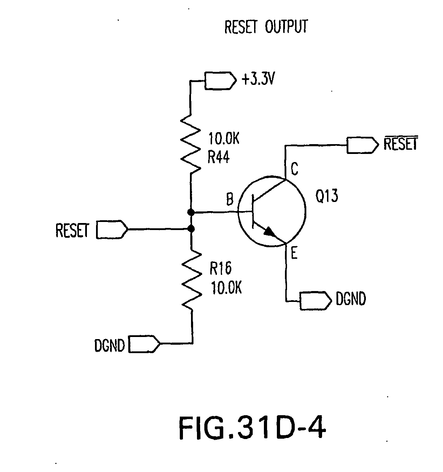

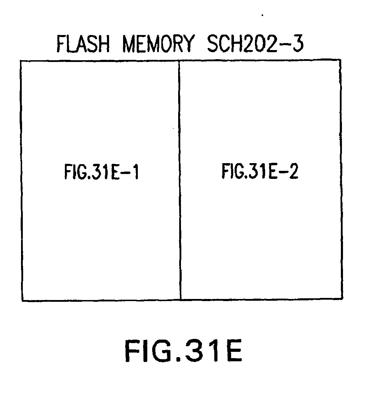

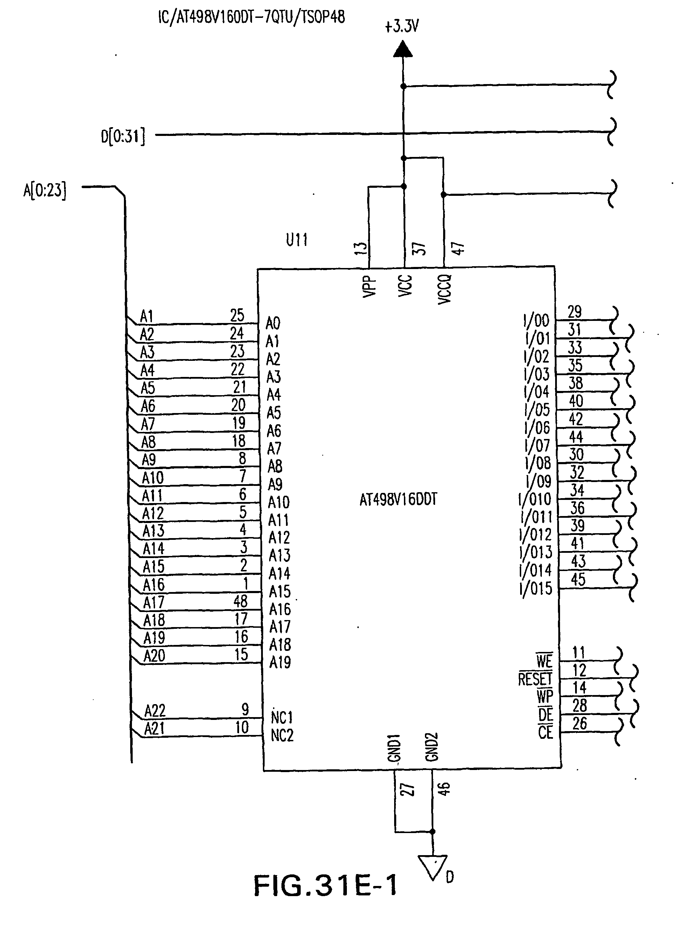

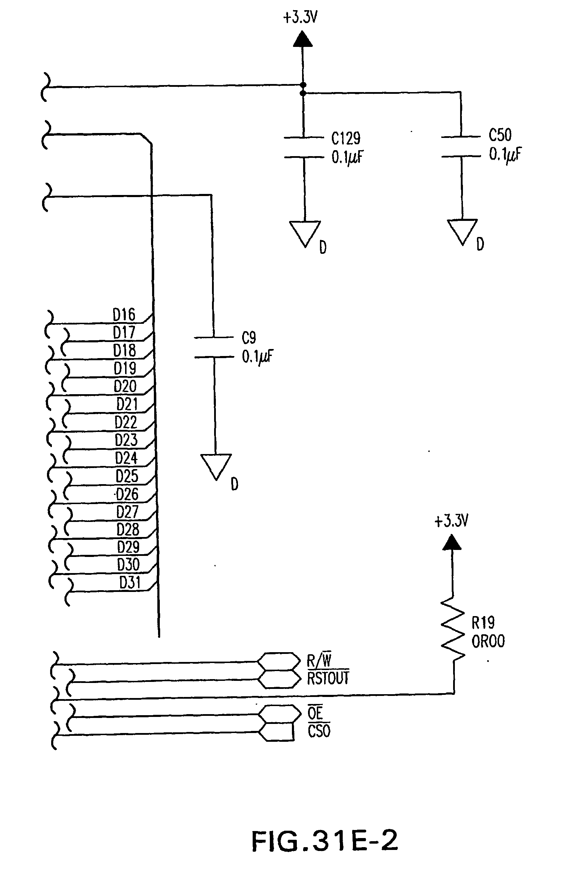

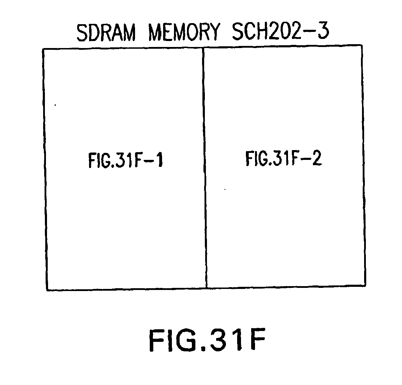

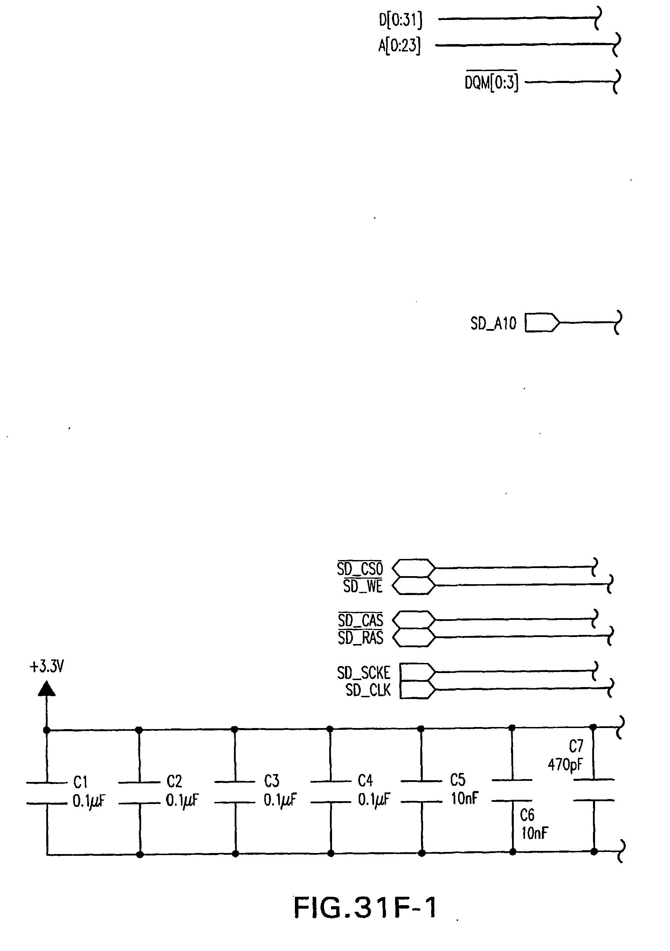

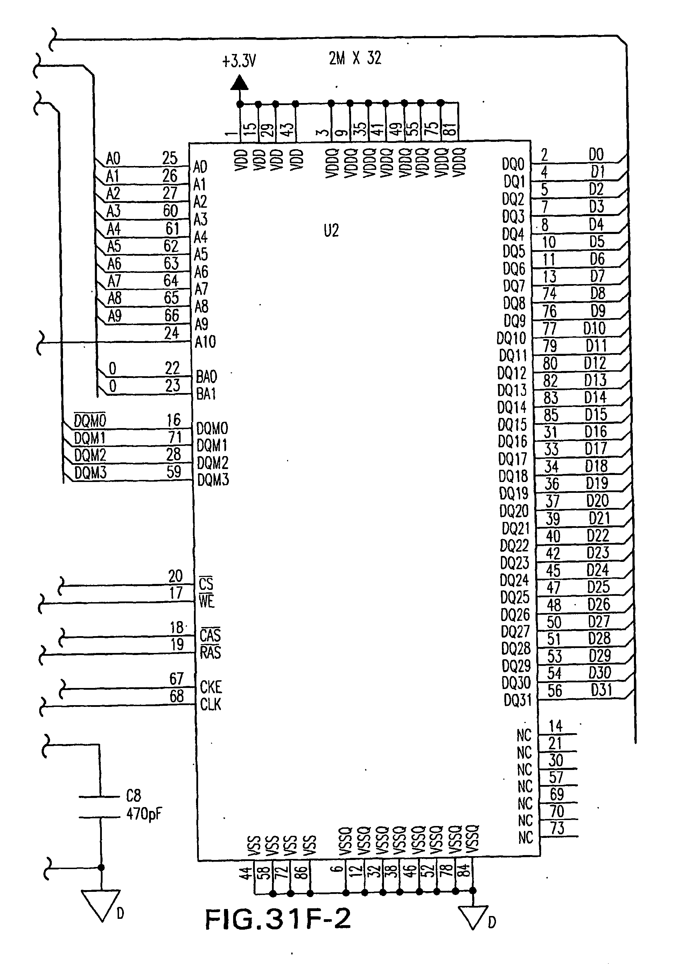

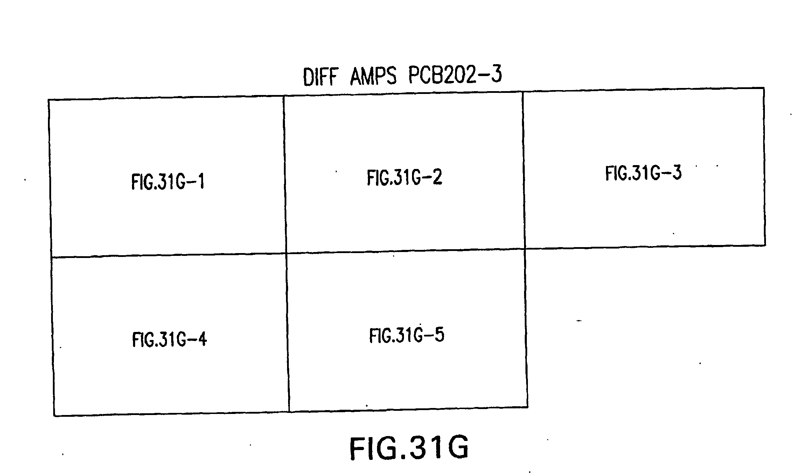

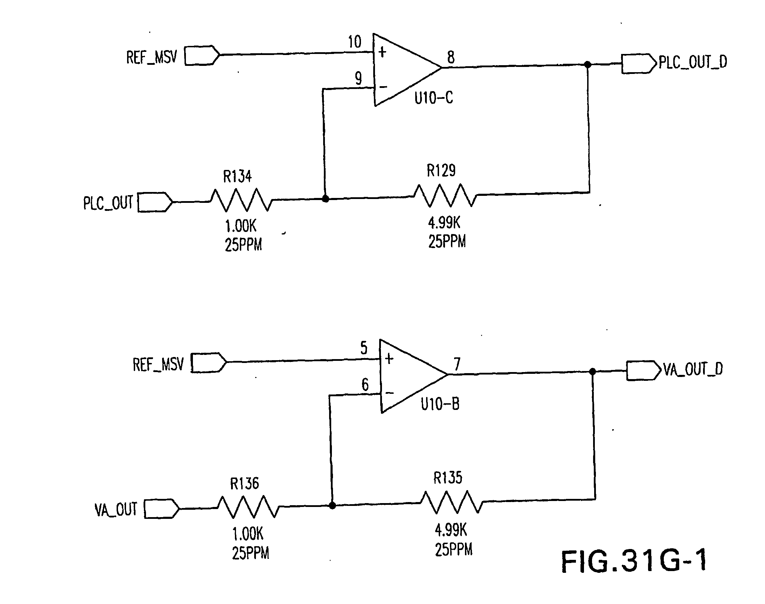

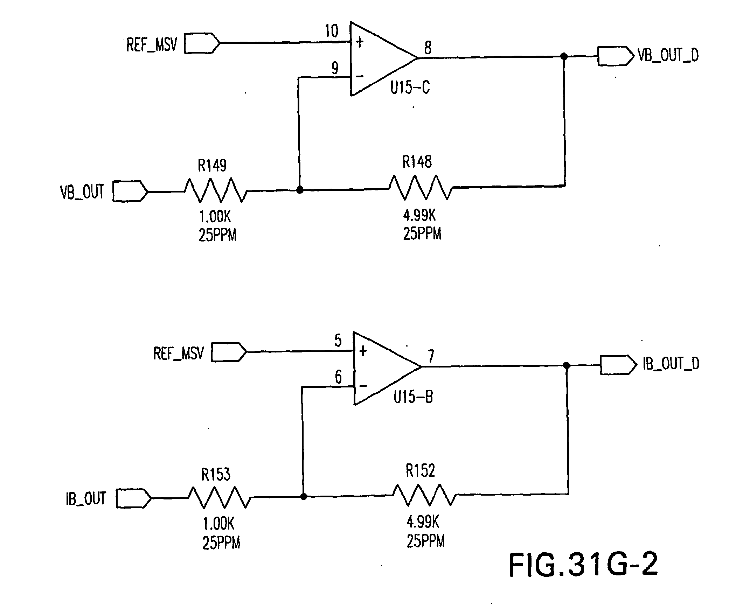

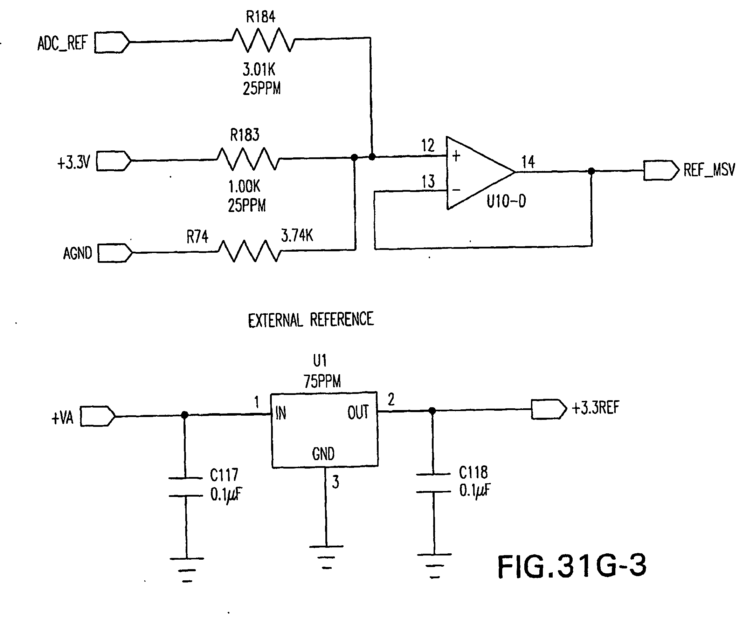

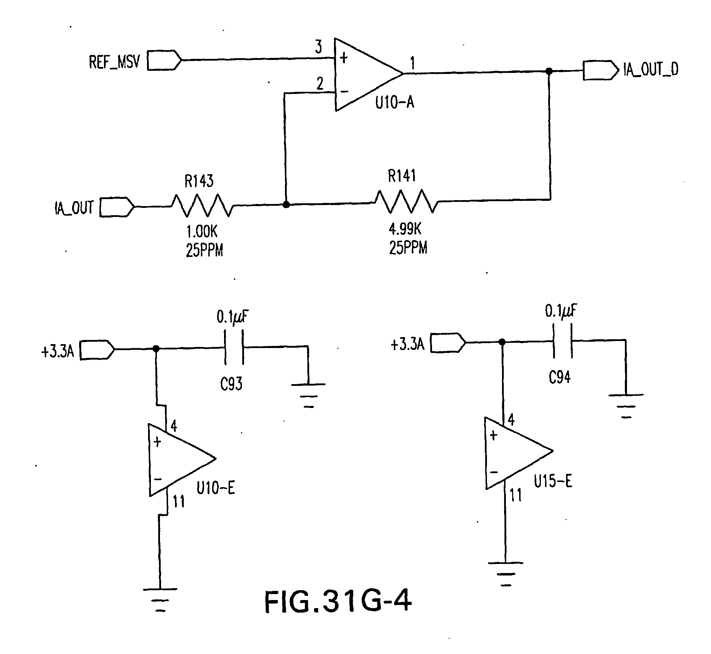

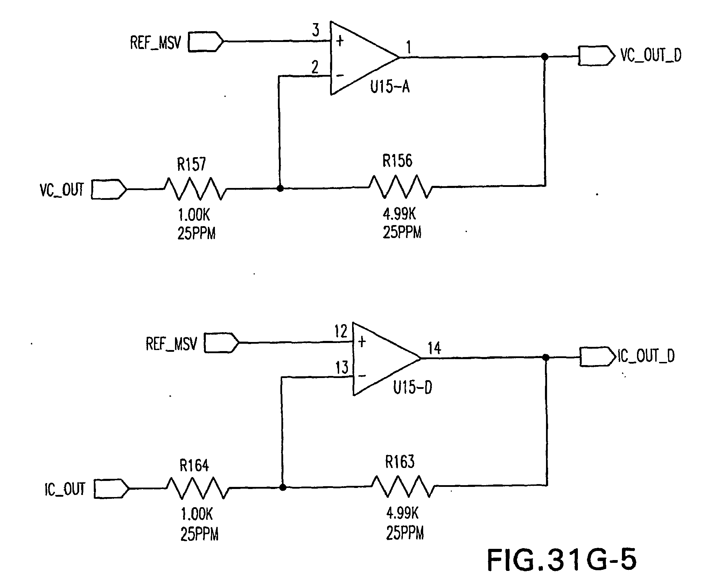

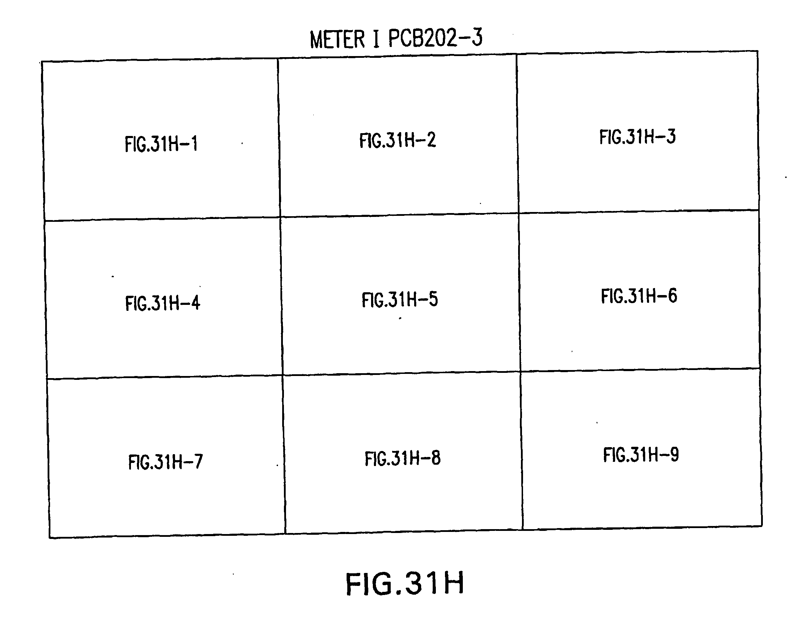

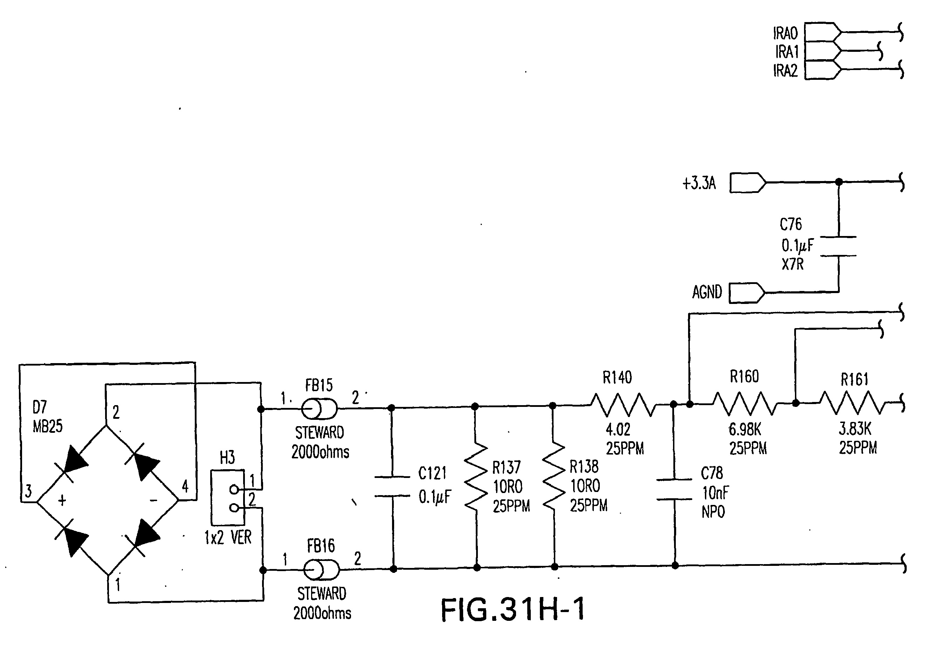

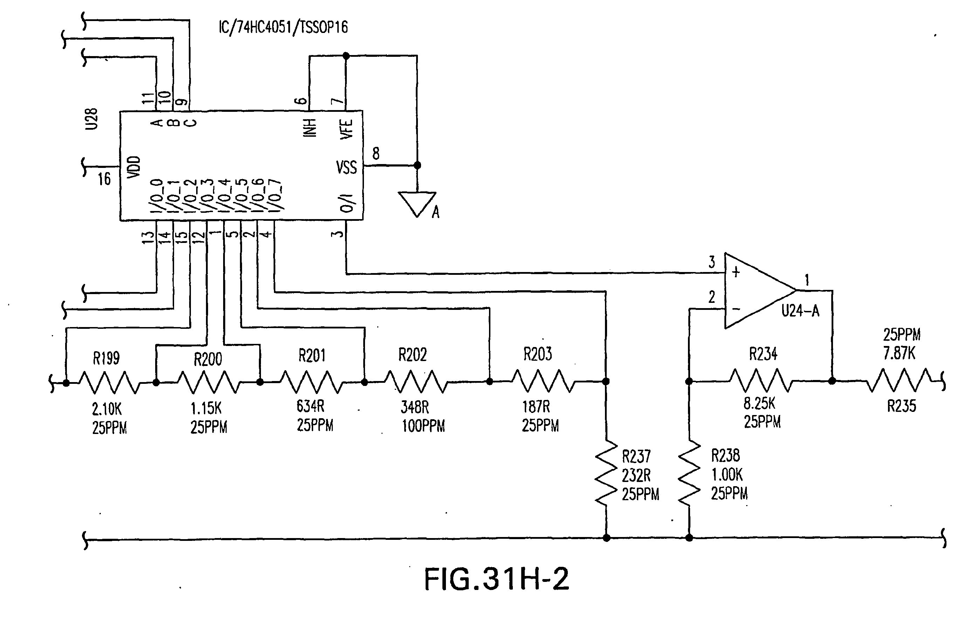

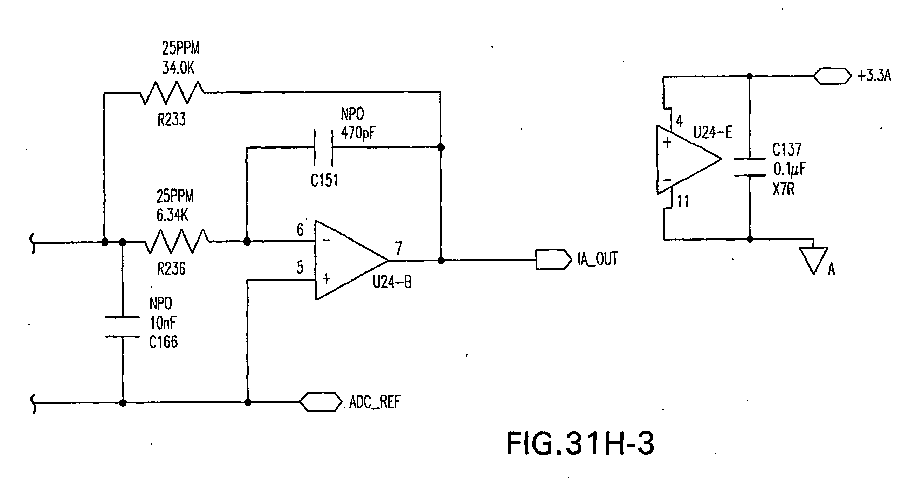

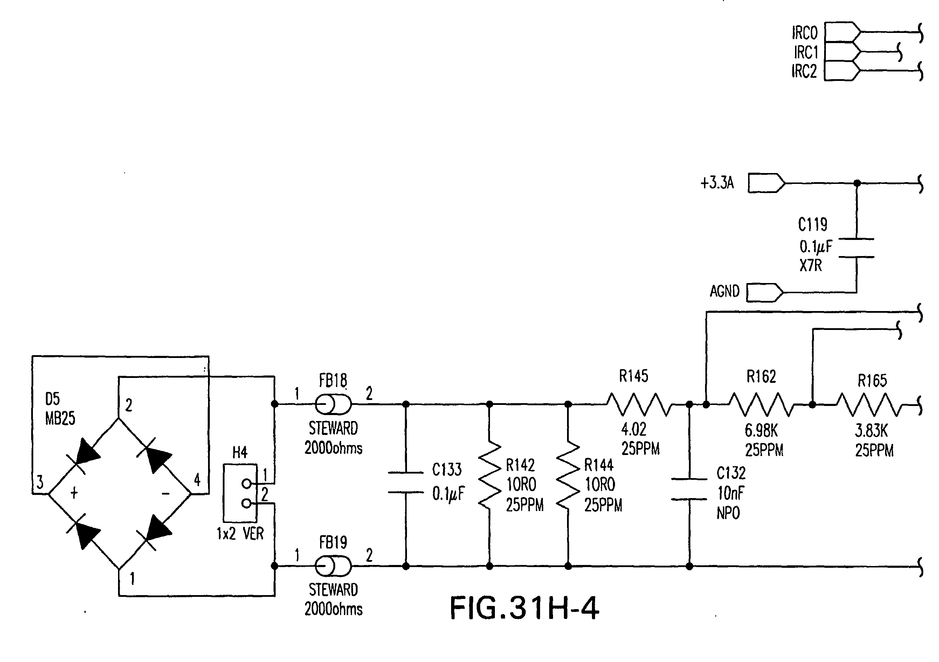

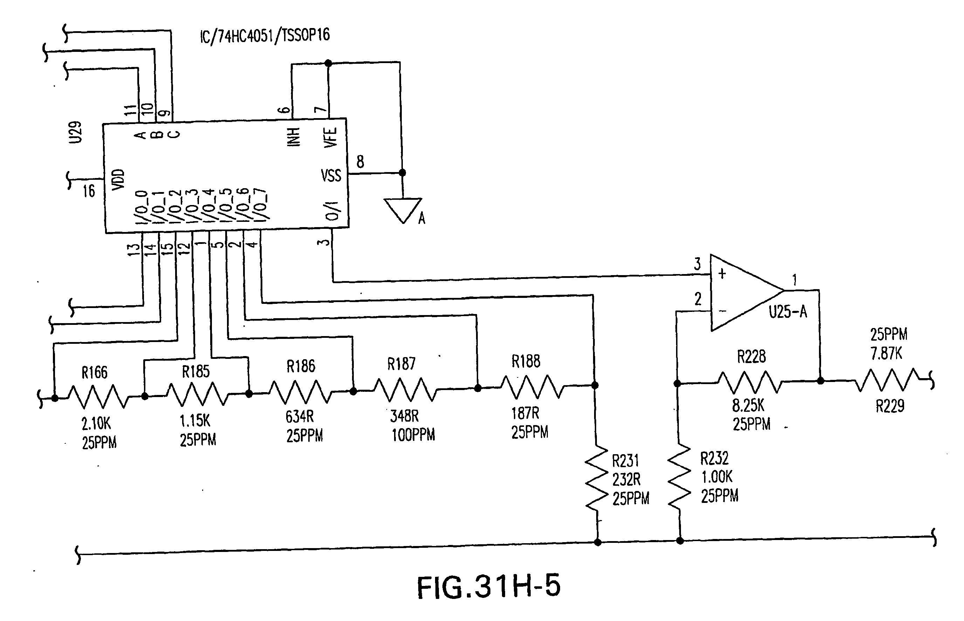

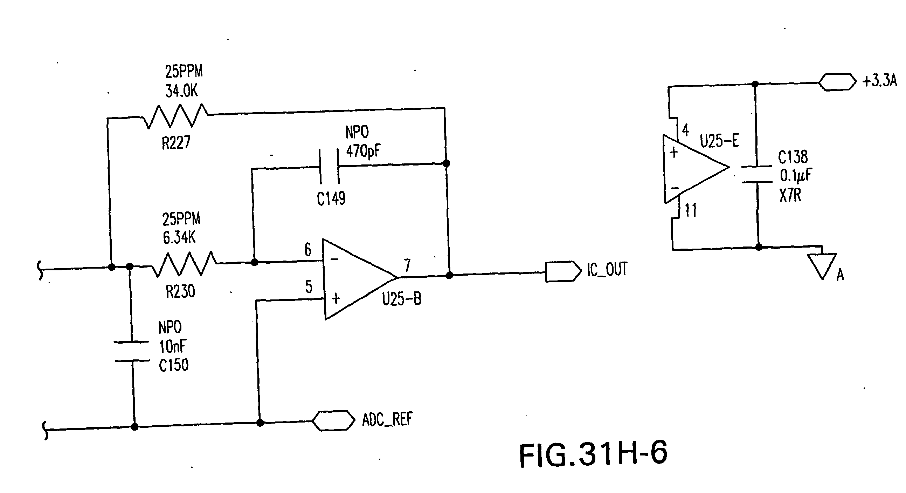

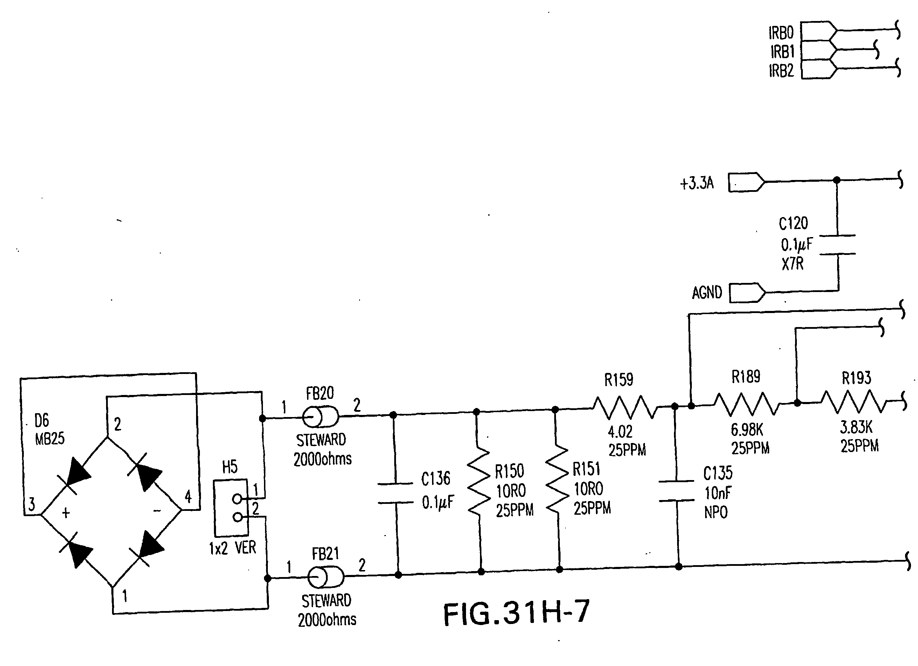

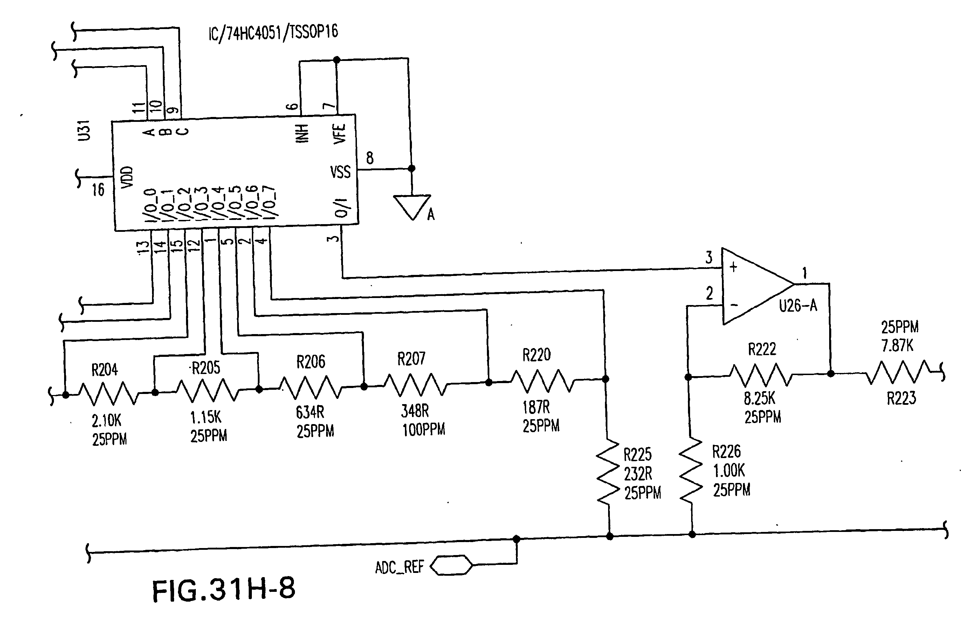

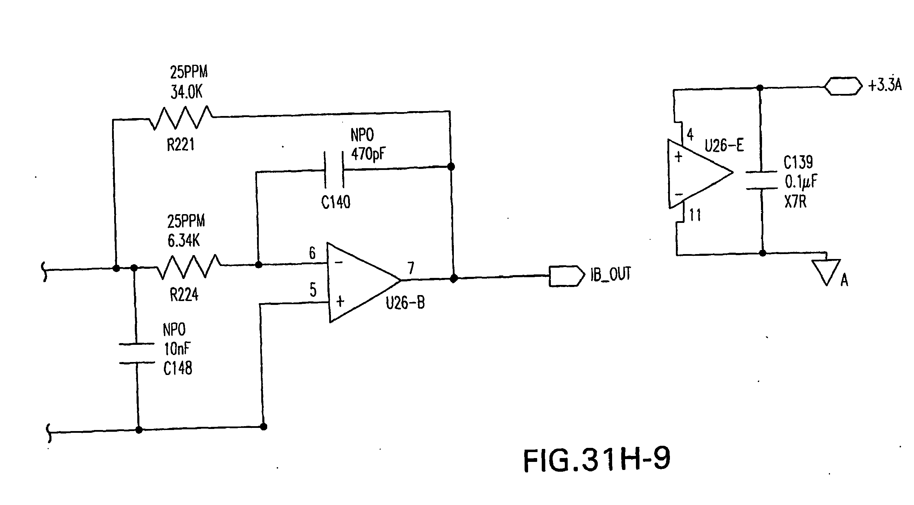

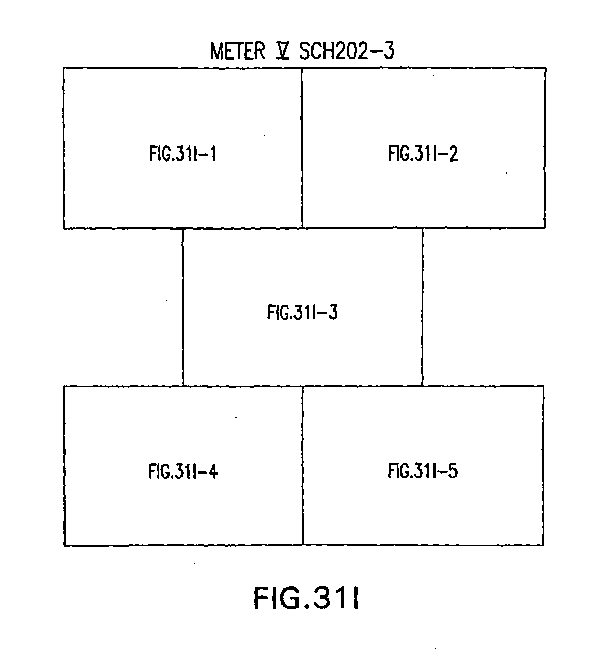

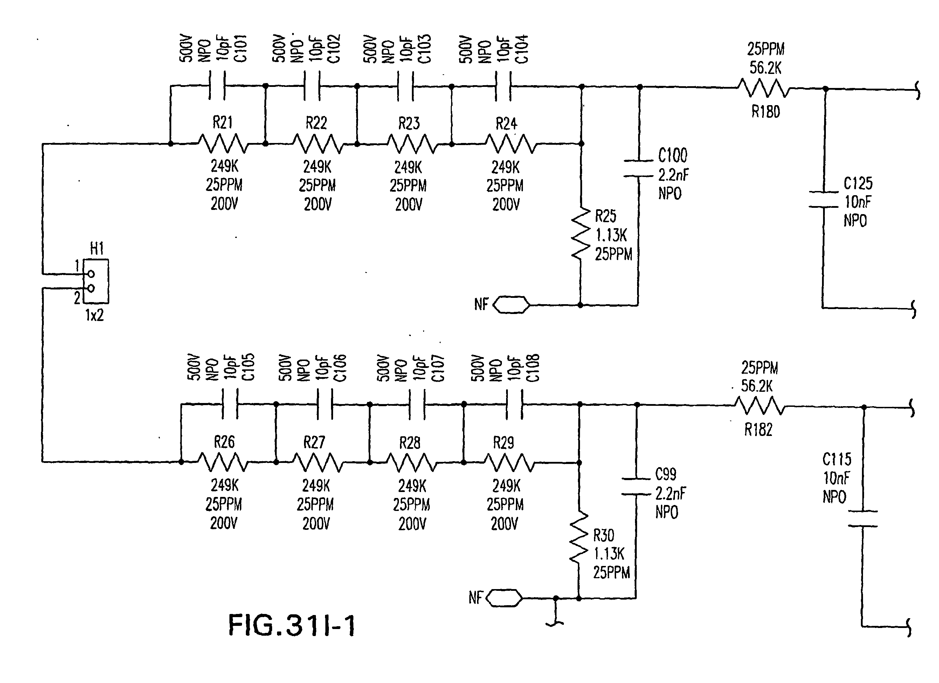

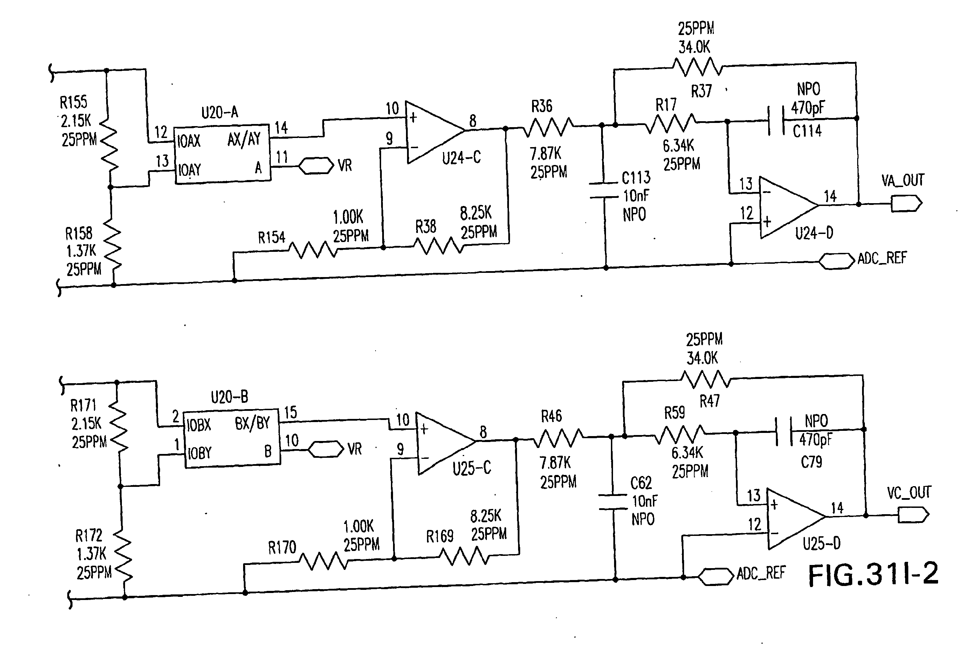

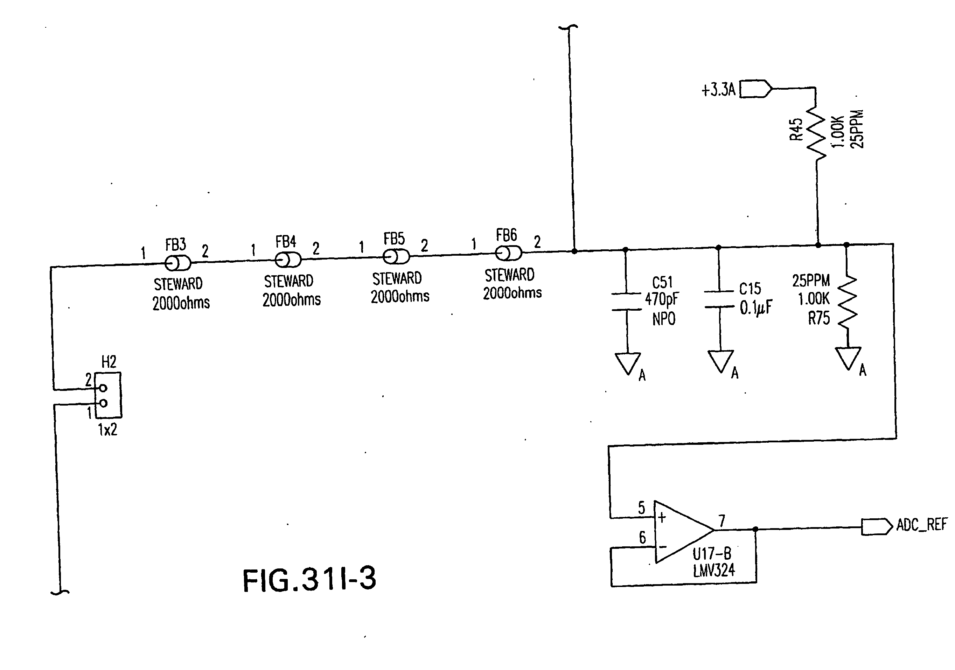

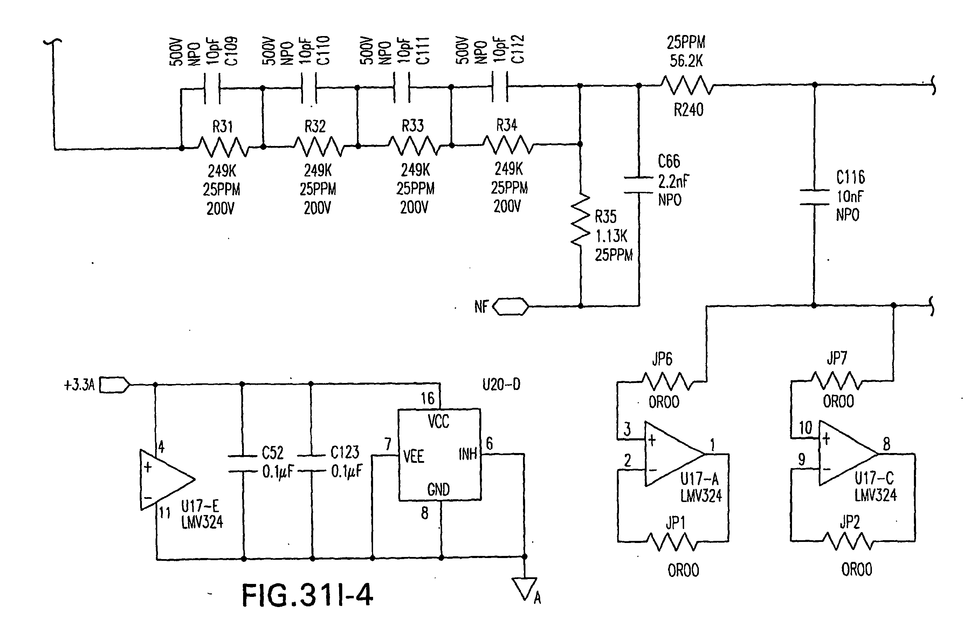

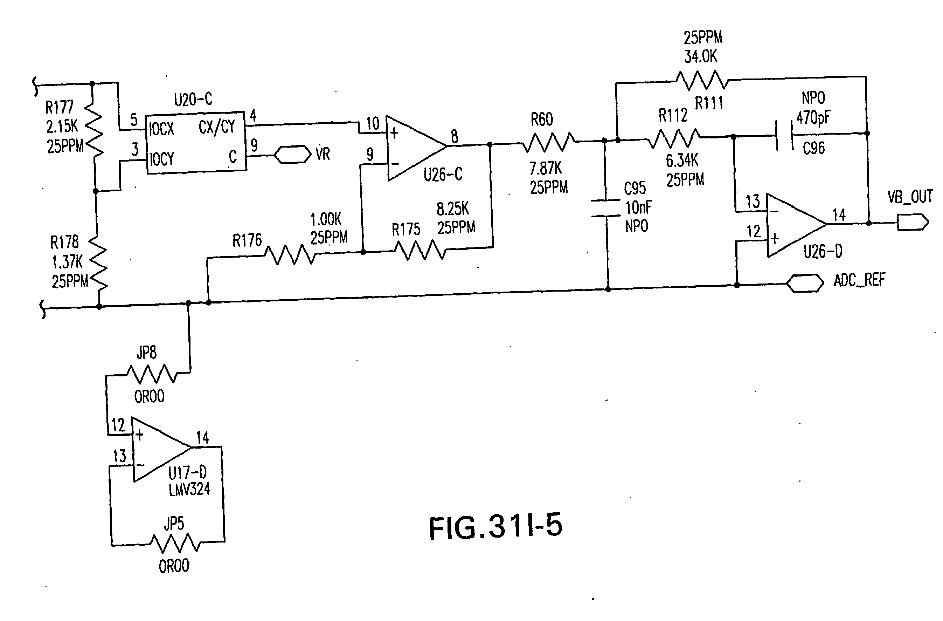

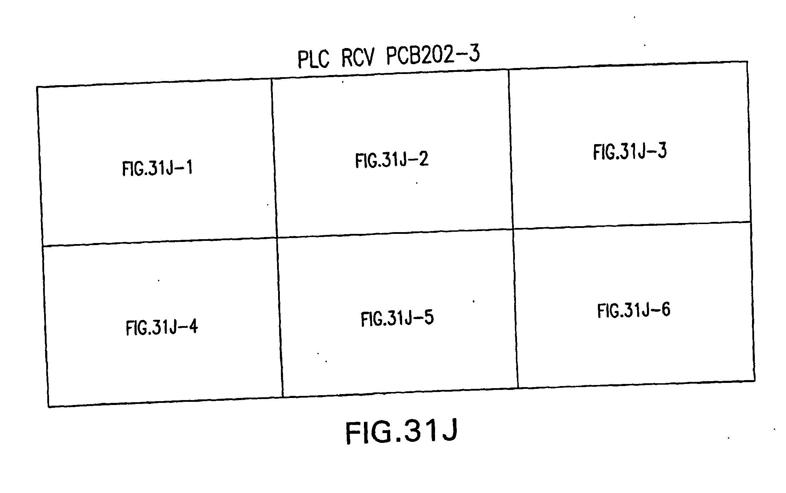

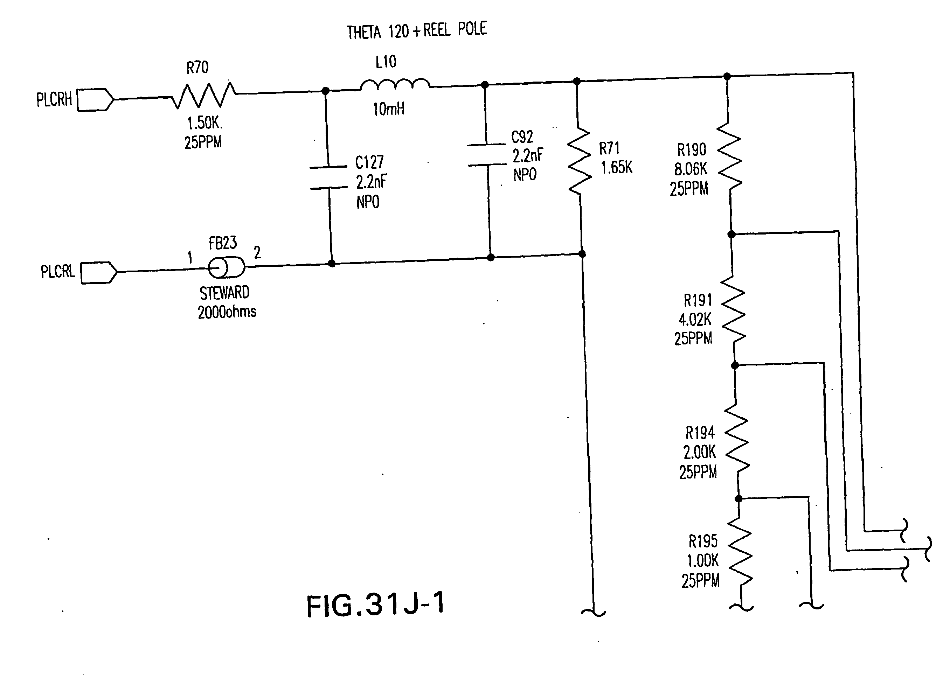

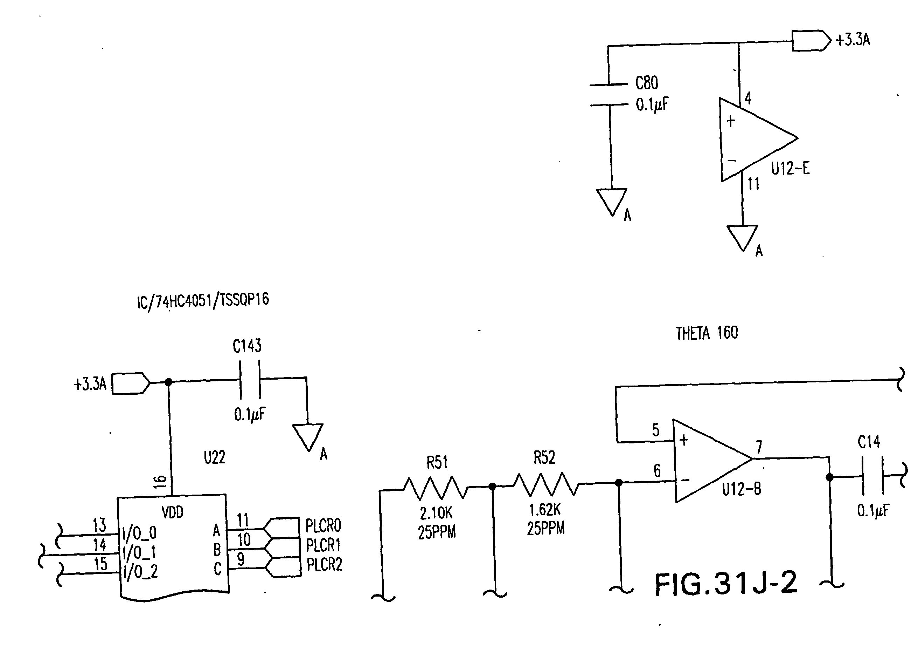

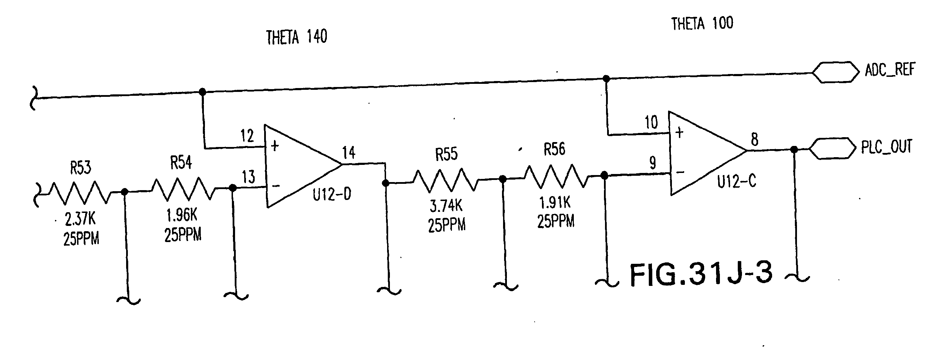

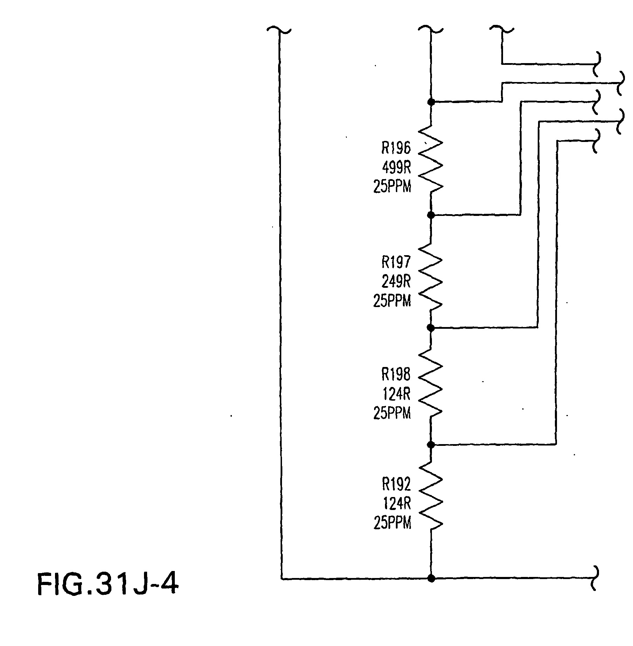

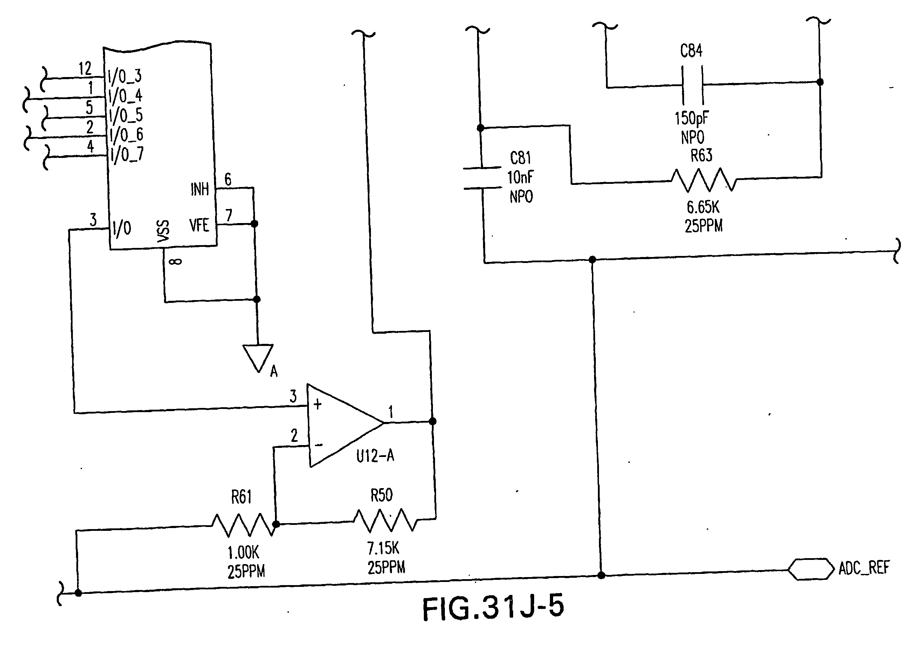

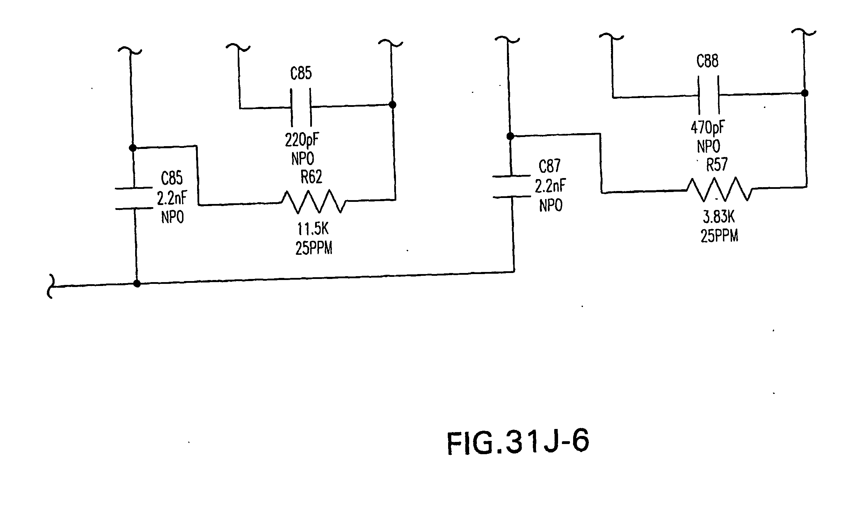

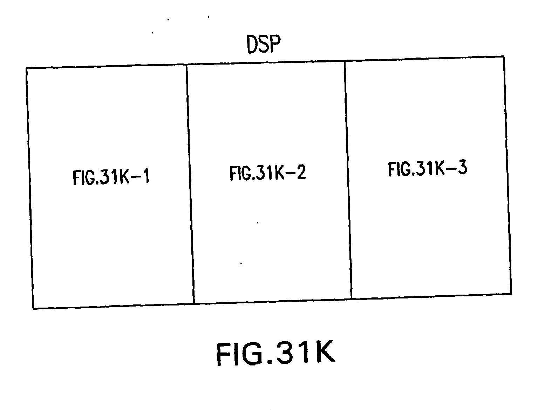

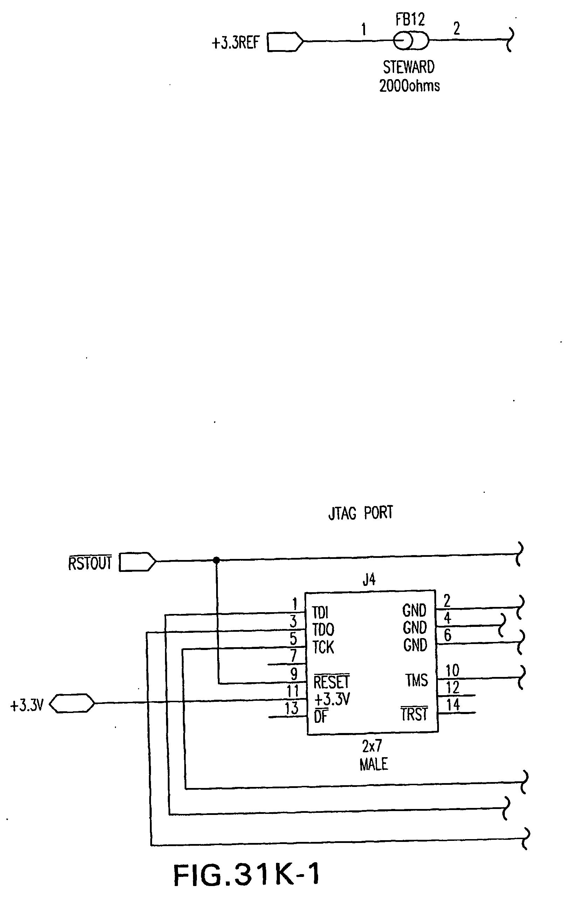

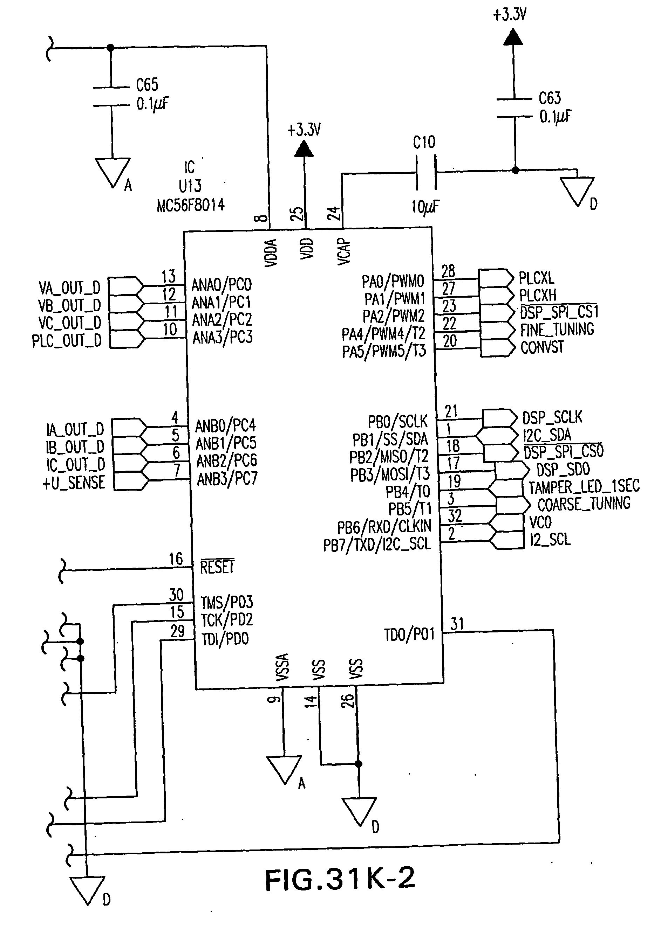

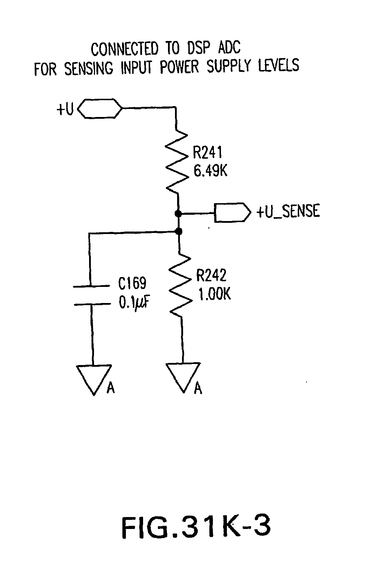

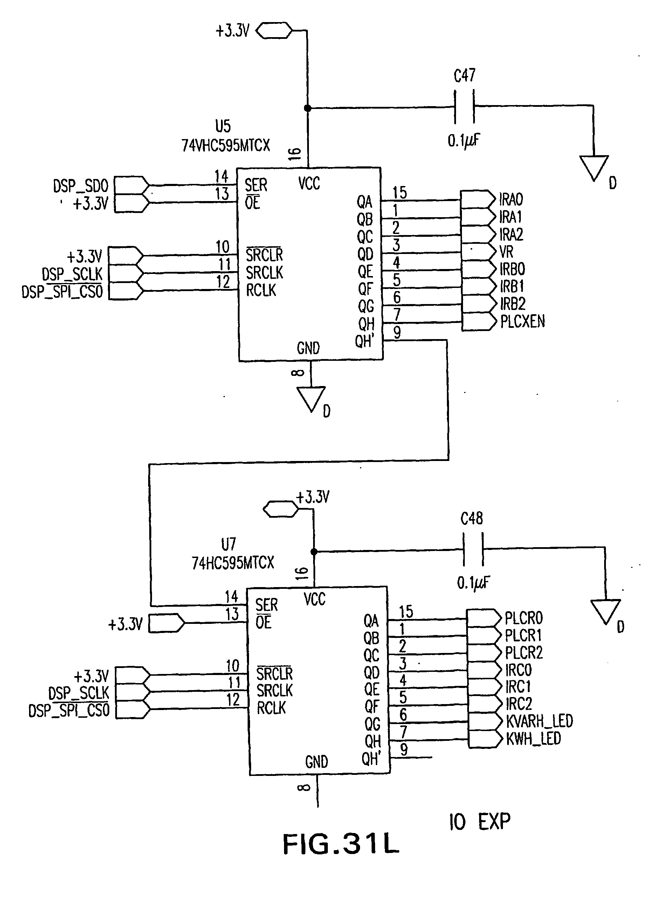

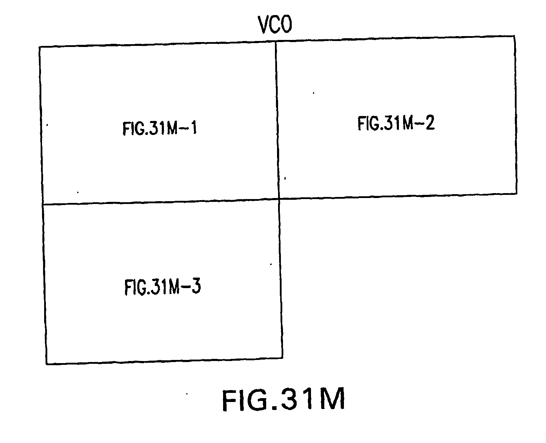

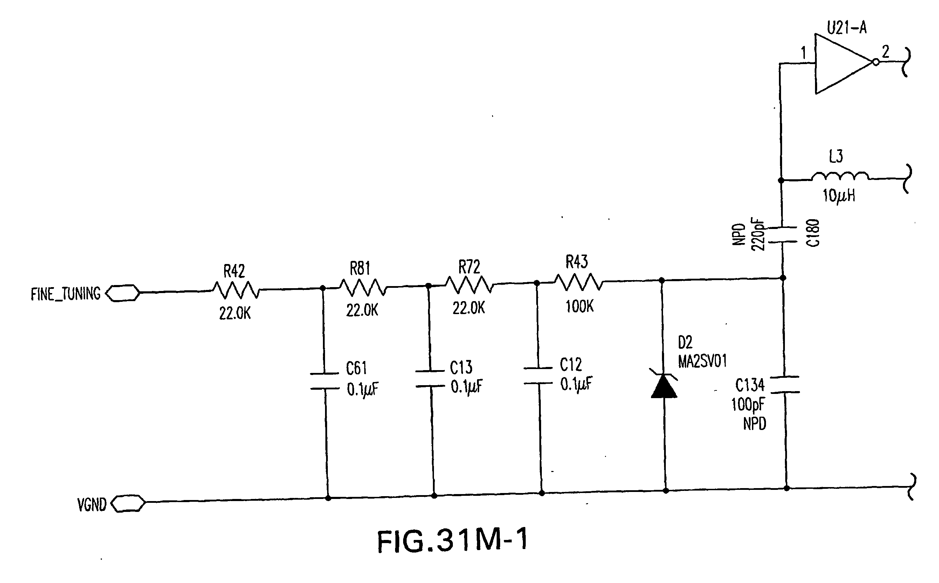

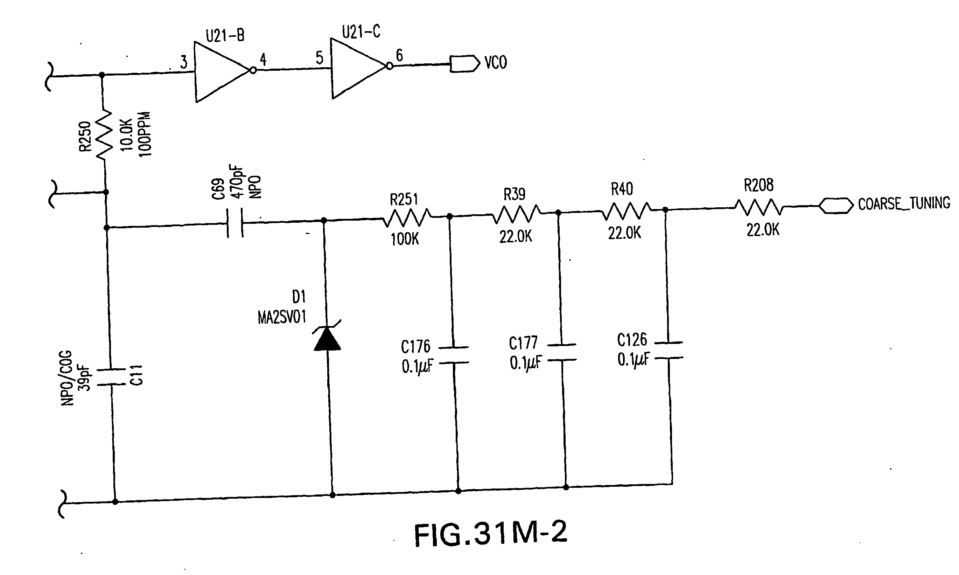

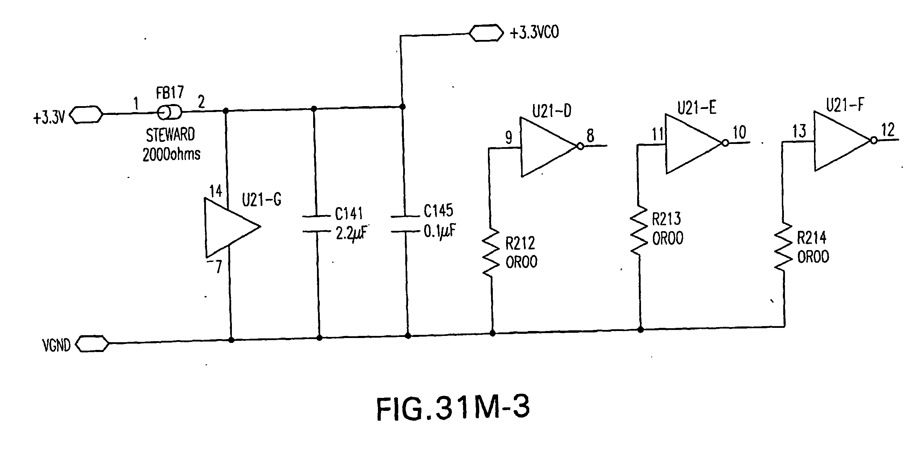

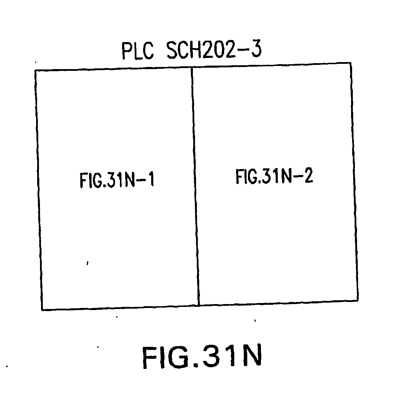

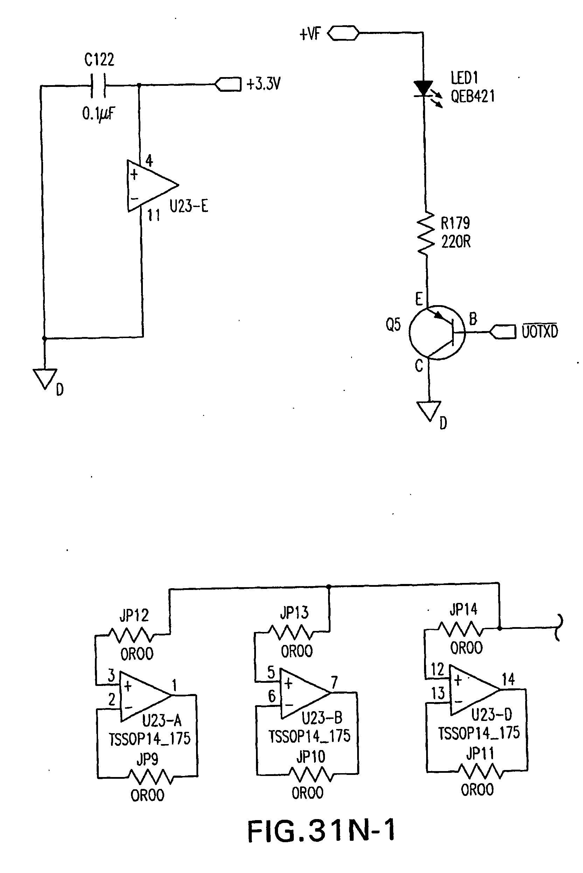

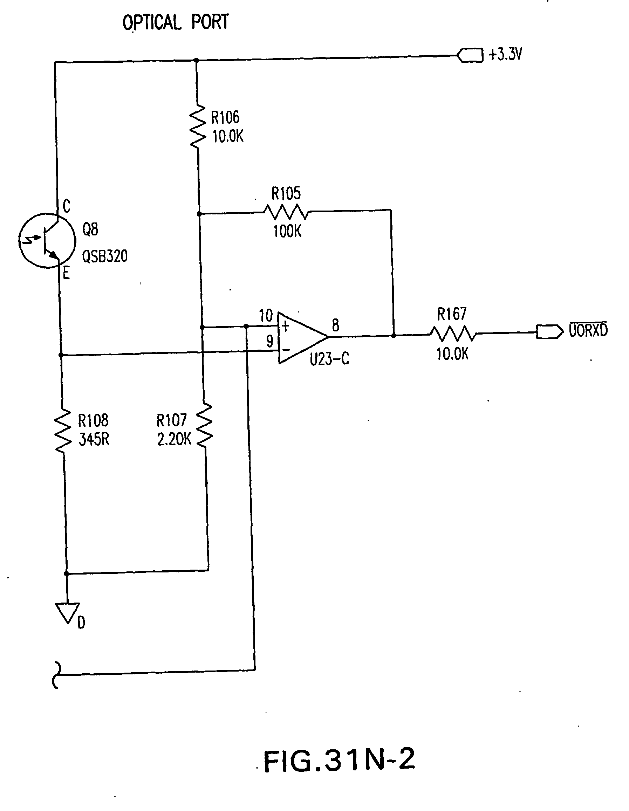

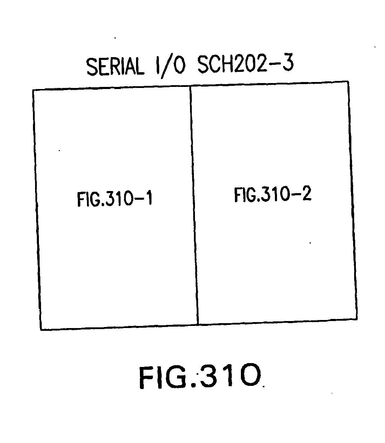

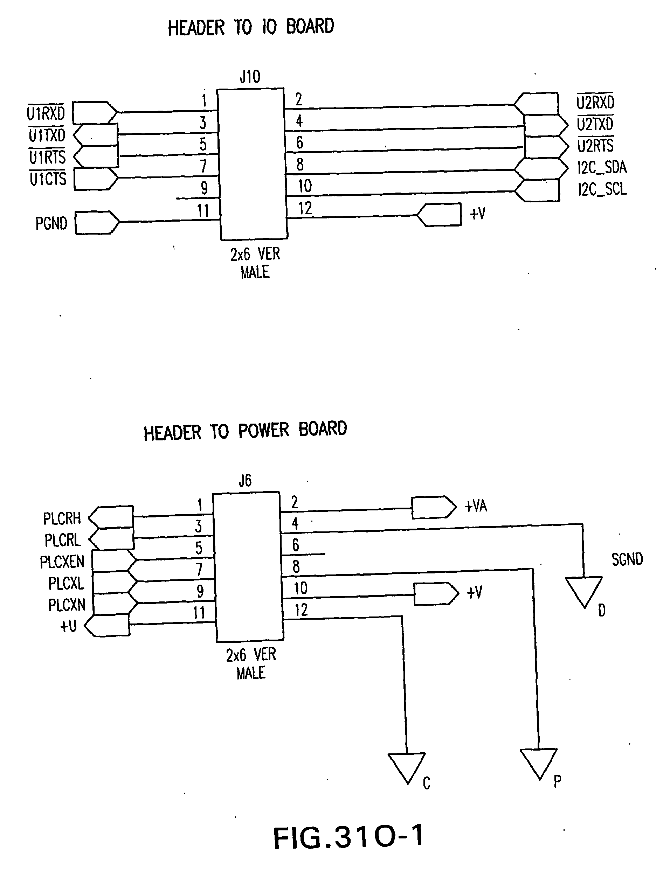

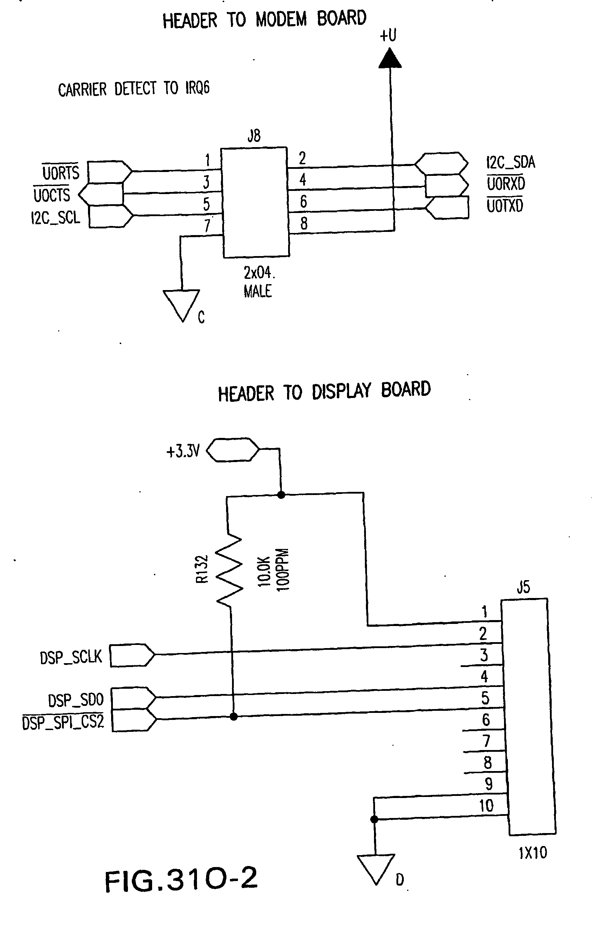

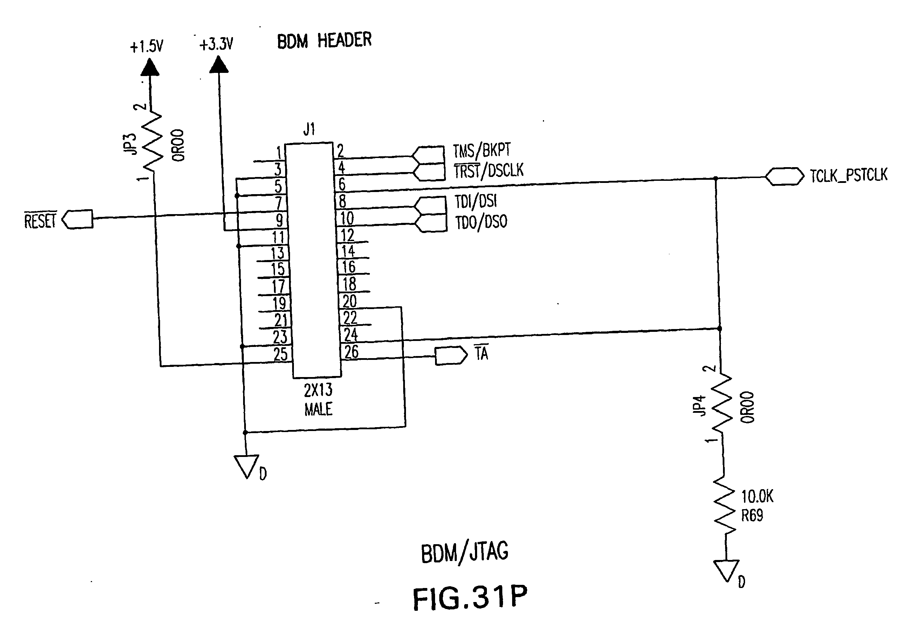

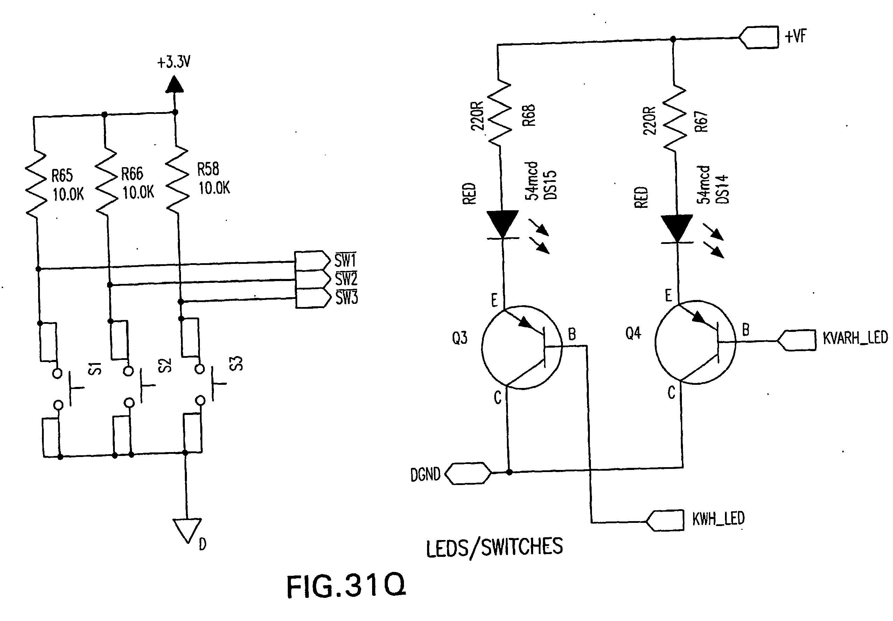

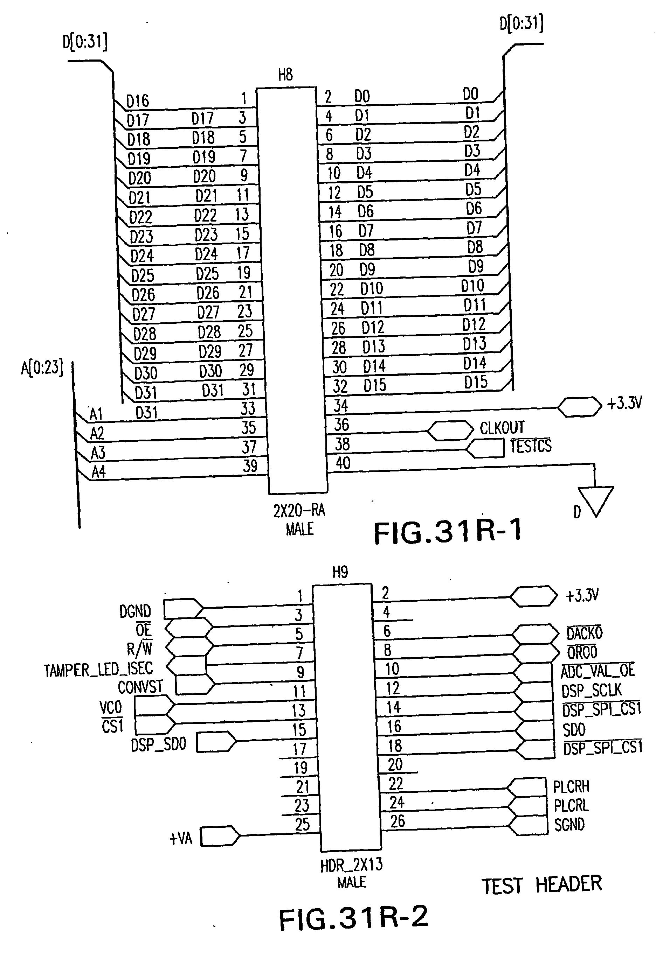

Control Module 2520 also comprises a CPU Board (PCB 202; see FIG. 31 for schematic), which has a Digital Signal Processing (DSP) processor on board.

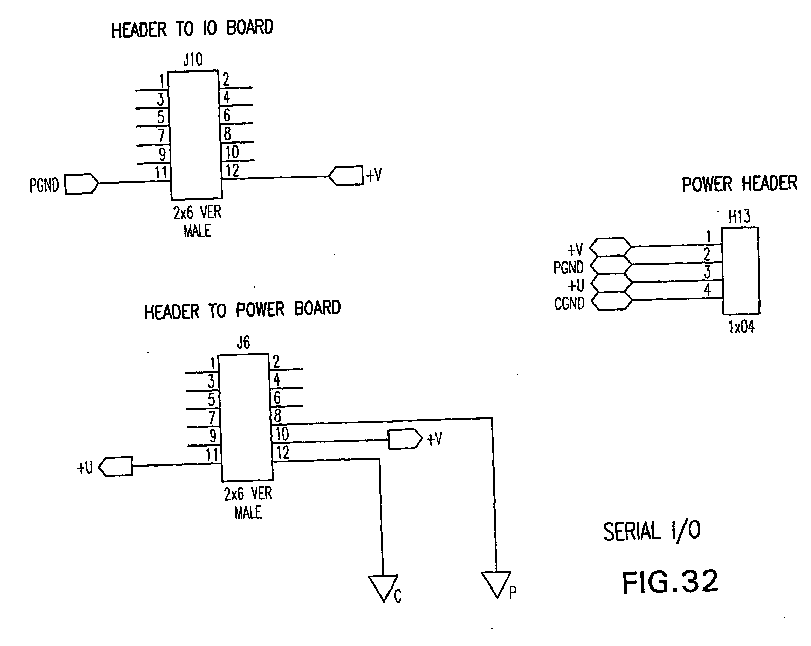

Finally, Control Module 2520 comprises a routing board (PCB 235; see FIG. 32 for schematic) with traces and a header with no electronic components on it.

Each Customer Display Module (CDM) 2530 is installed at the customer's premises and can bidirectionally communicate with the EG installed at the distribution transformer serving the customer. Two-way PLC enables utility-customer communication over low voltage power lines and allows the utility to send regular information, warnings, special information about outages, etc. to the customer.

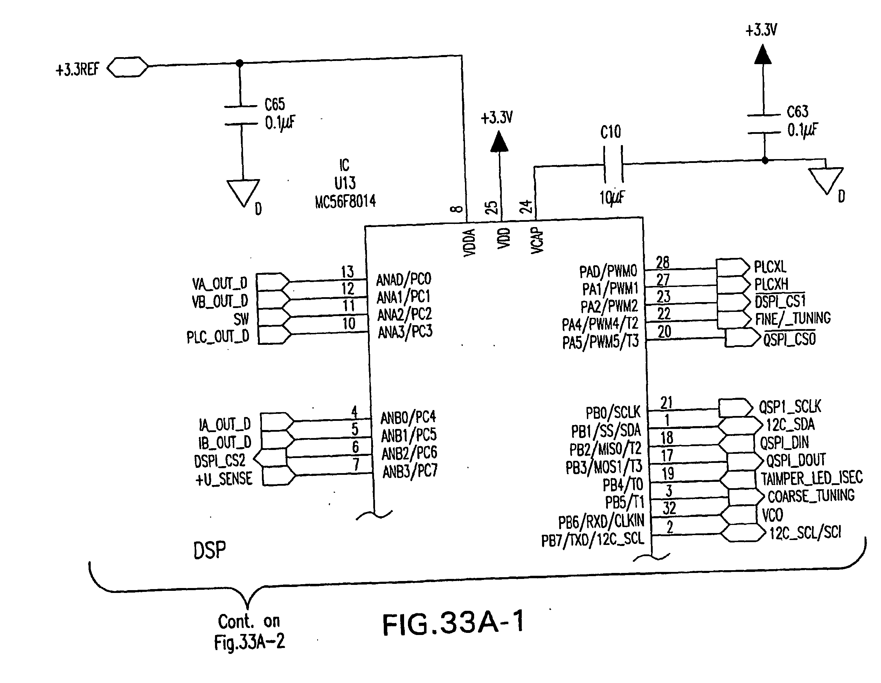

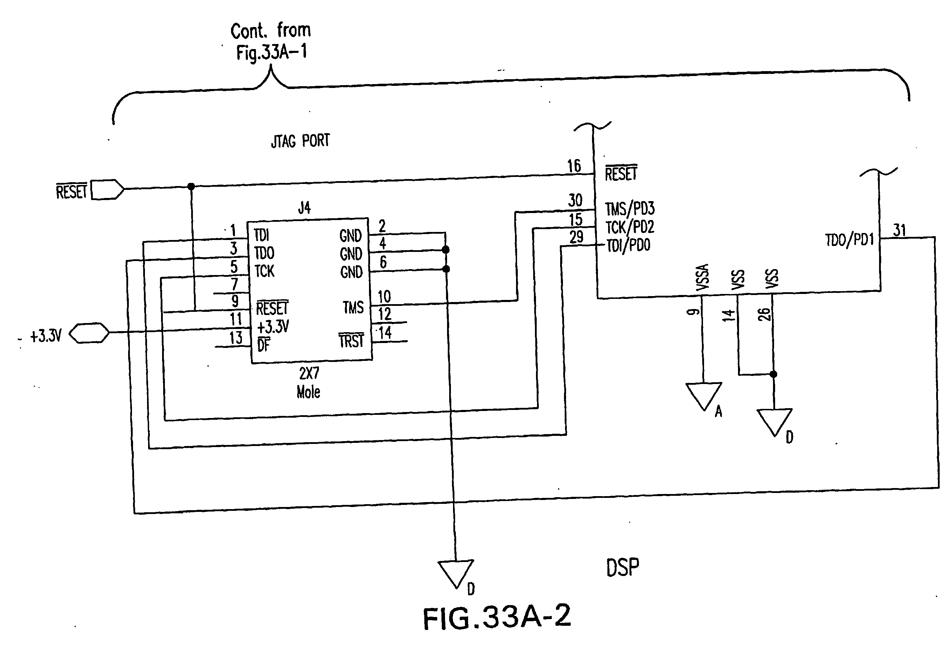

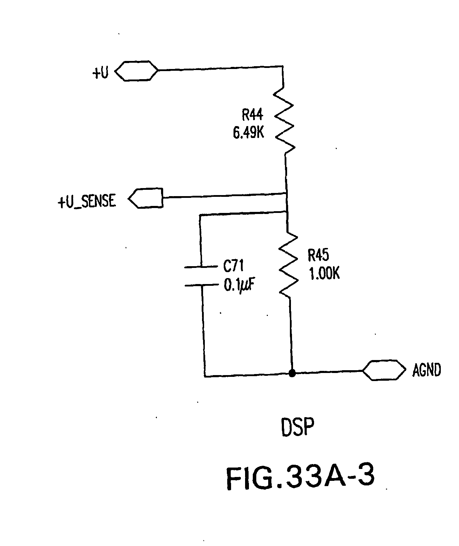

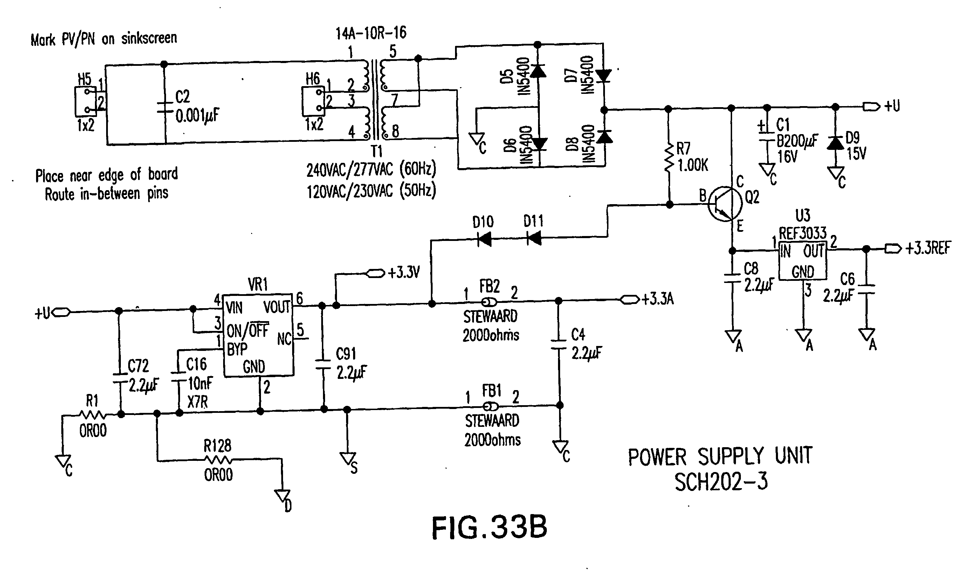

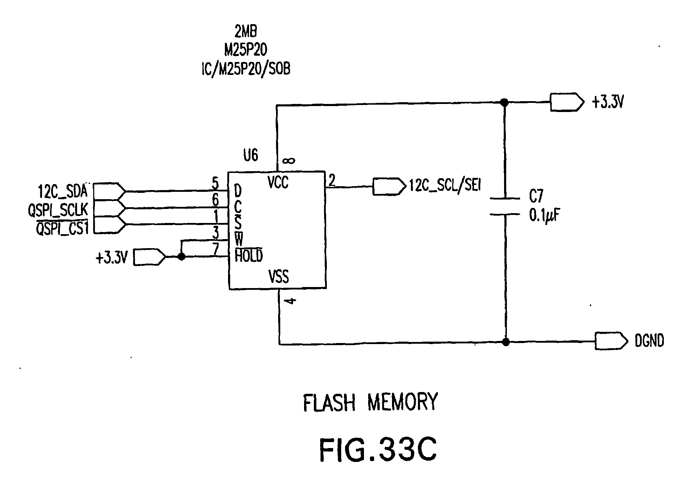

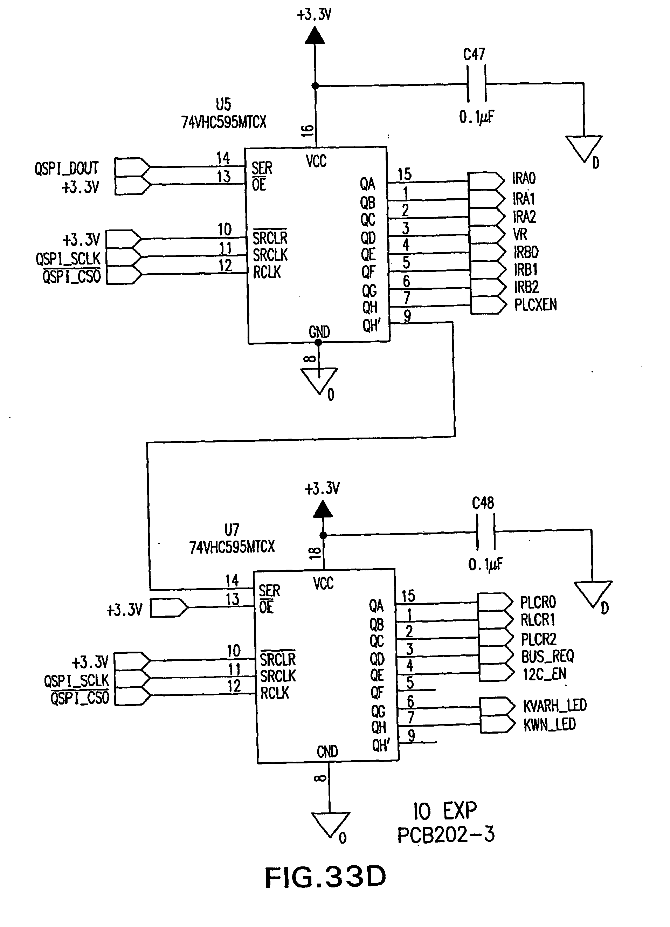

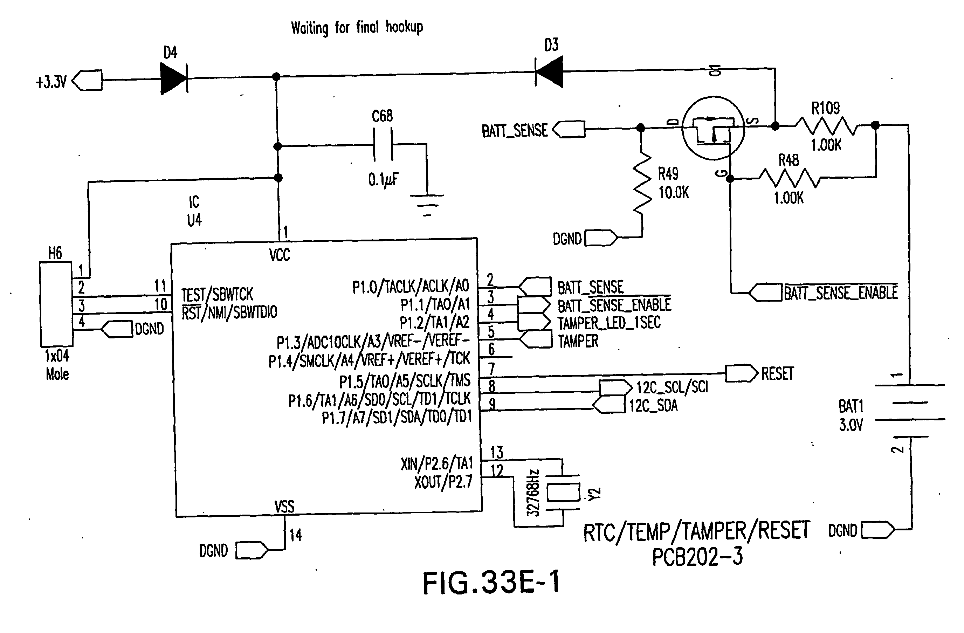

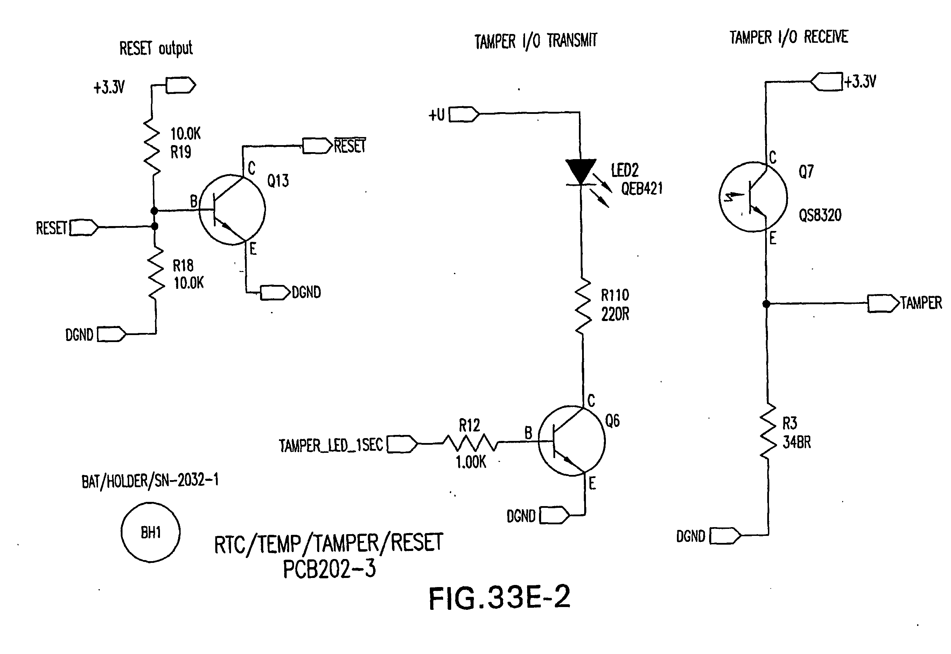

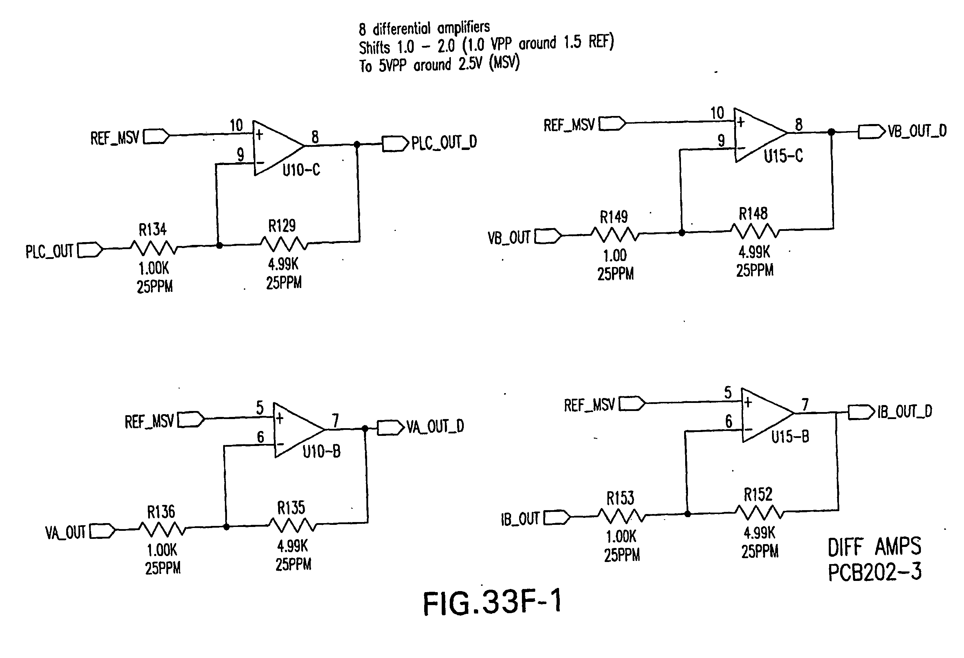

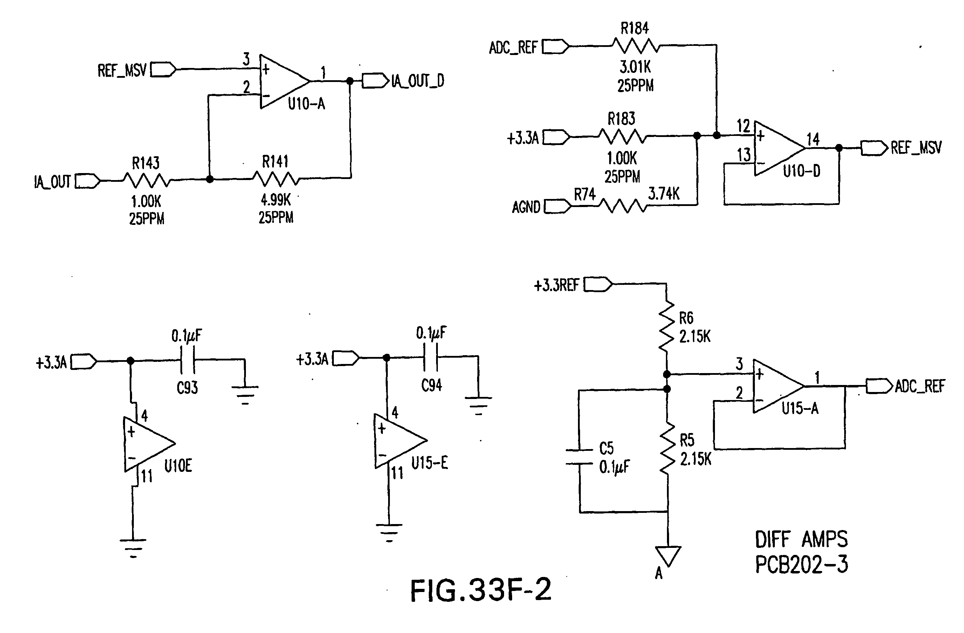

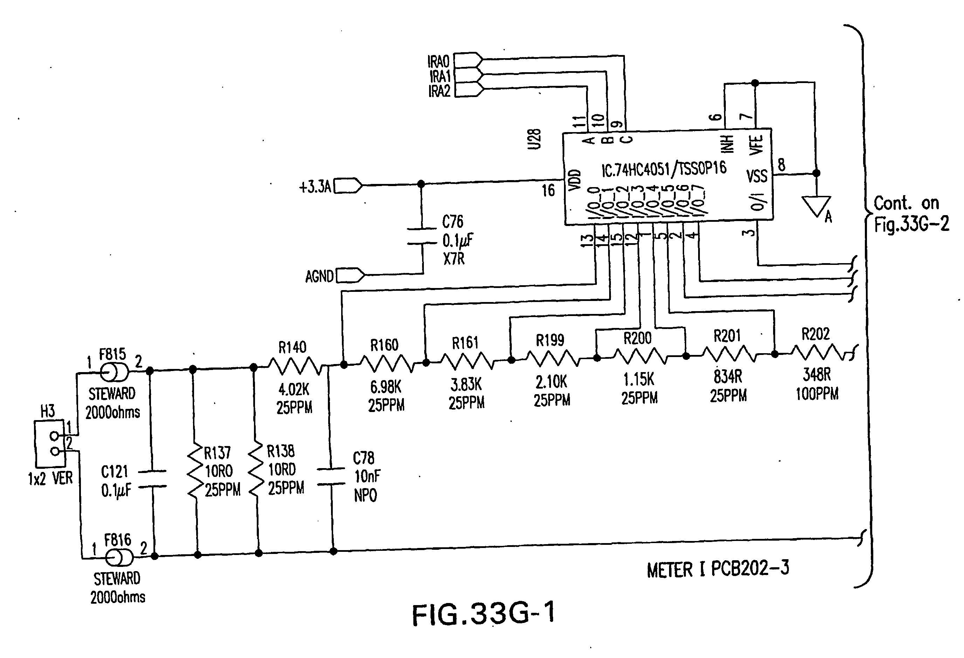

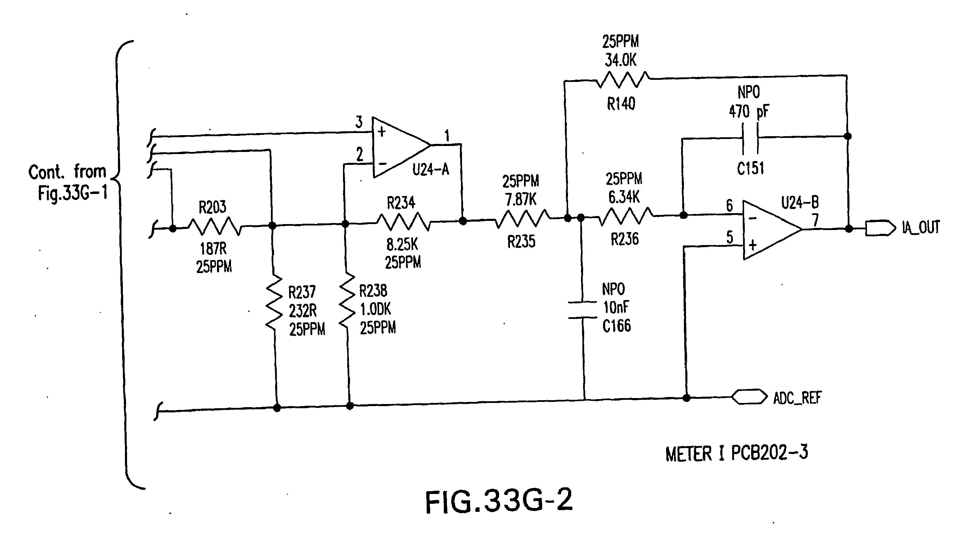

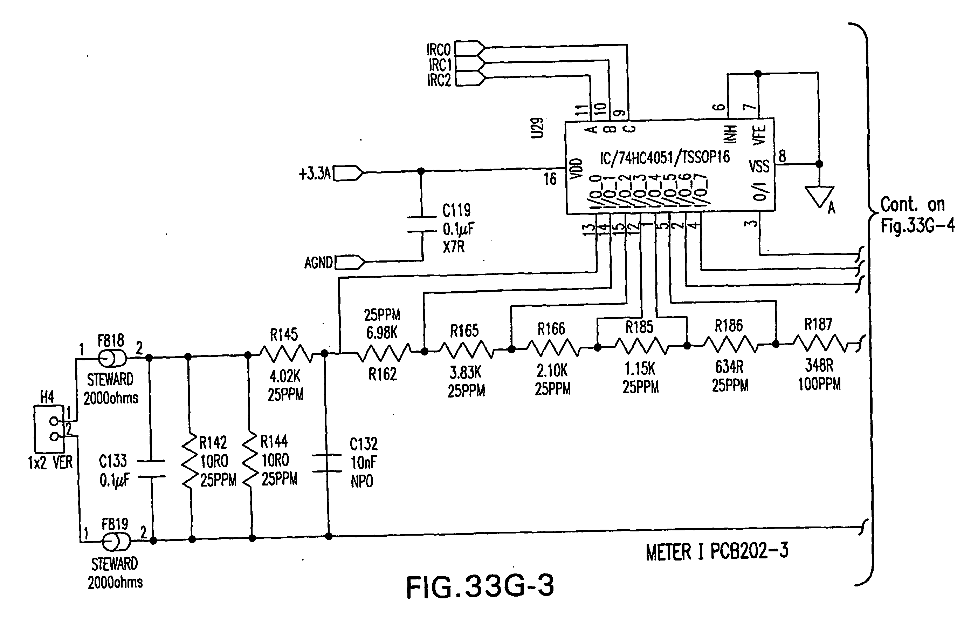

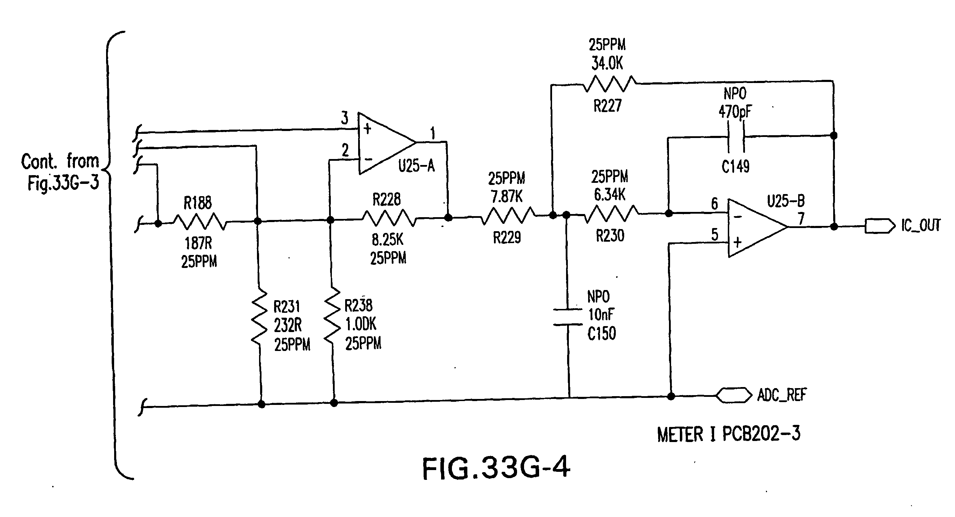

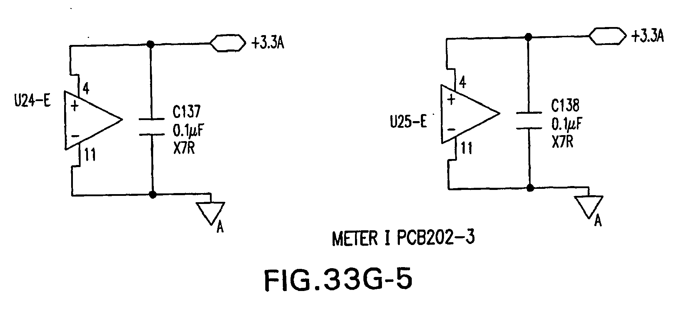

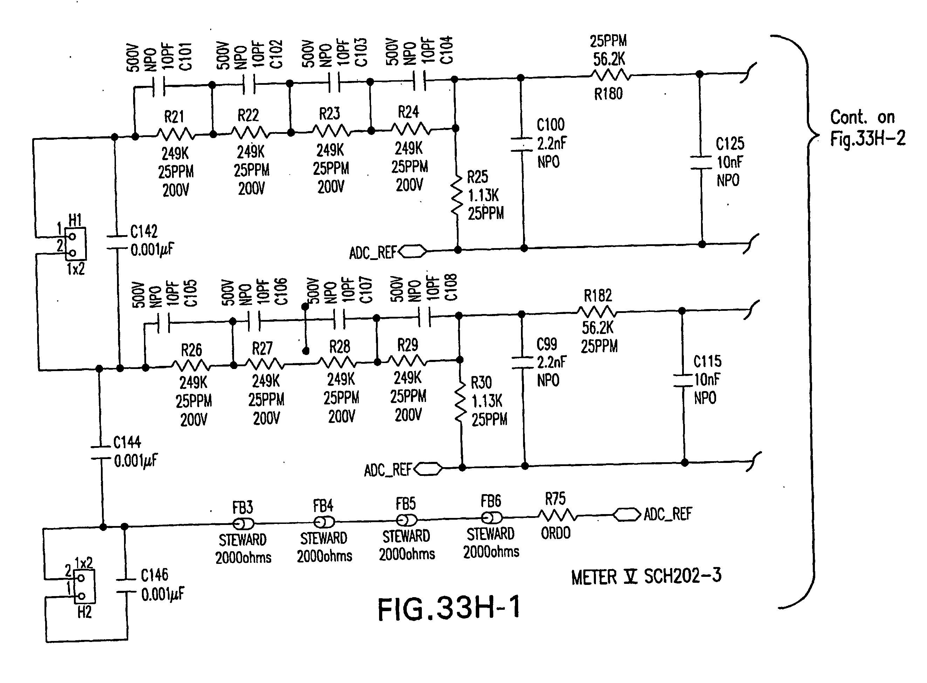

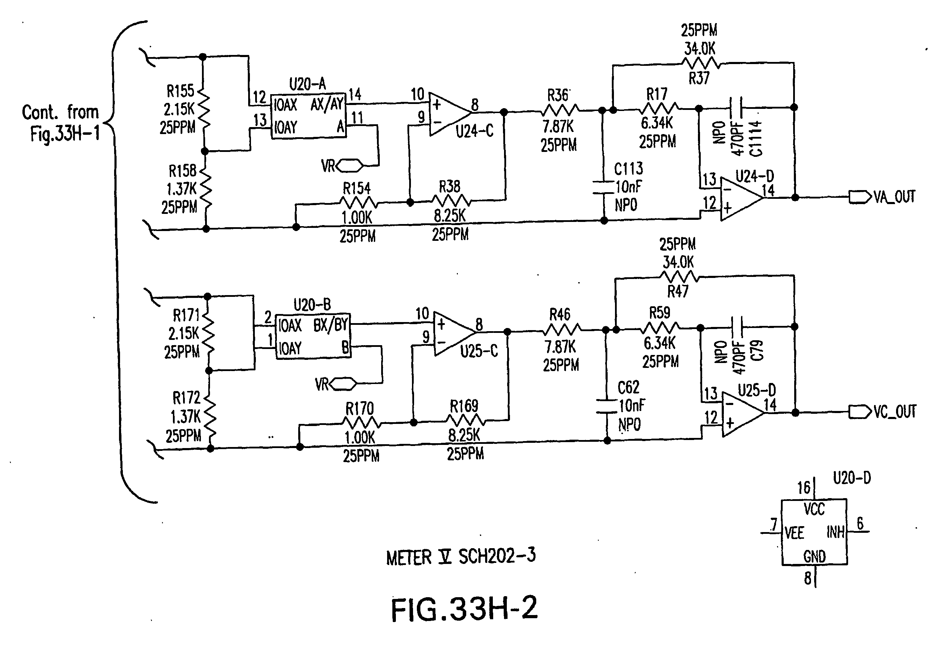

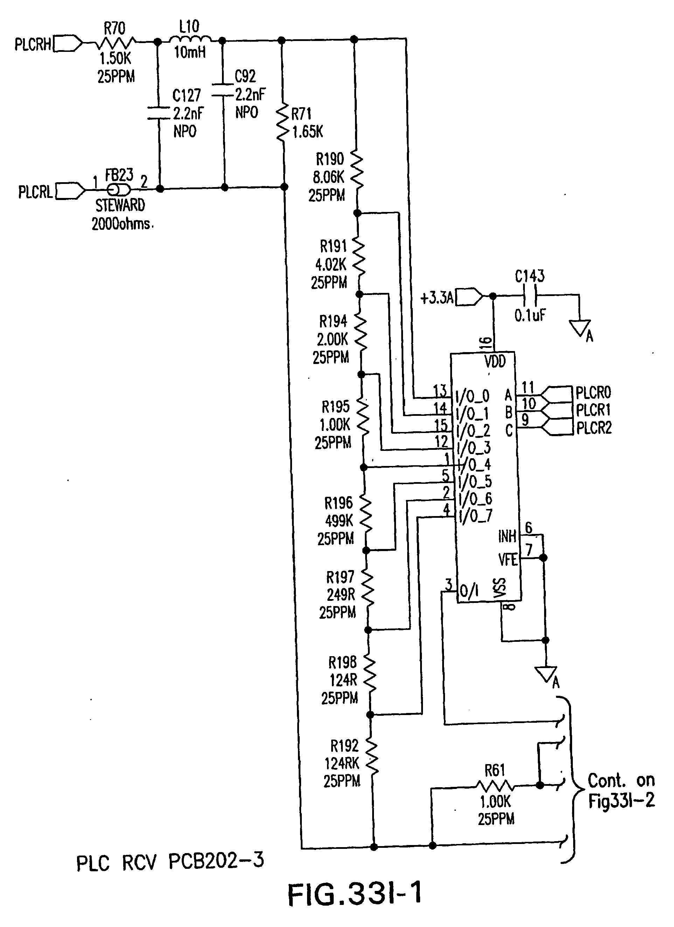

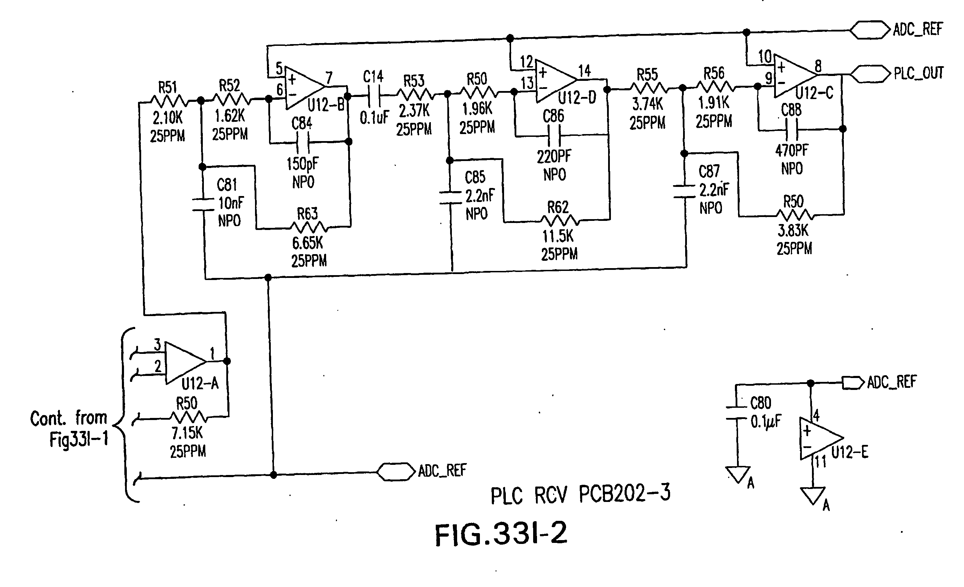

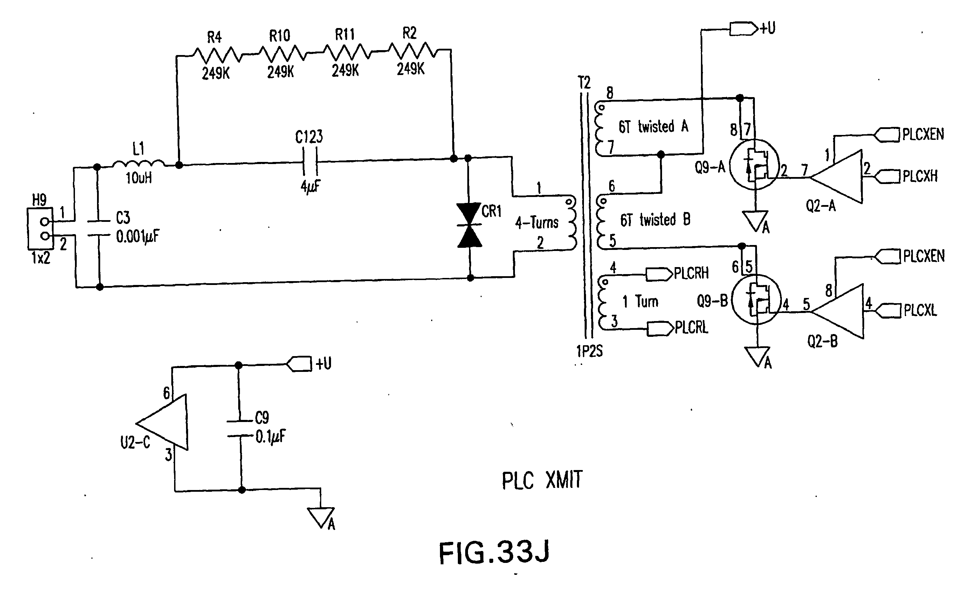

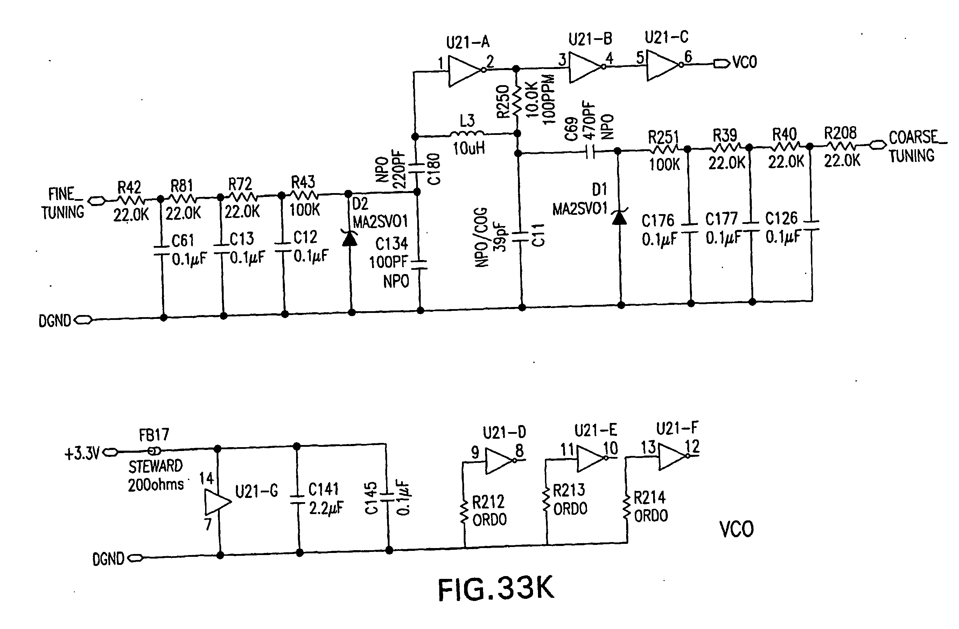

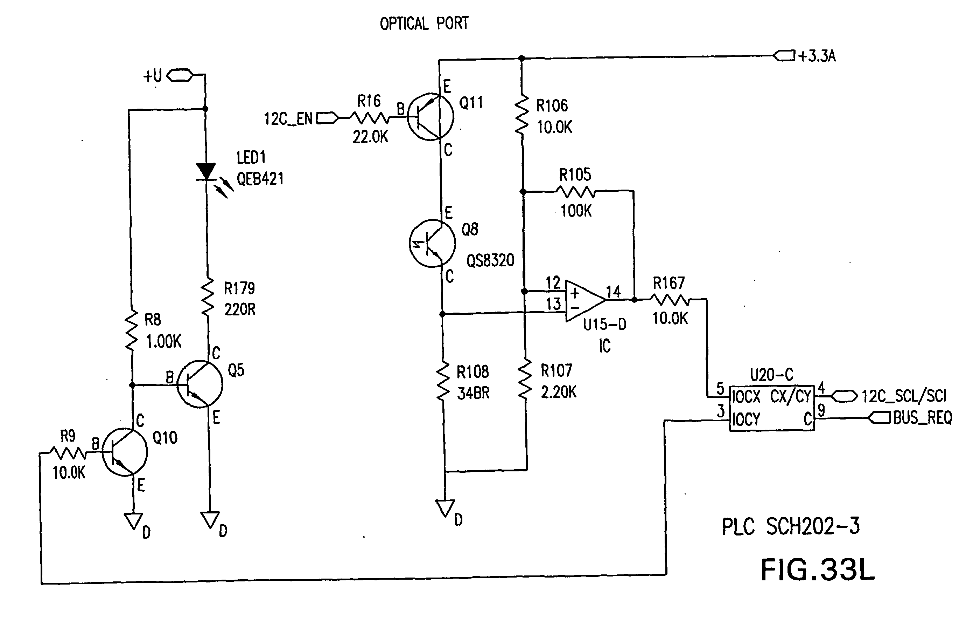

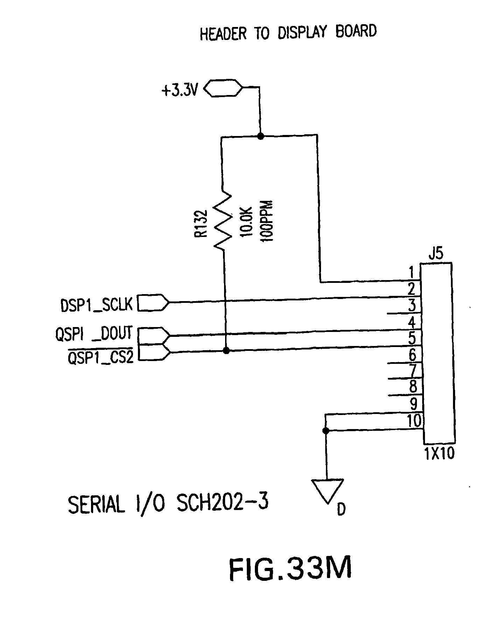

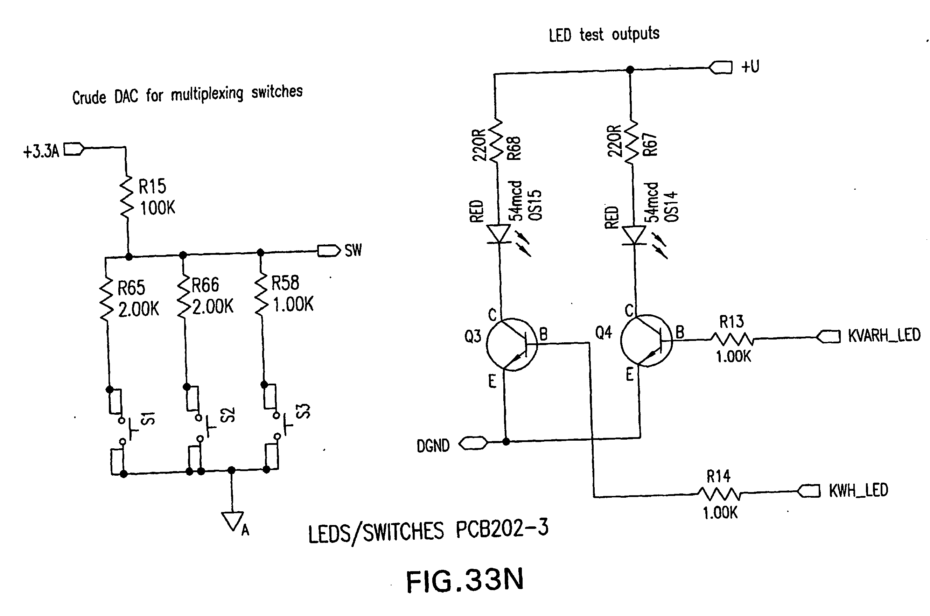

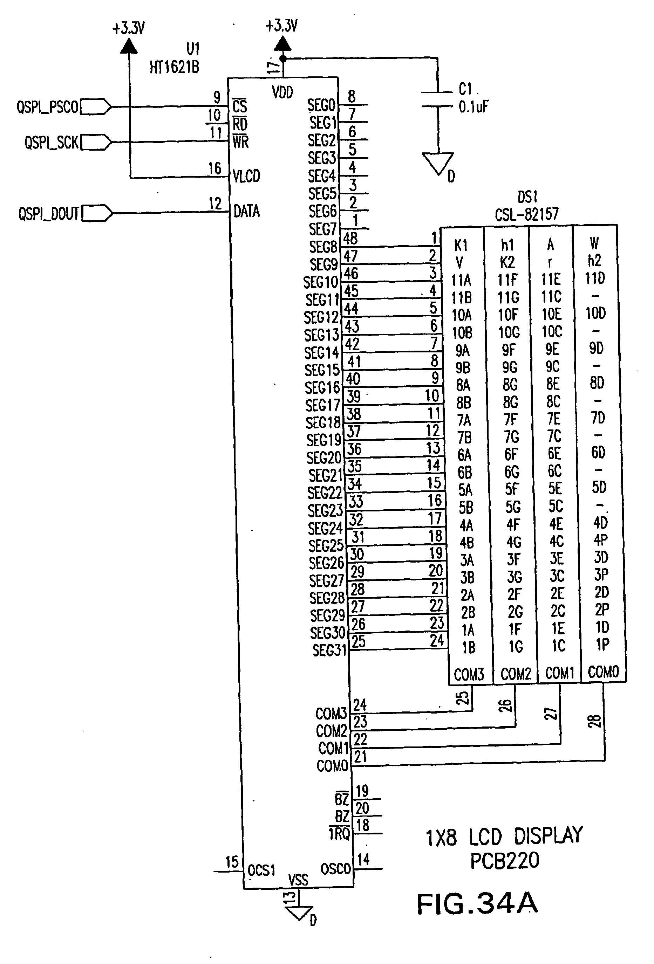

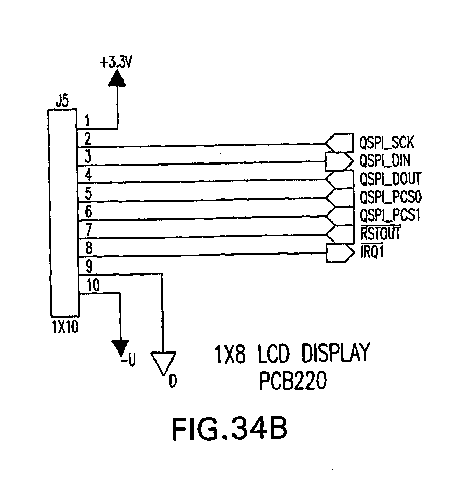

Each CDM 2530 comprises a selected combination of metering and power supply along with PLC circuitry on the same board (PCB 240; see FIG. 33 for schematic). Each CDM preferably also has a 9-digit display board (PCB 220; see FIG. 34 for schematic). This display communicates with EG and shows information about consumption, cautions, warnings, and other utility messages.

Hardware Implementation

In one embodiment, the Energy Guard implements Fast Fourier Transform (FFT) on the PLC communication signal both at the ST and the meter, and for metering purposes performs detailed harmonic analysis. This section discusses an implementation scheme of the Metering Modules, communication with Control Modules and PLC communication of the Control Module with a remotely located Scan Transponder.

The Control Module 2520 comprises power supply and PLC circuitry (PCB 210; see FIGS. 25 and 29); I/O extension (PCB 230; see FIG. 30) and CPU board named D Meter (PCB 202; see FIG. 31). The power supply supplies power to the D meter and I/O extension and contains the PLC transmitter and receiver circuitry. PCB 235 provides a trace routing and header connection between various boards.

The Metering Module may have two versions: 2-phase or 3-phase. The 2-phase version can be programmed by software to function as a single 2-phase meter or two 1-phase meters. The 2-phase version comprises a B2 meter (PCB 203 schematic shown in FIG. 26), whereas the 3-phase version comprises a B3 meter (PCB204 schematic shown in FIG. 27). The B meters act as slaves to the D meter in Control Module 2520. The D and B meters can communicate via a serial ASCII protocol. The various B meters are interconnected via BPB 2510 to 2520 that provides power, a J Hz reference and serial communications to the D meter. The preferred DSP engine for the B meter is the Freescale 56F8014VFAE chip. The preferred microprocessor used for implementing the CPU on the D meter is one among the family of ColdFire Integrated Microprocessors, MCF5207. The use of a specific processor is determined by RAM and Flash requirements dictated by the meter version. A separate power supply and LCD board complete the electronic portion of the D meter as a product. Apart from acting as a master for B meters, the D meter is also a 3-phase meter and measures the total transformer output on which the EG is installed. As an anti-theft feature, this total is compared with the total consumption reported by the various B meters.

$$\sum_{n=1}^{24} kWh_n = \text{Total Transformer output}$$

The signal streams constituency is as follows:

B2: Two voltage, Two current, and No Power Line Carrier (PLC) Channel.

B3: Three voltage, Three current, and No PLC Channel.

D: Three voltage, Three current, and one PLC Channel.

Each stream has an associated circuit to effect analog amplification and anti-aliasing.

Specific to the D meter is the preferred implementation of:

- A Phase Locked Loop (PLL) to lock the sampling of the signal streams to a multiple of the incoming A/C line (synchronous sampling to the power line).

- A Voltage Controlled Oscillator (VCO) at 90-100 MHz controlled by DSP processor via two PWM modules directly driving the system clock hence making the DSP coherent with the PLL.

- A synchronous phase detector that responds only to the fundamental of the incoming line frequency wave and not to its harmonics.

- Option for performing FSK and PSK modulation schemes.

Each metering and communication channel preferably comprises front-end analog circuitry followed by the signal processing. Unique to the analog circuitry is an anti-aliasing filter with fixed gain which provides first-order temperature tracking, hence eliminating the need to recalibrate meters when temperature drifts are encountered. This is discussed next, and then a preferred signal processing implementation is discussed.

Voltage and Current Analog Signal Chain

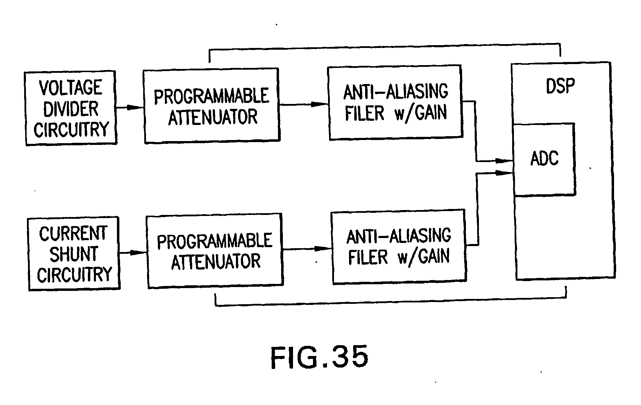

The analog front-end for voltage (current) channels comprises voltage (current) sensing elements and a programmable attenuator, followed by an anti-aliasing filter. The attenuator reduces the incoming signal level so that no clipping occurs after the anti-aliasing filter. The constant gain anti-aliasing filter restores the signal to full value at the input of the Analog to Digital Converter (ADC). For metering, the anti-aliasing filter cuts off frequencies above 5 kHz. The inputs are then fed into the ADC which is a part of the DSP. See FIG. 35, which is a block diagram of a preferred analog front-end for metering.

Whereas a typical implementation would include a Programmable Gain Amplifier (PGA) followed by a low gain anti-aliasing filter, the invention, in this embodiment, implements a programmable attenuator followed by a large fixed-gain filter. In addition, the implementation of both the anti-aliasing filters on a single chip is the same using the same Quad Op Amps along with 25 ppm resistors and NPO/COG capacitors. This unique implementation by pairing the anti-aliasing filters ensures that the phase drifts encountered in both voltage and current channels are exactly identical and hence accuracy of the power calculation (given by the product of V and I) is not compromised. This provides a means for both V and I channels to track temperature drifts up to first order without recalibrating the meter.

In contrast, using a PGA along with a low gain filter cannot track the phase shift in the V and I signals introduced due to temperature. This is because the phase shift introduced by PGA is a function of the gain.

Voltage, Current and PLC Digital Signal Chain

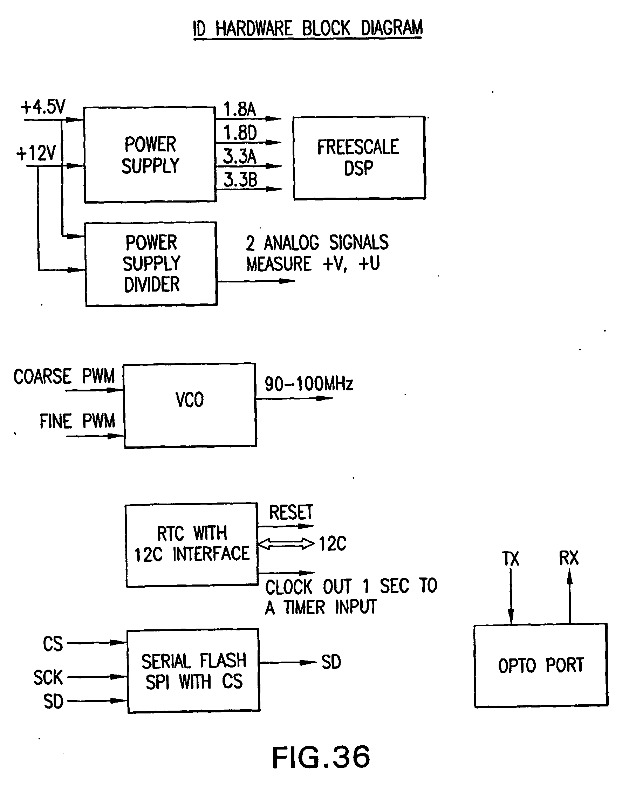

FIG. 36 is a block diagram of the PCB 202 board; the functions of each block will be apparent to those skilled in the art. FIG. 36 shows a preferred DSP implementation.

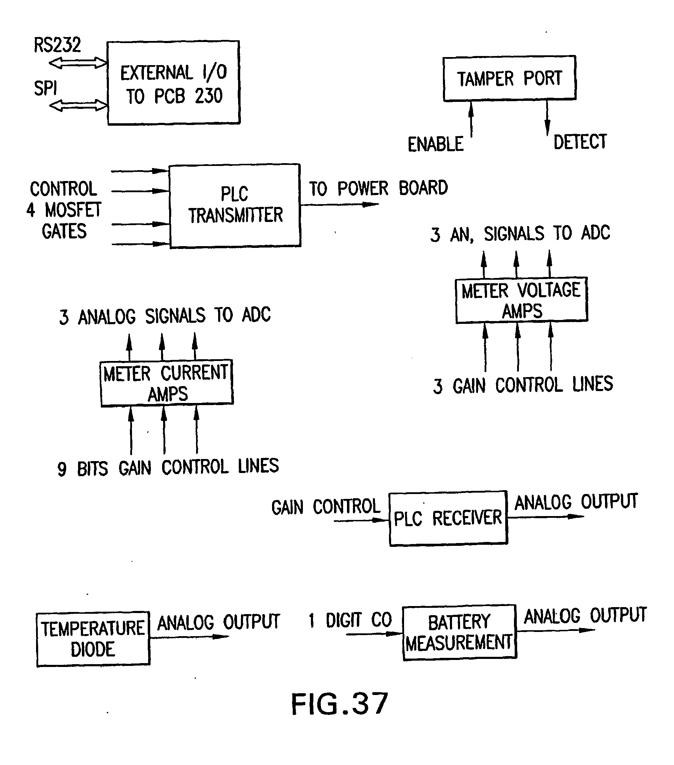

This embodiment preferably uses a PLL to lock the sampling of the signal streams to a multiple of the incoming A/C line frequency. In the embodiment discussed above, the sampling is at a rate asynchronous to the power line. In the D meter, there is a VCO at 90-100 MHz which is controlled by the DSP engine via two PWM modules. The VCO directly drives the system clock of the DSP chip (disabling the internal PLL), so the DSP becomes an integral part of the PLL. Locking the system clock of the DSP to the power line facilitates the alignment of the sampling to the waveform of the power line. The phase detector should function so as to respond only to the fundamental of the incoming 60Hz wave and not to it harmonics. FIG. 37 is a block diagram of this preferred DSP implementation.

A DSP BIOS or voluntary context switching code provides three stacks, each for background, PLC communications and serial communications. The small micro communicates with the DSP using a I2C driver. The MSP430F2002 integrated circuit measures the power supplies, tamper port, temperature and battery voltage. The tasks of the MSP430F2002 include:

i. maintain an RTC;

ii. measure the battery voltage;

iii. measure the temperature;

iv. measure the +U power supply;

v. reset the DSP on brown out;

vi. provide an additional watchdog circuit; and

vii. provide a 1-second reference to go into the DSP for a time reference to measure the 1-second reference against the system clock from the VCO.

D Meter PLC Communication Signal Chain

A typical installation consists of multiple EGs and STs communicating over the power lines. The D meter communicates bi-directionally with a remotely located Scan Transponder through the distribution transformer. To enable this, this embodiment uses a 10-25 kHz band for PLC communication. The PLC signal is sampled at about 240 kHz (212 * 60), synchronous with line voltage, following which a Finite Impulse Response (FIR) filter is applied to decimate the data. Preferred FIR specifications are given below:

10-25 kHz Band

| | |
|---|---|
| Number of Taps | 65 |
| Stop Band Attenuation | 71.23dB |
| Pass band Upper Freq | 25kHz |
| Stop band Lower Freq | 35kHz |
| Sampled in | 60 * 4096 |
| Sample Out | 30* 2048 |

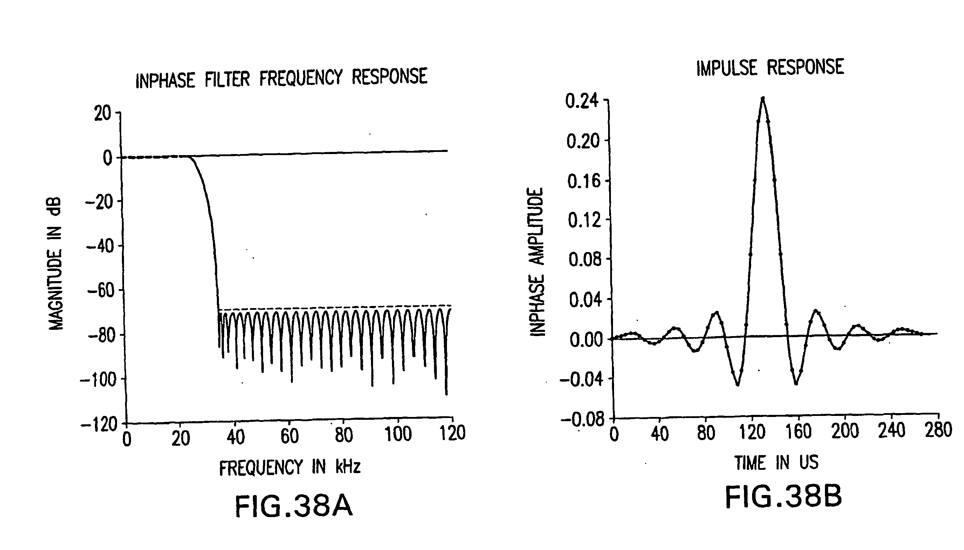

See FIG. 38 for preferred inphase filter frequency response and impulse response characteristics.

After the decimation is done to 60 kHz ($2^{11}$ * 30), a 2048-point FFT is then performed on the decimated data. The data rate is thus determined to be 30 baud depending on the choice of FIR filters. Every FFT yields two bits approximately every 66 msec when using FIR in the 10-25 kHz band to communicate through distribution transformers.

To circumvent the problem of communicating in the presence of line noise, this embodiment preferably implements a unique technique for robust and reliable communication. This is done by injecting PLC signals at frequencies that are half odd harmonics of the line frequency (60Hz). This is discussed below, for an embodiment using a typical noise spectrum found on AC lines in the range 12-12.2 kHz.

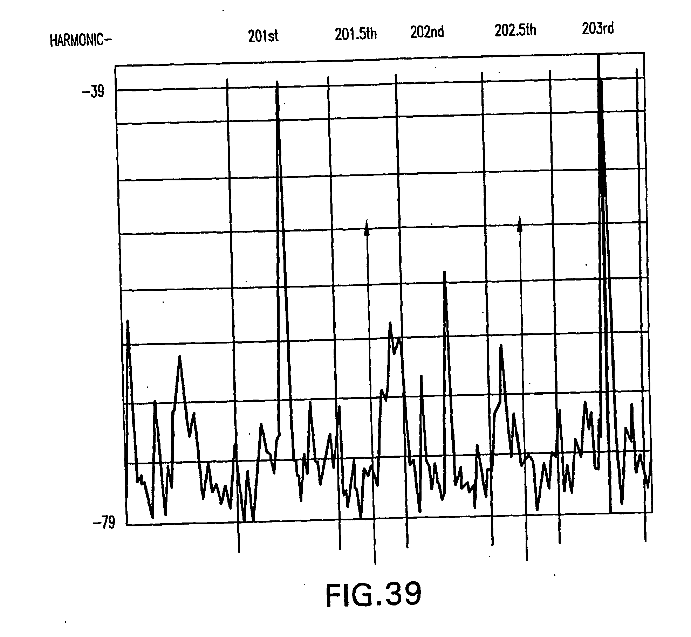

FIG. 39 illustrates injecting PLC signals at half-odd harmonics of 60 Hz. Since FFT is done every 30 Hz and the harmonics are separated by 60 Hz, the data bits reside in the bin corresponding to the 201.5th and 202.5th harmonic of 60 Hz in FIG. 39. The algorithm considers these two bins of frequencies and compares the amplitude of the signal in the two to determine 1 or 0. This FSK scheme uses two frequencies and yields a data rate of 30 baud. Alternatively, QFSK, which uses 4 frequencies, can be implemented to yield 60 baud.

When traversing through transformers, both STs and D meters preferably perform FFT on the PLC and data signals every 30 Hz in a 10-25 kHZ range. Because the Phase Lock Loops (PLLs) implemented in both the ST and the D meter are locked to the line, the data frames are synchronized to the line frequency (60 Hz) as well. However, the data frames can shift in phase due to:

   1. various transformer configurations that can exist in the path between the ST and meter (delta-Wye, etc.); and
   2. a shift in phase due to the fact that STs are locked on a particular phase, whereas single and polyphase meters can be powered up by other phases.

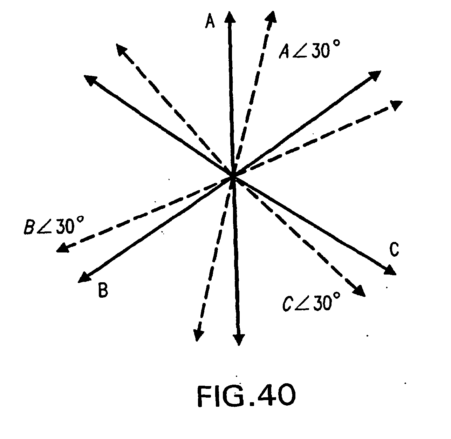

The signal to noise ratio (SNR) is maximized when the meter data frame and ST data frames are aligned close to perfection. From a meter's standpoint, this requires receiving PLC signal from all possible STs that it can "hear," decoding the signal, checking for SNR by aligning data frames, and then responding to the ST that is yielding maximum SNR. FIG. 40 depicts the 12 possible ways in which the FFT frame received by the meter can be out of phase with ST FFT frame. Dotted lines correspond to a 30 degree rotation accounting for a delta transformer in the signal path between ST and the meter.

In addition, because the data frames are available every 30 Hz on a 60 Hz line, there are two possibilities corresponding to the 2 possible phases obtained by dividing 60 Hz by 2. Hence, there are 24 ways that meter data frames can be misaligned with ST data frames.

In each frame of the ST, there are an odd integral number of cycles of the carrier frequency. Since the preferred modulation scheme is Frequency Shift Keying (FSK), if there are n cycles for transmitting bit 1, bit 0 is transmitted using n+2 cycles of the carrier frequency. It becomes vital for the meter to recognize its own 2 cycles of 60 Hz in order to be able to decode its data bits which are available every 1/30th of a second.

If the D meter decodes signals with misaligned data frames, there is energy that spills over into the adjacent (half-odd separated) frequencies. If the signal level that falls into the "adjacent" frequency bin is less than the noise floor, the signal can be decoded correctly. However, if the spill-over is more than the noise floor, the ability to distinguish between 1 and 0 decreases, and hence the overall SNR drops, resulting in an error in decoding. In conclusion:

   a. If the frames are misaligned, smearing of data bits occurs and the SNR degrades.

   b. In the event that the frequency changes and there are misaligned data frames, there is a substantial amount of energy that spills over into the adjacent FFT bins, hence interfering with the other STs in the system that communicate using frequencies in that specific bins.

Once the clock shift is determined corresponding to the highest SNR, the meter then locks until a significant change in SNR ratio is encountered by the meter, in which case the process repeats.

Implementation of Metering in D and B Meter using FFT

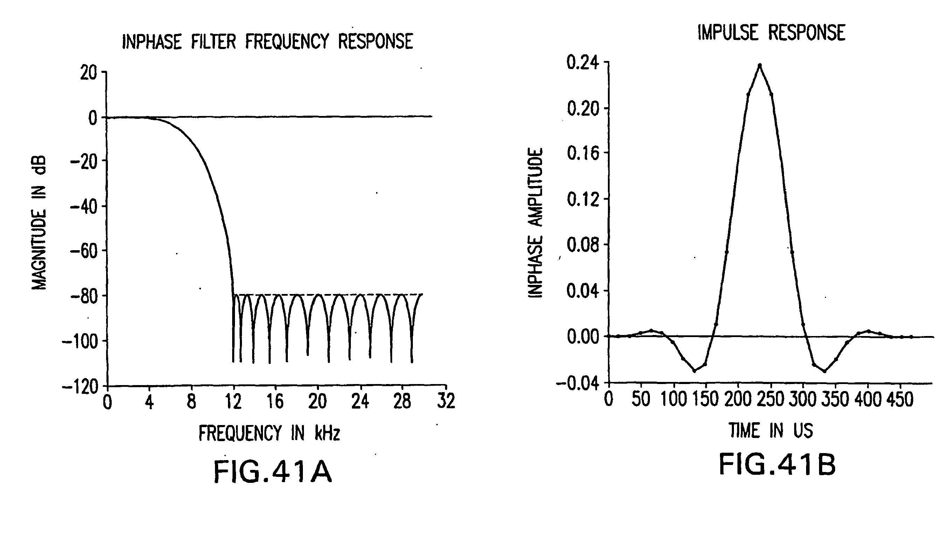

Whereas versions of the B meter and the D meter perform metering, the D meter also is responsible for collecting the metering information from the various B meters via PCB 234. Each data stream in the meters has an associated circuit to effect analog amplification and anti-aliasing. Each of the analog front end sections has a programmable attenuator that is controlled by the higher level code. The data stream is sampled at 60 kHz ($2^{10}$ * 60) and then an FIR filter is applied to decimate the data stream to ~15 kHz ($2^8$ * 60). Preferred filter specifications are shown in the table below and FIG. 41.

| | |
|---|---|
| Number of Taps | 29 |
| Stop Band Attenuation | 80.453dB |
| Pass band Upper Freq | 3kHz |
| Stop band Lower Freq | 12kHz |

Since only the data up to 3 kHz is of interest, praferably a 3-12 kHz roll off on the decimating FIR is used with ~15kHZ sample rate. The frequencies from 0-3 kHz or 12-15 kHz are mapped into 0-3 kHZ. A real FFTs is performed to yield 2 streams of data which can be further decomposed into 4 streams of data: Real and Imaginary Voltage and Real and Imaginary Current. This is achieved by adding and subtracting positive and negative mirror frequencies for the real and imaginary parts, respectively. Since the aliased signal in the 12-15 kHZ range falls below 80 dB, the accuracy is achieved using the above-discussed FIR filter. Alternatively, a 256-point complex FFT can be performed on every phase of the decimated data stream. This yields 2 pairs of data streams: a real part, which is the voltage, and an imaginary part, which is the current. This approach requires a 256 complex FFT every 16.667 milliseconds.

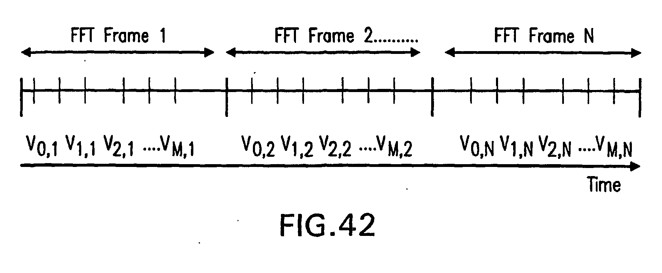

The results of performing either FFT are the voltage and current shown in FIG. 42, where the notation $V_{m,n}$ denotes the $m^{th}$ harmonic of the $n^{th}$ cycle number. For example, $V_{11}$ and $I_{11}$ correspond to the fundamental of the first cycle, and $V_{21}$ and $I_{21}$ to the first harmonic of the first cycle, etc., as shown in FIG. 42, which depicts FFT frames for voltage, indicating the harmonics.

The real and imaginary parts of the harmonic content of any $k^{th}$ cycle are given by:

$$V_{mk} = \mathrm{Re}(V_{mk}) + i\,\mathrm{Im}(V_{mk}); m = 1...M$$

$$I_{mk} = \mathrm{Re}(I_{mk}) + i\,\mathrm{Im}(I_{mk}); k = 1....n$$

The imaginary part of voltage is the measure of lack of synchronization between the PLL and the line frequency. In order to calculate metering quantities, the calculations are done in the time domain. In the time domain, the FFT functionality offers the flexibility to calculate metering quantities either using only the fundamental or including the harmonics. Using the complex form of voltage and current obtained from the FFT, the metering quantities are calculated as:

$$P = V_{mk} * I_{mk}^{\;\bullet}$$

$$W = \mathrm{Re}(P) = \mathrm{Re}(V_{mk}) * \mathrm{Re}(I_{mk}) + \mathrm{Im}(I_{mk}) * \mathrm{Im}(V_{mk})$$

$$Var = \mathrm{Im}(P) = \mathrm{Re}(I_{mk}) * \mathrm{Im}(V_{mk}) - \mathrm{Re}(V_{mk}) * \mathrm{Im}(I_{mk})$$

$$PowerFactor = W / P$$

However, in the above formulas, when the harmonics are included ($V_{mk}$ & $I_{mk}$; $m = 1...M$, $k = 1...n$), all metering quantities include the effects of harmonics. On the other hand, when only the fundamental is used ($V_{lk}$ & $I_{lk}$), all calculated quantities represent only the 60 Hz contribution. As an example, we show the calculations when only the fundamental is used to perform calculations. Only $V_l$ and $I_l$ are used from all FFT data frames. The following quantities are calculated for a given set of $N$ frames and a line frequency of $f_{line}$ :

$$kWh = \sum_{t=1}^{N}[\mathrm{Re}(V_{1t}) * \mathrm{Re}(I_{1t}) + \mathrm{Im}(V_{1t}) * \mathrm{Im}(I_{1t})] * \Delta t_{t} * 10^{-3}$$

$$kVAr = \sum_{t=1}^{N}[\mathrm{Re}(I_{1t}) * \mathrm{Im}(V_{1t}) - \mathrm{Re}(V_{1k}) * \mathrm{Im}(I_{1k})] * \Delta t_{t} * 10^{-3}$$

$$kVAh = \sum_{t=1}^{N}|V_{1t}| * |I_{1t}| * \Delta t_{t} * 10^{-3} \qquad\qquad ; \Delta t = \frac{1}{f_{line}}$$

$$V^2h = \sum_{t=1}^{N} |V_{1t}|^2 * \Delta t,$$

$$I^2h = \sum_{t=1}^{N} |I_{1t}|^2 * \Delta t,$$

The displacement power factor is given by:

$$Cos(\theta) = \left| \frac{W}{VA} \right| \; ; \text{ where } W \text{ and } VA \text{ include only the fundamentals and } VA_l = V_lRMS^* I_lRMS; \text{ where}$$

$$V_1RMS = \sqrt{\sum_{n=1}^{N} |V_{1,n}|^2} \; \& \; I_1RMS = \sqrt{\sum_{n=1}^{N} |I_{1,n}|^2} \; ; \; \text{for N cycles.}$$

This flexibility to either include or exclude the harmonics when calculating metering quantities translates to a significant improvement over the capabilities offered by the above-described embodiment Yet another feature offered by this embodiment is the calculation of Total Harmonic Distortion (THD). The THD is the measurement of the harmonic distortion present, and is defined as the ratio of the sum of the powers of all harmonic components to the power of the fundamental. For the $n^{th}$ cycle, this is evaluated as:

$$VTHD_n = \frac{\sqrt{\sum_{m=2}^{M} V_{mn}^2}}{V_{1n}} \; \& \; ITHD_n = \frac{\sqrt{\sum_{m=2}^{M} I_{mn}^2}}{I_{1n}} \; ;$$

$V_{mm}$ ($I_{mm}$) is the $m^{th}$ harmonic from the $n^{th}$ cycle obtained from the FFT, where

$$V_{mn}^2 = Re(V_{mn})^2 + Im(V_{mn})^2 \; \& \; I_{mn}^2 = Re(I_{mn})^2 + Im(I_{mn})^2.$$

Customer Display Module

The customer display module is installed at the customer premises, communicates with Energy Guard near the transformer, and comprises: PCB 240, power supply and PLC circuitry (see FIG. 33); and PCB 220, LCD display (see FIG. 34). In one embodiment, the customer display unit installed at customers residence is a bidirectiorod PLC unit that communicates with EG. For example, not only can the utility send messages, the customer can also request a consumption verification with the EG installed at the pole.

APPENDIX

LCM.DEF

```
; QLC LCM (Load Control Module) program for PIC 16C63A;
;
        include 'C:\pictools\16c63a.inc'
;       include 'C:\pictools\16c63.inc'            ;
```

; Configuration bits

```
        FUSES _BODEN_OFF ; Brown-out reset disabled
        FUSES _CP_OFF            ; No code protect
        FUSES _PWRTE_OFF ; Disable power-up timer
        FUSES _WDT_ON            ; Watchdog Timer Enabled
        FUSES _RC_OSC            ; Oscillator = RC
```

; Program Parameter Equates

```
Software_type   equ     7       ; Which PIC program is this?
                                ; 7 = LCM program
Software_version equ    2       ; Version #

LCM_base_addr equ       16      ; Address of first LCM

Ram_start       equ     020h    ; Beginning of available RAM

RESET_VECTOR            equ     0       ; Location of reset vector

ROM_start       equ     008h    ; first available program location

Num_start_bits equ      12      ; Number of start bits
;
;       Port definitions
;
comm_port       equ     PORTA

data_out        equ     3
data_in         equ     4
clock_in        equ     5

ctl_port equ    PORTA

driver_enable   equ     0                       ; output bit to turn on the drivers

Driver_enable_mask      equ     1 << driver_enable
```

;       Initialization values for I/O ports

```
init_TRISA      equ     00110000b       ; Data direction for port A

init_TRISB      equ     000h            ; B port data direction - all ports output
init_TRISC      equ     000h            ; C port data direction - all out
```

```
read_TRISC      equ      01fh            ; C port data direction for jumper read - 0-4 in

Init_comm_port_value  equ      1 << data_out + Driver_enable_mask

option_reg_val  equ      10001111b ; Option register init value

;              bit 7 = 1:      Port B pullups disabled
;              bit 6 = 0:      Int on falling edge
;              bit 5 = 0:      Timer 0 uses inst clock
;         .    bit 4 = 0:      Timer 0 counts on rising edge
;              bit 3 = 1:      Prescaler used by WDT
;              bit 2,1,0 = 111:Prescaler divide by 128

; NOTE - interrupts and timer 0 are not used by this program

ms_preset       equ      700      ; Time set for millisecond delay
;

; RAM locations

        ORG     Ram_start

Status_reg              ds      4       ; status register
                ORG     Status_reg
Status_MSB              ds      1

Clk_timeout_flag        equ     7       ; Timeout waiting for comm clock edge
bad_reset_flag          equ     6       ; Non-POR, non-WDT reset encountered
POR_flag                equ     5       ; Power-on reset detected
WDT_reset_flag                  equ     4       ; WDT reset, not from sleep

Status_LSB              ds      1

CPU_reset_flag          equ     7
Need_param_refresh_flag         equ     6
Parity_err_flag         equ     5

Global_cmd_timer        ds      1

Jumper_state            ds      1       ; current state of input jumpers

Parameter_reg           ds      4       ; Communication parameters
                        org     Parameter_reg
                        ds      1       ;
                        ds      2       ;
                .       ds      1       ;
;
; Fast communication variables
;
.
Comm_state              ds      1       ; Stored state of fast comm uart
Wstate                  ds      1       ; Stored state of fast comm word handler
Comm_bit_count                  ds      1       ; Bit counter for fast comm
Comm_buffer             ds      1       ; fast comm word buffer
```

```
Work_addr          ds     1      ; Address read from jumpers
Temp               ds     1      ; temporary register
Tpar               ds     1      ; Transverse parity
Word_count         ds     1      ; Counter for sending and receiving 5-bit words
Command                   ds     1      ; Command received over comm link
Register_ID        ds     1      ; Register specified in comm command
PIC_addr           ds     1      ; Address of this PIC chip
Comm_buf           ds     5      ; Communication buffer

Input_hold         ds     1      ; Hold register for comm rcv value

Output_bit_reg     ds     4      ; Hold register for output bit mask

Flags              ds     1      ; Program control flags

Clk_wait_flag      equ    7      ; indicates which clock edge we are waiting for
Global_cmd_flag           equ    6      ; Processing global command

scratch            ds     1      ; Work register
Timeout_ctr        ds     2      ; Counter for pulse duration
Millisecs          ds     1      ; Counter for pulse duration milliseconds

Clk_timeout_ctr           ds     2      ; counter for clock timeout

NPR_timer          ds     2      ; counter for need parameter refresh

;

       ORG    0a0h

; Bank 1 RAM locations

       IF     $ - 1 and 0100h
       error - RAM overflow
       ENDIF

;

       ORG    RESET_VECTOR
       jmp    start                      ; Jump to first program location
;
;      Start of program space
;
       ORG    ROM_start

;
;      Initialization
;
Start
       setb   RP0                        ; point to upper register bank
       jnb    NOT_POR,got_POR            ; Power on reset, set flags
       clrb   RP0                        ; point to RAM bank 0
       jnb    NOT_TO,WDT_reset  ; Watchdog reset
       setb   status_MSB.bad_reset_flag        ; Indicate unknown reset condition
       jmp    Do_initialize
```

```
WDT_reset
        setb    Status_MSB.WDT_reset_flag
        jmp     do_initialize
got_POR
        clrb    RP0                     ; point to RAM bank 0
        mov     Status_MSB,#1 << POR_flag ; Set POR flag
        clr     Status_LSB
Do_initialize
        mov     FSR,#Ram_start+2        ; Point past status flags
:clr_loop
        clr     INDF                    ; Clear RAM location
        inc     FSR                     ; Increment pointer
        jz      Init_state              ; If zero, done
        mov     W,FSR                   ; get pointer
        and     W,#7fH                  ; look at 7 LSB's
        jnz     :clr_loop               ; Not end of segment, continue
        add     FSR,#20h                ; Point to next segment
        jmp     :clr_loop               ; Not last segment, continue
Init_state

        setb    Status_LSB.CPU_reset_flag         ; Indicate CPU reset
        setb    Status_LSB.Need_param_refresh_flag ; Indicate parameter refresh needed
        mov     comm_port,#Init_comm_port_value    ; initialize comm port state
        mov     Comm_state,#Edge_wait
        mov     Comm_bit_count,#Num_start_bits     ; Initialize fast comm state
machine
        clr     PORTB
        clr     PORTC
        jmp     Main_loop               ; start running main program


;
; Comm Receive routines
;
Edge_wait
                                        ; Initialize Watchdog timer
        mov     !OPTION,#option_reg_val         ; Set option reg
        setb    comm_port.data_out              ; send a 1
        dec     Comm_bit_count                  ; decrement bit count
        jz      See_edge_one                    ; if zero, looking for a 1
        jb      Input_hold.data_in,Set_edge_wait ; Looking for 0, reset bit count if 1
        jmp     Comm_ret                        ; done
See_edge_one
        jnb     Input_hold.data_in,Set_edge_wait ; looking for 1, reset if 0
        mov     Wstate,#Rcv_addr                ; First word is address
        mov     Tpar,#01fh                      ; Init parity
        jmp     Rcv_next_word

Rcv_stop
        mov     Comm_state,#Edge_wait
        mov     Comm_bit_count,#Num_start_bits  ; Preset state to wait for edge
        jnb     Input_hold.data_in,Parity_error ; stop bit must be 1
        jmp     Cmd_exec                        ; Done, process received buffer

Rcv_bits
        clc                                     ; copy ...
```

```
        snb     Input_hold.data_in      ;       ... input bit ...
        setc                            ;           ... to carry
        rl      Comm_buffer             ; shift buffer
        jmp     Rcv_word_handler        ; Check for complete word
;
; Comm Transmit routines
;
Send_edge
        dec     Comm_bit_count                  ; decrement bit count
        jz      :One                    ; if zero, send a 1
        clrb    comm_port.data_out      ; send a 0
        jmp     Comm_ret
:One
        setb    comm_port.data_out      ; send a 1
        jmp     Do_xmit_word


Send_bits
        rl      Comm_buffer             ; put xmit bit into carry
        jc      :one
        clrb    comm_port.data_out      ; send a '0'
        jmp     :check
:one
        setb    comm_port.data_out      ; send a '1'
:check
        jmp     Xmit_word_handler



;
;       Comm receive word handler routines
;


Rcv_word_handler
        djnz    Comm_bit_count,Comm_ret         ; If word not complete, continue
        and     Comm_buffer,#03fh               ; only 6 bits
        clc
        mov     W,>>Comm_buffer                 ; get 5 MSBs of received word
        call    parity_lookup
        xor     W,Comm_buffer                   ; compare with received word
        jnz     Parity_error
        rr      Comm_buffer
        and     Comm_buffer,#01fh               ; extract 5-bit value
        xor     Tpar,Comm_buffer                ; calculate total parity
        mov     PCLATH,#Rcv_addr<
        mov     W,Wstate
        jmp     W                               ; Execute word handler routine


Rcv_addr
        clrb    Flags.Global_cmd_flag ; Clear global command flag
        mov     W,Comm_buffer                   ; Get received address
        mov     PIC_addr,W      ; save it
        xor     W,#1fh          ; is it global command
        jnz     See_if_us       ; No, check for address match
        setb    Flags.Global_cmd_flag ; Set global command flag
        jmp     Its_us          ; process rest of command
See_if_us
```

```
                    mov    !PORTC,#read_TRISC  ; Switch C port bit 0-4 to input
                    clrb   ctl_port.driver_enable  ; Disable output drivers, enable jumper read
                    mov    temp,#9
             :loop
                    djnz   temp,:loop           ; Wait at least 20 uSec
                    mov    W,/PORTC             ; Get inverse of jumpers in W
                    mov    Work_addr,W          ; Save jumper value
                    setb   ctl_port.driver_enable  ; Enable output drivers
                    mov    !PORTC,#init_TRISC   ; Restore C port status
                    mov    Jumper_state,Work_addr   ; Save jumper state
                    and    Work_addr,#03h           ; Ignore all but 2 LSBs
                    add    Work_addr,#LCM_base_addr ; Add base offset
                    cjne   Work_addr,PIC_addr,Set_edge_wait
             Its_us
                    mov    Wstate,#Rcv_cmd      ; point to next routine
                    jmp    Rcv_next_word


             Rcv_cmd
                    mov    Command,Comm_buffer              ; save command
                    jnb    Command.4,Comm_get_fast          ; Fast read command, skip Reg ID
                    mov    Wstate,#Rcv_reg_ID   ; point to next routine
                    jmp    Rcv_next_word
             Comm_get_fast
                    mov    Wstate,#Rcv_tpar     ; point to next routine
                    jmp    Rcv_next_word


             Rcv_reg_ID
                    mov    register_ID,Comm_buffer          ; save register number
                    mov    Wstate,#Rcv_tpar     ; point to next routine
                    jnb    Command.3,Rcv_next_word          ; If no value, done
                    mov    word_count,#7        ; Init word count
                    mov    Wstate,#Rcv_value    ; point to next routine
                    jmp    Rcv_next_word


             Rcv_value
                    rl     Comm_buffer
                    rl     Comm_buffer
                    rl     Comm_buffer          ; Shift rcvd bits to MSBs
                    mov    Comm_bit_count,#5     ; shift 5 bits
             :shift_loop
                    rl     Comm_buffer
                    rl     Comm_buf+4
                    rl     Comm_buf+3
                    rl     Comm_buf+2
                    rl     Comm_buf+1
                    rl     Comm_buf             ; Shift a bit from Comm_buf to comm_buf
                    djnz   Comm_bit_count,:shift_loop
                    djnz   word_count,Rcv_next_word          ; any more words?
                    mov    Wstate,#Rcv_tpar     ; point to next routine
                    jmp    Rcv_next_word


             Rcv_tpar
                    mov    W,Tpar               ; Get result of parity calculations
                    jnz    Parity_error         ; If not 0, parity error
                    jmp    Set_rcv_stop         ; set up to receive stop bit
```

```
;
;        Comm transmit word handler routines
;

Xmit_word_handler
        djnz    Comm_bit_count,Comm_ret         ; If word not complete, continue
Do_xmit_word
        mov     PCLATH,#$<
        mov     W,Wstate
        jmp     W                               ; Execute word handler routine


Send_addr
        mov     Wstate,#Send_cmd>               ; point to next word routine
        mov     W,PIC_addr                      ; get address
        jmp     Send_next_word


Send_cmd
        mov     Wstate,#Send_value>             ; point to send value
        jnb     Command.4,Value_is_next              ; Is it fast read command?
        mov     Wstate,#Send_reg_ID>            ; point to next word routine
Value_is_next
        mov     W,Command                       ; get command
        jmp     Send_next_word


Send_reg_ID
        mov     Wstate,#Send_value>             ; point to next word routine
        mov     W,Register_ID                   ; get Register ID
        jmp     Send_next_word

Send_value
        mov     Wstate,#Next_value>             ; point to next word routine
        mov     Word_count,#7                   ; value is 7 words long


Next_value
        mov     Comm_bit_count,#5
:loop
        rl      comm_buf+4                                      .
        rl      comm_buf+3
        rl      Comm_buf+2
        rl      Comm_buf+1
        rl      Comm_buf
        rl      Comm_buffer
        djnz    Comm_bit_count,:loop
        mov     W,Comm_buffer                           ; Get 5-bit word
        djnz    word_count,Send_next_word       ; if not last word, all set
        mov     Wstate,#Send_Tpar>              ; send parity next
        mov     W,Comm_buffer
        jmp     Send_next_word

Send_Tpar
        mov     Wstate,#Send_stop              ; point to next word routine
        mov     W,Tpar                         ; get transverse parity
```

```
            jmp     Send_next_word

Send_stop
            jmp     Set_edge_wait                  ; Go back to receive mode


;
;
;        Process received buffer
;
            org     100h

Cmd_exec
Process_cmd
            cjbe    Command,#7h,Fast_register_read      ; is it fast read?
            cje     Command,#10h,read_register   ; is it read register command?
            cje     Command,#18h,write_register  ; is it write register?
            cje     Command,#19h,reset_status_bits       ; is it reset status?
            jmp     Cmd_process_done
Fast_register_read
            mov     register_ID,command    ; Register number is same as command code
Read_register
            mov     W,#27
            mov     W,register_ID-W               ; Get index of register to read
            jnc     Cmd_process_done       ; if negative, not a valid register
            mov     Temp,W                            ; save index
            mov     PCLATH,#$<             ; set up High-order PC bits
            mov     W,Temp                            ; get index
            jmp     PC+W
            jmp     cpy_output_reg
            jmp     cpy_reg_28
            jmp     cpy_reg_29
            jmp     cpy_reg_30
Cpy_reg_31                                  ; Reg 31 = Status register
            mov     Comm_buf,Status_reg
            mov     Comm_buf+1,Status_reg+1
            mov     Comm_buf+2,Status_reg+2
            mov     Comm_buf+3,Status_reg+3
            jmp     Setup_reply


Cpy_reg_30                                  ; Reg 30 = Serial number
            call    serno
            mov     comm_buf+3,W
            call    serno+1
            mov     comm_buf+2,W
            call    serno+2
            mov     comm_buf+1,W
            call    serno+3
            mov     comm_buf,W
            jmp     Setup_reply


Cpy_reg_29                                  ; Reg 29 = Software type and version
            mov     Comm_buf,#Software_type
            mov     Comm_buf+1,#Software_version
            mov     Comm_buf+2,#0
            mov     Comm_buf+3,#0                     ; Send Software type and version
```

21

```
            jmp     Setup_reply

Cpy_reg_28                          ; Reg 28 = Parameter reg
            mov     Comm_buf,Parameter_reg
            mov     Comm_buf+1,Parameter_reg+1
            mov     Comm_buf+2,Parameter_reg+2
            mov     Comm_buf+3,Parameter_reg+3
            jmp     Setup_reply

Cpy_output_reg                      ; Reg 27 = Output state
            mov     Comm_buf,Output_bit_reg
            mov     Comm_buf+1,Output_bit_reg+1
            mov     Comm_buf+2,Output_bit_reg+2
            mov     Comm_buf+3,Output_bit_reg+3
            jmp     Setup_reply

Write_register
            mov     Comm_bit_count,#5                           ; need to shift buffer by 5
bits
:loop
            rl      comm_buf+4
            rl      comm_buf+3
            rl      comm_buf+2
            rl      comm_buf+1
            rl      comm_buf
            djnz    Comm_bit_count,:loop
            cjne    Register_ID,#28,See_write_output_reg   ; Not reg 28, see if output reg
            mov     Parameter_reg,Comm_buf
            mov     Parameter_reg+1,Comm_buf+1
            mov     Parameter_reg+2,Comm_buf+2
            mov     Parameter_reg+3,Comm_buf+3           ; Copy received data to reg
            clrb    Status_LSB.Need_param_refresh_flag   ; Reset need parameter refresh flag
            jmp     Cpy_reg_28                            ; send contents back in reply
See_write_output_reg
            cjne    Register_ID,#27,Cmd_process_done      ; if not output reg, ignore
            mov     Output_bit_reg,Comm_buf
            mov     Output_bit_reg+1,Comm_buf+1
            mov     Output_bit_reg+2,Comm_buf+2
            mov     Output_bit_reg+3,Comm_buf+3           ; Copy received data to reg
            call    Update_outputs
            jmp     Cpy_output_reg                        ; send contents back in reply

Reset_status_bits
            mov     Comm_bit_count,#5                           ; need to shift buffer by 5
bits
:loop
            rl      comm_buf+4
            rl      comm_buf+3
            rl      comm_buf+2
            rl      comm_buf+1
            rl      comm_buf
            djnz    Comm_bit_count,:loop
            mov     W,/Comm_buf+1                              ; get byte
            and     Status_reg+1,W                     ; Clear bits
    /       mov     W,/Comm_buf                        ; get MSB
```

```
        and     Status_reg,W              ; Clear bits
        mov     Register_ID,#31                    ; indicate status reg in reply
        jmp     Cpy_reg_31

                        .

Setup_reply
        jb      Flags.Global_cmd_flag,Set_edge_wait  ; If it was global, don't reply
        mov     W,Status_LSB             ; Get status LSB
        mov     Comm_buf+4,W                       ; preset stored flags
        and     W,#01fh                            ; Turn off 3 MSBs
        or      W,Status_MSB             ; Combine 5 LSbs with Status_MSB
        sz
        setb    Comm_buf+4.7             ; If any other flag bits set, indicate in
MSB
        mov     Tpar,#1fh                ; Initialize parity word
        mov     Comm_state,#Send_edge              ; Go to send_edge state
        mov     Wstate,#Send_addr        ; Point to next routine
        mov     Comm_bit_count,#Num_start_bits     ; Init number of bits
        jmp     Comm_ret


Cmd_process_done
        jmp     Set_edge_wait            ; No reply needed, done


;
; Exit routines for comm
;


Parity_error
        setb    status_LSB.Parity_err_flag    ; Indicate parity error
Set_edge_wait
        mov     Comm_state,#Edge_wait         ; Go to edge wait state
        mov     Comm_bit_count,#Num_start_bits ; Init number of bits
        jmp     Comm_ret


Set_send_reply
        mov     Comm_state,#Send_edge         ; Go to send edge state
        mov     Comm_bit_count,#Num_start_bits
        jmp     Comm_ret


Rcv_next_word
        mov     Comm_state,#Rcv_bits          ; set up to receive 6-bit word
        mov     Comm_bit_count,#6
        jmp     Comm_ret


Send_next_word
        and     W,#01fh                       ; only 5 bits
        xor     Tpar,W                        ; update parity calculation
        call    parity_lookup
        mov     Comm_buffer,W                 ; Save word with parity (6 bits)
        rl      Comm_buffer
        rl      Comm_buffer                   ; move to MSbs
        mov     Comm_state,#Send_bits         ; set up to send 6-bit word
        mov     Comm_bit_count,#6
        jmp     Comm_ret


Set_rcv_stop
```

```
            mov     Comm_state,#Rcv_stop        ; point to next routine
            jmp     Comm_ret

            ORG     200h
Semo
;           retw    05ah,092h,05fh,000h
;           retw    0ffh,0ffh,0ffh,0ffh
            ds      4
            ret

;
;
;
;           Returns 6-bit value corresponding to passed 5-bit value with odd parity
;
parity_lookup
            mov     Temp,W                  ; Save index
            mov     PCLATH,#:table<         ; Set up high-order bits
            mov     W,Temp                  ; get index
            jmp     pc+w
:table
            retw
            1,2,4,7,8,11,13,14,16,19,21,22,25,26,28,31,32,35,37,38,41,42,44,47,49,50,52,55,56,5
9,61,62


;
;           Sets output bits according to received data
;           Comm_buf = Pulse duration in milliseconds
;                           0:      Continuous output (infinite duration)
;                           1-255:  Set output state for specified duration
;                                   After duration is over, turn all outputs off
;
;           Comm_buf+1[3] = Bit map of output states - MSB first
;                           bits 23-18:     Unused
;                           bits 17-0:      Outputs 18-1
;

Update_outputs
            mov     W,Comm_buf+3        .       ; get lsbs
            and     W,#03h              ; only need 2 bits
            mov     Temp,W
            add     Temp,W                      ; Shift into bits 1 and 2 (X1 and X2)
            mov     W,PORTA                     ; Get present status of port A pins
            and     W,#0f9h                     ; clear output control bits
            or      W,Temp                      ; Set desired output state
            mov     PORTA,W                     ; output new value
            rr      comm_buf+1
            rr      comm_buf+2
            rr      comm_buf+3
            rr      comm_buf+1
            rr      comm_buf+2
            rr      comm_buf+3                  ; shift buffer left 2 bits
            mov     PORTB,comm_buf+2
            mov     PORTC,comm_buf+3
            mov     !PORTA,#init_TRISA
```

24

```
        mov     !PORTB,#init_TRISB
        mov     !PORTC,#init_TRISC
        mov     Millisecs,Comm_buf    ; first byte is pulse duration
        jz      done_output_set
ms_loop
        mov     Timeout_ctr,#ms_preset<
        mov     Timeout_ctr+1,#ms_preset>
:loop
        djnz    Timeout_ctr+1,:loop
        djnz    Timeout_ctr,:loop
        djnz    Millisecs,ms_loop     ; delay for pulse duration
        and     PORTA,#0f9h           ; turn off X1 and X2
        clr     PORTB
        clr     PORTC                 ; turn off other outputs
done_output_set
        ret




        ;
        ;       Main Program start
        ;


Main_loop
        mov     !PORTA,#Init_TRISA  ; Initialize port A direction
        mov     !PORTB,#Init_TRISB  ; Initialize port B direction
        mov     !PORTC,#Init_TRISC  ; Init port C direction
        mov     Clk_timeout_ctr,#12 ; preset ...
        clr     Clk_timeout_ctr+1   ; ... clock timeout counter
        clrb    Flags.Clk_wait_flag ; Indicate waiting for clock low
Clkwait_loop
        djnz    scratch,Clk_cont
        clr     WDT                         ; Reset watchdog
        djnz    Clk_timeout_ctr+1,Clk_cont
        djnz    Clk_timeout_ctr,Clk_cont
        jb      Status_MSB.POR_flag,got_POR        ; Ignore clock timeout until POR
flag cleared
        setb    Status_MSB.Clk_timeout_flag ; Indicate timeout on comm clock
        jmp     do_initialize
Clk_cont
        jb      Comm_port.clock_in,:high    ; clock high
:low
        jb      Flags.Clk_wait_flag,Clkwait_loop
        mov     Input_hold,Comm_port        ; Save Data port value
        setb    Flags.Clk_wait_flag         ; Indicate waiting for clock high
        jmp     Clkwait_loop
:high
        jnb     Flags.Clk_wait_flag,Clkwait_loop
        djnz    NPR_timer+1,:cont           ; Dec LSB of need parm timer
        djnz    NPR_timer,:cont             ; Dec MSB
        setb    Status_LSB.Need_param_refresh_flag  ; set flag every 64k clocks
:cont   ,
        mov     PCLATH,#0                   ; Set up high-order bits for routines in page 0
        mov     W,Comm_state                ; get vector
        jmp     W..                         ; Execute comm state machine
```

```
Comm_ret
        jmp    Main_loop
```

PIC.DEF

```
/*
include file for serial communication with PIC chips
*/

#pragma switch(ALL,FREQ)

    switch (PIC_serial_status)
        {
        case sending_bits:
        case sending_st5_bits:

#ifdef VATEST

        out_bit_value = (PICxmitBuf.bits.bufLong[0] and 0x80000000) != 0;    /* out bit value =
MSB */
        PICxmitBuf.bits.bufLong[0] = PICxmitBuf.bits.bufLong[0] << 1;
        if (PICxmitBuf.bits.bufLong[1] and 0x80000000)
            PICxmitBuf.bits.bufLong[0]++;
        PICxmitBuf.bits.bufLong[1] = PICxmitBuf.bits.bufLong[1] << 1;
        if (PICxmitBuf.bits.bufLong[2] and 0x80000000)
            PICxmitBuf.bits.bufLong[1]++;
        PICxmitBuf.bits.bufLong[2] = PICxmitBuf.bits.bufLong[2] << 1;       /* Shift 96-bit
buffer */

#else
        out_bit_value = 0;
        shift_LSB_ptr = andPICxmitBuf.bits.bufByte[12];   /* point past least significant word
of 96-bit register */
        asm(" MOVE.L   _shift_LSB_ptr,A0",              /* Get pointer to buffer, clear carry */
            " ROXL.W   -(A0)",                  /* rotate left and decrement pointer */
            " ROXL.W   -(A0)",                  /* rotate left and decrement pointer */
            " ROXL.W   -(A0)",                  /* rotate left and decrement pointer */
            " ROXL.W   -(A0)",                  /* rotate left and decrement pointer */
            " ROXL.W   -(A0)",                  /* rotate left and decrement pointer */
            " ROXL.W   -(A0)",      ·           /* 96 bits have been shifted, MSB is in carry
*/
            " ROXL.W   _out_bit_value"          /* Put MSB in out_bit_value */
            );          ·

#endif
            break;
        case do_send_cmd:
            bit_count = NUM_START_BITS-1;
            PIC_serial_status = sending_start;
            out_bit_value = 0;
            break;
        case do_PIC_start :
            bit_count = 3 * BITS_PER_SEC;
            out_bit_value = 1;
            PIC_serial_status = sending_PIC_start;
            break;
        case sending_start:
            out_bit_value = 0;
            break;
```

```
    case sending_stop:
    case sending_start_1:
      out_bit_value = 1;
      break;
    default:
      out_bit_value = 1;
    }

if (out_bit_value)
   fs1004.io.pulseOut2Off = 1;
else
   fs1004.io.pulseOut2Off = 0;        /* Send bit out */
in_bit_value = fs1004.io.pulseIn1State;    /* Get rcvd bit value */
fs1004.io.pulseOut1Off = 1;          /* Send clock rising edge */

switch (PIC_serial_status)
   {
   case waiting_for_start:
     if (in_bit_value == 0)
        zero_count++;
     else
        {
        if (zero_count == (NUM_START_BITS-1))
           {
           PIC_serial_status = rcving_bits;
           bit_count = PICrcvBuf.bitCount + 1;
           }
        else
           zero_count = 0;
        } .
     break;
   case rcving_bits:

#ifdef VATEST

     PICrcvBuf.bits.bufLong[0] = PICrcvBuf.bits.bufLong[0] << 1;
     if (PICrcvBuf.bits.bufLong[1] and 0x80000000)
        PICrcvBuf.bits.bufLong[0]++;
     PICrcvBuf.bits.bufLong[1] = PICrcvBuf.bits.bufLong[1] << 1;
     if (PICrcvBuf.bits.bufLong[2] and 0x80000000)
        PICrcvBuf.bits.bufLong[1]++;
     PICrcvBuf.bits.bufLong[2] = (PICrcvBuf.bits.bufLong[2] << 1) +
        in_bit_value;
#else

     shift_LSB_ptr = andPICrcvBuf.bits.bufByte[12];   /* point past least significant word
of 96-bit register */
       asm(" MOVE.L  _shift_LSB_ptr,A0",        /* Get pointer to buffer, clear carry */
         " ROXL.W  -(A0)",         /* rotate left and decrement pointer */
         " ROXL.W  -(A0)",         /* rotate left and decrement pointer */
         " ROXL.W  -(A0)",         /* rotate left and decrement pointer */
         ". ROXL.W  -(A0)",         /* rotate left and decrement pointer */
         " ROXL.W  -(A0)",         /* rotate left and decrement pointer */
         " ROXL.W  -(A0)"          /* 96 bits have been shifted, LSb is unknown
*/
```

```
  );
  PICrcvBuf.bits.bufByte[11] =
    (PICrcvBuf.bits.bufByte[11] and 0xfe) | in_bit_value;        /* add in received bit */

#endif

    break;
  default:
    {
    }
  }

  if (--bit_count <= 0)
    {
    switch (PIC_serial_status)
      {
      case rcving_bits:
        PIC_serial_status = rcving_stop;
        bit_count = 1;
        break;
      case sending_bits:
        PIC_serial_status = sending_stop;
        bit_count = 1;
        break;
      case sending_stop:
        if (PICxmitBuf.PIC_addr == GLOBAL_PIC_ADDR)
          PIC_serial_status = idle;
        else
          {
          PIC_serial_status = waiting_for_start;
          bit_count = PIC_wait_limit;
          zero_count = 0;
          }
        break;
      case sending_PIC_start:
        PIC_serial_status = idle;
        break;
      case sending_start:
        PIC_serial_status = sending_start_1;
        bit_count = 1;
        break;
      case sending_start_1:
        PIC_serial_status = sending_bits;
        bit_count = PICxmitBuf.bitCount;
        break;
      case waiting_for_start:
        PICrcvBuf.flags |= rcv_timeout_flag | rcv_data_ready_flag;
        PIC_serial_status = idle;
        break;
      case rcving_stop:
        if (in_bit_value == 0)
          PICrcvBuf.flags |= rcv_bad_length_flag;
        PIC_serial_status = idle;
        PICrcvBuf.flags |= rcv_data_ready_flag;
        bit_count = 1;
```

```
      break;
   default:
      PIC_serial_status = idle;
   }
}

#pragma switch(ALL,NOFREQ)
```

PULSE.C

```
#include "mtrlink.def"
/* #include "flash.def" */
#define PSTRU_DEFINED
#include "pulselink.def"

#include "pulse.h"
#include "ufloat.h"

#include "log.h"

#include "alarm.h"

#include "copymem.h"

#include "plcctrl.h"

#include <stdio.h>


#ifdef fakeMC5
   #undef NUMPH
   #define NUMPH 24
#endif

/* define WDT flags for the PIC communication routine */
#pragma region ("ram=WDTFlags")
short int  WDTpulseSec ;
#pragma region ("ram=ram")


#pragma region ("data=secondBack")
void (*pulseSecondp)(void)=pulseSecond;
#pragma region ("data=data")

#ifndef IS_MC5
#pragma region ("data=everySubsecond")
#ifdef IS_RSM
void (*pulseSubsecp)(void)=pulseSubsecond ;
#else
void (*pulseSubsecp)(void)=pulseService;
#endif
#pragma region ("data=data")
#endif

#pragma region ("data=powerUp")
void (*pulseStartupp)(void)=pulseStartup ;
#pragma region ("data=data")

#pragma region ("data=dayBack")
void (*pulseDayp)(void)=pulseDay ;
#pragma region ("data=data")
```

```
/* clear out PIC */
void pulseColdstart()
{
    int i ;
    for (i=0;  i<num_PICs;  i++)
        if (PIC_status[i].software_type == 3)
            {
            PIC_status[i].clear_pulse_regs = TRUE;
            PIC_status[i].get_status = TRUE;
            }
    clear_state = SEND_GLOBAL_CLR;
}


void pulseStartup(void)
{
    int i;

#ifndef IS_RSM
    int work_PIC_addr;
#endif
#ifdef IS_MC5
    int work_num_pulses;
#endif

#ifdef VATEST
/* test !!!!! */
    temp_command = SYSTEM_CONTROL;
    temp_reg_ID = 0;
    temp_command_data = READ_ENCODER_ID;
    temp_flags = rcv_data_ready_flag;
#endif

    for (i=0;(!dont_clear_PIC_stats) andand (i<(2*NUMPH));i++)
        {
        pulseData[i].error_cnt = 0;
        pulseData[i].ID_field[0]=0;
        pulseData[i].reading = 0;
        }

    for (i=0;  i<MAX_PICS;  i++)
        PIC_status[i].PIC_addr = 0;

    hold_num_pulse_ctrs = releaseCodep->option.numPulseCounters;
    if (hold_num_pulse_ctrs > NUMPH)
        num_pulse_ctrs = NUMPH;
    else
        num_pulse_ctrs = hold_num_pulse_ctrs;

    num_PICs = 1;

#ifdef IS_MC5
    PIC_status[0].PIC_addr = MC5_MUX_PIC_ADDR;   /* If MC5, add PDM PIC(s) to PIC
table */
```

```
if (int_configltmessg.configLTM[PULSE1].accum)
    {
    work_num_pulses = num_pulse_ctrs;
    work_PIC_addr = 0;
    while (work_num_pulses > 0)
        {
        PIC_status[num_PICs++].PIC_addr = work_PIC_addr++;   /* Pulse counters for Q13
*/
        work_num_pulses -= 4;
        } · .
    }
. if (int_configltmessg.configLTM[PULSE2].accum)
    {
    work_num_pulses = num_pulse_ctrs;
    work_PIC_addr = 6;
    while (work_num_pulses > 0)
        {
        PIC_status[num_PICs++].PIC_addr = work_PIC_addr++;   /* Pulse counters for Q14
*/
        work_num_pulses -= 4;
        }
    }
    num_LCMs = releaseCodep->option.LCM_flags and 0x03;
    work_PIC_addr = LCM_BASE_ADDR;
    for (i=0;i<num_LCMs;i++)
        {
        PIC_status[num_PICs++].PIC_addr = work_PIC_addr++;   /* LCM's */
        }
#else
#ifdef IS_ST5
    PIC_status[0].PIC_addr = ST5_MUX_PIC_ADDR;   /* If ST5, add mux to PIC table */
    ATM_work = releaseCodep->option.couplers_mask;
    work_PIC_addr = ATM_BASE_ADDR;
    for (i=0;i<4;i++)
        {
        if ((ATM_work and 0x08) != 0)
            {                /* Bit is set in mask, add ATM PIC to table */
            PIC_status[num_PICs++].PIC_addr = work_PIC_addr;
            }
        work_PIC_addr++;
        ATM_work = ATM_work << 1;
        }

#else
    if (num_pulse_ctrs == 0)
        num_PICs = 0;
#endif
#endif
    for (i=0; i<MAX_PICS; i++)
        {                                    /* Build PIC table */
        PIC_status[i].get_serno = TRUE;
        PIC_status[i].get_version = TRUE;
        PIC_status[i].get_status = FALSE;
        PIC_status[i].reset_status = FALSE;
        PIC_status[i].update_parameter = FALSE;
```

```
        if (!dont_clear_PIC_stats)
            {
            PIC_status[i].PIC_reset_count = 0;
            PIC_status[i].comm_error_count = 0;
            PIC_status[i].PIC_data_err_count = 0;
            PIC_status[i].software_type = 0;
            PIC_status[i].software_version = 0;
            PIC_status[i].serial_number = 0;
            }

        PIC_status[i].curr_pulse_reg = 0;

#ifdef IS_MC5

        if (PIC_status[i].PIC_addr >= ST5_MUX_PIC_ADDR)
            PIC_status[i].reply_wait_limit = DIRECT_PIC_WAIT_LIMIT;
        else
            PIC_status[i].reply_wait_limit = BUFFERED_PIC_WAIT_LIMIT;
#else
        PIC_status[i].reply_wait_limit = DIRECT_PIC_WAIT_LIMIT;
#endif

        if (PIC_status[i].PIC_addr <= MAX_PULSE_PIC_ADDR)
            PIC_status[i].num_pulse_regs = PULSES_PER_PIC;
        else·
            PIC_status[i].num_pulse_regs = 0;


        }

    current_PIC_index = 0;
    rcv_PIC_index = 0;

    if (dont_clear_PIC_stats)
        dont_clear_PIC_stats = FALSE;   /* Clear flag */
    else
        {
        PIC_bad_addr_count = 0;
        PICrcvBuf.flags = 0;
        PIC_serial_status = do_PIC_start;
        PIC_clk_state = clk_low;                /* Initialize serial comm variables */
        }

    clear_state = NO_GLOBAL_SEND;

    pulseOutMode = releaseCode.option.picMode ;   /* for compatibility with old code */

    if (startup.coldStart)
        {
        pulseColdstart() ;
        }
    }
```

```
const unsigned char parity6[32] =
{1,2,4,7,8,11,13,14,16,19,21,22,25,26,28,31,32,35,37,38,41,42,44,47,49,50,52,55,56,59,61,62
};


void pulseDay()
{
    dont_clear_PIC_stats = TRUE;   /* Tell pulseStartup not to clear error counts */
    rebuild_timer = REBUILD_DELAY;  /* Set up for delayed table rebuild */
}

void pulseSecond()
{
#ifndef IS_ST5
    pulseService();
#endif
    if (Comm_background_flags.do_rebuild)
        {
        pulseStartup();
        Comm_background_flags.do_rebuild = FALSE;
        }
    if (Comm_background_flags.do_alarm)
        {
        putAlarm(andPIC_alarm,4);
        Comm_background_flags.do_alarm = FALSE;
        }
}


/* set_PLC_relays function                 */
/* Called from PLC routines to request update of   */
/* PLC port multiplexer PIC chip on ST5 power board */

#ifdef IS_ST5

void set_PLC_relays(int xmitRelay,int rcvRelay)
{
- while (MUX_control.active_flag || MUX_control.request_flag)
        {
        ccwait();
        }
    MUX_control.xmit_mask = xmitRelay;
    MUX_control.rcv_mask = rcvRelay;
    MUX_control.done_flag = FALSE;
    MUX_control.request_flag = TRUE;
    if ((MUX_control.xmit_mask != MUX_control.last_xmit_mask) ||
        (MUX_control.rcv_mask != MUX_control.last_rcv_mask))
        {
        while (!MUX_control.done_flag andand
            !(MUX_control.active_flag andand (PIC_serial_status == rcving_bits)) )
            {
            ccwait();
            }
        }
    }
```

```
#endif

void pulseService(void)
{
   BOOLEAN   need_pulse_read,
         copy_rcvd_data,
         rcv_buf_err;

#ifdef IS_MC5
   BOOLEAN
            got_ver_3,
            got_ver_3_3;

   int      j;

   unsigned char  *work_char_ptr;

   unsigned long work_bit_mask;

#endif

   int      work_pulse_index;
   phaccum   accumXfer;
   int i ;

   if (num_PICs == 0)
      PIC_serial_status = idle;

   if (PIC_serial_status == idle)
      {
      if (!WDTpulseSec)
         WDTpulseSec=1;  /*Tell WDT controller that we are OK*/
      }

   if (hold_num_pulse_ctrs != releaseCodep->option.numPulseCounters)
      {                           /*  hdwr -n has changed */
      dont_clear_PIC_stats = FALSE;
      rebuild_timer = 1;      /* Force immediate table rebuild */
      }

   if ((PIC_serial_status == idle) andand
       (rebuild_timer != 0) andand
       (--rebuild_timer == 0))
      {
      Comm_background_flags.do_rebuild = TRUE;
      }
   else if ((PIC_serial_status == idle) andand
         (num_PICs != 0) andand
         (pulseOutMode != PIC_MC_SERIAL) andand
         (!Comm_background_flags.do_rebuild))     /* Serial processing enabled? */
      {
      if (PICrcvBuf.flags and rcv_data_ready_flag)
         {                           /* Process received message */
         PICrcvBuf.flags and= ~rcv_data_ready_flag;
```

```
        rcv_buf_err = !decode_rcv_buffer();

        if ((PIC_comm_mon.control_flags and RCV_DATA_RDY) == 0)
          {
            PIC_comm_mon.rcv_buf = PICrcvBuf;
            PIC_comm_mon.control_flags |= RCV_DATA_RDY;
          }

        if ((ext_comm.control_flags and CPY_RCV_DATA) != 0)
          {
            ext_comm.rcv_buf = PICrcvBuf;
            ext_comm.control_flags and= ~CPY_RCV_DATA;
            ext_comm.control_flags |= RCV_DATA_RDY;
          }

#ifdef IS_ST5
        if (ATM_control.active_flag)
          {
            ATM_control.result_flags = PICrcvBuf.flags;
            if (rcv_buf_err)
              {
                if (ATM_control.state != WAIT_ALIGN)
                  {
                    ATM_control.error_flag = TRUE;
                    ATM_control.active_flag = FALSE;
                    ATM_control.done_flag = TRUE;
                  }
              }
            else
              {
                switch (ATM_control.state)
                  {
                    case DO_PRESET:
                      {
                        ATM_control.xmit_level = PICrcvBuf.command_data >> 24;
                        ATM_control.coupler_level = (PICrcvBuf.command_data >> 16) and 0x0ff;
                        ATM_control.active_flag = FALSE;
                      }
                      break;
                    case SET_ALIGN:
                      {
                        ATM_control.state = WAIT_ALIGN;
                      }
                      break;
                    case WAIT_ALIGN:
                      {
                        ATM_control.optimum_cap_code = PICrcvBuf.command_data and
ATM_RC_CAP_MASK;
                        ATM_control.optimum_reading = PICrcvBuf.command_data >> 16;
                        ATM_control.result_flags |= (PICrcvBuf.command_data and 0xe000);
                                        /* Copy flags from reply */
                        .if ((ATM_control.result_flags and 0xc000) != 0)
                          {                     /* Analog levels out of range */
                            ATM_control.error_flag = TRUE;
                          }
```

```
if (ATM_control.optimum_reading < ATM_MIN_READING)
    {
    ATM_control.result_flags |= 0x1000;  /* Indicate reading too low */
    ATM_control.error_flag = TRUE;
    }
ATM_control.active_flag = FALSE;
}
break;
case DO_PLC_SET:
case DO_ATM_DISCONNECT:
    {
    ATM_control.active_flag = FALSE;
    }
break;
default:
    {
    ATM_control.active_flag = FALSE;
    ATM_control.error_flag = TRUE;
    }
break;
    }
}
if (!ATM_control.active_flag)
    ATM_control.done_flag = TRUE;
}

if (MUX_control.active_flag)
    {
    MUX_control.result_flags = PICrcvBuf.flags;
    if (rcv_buf_err)
        {
        MUX_control.error_flag = TRUE;
        MUX_control.last_xmit_mask = 0;
        MUX_control.last_rcv_mask = 0;
        }
    else
        {
        MUX_control.last_xmit_mask = PICrcvBuf.command_data and 0xff;
        MUX_control.last_rcv_mask = (PICrcvBuf.command_data >> 8) and 0xff;
        }
    MUX_control.active_flag = FALSE;
    MUX_control.done_flag = TRUE;
    }
#endif

        if (rcv_buf_err)
            {
#ifdef IS_ST5
            if (!ATM_control.active_flag || (ATM_control.state != WAIT_ALIGN))
#endif
                {
                last_comm_err_flag = PICrcvBuf.flags;
                copymem(sizeof (PICbitBuf), (char *) (andHoldrcvBuf), (char *)
(andPICrcvBuf));
                if ((PICrcvBuf.flags and rcv_bad_addr_flag) != 0)
```

```
        {       /* past end of valid PICs, address error */
        PIC_bad_addr_count++;
        set_PIC_alarm(PIC_adderr_0,PICrcvBuf.PIC_addr,
                (PICxmitBuf.PIC_addr << 8)+PICxmitBuf.command);
        }
        else
        {       /* PIC address was valid, but comm failed */
        PIC_status[rcv_PIC_index].comm_error_count++;
        if (PIC_status[rcv_PIC_index].comm_error_count > 2)
                {
                set_PIC_alarm(PIC_comerr_0,PIC_status[rcv_PIC_index].PIC_addr,
                        PICrcvBuf.flags);
                }
                /* Lost contact with PIC, read serial number and software version */
        PIC_status[rcv_PIC_index].get_serno = TRUE;
        PIC_status[rcv_PIC_index].get_version = TRUE;
                }
        }
        }
    else
        {                               /* Valid message received */
        if ((PICrcvBuf.command == READ_REGISTER) andand (PICrcvBuf.reg_ID ==
STATUS_REG))
                {
                process_status_bits();
                }
        else if (PICrcvBuf.command == SYSTEM_CONTROL)
                {
                if (PICrcvBuf.reg_ID == STATUS_REG)
                        {               /* Response frome reset status bits cmd */
                        PIC_status[rcv_PIC_index].reset_status = FALSE;
                        process_status_bits();
                        }
#ifdef IS_MC5
                else if ( (PIC_status[rcv_PIC_index].software_type == 4) andand
                        ((PIC_status[rcv_PIC_index].last_cmd_data and 0xffff0000) ==
READ_ENCODER_ID) )
                        {                       /* response from encoder read ID comd */
                        work_pulse_index = (PICrcvBuf.PIC_addr * PULSES_PER_PIC) +
PICrcvBuf.reg_ID;
                        i = (PIC_status[rcv_PIC_index].last_cmd_data and 0x0000ff00) >> 8;
                        work_char_ptr = (unsigned char *) andPICrcvBuf.command_data;
                        for (j=0; j<4 ; j++)
                        {
                        if ((*work_char_ptr == 0) || (i >= ID_FIELD_LENGTH))
                                {
                                j = 10;    /* indicate end of message found */
                                }
                        else
                                {
                                pulseData[work_pulse_index].ID_buffer[i] = *work_char_ptr;
                                i++;
                                work_char_ptr++;
                                }
                        }
```

```
if (j>5)
    {                    /* found end of ID field from remote encoder */
    for (i=0; i<ID_FIELD_LENGTH; i++)
        {
        pulseData[work_pulse_index].ID_field[i] =
pulseData[work_pulse_index].ID_buffer[i];
        pulseData[work_pulse_index].ID_buffer[i] = 0;
        }
    }
    }
    }
    else if ((PICrcvBuf.command == READ_REGISTER) andand (PICrcvBuf.reg_ID
== ERROR_REG))
    {
    if (PIC_status[rcv_PIC_index].software_type == 4)
        {                    /* Remote encoder interface module */
        work_pulse_index = (PICrcvBuf.PIC_addr * PULSES_PER_PIC) +
(PICrcvBuf.command_data >> 24);
        if (work_pulse_index < (2 * NUMPH))
            {
            pulseData[work_pulse_index].error_cnt++;
            for (i=0; i<ID_FIELD_LENGTH;
pulseData[work_pulse_index].ID_buffer[i++] = 0);
            }
        }
#endif
    }
    else if ((PICrcvBuf.command == WRITE_REGISTER) andand (PICrcvBuf.reg_ID
== PARM_REG))
        {
        PIC_status[rcv_PIC_index].update_parameter = FALSE;
        }
    else if ((PICrcvBuf.command == READ_REGISTER) andand (PICrcvBuf.reg_ID
== VERS_REG))
        {
        PIC_status[rcv_PIC_index].get_version = FALSE;
        PIC_status[rcv_PIC_index].software_type =
        (PICrcvBuf.command_data and 0xff000000) >> 24;
        PIC_status[rcv_PIC_index].software_version =
        (PICrcvBuf.command_data and 0x00ff0000) >> 16;
        PIC_status[rcv_PIC_index].loop_rate =
        (PICrcvBuf.command_data and 0x0000ff00) >> 8;
        }
    else if ((PICrcvBuf.command == READ_REGISTER) andand (PICrcvBuf.reg_ID
== SERNO_REG))
        {
        PIC_status[rcv_PIC_index].get_serno = FALSE;
        PIC_status[rcv_PIC_index].serial_number = PICrcvBuf.command_data;
        }
    :. else if (((PICrcvBuf.command == READ_REGISTER) || (PICrcvBuf.command <=
MAX_FAST_READ))
            andand (PICrcvBuf.reg_ID <= MAX_PULSE_REG))
        {        /* Pulse reading */
        work_pulse_index = (PICrcvBuf.PIC_addr * PULSES_PER_PIC) +
PICrcvBuf.reg_ID;
```

```
        if (work_pulse_index < (NUMPH * 2))
            {
            pulseData[work_pulse_index].reading = PICrcvBuf.command_data;
            copy_rcvd_data = FALSE;
            if (PIC_status[rcv_PIC_index].get_version)
                {
                }
            else if (PIC_status[rcv_PIC_index].software_type == 4)
                {                /* Remote encoder interface module */
                copy_rcvd_data = TRUE;
                accumXfer.low = pulseData[work_pulse_index].reading;
                }
            else if (PIC_status[rcv_PIC_index].software_type == 3)
                {                /* Remote pulse counter module */
                copy_rcvd_data = TRUE;

                if (!PIC_status[rcv_PIC_index].get_serno)
                    {
                    sprintf((char *) pulseData[work_pulse_index].ID_field,"S%08ldP%d",
                            PIC_status[rcv_PIC_index].serial_number,
                            PICrcvBuf.reg_ID);
                    }

                if (releaseCode.option.countEveryEdge)
                    {
                    accumXfer.low = pulseData[work_pulse_index].reading;
                    }
                else
                    {
                    accumXfer.low = pulseData[work_pulse_index].reading >> 1;
                    }
                }
            accumXfer.high = 0L;
#ifndef VATEST

            if (copy_rcvd_data)
                {
#ifndef IS_MC5
                /* It is an RSM or ST5, so mapping for pulse 1 thru 4 is M1Q13, M1Q14, M2Q13,
M2Q14 */

ph[0][work_pulse_index/2][(work_pulse_indexand0x01)?PULSE2:PULSE1].accum =

ph[1][work_pulse_index/2][(work_pulse_indexand0x01)?PULSE2:PULSE1].accum =
                accumXfer ;

#else
                /* It is an MC5, so mapping for pulse 1 thru 48 is M1Q13..M24Q13,
M1Q14..M24Q14   */


ph[0][work_pulse_index%NUMPH][(work_pulse_index/NUMPH)?PULSE2:PULSE1].accu
m =
```

```
ph[1][work_pulse_index%NUMPH][(work_pulse_index/NUMPH)?PULSE2:PULSE1].accu
m =
                    accumXfer ;
#endif
                }

#endif
            }
        }

        if ((PICrcvBuf.flags and (PIC_error_flag | PIC_invalid_data_flag)) != 0)
            PIC_status[rcv_PIC_index].get_status = TRUE; .
        if ((PICrcvBuf.flags and PIC_need_refresh_flag) != 0)
            PIC_status[rcv_PIC_index].update_parameter = TRUE;
        /* check status flags */
        }
    }

    /* Decide what command to send */

    PICxmitBuf.flags = 0;

#ifndef IS_ST5

    /* MC5 or RSM, check for cold-start processing to clear pulse registers */

    if (clear_state == SEND_GLOBAL_CLR)
        {                           /* Cold start, send global clr */
        PICxmitBuf.PIC_addr = GLOBAL_PIC_ADDR;
        PICxmitBuf.command = CLEAR_PULSE_REGISTERS;
        format_xmit_buffer();
        clear_state = SENDING_GLOBAL_CLR;
        PIC_serial_status = do_send_cmd;        /* Start UART */
        }
    else if (clear_state == SENDING_GLOBAL_CLR).
        {
        clear_state = GLOBAL_CLR_SENT;
        }
#else

    /* ST5, check for ATM (Automatic Tuning Module) operations */

    if (ATM_control.request_flag)
        {
        ATM_control.request_flag = FALSE;
        ATM_control.error_flag = FALSE;
        ATM_control.active_flag = TRUE;
        ATM_control.state = ATM_DONE;
        PICxmitBuf.PIC_addr = ATM_control.ATM_number + ATM_BASE_ADDR;

        switch (ATM_control.operation)
            {       .
            case SET_PRE_ALIGN:.
```

```
        PICxmitBuf.command = WRITE_REGISTER;
        PICxmitBuf.reg_ID = OUTPUT_REG;
        PICxmitBuf.command_data = ATM_control.start_cap_code and
ATM_RC_CAP_MASK;
        PICxmitBuf.command_data |= ATM_PRESET_CODE;
        ATM_control.state = DO_PRESET;
        break;


    case DO_ALIGN:
        PICxmitBuf.command = WRITE_REGISTER;
        PICxmitBuf.reg_ID = CONTROL_REG;
        if (ATM_control.start_cap_code > ATM_control.end_cap_code)
            ATM_control.end_cap_code = ATM_control.start_cap_code;
        PICxmitBuf.command_data = ATM_control.start_cap_code and
ATM_RC_CAP_MASK;
        PICxmitBuf.command_data = (PICxmitBuf.command_data << 12 ) |
                    (ATM_control.end_cap_code and ATM_RC_CAP_MASK) |
                    (ATM_MEAS_TIME << 24);
        ATM_control.state = SET_ALIGN;
        ATM_control.align_timer = ATM_control.end_cap_code -
ATM_control.start_cap_code;
        ATM_control.align_timer *= ((ATM_DISC_TIME + ATM_MEAS_TIME + 4) *
(1.25 / 62.5));
        ATM_control.align_timer += 13;  /* Time in 1/64 sec to wait before checking
result */
                        /* Number of steps * time per step + 25% + .2 second */
        break;


    case SET_NORMAL_PLC:
        PICxmitBuf.command = WRITE_REGISTER;
        PICxmitBuf.reg_ID = OUTPUT_REG;
        PICxmitBuf.command_data = ATM_control.optimum_cap_code and
ATM_RC_CAP_MASK;
        PICxmitBuf.command_data |= ATM_PLC_CODE;
        ATM_control.state = DO_PLC_SET;
        break;


    case DISCONNECT_COUPLER:
        PICxmitBuf.command = WRITE_REGISTER;
        PICxmitBuf.reg_ID = OUTPUT_REG;
        PICxmitBuf.command_data = ATM_control.optimum_cap_code and
ATM_RC_CAP_MASK;
        PICxmitBuf.command_data |= ATM_DISC_CODE;  .
        ATM_control.state = DO_ATM_DISCONNECT;
        break;


    default:
    case READ_XMIT_LEVEL:
        ATM_control.error_flag = TRUE;
        ATM_control.done_flag = TRUE;
        ATM_control.active_flag = FALSE;
        break;

    }
```

```
            if (ATM_control.active_flag)
                {
                format_xmit_buffer();
                PIC_wait_limit = DIRECT_PIC_WAIT_LIMIT;
                PIC_serial_status = do_send_cmd;        /* Start UART */
                }


            }
        else if (ATM_control.active_flag)  :
            {
            if ((ATM_control.state != WAIT_ALIGN) ||
                (--ATM_control.align_timer <= 0))
                {
                ATM_control.error_flag = TRUE;
                ATM_control.done_flag = TRUE;
                ATM_control.active_flag = FALSE;
                }
            else
                {                        /* poll ATM for auto-tune end */
                PICxmitBuf.command = 0;
                format_xmit_buffer();
                PIC_wait_limit = DIRECT_PIC_WAIT_LIMIT;
                PIC_serial_status = do_send_cmd;        /* Start UART */
                }
            }

        else if (MUX_control.request_flag)
            {
            MUX_control.request_flag = FALSE;
            MUX_control.error_flag = FALSE;
            if ((pulseOutMode == PIC_ST_SERIAL))
                {
                PICxmitBuf.bits.bufByte[0] = ((MUX_control.rcv_mask and 0x03) << 5) |
                                ((MUX_control.xmit_mask and 0x7f) >> 2);

                PICxmitBuf.bits.bufByte[1] = ((MUX_control.xmit_mask and 0x03) << 6);

                bit_count = 11;
                PIC_serial_status = sending_st5_bits;        /* Start UART */
                MUX_control.last_xmit_mask = MUX_control.xmit_mask;
                MUX_control.last_rcv_mask = MUX_control.rcv_mask;
                MUX_control.done_flag = TRUE;
                }
            else
                {
                MUX_control.active_flag = TRUE;
                PICxmitBuf.PIC_addr = ST5_MUX_PIC_ADDR;
                PICxmitBuf.command = WRITE_REGISTER;
                PICxmitBuf.reg_ID = OUTPUT_REG;
                PICxmitBuf.command_data = (MUX_control.rcv_mask << 8) +
        MUX_control.xmit_mask;
                format_xmit_buffer();
                PIC_wait_limit = DIRECT_PIC_WAIT_LIMIT;
                PIC_serial_status = do_send_cmd;        /* Start UART */
```

44

```
      }
    }

#endif

        else if ((ext_comm.control_flags and (XMIT_DATA_RDY | XMIT_REQUEST)) ==
            (XMIT_DATA_RDY | XMIT_REQUEST))
        {                               /* Send command for external routine */
        PICxmitBuf = ext_comm.xmit_buf;
        ext_comm.control_flags and= ~XMIT_REQUEST;
        ext_comm.control_flags |= CPY_RCV_DATA;

        /*   Look up correct PIC_status index for reuested PIC */
        for (i=0; ((i<MAX_PICS) andand (PIC_status[i].PIC_addr != PICxmitBuf.PIC_addr));
    i++);

        if (i < num_PICs)
            {
            PIC_status[i].last_cmd_data = PICxmitBuf.command_data;
            PIC_status[i].last_command = PICxmitBuf.command;
            }

#ifdef IS_MC5
        if (ext_comm.xmit_buf.PIC_addr < ST5_MUX_PIC_ADDR)
            PIC_wait_limit = BUFFERED_PIC_WAIT_LIMIT;
        else
#endif
            PIC_wait_limit = DIRECT_PIC_WAIT_LIMIT;

        format_xmit_buffer();
        PIC_serial_status = do_send_cmd;        /* Start UART */
        }

        else if ( ((ext_comm.control_flags and SUPPRESS_NORMAL_COMM) == 0)
#ifdef IS_ST5
            andand (--ST5_PIC_delay_ctr <= 0))
            {
            ST5_PIC_delay_ctr = ST5_PIC_DELAY;    /* Slow down routine communications in
    the ST5 */
#else
                                                  )
            {
#endif
            PICxmitBuf.PIC_addr = PIC_status[current_PIC_index].PIC_addr;
            need_pulse_read = TRUE;     /* Set defaults */

#ifdef IS_ST5

            if ((pulseOutMode == PIC_ST_SERIAL) andand
                (PICxmitBuf.PIC_addr == ST5_MUX_PIC_ADDR))
                {
                }
            else
```

45

```
#endif

    if (PIC_status[current_PIC_index].force_pulse_read andand
        (!PIC_status[current_PIC_index].get_version) andand
        (PIC_status[current_PIC_index].PIC_addr < ST5_MUX_PIC_ADDR) )
        {
        PIC_status[current_PIC_index].force_pulse_read = FALSE;
        }  ·
    else .                              · ·
        {
        PIC_status[current_PIC_index].force_pulse_read = TRUE;

#ifndef IS_ST5
    if (PIC_status[current_PIC_index].clear_pulse_regs andand
        (clear_state == GLOBAL_CLR_SENT) )
        {                              /* Global clear sent, get status */
        need_pulse_read = FALSE;
        PICxmitBuf.command = READ_REGISTER;
        PICxmitBuf.reg_ID = STATUS_REG;
        format_xmit_buffer();
        }
    else

#endif
    if (PIC_status[current_PIC_index].get_version)
        {  ·.              ,          ｜.              ·
        need_pulse_read = FALSE;
        PICxmitBuf.command = READ_REGISTER;
        PICxmitBuf.reg_ID = VERS_REG;
        format_xmit_buffer();
        }
    else if (PIC_status[current_PIC_index].get_serno)
        {
        need_pulse_read = FALSE;
        PICxmitBuf.command = READ_REGISTER;
        PICxmitBuf.reg_ID = SERNO_REG;
        format_xmit_buffer();
        }
    else if (PIC_status[current_PIC_index].update_parameter)
        {
        PICxmitBuf.command = WRITE_REGISTER;
        if (PIC_status[current_PIC_index].software_type == 3)
            {                                    /* Pulse ctr */

            /* Pulse ctr parameters:        */
            /* Power-On sample rate:  42/sec  */
            /* Power-off sample rate:  1/sec  */
            /* Days to count if rcving pulses:  */
            /*    .   RSM: 5 days       */
            /*        PDM: 35 days       */
            /* Days to count if no pulses rcvd:  */
            /*    · RSM: 1 day        */
            /*        PDM: 3 days     . */

            /* on RSM, the 2 lsbs of       */
```

```
                    /* load_shed mask[0] are sent to   */
                    /* the PIC output bits          */
#ifdef IS_RSM
                PICxmitBuf.command_data = 0x01150507 and
                                  (load_shed_state[0] | 0xfffffffc);
#else
                PICxmitBuf.command_data = 0x0115230d;
#endif
                }
#ifdef IS_MC5
            else if (PIC_status[current_PIC_index].software_type == 4)
                {                          /* Remote encoder reader */
            PICxmitBuf.command_data = READ_ENCODER_PARM;
            if ((releaseCodep->option.couplers_mask and 0x01) == 0)
                {                      /* If mask bit 0 is 0, no touch-pad compatibility */
                PICxmitBuf.command_data and= 0xff00ffff;
                }
                }
            else if (PIC_status[current_PIC_index].software_type == 5)
                {                          /* MC5 mux */
            got_ver_3 = got_ver_3_3 = FALSE;

            for (i=0; i<num_PICs; i++)
                {
                if (PIC_status[i].get_version)
                    {
                    got_ver_3 = TRUE;
                    got_ver_3_3 = TRUE;
                    }
                else if (PIC_status[i].software_type == 3)
                    {
                    got_ver_3 = TRUE;
                    if (PIC_status[i].software_version == 3)
                        got_ver_3_3 = TRUE;
                    }
                }
            if (got_ver_3)
                {
                if (got_ver_3_3 andand
                    ((releaseCodep->option.couplers_mask and 0x02) != 0))
                    {
                    PICxmitBuf.command_data = 0x0c007000;  /* 32 bps, periodic wake-up
*/
                    }
                else
                    {
                    PICxmitBuf.command_data = 0x0c007080;  /* 32 bps, no wake-up */
                    }
                }
            else
                PICxmitBuf.command_data = 0x02030080;  /* 205 bps, no wake-up */

                }
#endif
#ifdef IS_ST5
```

```
            else if (PIC_status[current_PIC_index].software_type == 8)
                {                                  /* Auto tune module */
                PICxmitBuf.command_data = 0x02030000 | (ATM_DISC_TIME << 8) |
                            (ATM_RC_XMIT_ON >> 8) | ATM_NUM_CAP_BITS;
                /* xmit offset = 2, cplr offset = 3,              */
                /* relay delay = ATM_DISC_TIME, Xmit mask = ATM_RC_XMIT_ON,   */
                /* number of capacitor relays = ATM_NUM_CAP_BITS            */
                }
            else if (PIC_status[current_PIC_index].software_type == 6)
                {                                  /* ST5 mux */
                PICxmitBuf.command_data = 0x00000000;
                }
#endif
            else if (PIC_status[current_PIC_index].software_type == 7)
                {                                  /* Load Control Module */
                PICxmitBuf.command_data = 0x00000000;
                }
            else
                {
                PIC_status[current_PIC_index].update_parameter = FALSE;
                        /* unknown software type, cancel command */
                }

            if (PIC_status[current_PIC_index].update_parameter)
                {
                need_pulse_read = FALSE;
                PICxmitBuf.reg_ID = PARM_REG;
                format_xmit_buffer();
                }
            }
        else if (PIC_status[current_PIC_index].reset_status)
            {
            need_pulse_read = FALSE;
            PICxmitBuf.command = SYSTEM_CONTROL;
            PICxmitBuf.command_data =
            (PIC_status[current_PIC_index].status_reg_value and 0xffbf);
            PICxmitBuf.command_data = PICxmitBuf.command_data << 16;  /* Move
status bits to MSb's */
            PICxmitBuf.reg_ID = STATUS_REG;
            format_xmit_buffer();
            }
        else if (PIC_status[current_PIC_index].get_status)
            {
            need_pulse_read = FALSE;
            PICxmitBuf.command = READ_REGISTER;
            PICxmitBuf.reg_ID = STATUS_REG;
            format_xmit_buffer();
            }

#ifdef IS_MC5
        if (need_pulse_read andand (PIC_status[current_PIC_index].software_type == 4))
            {
            need_pulse_read = FALSE;
            PICxmitBuf.command = SYSTEM_CONTROL;
```

```
        if (++PIC_status[current_PIC_index].curr_ID_reg >= PULSES_PER_PIC)
            PIC_status[current_PIC_index].curr_ID_reg = 0;

        if ( (((PIC_status[current_PIC_index].PIC_addr * PULSES_PER_PIC) +
            PIC_status[current_PIC_index].curr_ID_reg) % 24) >= num_pulse_ctrs)
                    PIC_status[current_PIC_index].curr_ID_reg = 0;


        PICxmitBuf.reg_ID = PIC_status[current_PIC_index].curr_ID_reg;
        work_pulse_index = (PIC_status[current_PIC_index].PIC_addr *
PULSES_PER_PIC) + PICxmitBuf.reg_ID;
        for (i=0; i<ID_FIELD_LENGTH; i++)
            {
            if (pulseData[work_pulse_index].ID_buffer[i] == 0)
                {
                j = i - 1;
                i = ID_FIELD_LENGTH;
                }
            }

        if (j<0)
            {
            j = 0;
            }
        else if (j > (ID_FIELD_LENGTH-4))
            {
            j = ID_FIELD_LENGTH-4;
            }

        PICxmitBuf.command_data = READ_ENCODER_ID | (j << 8);;
        format_xmit_buffer();
            }
#endif
        }


        if (need_pulse_read)
            {
#ifdef IS_MC5
        if (PIC_status[current_PIC_index].software_type == 7)
            {
            i = PIC_status[current_PIC_index].PIC_addr - LCM_BASE_ADDR;   /* get
LCM # */
            work_bit_mask = (load_shed_state[0]  >> (9 * i)) and 0x000001ff;
            PICxmitBuf.command_data = 0;
            for (i=0;i<9;i++).
                {
                if ((work_bit_mask and 0x100) != 0)
                    PICxmitBuf.command_data = (PICxmitBuf.command_data << 2) + 1; /* lsb
turns relay on */
                else
                    PICxmitBuf.command_data = (PICxmitBuf.command_data << 2) + 2; /* msb
turns relay on */
                work_bit_mask = work_bit_mask << 1;
                }
            PICxmitBuf.command_data |= 0x32000000;    /* Set pulse time = 50 mS */
```

```
                PICxmitBuf.command = WRITE_REGISTER;
                PICxmitBuf.reg_ID = OUTPUT_REG;
                format_xmit_buffer();
                need_pulse_read = FALSE;
                }
            else
#endif
            if (PIC_status[current_PIC_index].num_pulse_regs == 0)
                {
#ifndef IS_ST5
                PICxmitBuf.command = READ_REGISTER;
                PICxmitBuf.reg_ID = VERS_REG;
                format_xmit_buffer();
                need_pulse_read = FALSE;
#endif
                }
            else
                {
#ifdef IS_MC5
                if ( (((PIC_status[current_PIC_index].PIC_addr * PULSES_PER_PIC) +
                        PIC_status[current_PIC_index].curr_pulse_reg) % 24) >=
num_pulse_ctrs)
                        PIC_status[current_PIC_index].curr_pulse_reg = 0;
#endif
                if (PIC_status[current_PIC_index].curr_pulse_reg <= MAX_FAST_READ)
                    PICxmitBuf.command = PIC_status[current_PIC_index].curr_pulse_reg;
                else
                    PICxmitBuf.command = READ_REGISTER;

                PICxmitBuf.reg_ID = PIC_status[current_PIC_index].curr_pulse_reg;
                format_xmit_buffer();
                need_pulse_read = FALSE;
                if (++PIC_status[current_PIC_index].curr_pulse_reg >=
PIC_status[current_PIC_index].num_pulse_regs)
                    {
                    PIC_status[current_PIC_index].curr_pulse_reg = 0;
#ifdef IS_RSM
                    PIC_status[current_PIC_index].update_parameter = TRUE;
#endif
                    }
                }
            }

        PIC_status[current_PIC_index].last_cmd_data = PICxmitBuf.command_data;
        PIC_status[current_PIC_index].last_command = PICxmitBuf.command;

        PIC_wait_limit = PIC_status[current_PIC_index].reply_wait_limit;

        rcv_PIC_index = current_PIC_index;

        if (++current_PIC_index == num_PICs)
            current_PIC_index = 0;

        if (!need_pulse_read)
            PIC_serial_status = do_send_cmd;        /* Start UART */
```

```
        }

    }

}

#ifdef IS_RSM    /* In RSM, generate serial stream from subseconds */

void pulseSubsecond(void)
{
  if (num_PICs != 0)
    {
    if (PIC_clk_state == clk_high)
      {
      /* Falling edge, just set clock low */
      fs1004.io.pulseOut1Off = 0;
      PIC_clk_state = clk_low;
      }
    else
      {
      PIC_clk_state = clk_high;

#include "pic.def"   /* Do PIC serial comm on clock rising edge */


      }
    }
}

#endif


void process_status_bits(void)
{
  unsigned int    work_pulse_index, work_status_bits;

  PIC_status[rcv_PIC_index].get_status = FALSE;
  PIC_status[rcv_PIC_index].status_reg_value = PICrcvBuf.command_data >> 16;
  PIC_status[rcv_PIC_index].time_since_global = (PICrcvBuf.command_data >> 8) and
0xff;

  if (PIC_status[rcv_PIC_index].status_reg_value != 0)
    {
    PIC_status[rcv_PIC_index].reset_status = TRUE;
    if ((PIC_status[rcv_PIC_index].status_reg_value and 0x8f10) != 0)
      {
      PIC_status[rcv_PIC_index].PIC_data_err_count++;   /* PIC detected bad data */
      set_PIC_alarm(PIC_flags_0,PIC_status[rcv_PIC_index].PIC_addr,
            PIC_status[rcv_PIC_index].status_reg_value);
      work_status_bits = (PIC_status[rcv_PIC_index].status_reg_value >> 8) and 0x0f;
      work_pulse_index = PIC_status[rcv_PIC_index].PIC_addr * PULSES_PER_PIC;
      while (work_status_bits > 0)
        {
        if (work_status_bits and 0x01)
          pulseData[work_pulse_index].error_cnt++;
```

```
            work_status_bits = work_status_bits >> 1;
            work_pulse_index++;
            }

        }
      if (((PIC_status[rcv_PIC_index].status_reg_value and 0x20) != 0) andand
          !PIC_status[rcv_PIC_index].clear_pulse_regs)
          {
          PIC_status[rcv_PIC_index].comm_error_count++;    /* PIC detected comm parity err
*/
          if (PIC_status[rcv_PIC_index].comm_error_count > 2)
              {
              set_PIC_alarm(PIC_comerr_0,PIC_status[rcv_PIC_index].PIC_addr,
                  PICrcvBuf.flags | 0x0800);
              }
          }
      if ((PIC_status[rcv_PIC_index].status_reg_value and 0x3080) != 0)
          {
          PIC_status[rcv_PIC_index].PIC_reset_count++;    /* PIC was reset */
          if (PIC_status[rcv_PIC_index].PIC_reset_count > 1)              {
              {
              set_PIC_alarm(PIC_reset_0,PIC_status[rcv_PIC_index].PIC_addr,
                  PIC_status[rcv_PIC_index].status_reg_value);
              }
          }
      }


    if (PIC_status[rcv_PIC_index].clear_pulse_regs andand
        (clear_state == GLOBAL_CLR_SENT) )
        {
        PIC_status[rcv_PIC_index].clear_pulse_regs = FALSE;
        if ( ((PIC_status[rcv_PIC_index].status_reg_value and 0x0f) != 0x0f) andand
            (PIC_status[rcv_PIC_index].software_type == 3) )
            {
            PIC_status[rcv_PIC_index].PIC_data_err_count++;    /* Clear cmd failed */
            set_PIC_alarm(PIC_flags_0,PIC_status[rcv_PIC_index].PIC_addr,
                PIC_status[rcv_PIC_index].status_reg_value);
            }
        }
    else if ( ((PIC_status[rcv_PIC_index].status_reg_value and 0x0f) != 0) andand
            ((PIC_status[rcv_PIC_index].status_reg_value and 0xf10) == 0) )
        {
        PIC_status[rcv_PIC_index].PIC_data_err_count += 1000;    /* Spurious clr cmd */
        set_PIC_alarm(PIC_flags_0,PIC_status[rcv_PIC_index].PIC_addr,
                PIC_status[rcv_PIC_index].status_reg_value);
        }
    }


void set_PIC_alarm(alarmcodes pass_alarm_codes,
                int pass_PIC_addr,
                unsigned int pass_alarm_data)
    {
    if (!Comm_background_flags.do_alarm)
        {
        PIC_alarm.alarm_codes = pass_alarm_codes + pass_PIC_addr;
```

```
            PIC_alarm.ack = pass_alarm_data;
            Comm_background_flags.do_alarm = TRUE;
            }
        }

unsigned char workTpar;

BOOLEAN decode_rcv_buffer(void)
{
    int         i;
    unsigned int   workInt;

    workTpar = 0x1f;

    if (PICrcvBuf.flags == 0)
        {
        work_PIC_addr = Get5();
        if (PICrcvBuf.flags == 0)
            PICrcvBuf.PIC_addr = work_PIC_addr;    /* Valid address received */
        PICrcvBuf.command = Get5();
        if (PICrcvBuf.command > 0x0f)
            PICrcvBuf.reg_ID = Get5();
        else
            PICrcvBuf.reg_ID = PICrcvBuf.command;
        PICrcvBuf.command_data = 0;
        for (i=0; i<6; i++)
            PICrcvBuf.command_data = (PICrcvBuf.command_data << 5) + Get5();
        workInt = Get5();
        PICrcvBuf.command_data = (PICrcvBuf.command_data << 2) + (workInt >> 3);
        PICrcvBuf.flags |= workInt and 0x07;
        workInt = Get5();
        if (workTpar != 0)
            PICrcvBuf.flags |= rcv_tpar_error_flag;
        }
    /*    Look up correct PIC_status index for data in rcv buffer */
    for (i=0; ((i<MAX_PICS) andand (PIC_status[i].PIC_addr != PICrcvBuf.PIC_addr)); i++);

    if (i >= num_PICs)
        PICrcvBuf.flags |= rcv_bad_addr_flag; /* past end of valid PICs, address error */

    if (i == MAX_PICS)
        rcv_PIC_index = 0;
    else
        rcv_PIC_index = i;

#ifdef VATEST

#if VATEST==1
    PICrcvBuf.command = temp_command;
    PICrcvBuf.reg_ID = temp_reg_ID;
    PICrcvBuf.command_data = temp_command_data;
    PICrcvBuf.flags = temp_flags;

#endif
#endif
```

```
return((PICrcvBuf.flags and
        ~(PIC_error_flag | PIC_need_refresh_flag | PIC_invalid_data_flag)) == 0);
}

void format_xmit_buffer(void)
{
    int      i,j,ShiftCount;
    unsigned int   WorkInt;
    unsigned long  WorkData;

    PICxmitBuf.bitCount = 0;
    PICxmitBuf.bits.bufLong[0] = 0;
    PICxmitBuf.bits.bufLong[1] = 0;
    PICxmitBuf.bits.bufLong[2] = 0;     /* Clear xmit bit buffer */

    workTpar = 0x1f;              /* Initializa Tpar */

    Stuff6(PICxmitBuf.PIC_addr);
    Stuff6(PICxmitBuf.command);
    if (PICxmitBuf.command > 0x0f)
        {
        Stuff6(PICxmitBuf.reg_ID);
        if (PICxmitBuf.command > 0x17)
            {
            WorkData = PICxmitBuf.command_data;
            ShiftCount = 32;
            for (i = 0,i<7;i++)
                {
                WorkInt = 0;
                for (j=0;j<5;j++)
                    {
                    WorkInt = WorkInt << 1;
                    if (WorkData and 0x80000000)
                        WorkInt += 1;
                    WorkData = WorkData << 1;
                    if (--ShiftCount == 0)
                        {
                        WorkInt = (WorkInt << 3) + (PICxmitBuf.flags and 0x07);
                        j = 5;
                        }
                    }
                Stuff6(WorkInt);
                }
            }
        }
    Stuff6(workTpar);
                              /* Buffer set, set up UART control */
    PICrcvBuf.bitCount = 66;

    if ((PIC_comm_mon.control_flags and XMIT_DATA_RDY) == 0)
        {
        PIC_comm_mon.xmit_buf = PICxmitBuf;
        PIC_comm_mon.control_flags |= XMIT_DATA_RDY;
        }
```

```
    PICrcvBuf.flags = 0;
    PICrcvBuf.PIC_addr = PICxmitBuf.PIC_addr;   /* preset address of remote PIC */
}


unsigned int Get5(void)
{
    int        byte_index, bit_index;
    unsigned int   work_result;

    work_result = 0;
    if ((PICrcvBuf.flags and
        ~(PIC_error_flag | PIC_need_refresh_flag | PIC_invalid_data_flag)) == 0)
        {
        byte_index = 96 - PICrcvBuf.bitCount;
        bit_index = byte_index and 0x07;
        byte_index = byte_index >> 3;
        work_result = (PICrcvBuf.bits.bufByte[byte_index] << 8) +
PICrcvBuf.bits.bufByte[byte_index+1];
        work_result = work_result >> (10 - bit_index);
        work_result and= 0x3f;
        if (parity6[work_result >> 1] != work_result)
            {
            work_result = 0;
            PICrcvBuf.flags |= rcv_parity_err_flag;
            }
        else
            {
            work_result = work_result >> 1;
            workTpar ^= work_result;
            PICrcvBuf.bitCount -= 6;
            if (PICrcvBuf.bitCount < 0)
                PICrcvBuf.flags |= rcv_bad_length_flag;
            }
        }
    return(work_result);
}


void Stuff6(int pass_data)
{
    int byte_index, bit_index;
    workTpar ^= pass_data;
    byte_index = PICxmitBuf.bitCount >> 3;
    bit_index = PICxmitBuf.bitCount and 0x07;
    pass_data = parity6[pass_data] << (10 - bit_index);
    PICxmitBuf.bits.bufByte[byte_index] |= pass_data >> 8;
    PICxmitBuf.bits.bufByte[byte_index+1] |= pass_data and 0xff;
    PICxmitBuf.bitCount += 6;
}
```

PULSE.H

```
/*
*/

#ifndef BOOLEAN_DEFINED
#define BOOLEAN_DEFINED
typedef int BOOLEAN ;
#endif


/* subsecond processing for pulse counters */
void pulseSubsecond(void);

/* Daily PIC table rebuild */
void pulseDay(void);

/* Main PIC communication routine */
void pulseService(void);

/* PIC comm routine - once-per-second code */
void pulseSecond(void);

/* Subroutines for PIC communication */
void Stuff6(int pass_data);
void format_xmit_buffer(void);
BOOLEAN decode_rcv_buffer(void);
void process_status_bits(void);
unsigned int Get5(void);

void set_PIC_alarm(alarmcodes pass_alarm_type,
                int pass_PIC_addr,                    .
                    unsigned int pass_alarm_data);


/* Startup code for PIC communication */
void pulseStartup (void);

/* Routine to clear pulse registers after cold start */
void pulseColdstart(void);

/* defined in pt.c */
#define RELAY_A 0
#define RELAY_B 1
void pulseOut(int picNbr,int relayNbr,int ONoff);
void ptEveryMinute(void) ;
void ptEverySecond(void) ;
void set_PLC_relays(int xmitRelay,int rcvRelay) ;
```

PICEND.DEF

```
/*
include file at end of mtrsamp to control MC and ST pic chips from mtrsamp interrupt
*/

#ifdef IS_MC5

if (pulseOutMode==PIC_MC_SERIAL)
        {
        asm (" MOVE.L #0x80400E,A0");
        asm (" AND.W #0xFCFF,(A0)");   /* Clear clock and data ports */
        }

#endif

#ifdef IS_ST5

  asm (" MOVE.L #0x80400E,A0");
  asm (" AND.W #0xFEFF,(A0)");   /*  Insert clock falling edge */

if (PIC_serial_status == sending_st5_bits)
        {
  asm (" NOP");
  asm (" NOP");
  asm (" NOP");
  asm (" NOP");
  asm (" NOP");
  asm (" NOP");
  asm (" NOP");
  asm (" NOP");
  asm (" NOP");
  asm (" NOP");
  asm (" NOP");
  asm (" NOP");
  asm (" NOP");
  asm (" MOVE.L #0x80400E,A0");
  asm (" OR.W #0x0100,(A0)");   /* If sending bits, activate clock*/
        }

#endif
```

PICVARS.DEF

```
/*
local variables to control MC and ST pic chips from mtrsamp interrupt
meter/c/lib/picvars.def
*/

unsigned long bitOneFlag;
```

PULSELINK.DEF

```
/* determine if variables are external or defined here */
#undef ref
#ifdef PSTRU_DEFINED
#define ref
#else
#define ref extern
#endif


#if (NUMPH > 6)
#define IS_MC5
#else
#ifdef MAX_SCAN_METERS
#define IS_ST5
#else
#define IS_RSM
#endif
#endif

/* Values for hdwr -p (pulseOutMode) */

#define STANDARD_PIC_COMM 0

#if 0     /* remove these equates from mtrlink.def */
#define PIC_PULSE_SERIAL 1
#define PIC_MC_SERIAL 2
#define PIC_ST_SERIAL 3
#endif    /* then uncomment them here */

/* #define VATEST     1 */


#ifdef VATEST


#undef IS_MC5
#undef IS_RSM
#undef IS_ST5

#define IS_RSM
#undef NUMPH
#define NUMPH 3
#undef MAX_SCAN_METERS

#endif

/* Uncomment for water meters (Oakville Hydro) */
#define READ_ENCODER_ID 0x49ff0000
#define READ_ENCODER_PARM 0x0312500c


/* Uncomment for gas meters (Sonix)
#define READ_ENCODER_ID 0x49fe0389
```

```
#define READ_ENCODER_PARM 0x0300500c
*/

#define ID_FIELD_LENGTH 13


#define PULSES_PER_PIC     4

#ifdef IS_MC5
#define BITS_PER_SEC        822
#define MAX_PICS     16
#else
#ifdef IS_ST5
#define BITS_PER_SEC        942
#define MAX_PICS     5
#else
#define BITS_PER_SEC   32
#define MAX_PICS     1
#endif
#endif


#define DIRECT_PIC_WAIT_LIMIT   24
#define BUFFERED_PIC_WAIT_LIMIT 10 * BITS_PER_SEC

#define NUM_START_BITS   12


#ifdef IS_ST5
#define  REBUILD_DELAY 30000
#else
#define  REBUILD_DELAY 1000
#endif

typedef
        struct {
                        unsigned long   serial_number;
        unsigned long  last_cmd_data;
        unsigned char          PIC_addr;
        unsigned char          software_type;
        unsigned char          software_version;
                        unsigned char   loop_rate;
                        unsigned int    status_reg_value;
                        unsigned char   time_since_global;
                        unsigned char   num_pulse_regs;
                        unsigned char   curr_pulse_reg;
        unsigned char  curr_ID_reg;
        unsigned char  last_command;
                        unsigned int    reply_wait_limit;
                        unsigned int    PIC_data_err_count;
                        unsigned int    PIC_reset_count;
                        unsigned int    comm_error_count;
                        unsigned        force_pulse_read: 1;
                        unsigned        get_serno      : 1;
                        unsigned        get_version    : 1;
                        unsigned        get_status     : 1;
                        unsigned        reset_status   : 1;
```

```
                unsigned        update_parameter: 1;
                unsigned        clear_pulse_regs: 1;
                }
                        PIC_status_t;

typedef
        enum    {
    sending_bits,
    sending_st5_bits,
                rcving_bits,
                do_PIC_start,
                sending_PIC_start,
                do_send_cmd,
                sending_start,
                sending_start_1,
                sending_stop,
                waiting_for_start,
                rcving_stop,
                idle
                }
                        PIC_s_stat_t;

typedef
        enum    {
    SET_PRE_ALIGN,
    DO_ALIGN,
    SET_NORMAL_PLC,
    DISCONNECT_COUPLER,
    READ_XMIT_LEVEL
                }
                        ATM_op_t;

typedef
        enum    {
    DO_PRESET,
    DO_PLC_SET,
    SET_ALIGN,
    WAIT_ALIGN,
    DO_ATM_DISCONNECT,
    ATM_DONE
                }
                        ATM_state_t;


typedef
        struct{
            unsigned char   PIC_addr;
            unsigned char   command;
            unsigned char   reg_ID;
            unsigned long   command_data;
                        unsigned int        flags;
            int                 bitCount;
            union {
                unsigned long bufLong[3];
                unsigned char bufByte[12];
```

```
        } bits;
    }
        PICbitBuf;

#ifndef BOOLEAN_DEFINED
#define BOOLEAN_DEFINED
typedef int BOOLEAN ;
#endif

/* Definition of bits in Flags field of PIC comm buffers */

/* NOTE- Top 4 bits (0xf000) reserved for use by ATM code   */

#define rcv_bad_addr_flag     0x0100
#define rcv_tpar_error_flag   0x0080
#define rcv_data_ready_flag   0x0040
#define rcv_bad_length_flag   0x0020
#define rcv_timeout_flag      0x0010
#define rcv_parity_err_flag   0x0008
#define PIC_error_flag        0x0004
#define PIC_need_refresh_flag 0x0002
#define PIC_invalid_data_flag 0x0001

/* Command codes for PIC communication */

#define MAX_FAST_READ         0x07
#define CLEAR_PULSE_REGISTERS  0x08
#define READ_REGISTER         0x10
#define WRITE_REGISTER        0x18
#define SYSTEM_CONTROL  0x19

/* Register ID codes for PIC communication */

#define MAX_PULSE_REG          15
#define CONTROL_REG      16
#define ERROR_REG      26
#define OUTPUT_REG     27
#define PARM_REG          28
#define VERS_REG          29
#define SERNO_REG         30
#define STATUS_REG        31

/* Special-purpose PIC addresses */

#define GLOBAL_PIC_ADDR   31
#define MC5_MUX_PIC_ADDR  30
#define ST5_MUX_PIC_ADDR  29

#define LCM_BASE_ADDR     16 /* First LCM is at address 16 */
#define ATM_BASE_ADDR     20 /* First ATM is at address 20 */
#define MAX_PULSE_PIC_ADDR 15 /* pulse couters are from 0 to 15 */


/* Bit usage in the ATM relay control word */
```

```
#define ATM_RC_XMIT_ON     0x00008000
#define ATM_RC_MEAS_XMIT   0x00004000
#define ATM_RC_MEAS_CPLR   0x00002000
#define ATM_RC_RES_SHORTED 0x00001000


#define ATM_RC_CAP_MASK    0x000003ff
#define ATM_NUM_CAP_BITS   10


#define ATM_PRESET_CODE    ATM_RC_XMIT_ON | ATM_RC_MEAS_XMIT |
ATM_RC_MEAS_CPLR
#define ATM_PLC_CODE       ATM_RC_XMIT_ON | ATM_RC_RES_SHORTED
#define ATM_DISC_CODE      0


/* Other ATM control equates */


#define ATM_MEAS_TIME      20L     /* mSec to wait between cap change and ADC
reading */
#define ATM_DISC_TIME      20L     /* mSec to wait before switching cap relays */
#define ATM_MIN_READING    0x0038  /* If reading at end of autotune less than this, fail
*/



/* Equates for ST5 comm */


#define ST5_PIC_DELAY      66


#pragma region ("ram=ram")


ref unsigned short        current_PIC_index, rcv_PIC_index;
ref PIC_status_t    PIC_status[MAX_PICS];


struct          {
    unsigned long    reading;
    int              error_cnt;
    unsigned char    ID_field[ID_FIELD_LENGTH];
    unsigned char    ID_buffer[ID_FIELD_LENGTH];
            } ref     pulseData[2*NUMPH];


struct          {
    PICbitBuf    xmit_buf;
    PICbitBuf    rcv_buf;
    int          control_flags;
            } ref        ext_comm, PIC_comm_mon;


struct             {
    ATM_op_t      operation;
    unsigned int  ATM_number;
    ATM_state_t   state;
    unsigned      request_flag : 1;
    unsigned      done_flag : 1;
    unsigned      error_flag : 1;
    unsigned      active_flag : 1;
    unsigned int  start_cap_code;
    unsigned int  end_cap_code;
    unsigned int  optimum_cap_code;
```

```
        unsigned int   optimum_reading;
        unsigned int   xmit_level;
        unsigned int   coupler_level;
        unsigned int   result_flags;
        long int       align_timer;
                } ref      ATM_control;


struct          {
        unsigned       request_flag : 1;
        unsigned       done_flag : 1;
        unsigned       error_flag : 1;
        unsigned       active_flag : 1;
        unsigned int   xmit_mask;
        unsigned int   rcv_mask;
        unsigned int   result_flags;
        unsigned int   last_xmit_mask;
        unsigned int   last_rcv_mask;
                } ref      MUX_control;


struct          {
        unsigned       do_rebuild : 1;
        unsigned       do_alarm : 1;
                } ref      Comm_background_flags;


/* Bit definitions in ext_buf.control_flags */
#define  SUPPRESS_NORMAL_COMM   0x0001
#define  XMIT_REQUEST          0x0002   /* External routine requests send of xmit_buf */
#define  CPY_RCV_DATA          0x0004   /* External cmd was sent, copy rcvd buffer to
rcv_buf */
#define  RCV_DATA_RDY          0x0008   /* Got reply from external cmd, reply is in
rcv_buf */
#define  XMIT_DATA_RDY         0x0010   /* xmit_buf has copy of last cmd sent */


ref PICbitBuf           PICxmitBuf, PICrcvBuf, HoldrcvBuf;
ref PIC_s_stat_t    PIC_serial_status;
ref unsigned int    num_PICs;
ref unsigned int    num_LCMs;
ref unsigned int    rebuild_timer;
ref unsigned int    ATM_work;
ref unsigned int    work_PIC_addr;
ref unsigned int    num_pulse_ctrs;
ref unsigned int    hold_num_pulse_ctrs;
ref unsigned int    bit_count;
ref unsigned int        out_bit_value;
ref unsigned char   *shift_LSB_ptr;
ref unsigned char   in_bit_value;
ref unsigned int    PIC_wait_limit;
ref unsigned int    zero_count;
ref unsigned int    last_comm_err_flag;
ref BOOLEAN         dont_clear_PIC_stats;
ref int             ST5_PIC_delay_ctr;
ref unsigned int    PIC_bad_addr_count;
ref alarmstru       PIC_alarm;


#ifdef VATEST
```

```
/* test !!!! */
ref int                  temp_command;
ref int                  temp_reg_ID;
ref long        temp_command_data;
ref int                  temp_flags;
/* test !!!! */
#endif


ref enum {
·       clk_high,
        clk_low
·       }               PIC_clk_state;


ref enum {
        NO_GLOBAL_SEND,
        SEND_GLOBAL_CLR,
        SENDING_GLOBAL_CLR,
        GLOBAL_CLR_SENT
        }               clear_state;

/*   Old equates maintained for compatibility */
#if 0
#define RELAY_A_BIT 1
#define RELAY_B_BIT 2
#define IDLE 0
#define TX 1
#define RX 2
#define DATA_READY 3
#define WAKE 4
#define PIC_RESET 5

#define WAKE_COUNT_RELOAD (64*4)      /* Four Seconds */
#define RESET_COUNT_RELOAD 10     /* 1/4 Seconds */
#define RELAY_A_OFF_CMD 5                    /*active low trigger*/
#define RELAY_A_ON_CMD  4
#define RELAY_B_OFF_CMD 7
#define RELAY_B_ON_CMD  6
#define CLEAR_ACC_CMD 8
#define SUBACC_CMD 12
#define ECHO_CMD 14
#define SLEEP_CMD 15
#define PULSE_SERIAL_COM_MAX 15
#define WAKE_CMD 16
#define RESET_CMD 17
#define PULSE_COM_NUM 18
#define NO_PULSE_BIT_DATA 0xFFFFFFFF
#define RELAY_CMD_MIN 4
#define RELAY_CMD_MAX 7
#endif
```

EP 1 960 932 B1

PULSEOUTM.DEF

```
#include "clklink.def"
#include "mtrlink.def"

#include "plc.def"
#include "serlink.def"
#include "pulselink.def"

#ifndef NO_PULSES

#include "scan.h"
#include "pulse.h"
#include "log.h"

void pulseout_second_back(void);
void pulseout_ram_init1(void);
ADDRFN pulseoutaddrfn ;

#pragma region ("data=ramInit1")
void (*pulseout_ram_init1p)(void)=pulseout_ram_init1;
#pragma region ("data=data")

#pragma region ("data=secondBack")
void (*pulseout_second_backp)(void)=pulseout_second_back ;
#pragma region ("data=data")

ADDRFN_RET pulseoutaddrfn(reg8stru reg8)
{
  /*: write the load shed event to flash */
  putEvent(LOAD_SHED_EVENT,1,andreg8.ulong);

  return(0);
}

void pulseout_ram_init1()
{
  addrfn_tbl[GET_FROM_SLAVE][PULSEOUT_STATE] = pulseoutaddrfn ;
}
void pulseout_second_back()
{
}
#endif
```

## Claims

1. An apparatus for multi-channel metering of electricity, comprising:

   a meter head (140) located on a secondary side of a transformer (110),
   said meter head in communication with a transponder (210) located on a primary side of the transformer operable to transmit data to and receive data from said transponder via power line communication, said transponder operable to transmit data to and receive data from a remotely located computer;
   **characterised in that**:

   the meter head is operable to separately measure electricity usage for each of a plurality of electricity consumer lines; and
   the apparatus further comprises:

one or more load control modules (240) in communication with said meter head and operable to actuate connection and disconnection of each of a plurality of relays, each relay of said plurality of relays corresponding to one of said plurality of electricity consumer lines; and

a box containing said meter head, said load control module, and said relays.

2. An apparatus as in claim 1, further comprising a tamper detector in communication with said meter head (140).

3. An apparatus as in claim 2, wherein said tamper detector comprises a light and a reflective surface, and wherein said meter head is operable to instruct said one or more load control modules (240) to disconnect all of said customer lines if said tamper detector provides notification that said light is not detected reflecting from said reflective surface.

4. An apparatus as in claim 2, wherein said tamper detector comprises a detector of ambient light entering said box.

5. An apparatus as in claim 1, wherein said box is installed on a utility pole.

6. An apparatus as in claim 1, further comprising means for comparing transformer energy to total energy used by said consumer lines.

7. An apparatus as in claim 1, further comprising means for detecting reverse voltage flow through said consumer lines.

8. An apparatus as in claim 1, further comprising a computer readable memory in communication with said meter head (140) and a counter in communication with said meter head, said counter corresponding to a customer line and operable to count down an amount of energy stored in said memory, and said meter head operable to send a disconnect signal to a corresponding load control module (240) to disconnect said customer line when said counter reaches zero.

9. An apparatus as in claim 1, further comprising a computer readable memory in communication with said meter head (140), said memory operable to store a load limit for a customer line, and said meter head operable to send a disconnect signal to a corresponding load control module to disconnect said customer line when said load limit is exceeded.

10. An apparatus as in claim 1, further comprising a computer readable memory in communication with said meter head (140), said memory operable to store a usage limit for a customer line, and said meter head operable to send a disconnect signal to a corresponding load control module to disconnect said customer line when said usage limit is exceeded.

11. An apparatus as in claim 1, wherein said transponder (210) is operable to communicate with said remotely located computer over medium tension power lines.

12. An apparatus as in claim I, further comprising a display unit in communication with said meter head (140) and operable to display data received from said meter head.

13. An apparatus as in claim 12, wherein said display unit is operable to display information regarding a customer's energy consumption.

14. An apparatus as in claim 12, wherein said display unit is operable to display warnings regarding a customer's energy usage or suspected theft of energy.

15. An apparatus as in claim 12, wherein said display unit is operable to transmit to said meter head information entered by a customer.

16. An apparatus as in claim 1, wherein said transponder (210) is operable to report data to said remotely located computer via a telephone line.

17. An apparatus as in claim 1, wherein said meter head (140) is operable to measure electricity supplied to said meter head.

18. An apparatus as in claim 1, wherein said meter head (140) is operable to transmit data directly to said transponder (210) at frequencies within the range 10-25 kHz.

**19.** An apparatus as in claim 1, wherein said meter head (140) is operable to transmit data directly to said transponder (210) at frequencies corresponding to half-odd harmonics of line frequency.

**20.** An apparatus as in claim 1, wherein said box is installed on a utility pole above a medium tension line.

**Patentansprüche**

**1.** Vorrichtung für die Mehrkanalmessung von Elektrizität, die Folgendes umfasst:

einen Messkopf (140), der sich auf einer Sekundärseite eines Transformators (110) befindet, wobei der Messkopf mit einem auf einer Primärseite des Transformators befindlichen Transponder (210) in Verbindung steht und wirksam ist, um über Powerline-Kommunikation Daten zu dem Transponder zu übertragen und Daten davon zu empfangen, wobei der Transponder wirksam ist, um Daten zu einem entfernt befindlichen Computer zu übertragen und davon zu empfangen; **dadurch gekennzeichnet, dass**:

der Messkopf wirksam ist, um die Nutzung von Elektrizität für jede einer Vielzahl von Elektrizitätsverbraucherleitungen getrennt zu messen; und die Vorrichtung weiter Folgendes umfasst:

ein oder mehr Laststeuermodule (240) in Verbindung mit dem Messkopf, die wirksam sind, um das Anschließen und Abtrennen von jedem einer Vielzahl von Relais zu betätigen, wobei jedes der Vielzahl von Relais einer der Vielzahl von Elektrizitätsverbraucherleitungen entspricht; und einen Kasten, der den Messkopf, das Laststeuermodul und die Relais enthält.

**2.** Vorrichtung nach Anspruch 1, weiter umfassend einen Manipulationsdetektor in Verbindung mit dem Messkopf (140).

**3.** Vorrichtung nach Anspruch 2, wobei der Manipulationsdetektor ein Licht und eine reflektierende Oberfläche umfasst und wobei der Messkopf wirksam ist, um das eine oder mehr Laststeuermodule (240) anzuweisen, alle der Kundenleitungen abzutrennen, wenn der Manipulationsdetektor eine Meldung bereitstellt, dass nicht erfasst wird, dass das Licht von der reflektierenden Oberfläche reflektiert wird.

**4.** Vorrichtung nach Anspruch 2, wobei der Manipulationsdetektor einen Detektor für in den Kasten eindringendes Umgebungslicht umfasst.

**5.** Vorrichtung nach Anspruch 1, wobei der Kasten an einem Strommast installiert ist.

**6.** Vorrichtung nach Anspruch 1, weiter umfassend Mittel zum Vergleichen von Transformatorenergie mit von den Verbraucherleitungen verbrauchter Gesamtenergie.

**7.** Vorrichtung nach Anspruch 1, weiter umfassend Mittel zum Erfassen von Gegenspannungsfluss durch die Verbraucherleitungen.

**8.** Vorrichtung nach Anspruch 1, weiter umfassend einen computerlesbaren Speicher in Verbindung mit dem Messkopf (140) und einen Zähler in Verbindung mit dem Messkopf, wobei der Zähler einer Kundenleitung entspricht und wirksam ist, um eine in dem Speicher gespeicherte Energiemenge herunterzuzählen und wobei der Messkopf wirksam ist, um ein Abtrennsignal an ein entsprechendes Laststeuermodul (240) zu senden, um die Kundenleitung abzutrennen, wenn der Zähler null erreicht.

**9.** Vorrichtung nach Anspruch 1, weiter umfassend einen computerlesbaren Speicher in Verbindung mit dem Messkopf (140), wobei der Speicher wirksam ist, um eine Lastgrenze für eine Kundenleitung zu speichern und wobei der Messkopf wirksam ist, um ein Abtrennsignal an ein entsprechendes Laststeuermodul zu senden, um die Kundenleitung abzutrennen, wenn die Lastgrenze überschritten wird.

**10.** Vorrichtung nach Anspruch 1, weiter umfassend einen computerlesbaren Speicher in Verbindung mit dem Messkopf (140), wobei der Speicher wirksam ist, um eine Nutzungsgrenze für eine Kundenleitung zu speichern und wobei der Messkopf wirksam ist, um ein Abtrennsignal an ein entsprechendes Laststeuermodul zu senden, um die Kundenleitung abzutrennen, wenn die Nutzungsgrenze überschritten wird.

11. Vorrichtung nach Anspruch 1, wobei der Transponder (210) wirksam ist, um mit dem entfernt befindlichen Computer über Mittelspannungs-Stromleitungen zu kommunizieren.

12. Vorrichtung nach Anspruch 1, weiter umfassend eine Anzeigeeinheit in Verbindung mit dem Messkopf (140), die wirksam ist, um von dem Messkopf empfangene Daten anzuzeigen.

13. Vorrichtung nach Anspruch 12, wobei die Anzeigeeinheit wirksam ist, um Informationen betreffend den Energieverbrauch eines Kunden anzuzeigen.

14. Vorrichtung nach Anspruch 12, wobei die Anzeigeeinheit wirksam ist, um Warnungen betreffend die Energienutzung eines Kunden oder vermuteten Energiediebstahl anzuzeigen.

15. Vorrichtung nach Anspruch 12, wobei die Anzeigeeinheit wirksam ist, um von einem Kunden eingegebene Informationen zu dem Messkopf zu übertragen.

16. Vorrichtung nach Anspruch 1, wobei der Transponder (210) wirksam ist, um über eine Telefonleitung Daten zu dem entfernt befindlichen Computer zu melden.

17. Vorrichtung nach Anspruch 1, wobei der Messkopf (140) wirksam ist, um zu dem Messkopf zugeführte Elektrizität zu messen.

18. Vorrichtung nach Anspruch 1, wobei der Messkopf (140) wirksam ist, um Daten mit Frequenzen im Bereich 10-25 kHz direkt zu dem Transponder (210) zu übertragen.

19. Vorrichtung nach Anspruch 1, wobei der Messkopf (140) wirksam ist, um Daten mit Frequenzen, die halb ungeraden Oberschwingungen der Leitungsfrequenz entsprechen, direkt zu dem Transponder (210) zu übertragen.

20. Vorrichtung nach Anspruch 1, wobei der Kasten an einem Strommast über einer Mittelspannungsleitung installiert ist.

## Revendications

1. Un appareil de relevé d'électricité à canaux multiples comprenant :

une tête de compteur (140) placée sur un côté secondaire d'un transformateur (110),
ladite tête de compteur étant en communication avec un transpondeur (210) placé sur un côté primaire du transformateur et étant conçue de façon à émettre des données vers et à recevoir des données dudit transpondeur par l'intermédiaire d'une communication par ligne électrique, ledit transpondeur étant conçu de façon à émettre des données vers et à recevoir des données d'un ordinateur installé à distance,
**caractérisé en ce que** :

la tête de compteur est conçue de façon à mesurer de manière séparée une consommation d'électricité pour chaque ligne d'une pluralité de lignes de consommateur d'électricité, et
l'appareil comprend en outre :

un ou plusieurs modules de régulation de charge (240) en communication avec ladite tête de compteur et conçus de façon à actionner une connexion et une déconnexion de chaque relais d'une pluralité de relais, chaque relais de ladite pluralité de relais correspondant à une ligne de ladite pluralité de lignes de consommateur d'électricité, et
un boîtier contenant ladite tête de compteur, ledit module de régulation de charge et lesdits relais.

2. Un appareil selon la Revendication 1, comprenant en outre un détecteur de fraude en communication avec ladite tête de compteur (140).

**3.** Un appareil selon la Revendication 2, où ledit détecteur de fraude comprend une lumière et une surface réfléchissante, et où ladite tête de compteur est conçue de façon à ordonner auxdits un ou plusieurs modules de régulation de charge (240) de déconnecter la totalité desdites lignes clients si ledit détecteur de fraude fournit une notification selon laquelle ladite lumière n'est pas détectée se réfléchir à partir de ladite surface réfléchissante.

**4.** Un appareil selon la Revendication 2, où ledit détecteur de fraude comprend un détecteur de lumière ambiante entrant dans ledit boîtier.

**5.** Un appareil selon la Revendication 1 où ledit boîtier est installé sur un poteau électrique.

**6.** Un appareil selon la Revendication 1, comprenant en outre un moyen de comparaison d'une énergie de transformateur à une énergie totale utilisée par lesdites lignes de consommateur.

**7.** Un appareil selon la Revendication 1, comprenant en outre un moyen de détection d'un flux de tension inverse au travers desdites lignes de consommateur.

**8.** Un appareil selon la Revendication 1, comprenant en outre une mémoire lisible par ordinateur en communication avec ladite tête de compteur (140) et un compteur en communication avec ladite tête de compteur, ledit compteur correspondant à une ligne client et étant conçu de façon à décompter une quantité d'énergie stockée dans ladite mémoire, et ladite tête de compteur étant conçue de façon à envoyer un signal de déconnexion à un module de régulation de charge correspondant (240) de façon à déconnecter ladite ligne client lorsque ledit compteur atteint zéro.

**9.** Un appareil selon la Revendication 1, comprenant en outre une mémoire lisible par ordinateur en communication avec ladite tête de compteur (140), ladite mémoire étant conçue de façon à conserver en mémoire une limite de charge pour la ligne client, et ladite tête de compteur étant conçue de façon à envoyer un signal de déconnexion à un module de régulation de charge correspondant de façon à déconnecter ladite ligne client lorsque ladite limite de charge est dépassée.

**10.** Un appareil selon la Revendication 1, comprenant en outre une mémoire lisible par ordinateur en communication avec ladite tête de compteur (140), ladite mémoire étant conçue de façon à conserver en mémoire une limite de consommation pour une ligne client, et ladite tête de compteur étant conçue de façon à envoyer un signal de déconnexion à un module de régulation de charge correspondant de façon à déconnecter ladite ligne client lorsque ladite limite de consommation est dépassée.

**11.** Un appareil selon la Revendication 1, où ledit transpondeur (210) est conçu de façon à communiquer avec ledit ordinateur installé à distance par l'intermédiaire de lignes électriques moyenne tension.

**12.** Un appareil selon la Revendication 1, comprenant en outre une unité d'affichage en communication avec ladite tête de compteur (140) et conçue de façon à afficher des données reçues de ladite tête de compteur.

**13.** Un appareil selon la Revendication 12, où ladite unité d'affichage est conçue de façon à afficher des informations relatives à une consommation d'énergie d'un client.

**14.** Un appareil selon la Revendication 12, où ladite unité d'affichage est conçue de façon à afficher des avertissements relatifs à une consommation d'énergie d'un client ou à un vol d'énergie suspecté.

**15.** Un appareil selon la Revendication 12, où ladite unité d'affichage est conçue de façon à transmettre à ladite tête de compteur des informations entrées par un client.

**16.** Un appareil selon la Revendication 1, où ledit transpondeur (210) est conçu de façon à rapporter des données audit ordinateur installé à distance par l'intermédiaire d'une ligne téléphonique.

**17.** Un appareil selon la Revendication 1, où ladite tête de compteur (140) est conçue de façon à mesurer l'électricité fournie à ladite tête de compteur.

**18.** Un appareil selon la Revendication 1, où ladite tête de compteur (140) est conçue de façon à transmettre des données directement audit transpondeur (210) à des fréquences à l'intérieur de la plage de 10 à 25 kHz.

**19.** Un appareil selon la Revendication 1, où ladite tête de compteur (140) est conçue de façon à transmettre des données directement audit transpondeur (210) à des fréquences correspondant à des demi-harmoniques impaires d'une fréquence de ligne.

**20.** Un appareil selon la Revendication 1, où ledit boîtier est installé sur un poteau électrique au-dessus d'une ligne moyenne tension.

A    MEDIUM VOLTAGE
B
C
N

DISTRIBUTION
TRANSFORMER    ~110

LOW VOLTAGE

ENERGY GUARD
(INCLUDING MINICLOSET)    ~140

120

CURRENT TRANSFORMER (CT)

TO CUSTOMERS

PHASES: 1 2 3 ................ 24

FIG.1

290 — CUSTOMER CIRCUIT

BACK PLATE ASSEMBLY — 270

| RELAY/CT BOARD | RELAY/CT BOARD | RELAY/CT BOARD |
|---|---|---|

260          260          260

255          250          280 — SLIDE PLATE          220          210

| AC POWER SUPPLY | DC POWER SUPPLY | METER HEAD WITH PLC COMMUNICATION | SCAN TRANSPONDER |

LOAD CONTROL MODULE — 240

FIG.2

FIG.3A

FIG.3A-1 | FIG.3A-2
FIG.3A-3 | FIG.3A-4 | FIG.3A-5
FIG.3A-6 | FIG.3A-7 | FIG.3A-8
FIG.3A-9 | FIG.3A-10 | FIG.3A-11

A[00:23]

A23
A22
A21
A13
A12
A11
A10
A09
A08
A07
A06
A05
A04
A03
A02
A01

FIG.3A-1

A13
A14
A15
A16
A17
A18
A19
A20
A21
A22
A23

D15
D14
D13
D12

+5V

D[00:15]

**FIG.3A-2**

FIG.3A-3

FIG.3A-4

EP 1 960 932 B1

FIG.3A-5

FIG.3A-6

FIG.3A-7

FIG.3A-8

81

FIG.3A-9

EP 1 960 932 B1

FIG.3A-10

FIG.3A-11

FIG.3B-5

FIG.3B-4

FIG.3B-8

FIG.3B-3

FIG.3B-7

FIG.3B-2

FIG.3B-6

FIG.3B-1

FIG.3B

EP 1 960 932 B1

FIG.3B-1

86

FIG.3B-2

FIG.3B-3

S[01:60]

S33
S32
S31
S30
S29
S28
S27
S26
S25
S24
S23
S22
S21
S20
S19
S18
S17
S16
S15
S14
S13
S12
S11
S10
S09
S08
S07
S06
S05
S04
S03
S02
S01

R5
10K9

C5
0.1uF

EP 1 960 932 B1

FIG.3B-4

89

FIG.3B-5

S60
S61
S62
S63
S64
S65
S66
S67
S68
S69
S70
S71
S72
S73
S74
S75
S76
S77
S78
S79
S80
C16
C15
C14
C13
C12
C11
C10
C09
C08
C07
C06
C05
C04
C03
C02
C01

C[01:16]

FIG.3B-6

FIG.3B-7

FIG.3B-8

FIG.4

FIG.4A FIG.4B FIG.4C
FIG.4D FIG.4E FIG.4F
FIG.4G FIG.4H FIG.4I
FIG.4J FIG.4K FIG.4L

C37

C10

0.1μF

0.1μF

R70

D53

D54

R69

R1

1N4148

1N4148

10K

1K

1M

C13

U2
PIC16LC505

1.8μF/400V

V1

+5V   1   VDD   VSS   14

B   2   RB5   RB0   13   PO2

A   3   RB4   RB1   12   PI1

PO1   4   RB3   RB2   11   TX4

INVR3   5   RC5   RC0   10   TX1

INVR2   6   RC4   RC1   9   TX2

INVR1   7   RC3   RC2   8   TX3

385LA20A
CR1

R77

N

10K

N

FIG.4A

EP 1 960 932 B1

FIG.4B

EP 1 960 932 B1

FIG.4C

FIG.4D

FIG.4E

EP 1 960 932 B1

FIG.4F

EP 1 960 932 B1

100

FIG.4G

FIG.4H

EP 1 960 932 B1

FIG.41

C40

R76    1K

0.1µF

D59    D60

1N4148    1N4148

R75    10K

R7    1M

C19

CV4

1.8µF/400V

R80

385LA20A
CR7

N

CN4

10K

H1
39310120

CV4    7    1    CN4

N    6    2    N

9    3

10    4    V3

11    5

V2    12    6    V1

+U

C5

10µF/35V    +

FIG.4J

FIG.4K

FIG.4L

| | | |
|---|---|---|
| FIG.5A | FIG.5B | FIG.5C |
| FIG.5D | FIG.5E | FIG.5F |
| FIG.5G | FIG.5H | FIG.5I |

FIG.5

EP 1 960 932 B1

FIG.5A

EP 1 960 932 B1

FIG.5B

EP 1 960 932 B1

FIG.5C

FIG.5D

FIG.5E

FIG.5F

EP 1 960 932 B1

# FIG.5G

FIG.5H

FIG.51

| | | | | | | |
|---|---|---|---|---|---|---|
| FIG.6A | FIG.6B | FIG.6C | FIG.6D | FIG.6E | FIG.6F | FIG.6G |
| FIG.6H | FIG.6I | FIG.6J | FIG.6K | FIG.6L | FIG.6M | FIG.6N |
| FIG.6O | FIG.6P | FIG.6Q | FIG.6R | FIG.6S | FIG.6T | FIG.6U |

FIG.6

FIG.6A

## FIG.6B

FIG.6C

FIG.6D

N[01:24]

I[01:24]

+5V

CD4052M    U2

16

| | | | |
|---|---|---|---|
| 10 | A | VCC | |
| 9 | B | X0 | 12 | N01 |
| | | X1 | 14 | N04 |
| | | X2 | 15 | N07 |
| 13 | O/IX | X3 | 11 | N10 |

| 3 | O/IY | Y0 | 1 | I01 |
| | | Y1 | 5 | I04 |
| | | Y2 | 2 | I07 |
| 6 | INH | VSS GND | Y3 | 4 | I10 |

7  8

A-1

INH1-1

# FIG.6E

FIG.6F

FIG.6G

FIG.6H

FIG.61

FIG.6J

FIG.6K

FIG.6L

FIG.6M

FIG.6N

FIG.6O

FIG.6P

FIG.6Q

FIG.6R

FIG.6S

R87

3K92

Q1

RJ1

1
2
3
4
5
6
7
8

A-GND

H4

4 3 2 1

+5V
RXD
TXD

# FIG.6T

FIG.6U

| | | |
|---|---|---|
| FIG.7A−1 | FIG.7A−2 | FIG.7A−3 |
| | FIG.7A−4 | |

FIG.7A

FIG.7A-1

FIG.7A-2

EP 1 960 932 B1

FIG.7A-3

EP 1 960 932 B1

FIG.7A-4

| FIG.7B-1 | FIG.7B-2 | FIG.7B-3 |
|---|---|---|

# FIG.7B

FIG.7B-1

FIG.7B-2

FIG.7B-3

| | | |
|---|---|---|
| FIG.7C-1 | FIG.7C-2 | FIG.7C-3 |

FIG.7C

FIG.7C-1

FIG.7C-2

FIG.7C-3

| | |
|---|---|
| FIG.8A-1 | FIG.8A-2 |
| FIG.8A-3 | FIG.8A-4 |

FIG.8A

FIG.8A-1

FIG.8A-2

FIG.8A-3

FIG.8A-4

| | |
|---|---|
| FIG.8B-1 | FIG.8B-2 |
| FIG.8B-3 | FIG.8B-4 |

FIG.8B

FIG.8B-1

FIG.8B-2

FIG.8B-3

+U

U41
LP2985IM5-5.0

1 VIN
3 ON/OFF
BYPASS
4

VOUT 5

GND 2

+5VA

C59
2.2µF

C60
10nF

C61
2.2µF

A

A

A

LL4148
D32

R9    0

C

A

VA
VB
VC
N

N'
VC'
VB'
VA'

VA

VB

VC

N

R3    0
R4    0
R5    0
R6    0

VA'

VB'

VC'

N'

FIG.8B-4

EP 1 960 932 B1

| FIG.8C-1 | FIG.8C-2 | FIG.8C-3 | FIG.8C-4 | FIG.8C-5 |
|----------|----------|----------|----------|-----------|
| FIG.8C-6 | FIG.8C-7 | FIG.8C-8 | FIG.8C-9 | FIG.8C-10 |

NOTE: FOR INPUTS 1 AND 2, REFER TO H4 OF FIG.3

FIG.8C

FIG.8C-1

FIG.8C-2

FIG.8C-3

FIG.8C-4

FIG.8C-5

FIG.8C-6

FIG.8C-7

FIG.8C-8

FIG.8C-9

+5V

C32
0.1μF

14

U27-E
SN74HC02D

7

U27-D

11

12

13

SN74HC02D

FIG.8C-10

| FIG.8D-1 | FIG.8D-2 | FIG.8D-3 |
|----------|----------|----------|
| FIG.8D-4 | FIG.8D-5 | |

FIG.8D

OUT TO RJ BOARD A-PHASE

OUT TO RJ BOARD B-PHASE

FIG.8D-1

174

+5V

R10
182

LED2
QED523

TXD

FROM DISPLAY BOARD

H3

P11 — 1 | 2 — P02
3 | 4 — P01
5 | 6 — TESTN
7 | 8
GP2 — 9 | 10 — PLCX1
SW1 — 11 | 12 — PLCX2
SW2 — 13 | 14 — PLC1
SW3 — 15 | 16
17 | 18 — MV1
TXD — 19 | 20 — MV2
RXD — 21 | 22 — MV3
N1 — 23 | 24 — I1
N2 — 25 | 26 — I2
N3 — 27 | 28 — I3
29 | 30
BATT — 31 | 32 — VREF
33 | 34 — +5V

2X17
MALE

R43
100

DISPLAY — 1 | 3 — SW1
2 | 4
SW1

FIG.8D-2

TO RJ11 OPTION BOARD

FIG.8D-3

OUT TO RJ BOARD C-PHASE

FIG.8D-4

FROM DISPLAY BOARD

FIG.8D-5

| | | |
|---|---|---|
| FIG.9A−1 | FIG.9A−2 | FIG.9A−3 |
| FIG.9A−4 | FIG.9A−5 | FIG.9A−6 |
| FIG.9A−7 | FIG.9A−8 | FIG.9A−9 |

FIG.9A

FIG.9A-1

FIG.9A-2

FIG.9A-3

EP 1 960 932 B1

FIG.9A-4

FIG.9A-5

184

EP 1 960 932 B1

VREF-A

R73    10K
R74    10K

N07
I07
OPEN7
CLOSE7
CGNDA
+UDA
VREF-A
SH07

CT7
RJ45-VERT

8
7
6
5
4
3
2
1

VREF-A

R126    10K
R127    10K

N19
I19
OPEN19
CLOSE19
CGNDA
+UDA
VREF-A
SH19

CT19
RJ45-VERT

8
7
6
5
4
3
2
1

FIG.9A-6

FIG.9A-7

DIR+A
9
+

OPEN10
14

REN10A
8
−

U10-C
LM339DB

DIR-A
11
+

CLOSE10
13

10
−

U10-D
LM339DB

DIR+A
9
+

OPEN22
14

REN22A
8
−

U14-C
LM339DB

DIR-A
11
+

CLOSE22
13

10
−

U14-D
LM339DB

FIG.9A-8

VREF-A

R120  10K
R121  10K

CT10
RJ45-VERT

N10
I10
OPEN10
CLOSE10
+UDA
CGNDA
VREF-A
SH10

8
7
6
5
4
3
2
1

VREF-A

R130  10K
R131  10K

CT22
RJ45-VERT

N22
I22
OPEN22
CLOSE22
+UDA
CGNDA
VREF-A
SH22

8
7
6
5
4
3
2
1

EP 1 960 932 B1

FIG.9A-9

FIG.9B

FIG.9B-1

EP 1 960 932 B1

FIG.9B-2

EP 1 960 932 B1

VREF-B

R81 10K
R82 10K

CT2
RJ45-VERT

NO2 — 8
IO2 — 7
OPEN2 — 6
CLOSE2 — 5
CGNDB — 4
+UDB — 3
VREF-B — 2
SHO2 — 1

VREF-B

R134 10K
R135 10K

CT14
RJ45-VERT

N14 — 8
I14 — 7
OPEN14 — 6
CLOSE14 — 5
CGNDB — 4
+UDB — 3
VREF-B — 2
SH14 — 1

VREF-B

R85 10K
R86 10K

CT5
RJ45-VERT

NO5 — 8
IO5 — 7
OPEN5 — 6
CLOSE5 — 5
+UDB — 4
CGNDB — 3
VREF-B — 2
SHO5 — 1

VREF-B

R138 10K
R139 10K

CT17
RJ45-VERT

N17 — 8
I17 — 7
OPEN17 — 6
CLOSE17 — 5
+UDB — 4
CGNDB — 3
VREF-B — 2
SH17 — 1

# FIG.9B-3

FIG.9B-4

VREF-B

+5VAB
+5VA

U9
CD405iBCM

A 11
B 10
C 9

A-B
B-B
C-B

VDD 16

I/O_8 13
I/O_1 14
I/O_2 15
I/O_3 12
I/O_4 1
I/O_5 5
I/O_6 2
I/O_7 4

VSS 3

INH 6
VFE 7

O/I 8

C9
0.1μF

A
AGNDB

A
AGNDB

FGNDB

+5VAB
+5VA

U8
CD405iBCM

A 11
B 10
C 9

A-B
B-B
C-B

VDD 16

I/O_8 13
I/O_1 14
I/O_2 15
I/O_3 12
I/O_4 1
I/O_5 5
I/O_6 2
I/O_7 4

VSS 3

INH 6
VFE 7

O/I 8

C8
0.1μF

A
AGNDB

A
AGNDB

FGNDB

SH02
SH05
SH08
SH11
SH14
SH17
SH20
SH23

INHB

FIG.9B-5

VREF-B

R89    10K

R90    10K

N08        8
I08         7
$\overline{\text{OPEN8}}$    6
$\overline{\text{CLOSE8}}$   5
+UDB      4
CGNDB    3
VREF-B    2
SH08      1

CT8
RJ45-VERT

VREF-B

R142    10K

R143    10K

N20        8
I20         7
$\overline{\text{OPEN20}}$    6
CLOSE120   5
+UDB      4
CGNDB    3
VREF-B    2
SH20      1

CT20
RJ45-VERT

FIG.9B-6

EP 1 960 932 B1

**FIG.9B-7**

FIG.9B-8

FIG.9B-9

| | | |
|---|---|---|
| FIG.9C-1 | FIG.9C-2 | FIG.9C-3 |
| FIG.9C-4 | FIG.9C-5 | FIG.9C-6 |
| FIG.9C-7 | FIG.9C-8 | FIG.9C-9 |

FIG.9C

EP 1 960 932 B1

FIG.9C-1

+UC

DIR+C 5 + V+ 2 OPEN3

REN3C 4 − GND U21-A
LM339DB

12 −UC

DIR−C 7 + 1 CLOSE3

6 − U121-B
LM339DB

DIR+C 9 + 14 OPEN6

REN6C 8 − U21-C
LM339DB

+UC

DIR+C 5 + V+ 2 OPEN15

REN15C 4 − GND U23-A
LM339DB

12 −UC

DIR−C 7 + 1 CLOSE15

6 − U23-B
LM339DB

DIR+C 9 + 14 OPEN18

REN18C 8 − U23-C
LM339DB

FIG.9C-2

**FIG.9C-3**

FIG.9C-4

EP 1 960 932 B1

FIG.9C-5

EP 1 960 932 B1

VREF-C

R99    10K

R100    10K

CT9
RJ45-VERT

N09 ──── 8
I09 ──── 7
OPEN9 ──── 6
CLOSE9 ──── 5
CGNDC ──── 4
+UDC ──── 3
VREF-C ──── 2
SH09 ──── 1

VREF-C

R105    10K

R106    10K

CT21
RJ45-VERT

N21 ──── 8
I21 ──── 7
OPEN21 ──── 6
CLOSE121 ──── 5
CGNDC ──── 4
+UDC ──── 3
VREF-C ──── 2
SH21 ──── 1

FIG.9C-6

FIG.9C-7

FIG.9C-8

EP 1 960 932 B1

FIG.9C-9

EP 1 960 932 B1

| | |
|---|---|
| FIG.10A | FIG.10B |
| FIG.10C | FIG.10D |

FIG.10

FIG.10A

FIG.10B

EP 1 960 932 B1

R4
330K

J2
1 —————/\/\/\————● PAD1   CUSTOMER SIDE OF K3
2
39830–0102

R5
330K

————▷ SH

R6
1K

————▷ SL

# FIG.10C

FIG.10D

PIANO HINGE

GASKET

ENCLOSURE BOTTOM

SCREW AND RETAINING WASHER (X 3)

FIG.11

FIG.12

FIG.13

COMMON BUS BAR

CROSS BAR

FIG.14

FIG.15A

FIG.15B

FIG.16

FIG.17

FIG.18A

FIG.18B

FIG.19

**FIG.20**

FIG.21A

FIG.21B

FIG.21C

3 CT RELAY
BOX TOP

SELF TAPPING
SCREWS X 4

RELAY ASSEMBLY X 3

3 CT RELAY PCB

SELF TAPPING
SCREW X 2

3 CT RELAY
BOX BOTTOM

FIG.21D

FIG.22

FIG.23

COMMON STANDOFF
SCREW

CONTROL BOX (X 2)

SCREW (X 4)

STANDOFF A (X 8)

STANDOFF A

STANDOFF B (X 8)

SCREW INSULATING
BUSHING (X 8)

ENERGY GUARD
RELAY ASSEMBLY

INSULATION
MATERIAL C

HOME CABLE
BUSHING RETAINER
(X 12)

FEED
CABLE
BUSHING

SCREW
INSULATING
BUSHING

NUT (X 4)

ENCLOSURE
BOTTOM

PLASTIC ACCEPTOR ASSEMBLY
(MODULE BOX) SCREW.
SELF TAPPING (X 8)

HOME CABLE
BUSHING (X 12)

# FIG.24

ST: SCAN TRANSPONDER INSTALLED REMOTE TO EG

PLC COMMUNICATION

FIG.25

CPU PCB203

| FIG.26A-1 | FIG.26A-2 |
| FIG.26A-3 | FIG.26A-4 |

FIG.26A

EP 1 960 932 B1

FIG.26A-1

EP 1 960 932 B1

FIG.26A-2

FIG.26A-3

EP 1 960 932 B1

FIG.26A-4

IC
U3
MC56F8014

VDDA 8
VDD 25
VCAP 24

VA_OUT_D 13 ANA0/PC0
VB_OUT_D 12 ANA1/PC1
11 ANA2/PC2
10 ANA3/PC3

PA0/PWM0 28 CLOSE
PA1/PWM1 27 OPEN
PA2/PWM2 23 OPEN-2
PA4/PWM4/T2 22 FINE_TUNING
PA5/PWM5/T3 20 CLOSE-2

IA_OUT_D 4 ANB0/PC4
Ib_OUT_D 5 ANB1/PC5
6 ANB2/PC6
7 ANB3/PC7

PB0/SCLK 21 QSPI_SCK
PB1/SS/SDA 1 I2C_SDA
PB2/MISO/T2 18 QSPI_CS0
PB3/MOSI/T3 17 QSPI_DOUT
PB4/T0 19 XTAL_REF
PB5/T1 3 COARSE_TUNING
PB6/RXD/CLKIN 32 VCO
PB7/TXD 2 I2C_SCL

RESET 16 RESET

TMS 30 TMS/PD3
TCK 15 TCK/PD2
TDI 29 TDI/PD0

TDO/PD1 31 TDO

VSSA 9
VSS 14
VSS 26

A

DGND

EP 1 960 932 B1

## METER I PCB203

| | | |
|---|---|---|
| FIG.26B-1 | FIG.26B-2 | FIG.26B-3 |
| FIG.26B-4 | FIG.26B-5 | FIG.26B-6 |

## FIG.26B

FIG.26B-1

EP 1 960 932 B1

FIG.26B-2

FIG.26B-3

IRB0
IRB1
IRB2

+3.3VA

C119
0.1µF
X7R

AGND

R165
3.83K
25PPM

R162
6.98K
25PPM

C132
10nF
NPO

R145
4.02K
25PPM

R144
10R0
25PPM

R142
10R0
25PPM

C133
0.1µF

D8
MB25

FB18
STEWARD
2000ohms

FB19
STEWARD
2000ohms

H4
1x2 VER

**FIG.26B-4**

FIG.26B-5

FIG.26B-6

METER Ⅴ PCB203

| | |
|---|---|
| FIG.26C-1 | FIG.26C-2 |
| FIG.26C-3 | FIG.26C-4 |

FIG.26C

FIG.26C-1

FIG.26C-2

N

FB1    1   2
STEWARD
2000ohms

FB4    1   2
STEWARD
2000ohms

FB9    1   2
STEWARD
2000ohms

+3.3A   R35
1.00K
25PPM

C18   470pF
      NPO

C17
0.1μF

25PPM
1.00K
R37

FIG.26C-3

+3.3VA

U20-D

16

VCC

7 VEE INH 6

C123
0.1µF

GND

8

A

5

+

7

6

−

U9-B
LMV324

ADC_REF

FIG.26C-4

# 20 PIN EDGE CONNECTOR-FEMALE

H1

12C_SCL

12C_SDA

+V
+U
RESET
XTAL_REF
POS3
POS4
POS5
N
N

POS0
POS1
POS2
PGND
N
N

2X12
FEMALE

C

# JTAG TEST HEADER

J4                    JTAG PORT

MTG1
○ 1
4-40 HDWR

MTG2
○ 1
4-40 HDWR

TDI
TDO
TCK

RESET

TDI
TDO
TCK

RESET
+3.3V
DF

GND
GND
GND

TMS

TRST

TMS

DGND

2x7
MALE

EDGE CONNECTOR
PCB203

FIG.26D

EP 1 960 932 B1

LEDTOT

LEDB

LEDA

+V

LED3
QEB421

R36
220R

B C
Q1
E

1.00K
R43

KWH_PULSE

DGND

+V

LED1
QEB421

R2
220R

B C
Q2
E

1.00K
R45

KWH_PULSEB

DGND

+V

LED2
QEB421

R44
220R

B C
Q7
E

1.00K
R48

KWH_PULSEA

DGND

KWH LEDS PCB203

FIG.26E

EG24 BLADE METER PCB203

| | |
|---|---|
| FIG.26F-1 | FIG.26F-2 |

FIG.26F-3

# FIG.26F

EP 1 960 932 B1

FIG.26F-1

C180
220pF
NPO

C11
100pF
NPO

D4
MA2SV01

R31
100K

C12
0.1μF

R72
22.0K

C13
0.1μF

R81
22.0K

C61
0.1μF

R20
22.0K

FINE_TUNING

DGND

FIG.26F-2

EP 1 960 932 B1

FIG.26F-3

254

EG24 BLADE METER PCB203

| | |
|---|---|
| FIG.26G-1 | FIG.26G-2 |
| FIG.26G-3 | FIG.26G-4 |

FIG.26G

EP 1 960 932 B1

FIG.26G-1

256

FIG.26G-2

EP 1 960 932 B1

REF_MSV ⊳———————10 + 8 ———————⊳ IA_OUT_D

9 −

U1-C
LMV324

IA_OUT ⊳— R58 —/\/\/— 1.00K — R57 —/\/\/— 3.01K

25PPM          25PPM

REF_MSV ⊳———————12 + 14 ———————⊳ IB_OUT_D

13 −

U1-D
LMV324

IB_OUT ⊳— R61 —/\/\/— 1.00K — R60 —/\/\/— 3.01K

25PPM          25PPM

**FIG.26G-3**

FIG.26G-4

EG24 BLADE METER PCB203

| FIG.26H-1 | FIG.26H-2 |
|-----------|-----------|

FIG.26H

FIG.26H-1

FIG.26H-2

CPU

| | |
|---|---|
| FIG.27A | FIG.27B |

FIG.27

FIG.27A

IC
U2
M24C64-WMN6T

| | 8 |
| VCC | |
| 1 | EO |
| 2 | E1 |
| 3 | E2 | SDA | 5 |
| 6 | SCL |
| 7 | WC |
| VSS | |
| | 4 | IC/M24C64-WMN6T/SO8 |

FIG.27B

HDRS TO BLADES PCB234

| | |
|---|---|
| FIG.28B-1 | FIG.28B-2 |
| FIG.28B-3 | FIG.28B-4 |
| FIG.28B-5 | FIG.28B-6 |

FIG.28B

Aluminum bar mounted in this area

Aluminum Bar

FIG.28A

EP 1 960 932 B1

H1

1 2    BUS_RXD
3 4    BUS_REQ
5 6    BUS_TXD
7 8    BUS_ENABLE
9 10    PGND
11 12    PGND
13 14    PGND
15 16    PGND
17 18    N
19 20    N

+V
+U
RESET
XTAL_REF
PGND
POS4
POS5
N
N

2X10
MALE

C

H2

1 2    BUS_RXD
3 4    BUS_REQ
5 6    BUS_TXD
7 8    BUS_ENABLE
9 10    +V
11 12    PGND
13 14    PGND
15 16    PGND
17 18    N
19 20    N

+V
+U
RESET
XTAL_REF
PGND
POS4
POS5
N
N

2X10
MALE

C

FIG.28B-1

FIG.28B-2

FIG.28B-3

FIG.28B-4

H5

| | | | |
|---|---|---|---|
| +V | 1 | 2 | BUS_RXD |
| +U | 3 | 4 | BUS_REQ |
| RESET | 5 | 6 | BUS_TXD |
| XTAL_REF | 7 | 8 | BUS_ENABLE |
| PGND | 9 | 10 | PGND |
| POS4 | 11 | 12 | PGND |
| POS5 | 13 | 14 | +V |
| N | 15 | 16 | PGND |
| N | 17 | 18 | N |
| | 19 | 20 | N |

2X10
MALE

C

H6

| | | | |
|---|---|---|---|
| +V | 1 | 2 | BUS_RXD |
| +U | 3 | 4 | BUS_REQ |
| RESET | 5 | 6 | BUS_TXD |
| XTAL_REF | 7 | 8 | BUS_ENABLE |
| PGND | 9 | 10 | +V |
| POS4 | 11 | 12 | PGND |
| POS5 | 13 | 14 | +V |
| N | 15 | 16 | PGND |
| N | 17 | 18 | N |
| | 19 | 20 | N |

2X10
MALE

C

# FIG.28B-5

EP 1 960 932 B1

FIG.28B-6

HEADERS PCB234

| | |
|---|---|
| FIG.28C-1 | FIG.28C-2 |

FIG.28C

POWER HEADER

H13

+V — 1
PGND — 2
+U — 3
CGND — 4

1x04

RS232 HEADER

H14

BUS_RXD — 1 — TXD
XTAL_REF — 2 — RTS
BUS_TXD — 3 — RXD
BUS_REQ — 4 — CTS
PGND — 5 — GND

1x05

JUMPERS

J1

POS4 — 1   2 — PGND
        3   4 — +V
POS5 — 5   6
        7   8
BUS_ENABLE — 9   10
        11  12

2x6 VER
MALE

FIG.28C-1

275

POWER HEADER

H16

+V ——— 1
PGND ——— 2
+U ——— 3
CGND ——— 4

1x04

RS232 HEADER

H15

BUS_RXD ——— 1 ——— TXD
XTAL_REF ——— 2 ——— RTS
BUS_TXD ——— 3 ——— RXD
BUS_REQ ——— 4 ——— CTS
PGND ——— 5 ——— GND

1x05

JUMPERS

J2

POS4 ——— 1    2 ——— PGND
        3    4 ——— +V
POS5 ——— 5    6
        7    8
BUS_ENABLE ——— 9   10
        11   12

2x6 VER
MALE

# FIG.28C-2

POWER SUPPLY UNIT SCH210-1

FIG.29A-1

FIG.29A-2

FIG.29A-3

FIG.29A

FIG.29A-1

FIG.29A-2

EP 1 960 932 B1

FIG.29A-3

PLC SCH210-1

| | |
|---|---|
| FIG.29B-1 | FIG.29B-2 |
| FIG.29B-3 | |

FIG.29B

EP 1 960 932 B1

FIG.29B-1

FIG.29B-2

EP 1 960 932 B1

HEADER TO CPU BOARD

J4

PLCRH
PLCRL
PLCXEN
PLCXL
PLCXH
+U

1   2   +VA
3   4   SGND
5   6
7   8
9   10  +V
11  12

2x06
FEMALE

C

P

FIG.29B-3

EP 1 960 932 B1

## PCB230 POWER SUPPLY

| | |
|---|---|
| FIG.30A-1 | FIG.30A-2 |

## FIG.30A

EP 1 960 932 B1

FIG.30A-1

FIG.30A-2

HEADER TO CPU BOARD

HEADER FOR PROGRAMMING MSP430 CHIPS

J10

2x06
FEMALE

U1RXD
U1TXD
U1RTS
U1CTS

U2RXD
U2TXD
U2RTS
SDA
SCK

+V

1 2
3 4
5 6
7 8
9 10
11 12

P

J1

2x003
MALE

TEST_1
TEST_2

RST_1
RST_2

+VI

1 2
3 4
5 6

I

MTG1      FID1      FID2      FID3

1

FIDUCIAL   FIDUCIAL   FIDUCIAL

IO BOARD SCH230-1

FIG.30B

EP 1 960 932 B1

I/O PC BOARD PCB230-1

FIG.30C-1 FIG.30C-2 FIG.30C-3 FIG.30C-4

FIG.30C

FIG.30C-1

FIG.30C-2

EP 1 960 932 B1

FIG.30C-3

EP 1 960 932 B1

FIG.30C-4

I/O PC BOARD PCB230-1

| | |
|---|---|
| FIG.30D-1 | FIG.30D-2 |
| FIG.30D-3 | |

FIG.30D

EP 1 960 932 B1

FIG.30D-1

EP 1 960 932 B1

C15
0.1μF

C16
0.1μF

C17
0.1μF

J4    RS232 HEADER

1    TXD
2    RTS
3    RXD
4    CTS
5    GND

1x05

FIG.30D-2

FIG.30D-3

RELAY OUT PCB230

| | |
|---|---|
| FIG.30E-1 | FIG.30E-2 |

FIG.30E-3

# FIG.30E

FIG.30E-1

FIG.3OE-2

FIG.30E-3

GP10 PCB230

| | |
|---|---|
| FIG.30F-1 | FIG.30F-2 |

FIG.30F

EP 1 960 932 B1

FIG.30F-1

U1
MSP430F2002

VCC 1

P1.0/TACLK/ACLK/A0 2
P1.1/TA0/A1 3
P1.2/TA1/A2 4
P1.3/ADC10CLK/A3/VREF−/VEREF− 5
P1.4/SMCLK/A4/VREF+/VEREF+/TCK 6
P1.5/TA0/A5/SCLK/TMS 7
P1.6/TA1/A6/SDO/SCL/TDI/TCLK 8
P1.7/A7/SDI/SDA/TDO/TDI 9

TEST/SBWTCK 11
RST/NMI/SBWTDIO 10

XIN/P2.6/TA1 13
XOUT/P2.7 12

VSS 14

RCV_AB
XMIT_AB
XMIT_CLK_OUT
PIC_SDO/PGD_1
PIC_SDI
PIC_SCK/PGC_1
SCLK_1
SDA_1

TEST_2
RST_2

+3.3I

C20
0.1μF

IGND

IGND

Y1
32768Hz

303

QLC PIC BUS HEADER

U1RXDI

PIC_SDO/PGD_I

PIC_SDI

PIC_SCK/PGC_I

U1TXDI

J2

1
2
3
4
5
6

1x06

IGND

FIG.30F-2

EP 1 960 932 B1

304

12C PCB230

| | |
|---|---|
| FIG.30G-1 | FIG.30G-2 |
| FIG.30G-3 | FIG.30G-4 |

FIG.30G

FIG.30G-1

SCX

8
9
U13-C
10
SN74AHCT02DR

R34 220R

R35 220R

PGND

U4-A
1
2
7
HCPL-2630

PGND

R36 220R

3
R37 220R
4
U4-B
6
HCPL-2630

SDA

2
3
U13-A
1
SN74AHCT02DR

+V

R49 348R

EP 1 960 932 B1

FIG.30G-2

FIG.30G-3

FIG.30G-4

CPU SCH202-3

| | | | |
|---|---|---|---|
| FIG.31A-1 | FIG.31A-2 | FIG.31A-3 | FIG.31A-4 |
| FIG.31A-5 | FIG.31A-6 | FIG.31A-7 | FIG.31A-8 |

# FIG.31A

FIG.31A-1

+3.3V

| | |
|---|---|
| 3 | SD_VDD_1 |
| 17 | SD_VDD_2 |
| 33 | SD_VDD_3 |
| 35 | SD_VDD_4 |
| 61 | SD_VDD_5 |
| 89 | SD_VDD_6 |
| 110 | SD_VDD_7 |
| 123 | SD_VDD_8 |
| 30 | IVDD_1 |
| 68 | IVDD_2 |
| 84 | IVDD_3 |
| 113 | IVDD_4 |
| 143 | IVDD_5 |
| 86 | PLL_VDD |

U8
IC/MCF5207/LQFP144

| | | |
|---|---|---|
| PFECL0/U0CTS | 140 | |
| PFECL4/U0RTS | 141 | |
| U0RXD | 70 | |
| U0TXD | 71 | |
| PFECL1/U1CTS | 139 | |
| PFECH6/U1RTS | 142 | |
| U1RXD | 130 | |
| U1TXD | 131 | |
| QSPI_CS2/DACKO/U2RTS | 126 | |
| QSPI_CLK/I2C_SCL | 127 | |
| QSPI_DOUT/I2C_SDA | 128 | |
| QSPI_DIN/DREQ0 | 129 | |
| DT3IN/DT3OUT/U2CTS | 135 | |
| DT2IN/DT2OUT/U2RTS | 136 | |
| DT1IN/DT1OUT/U2RXD | 137 | |
| DT0IN/DT0OUT/U2TXD | 138 | |
| IRQ1/PIRQ1 | 132 | |
| IRQ4/DREQ0/PIRQ4 | 133 | |
| IRQ7/PIRQ7 | 134 | |
| FB_CS0/PCS0 | 122 | |

FIG.31A-2

FIG.31 A-3

FIG.31A-4

FIG.31A-5

FB_CS1/PCS1 — 121
FB_CS2/PCS2 — 120
FB_CS3/PCS3 — 119

$\overline{BWE0}$/SD_DQM0 — 50
$\overline{BWE1}$/SD_DQM1 — 48
$\overline{BWE2}$/SD_DQM2 — 20
$\overline{BWE3}$/SD_DQM3 — 18

$\overline{TS}$/DACK0 — 4
R/$\overline{W}$ — 59
$\overline{TA}$/BUSCTL2 — 90
$\overline{OE}$ — 60

SD_A10 — 37
SD_CKE — 6
SD_CLK — 31
$\overline{SD\_CLK}$ — 32
$\overline{SD\_CS}$ — 7
SD_DQS0_2 — 49
SD_DQS1_3 — 19
$\overline{SD\_CAS}$ — 38
$\overline{SD\_RAS}$ — 39
SD_SDR_DQS — 29
$\overline{SD\_WE}$ — 5

FB_CLK — 34
EXTAL — 78
XTAL — 80

TCLK/PSTCLK — 64
ALL_PST — 67
TDO/DSO — 69
TMS/$\overline{BKPT}$ — 75
$\overline{TRST}$/DSCLK — 76
TDI/DSI — 77
JTAC_EN — 83
TEST — 109

VSS_1 — 2
VSS_2 — 16
VSS_3 — 36
VSS_4 — 42
VSS_5 — 65
VSS_6 — 73
VSS_7 — 88
VSS_8 — 111
VSS_9 — 124

PLL_VSS — 85

D

## FIG.31A-6

FIG.31A-7

+3.3V

C30
0.1μF

C31
10nF

C32
470PF

C33
10nF

D

+1.5V

C35
0.1μF

C36
10nF

C37
470PF

C38
10nF

D

+1.5V

C39
0.1μF

C40
10nF

C41
470PF

C34
10nF

D

FIG.31A-8

POWER SUPPLY UNIT SCH202-3

| | |
|---|---|
| FIG.31B-1 | FIG.31B-2 |
| FIG.31B-3 | |

FIG.31B

EP 1 960 932 B1

FIG.31B-1

320

FIG.31B-2

FIG.31B-3

DMA RCON PCB202-3

| FIG.31C-1 | FIG.31C-2 | FIG.31C-3 |
| FIG.31C-4 | FIG.31C-5 | FIG.31C-6 |

FIG.31C

FIG.31C-1

DSP_SD0 — JP15 — SD0

0R00

CS1 — 1
QE — 2

U16-A — 3 — ADC_VAL_DE

SN74ALVC32APW

DACK0

IC
U14-A
74LVX74TT

4
SD1

2
D1

Q1 — 5 — DREQ0

DSP_SPI_CS1 — 3
CP1

Q1 — 6

CD1

D

+3.3V — 1

FIG.31C-2

FIG.31C-3

FIG.31C-4

FIG.31C-5

FIG.31C-6

RTC/TAMPER TEMP/RESET PCB202-3

| | |
|---|---|
| FIG.31D-1 | FIG.31D-2 |
| FIG.31D-3 | FIG.31D-4 |

**FIG.31D**

WAITING FOR FINAL HOOKUP

FIG.31D-1

EP 1 960 932 B1

FIG.31D-2

EP 1 960 932 B1

TAMPER I/O RECEIVE

+3.3V

Q7
QSB320

C

E

TAMPER

R3
348R

DGND

TAMPER I/O TRANSMIT

LED2
QEB421

+U

R110
220R

C

Q6

E

B

DGND

R15
1.00K

TAMPER_LED_1SEC

FIG.31D-3

333

RESET OUTPUT

FIG.31D-4

FLASH MEMORY SCH202-3

| | |
|---|---|
| FIG.31E-1 | FIG.31E-2 |

FIG.31E

IC/AT498V160DT-7QTU/TSOP48

+3.3V

D[0:31]

A[0:23]

U11

VPP 13
VCC 37
VCCQ 47

AT498V16DDT

| A1 | 25 | A0 |
| A2 | 24 | A1 |
| A3 | 23 | A2 |
| A4 | 22 | A3 |
| A5 | 21 | A4 |
| A6 | 20 | A5 |
| A7 | 19 | A6 |
| A8 | 18 | A7 |
| A9 | 8 | A8 |
| A10 | 7 | A9 |
| A11 | 6 | A10 |
| A12 | 5 | A11 |
| A13 | 4 | A12 |
| A14 | 3 | A13 |
| A15 | 2 | A14 |
| A16 | 1 | A15 |
| A17 | 48 | A16 |
| A18 | 17 | A17 |
| A19 | 16 | A18 |
| A20 | 15 | A19 |

| A22 | 9 | NC1 |
| A21 | 10 | NC2 |

| I/O0 | 29 |
| I/O1 | 31 |
| I/O2 | 33 |
| I/O3 | 35 |
| I/O4 | 38 |
| I/O5 | 40 |
| I/O6 | 42 |
| I/O7 | 44 |
| I/O8 | 30 |
| I/O9 | 32 |
| I/O10 | 34 |
| I/O11 | 36 |
| I/O12 | 39 |
| I/O13 | 41 |
| I/O14 | 43 |
| I/O15 | 45 |

| $\overline{WE}$ | 11 |
| RESET | 12 |
| $\overline{WP}$ | 14 |
| $\overline{DE}$ | 28 |
| $\overline{CE}$ | 26 |

GND1 27
GND2 46

D

# FIG.31E-1

FIG.31E-2

SDRAM MEMORY SCH202-3

| | |
|---|---|
| FIG.31F-1 | FIG.31F-2 |

# FIG.31F

FIG.31F-1

+3.3V    2M X 32

| | | | | | | | | | |
|1|15|29|43|3|9|35|41|49|55|75|81|

VDD VDD VDD VDD VDDQ VDDQ VDDQ VDDQ VDDQ VDDQ VDDQ VDDQ

U2

| A0 | 25 | A0 |
| A1 | 26 | A1 |
| A2 | 27 | A2 |
| A3 | 60 | A3 |
| A4 | 61 | A4 |
| A5 | 62 | A5 |
| A6 | 63 | A6 |
| A7 | 64 | A7 |
| A8 | 65 | A8 |
| A9 | 66 | A9 |
| | 24 | A10 |
| 0 | 22 | BA0 |
| 0 | 23 | BA1 |
| $\overline{DQM0}$ | 16 | DQM0 |
| DQM1 | 71 | DQM1 |
| DQM2 | 28 | DQM2 |
| DQM3 | 59 | DQM3 |
| | 20 | $\overline{CS}$ |
| | 17 | $\overline{WE}$ |
| | 18 | $\overline{CAS}$ |
| | 19 | $\overline{RAS}$ |
| | 67 | CKE |
| | 68 | CLK |

| DQ0 | 2 | D0 |
| DQ1 | 4 | D1 |
| DQ2 | 5 | D2 |
| DQ3 | 7 | D3 |
| DQ4 | 8 | D4 |
| DQ5 | 10 | D5 |
| DQ6 | 11 | D6 |
| DQ7 | 13 | D7 |
| DQ8 | 74 | D8 |
| DQ9 | 76 | D9 |
| DQ10 | 77 | D10 |
| DQ11 | 79 | D11 |
| DQ12 | 80 | D12 |
| DQ13 | 82 | D13 |
| DQ14 | 83 | D14 |
| DQ15 | 85 | D15 |
| DQ16 | 31 | D16 |
| DQ17 | 33 | D17 |
| DQ18 | 34 | D18 |
| DQ19 | 36 | D19 |
| DQ20 | 37 | D20 |
| DQ21 | 39 | D21 |
| DQ22 | 40 | D22 |
| DQ23 | 42 | D23 |
| DQ24 | 45 | D24 |
| DQ25 | 47 | D25 |
| DQ26 | 48 | D26 |
| DQ27 | 50 | D27 |
| DQ28 | 51 | D28 |
| DQ29 | 53 | D29 |
| DQ30 | 54 | D30 |
| DQ31 | 56 | D31 |

| NC | 14 |
| NC | 21 |
| NC | 30 |
| NC | 57 |
| NC | 69 |
| NC | 70 |
| NC | 73 |

C8
470pF

| | | | | | | | | | |
|44|58|72|86|6|12|32|38|46|52|78|84|

VSS VSS VSS VSS VSSQ VSSQ VSSQ VSSQ VSSQ VSSQ VSSQ VSSQ

FIG.31F-2

DIFF AMPS PCB202-3

| | | |
|---|---|---|
| FIG.31G-1 | FIG.31G-2 | FIG.31G-3 |
| FIG.31G-4 | FIG.31G-5 | |

# FIG.31G

FIG.31G-1

REF_MSV ⟩——————— 10 +

8 ————————⟩ VB_OUT_D

9 −

U15-C

VB_OUT ⟩——————— R149 ————— R148 —————

1.00K
25PPM

4.99K
25PPM

REF_MSV ⟩——————— 5 +

7 ————————⟩ IB_OUT_D

6 −

U15-B

IB_OUT ⟩——————— R153 ————— R152 —————

1.00K
25PPM

4.99K
25PPM

**FIG.31G-2**

EXTERNAL REFERENCE

FIG.31G-3

REF_MSV ▷ —— 3 + 1 ▷ IA_OUT_D

2 − U10-A

R143                R141
IA_OUT ▷ ——/\/\/——  ——/\/\/——

1.00K              4.99K
25PPM              25PPM

0.1μF                    0.1μF
+3.3A ▷ —— C93          +3.3A ▷ —— C94

4                        4
+  U10-E                 +  U15-E
−                        −
11                       11

FIG.31G-4

VC_OUT_D

U15-A
1
3 +
2 −

REF_MSV

R156
4.99K
25PPM

R157
1.00K
25PPM

VC_OUT

IC_OUT_D

U15-D
14
12 +
13 −

REF_MSV

R163
4.99K
25PPM

R164
1.00K
25PPM

IC_OUT

FIG.31G-5

METER I PCB202-3

| | | |
|---|---|---|
| FIG.31H-1 | FIG.31H-2 | FIG.31H-3 |
| FIG.31H-4 | FIG.31H-5 | FIG.31H-6 |
| FIG.31H-7 | FIG.31H-8 | FIG.31H-9 |

FIG.31H

EP 1 960 932 B1

FIG.31H-1

EP 1 960 932 B1

FIG.31H-2

EP 1 960 932 B1

FIG.31H-3

EP 1 960 932 B1

EP 1 960 932 B1

IRC0
IRC1
IRC2

+3.3A

C119
0.1μF
X7R

AGND

D5
MB25

2

3    +    4

1

H4

1
2

1x2 VER

FB18
1        2
STEWARD
2000ohms

FB19
1        2
STEWARD
2000ohms

C133
0.1μF

R142
10R0
25PPM

R144
10R0
25PPM

R145
4.02
25PPM

C132
10nF
NPO

R162
6.98K
25PPM

R165
3.83K
25PPM

# FIG.31H-4

FIG.31H-5

FIG.31H-6

EP 1 960 932 B1

FIG.31H-7

FIG.31H-8

FIG.31H-9

356

METER Ⅴ SCH202-3

| | |
|---|---|
| FIG.31I-1 | FIG.31I-2 |

FIG.31I-3

| | |
|---|---|
| FIG.31I-4 | FIG.31I-5 |

FIG.31I

EP 1 960 932 B1

FIG.31I-1

FIG.31I-2

EP 1 960 932 B1

FIG.31I-3

500V NPO 10pF C109  
500V NPO 10pF C110  
500V NPO 10pF C111  
500V NPO 10pF C112  

25PPM 56.2K  
R240  

R31 249K 25PPM 200V  
R32 249K 25PPM 200V  
R33 249K 25PPM 200V  
R34 249K 25PPM 200V  

R35 1.13K 25PPM  

C66 2.2nF NPO  

C116 10nF NPO  

NF  

+3.3A  

4  
+  
11 −  
U17-E  
LMV324  

C52 0.1μF  
C123 0.1μF  

16 VCC  
7 VEE  
6 INH  
8 GND  
U20-D  

A  

JP6 0R00  
3 +  
2 −  
1  
U17-A  
LMV324  
JP1 0R00  

JP7 0R00  
10 +  
9 −  
8  
U17-C  
LMV324  
JP2 0R00  

## FIG.31I-4

EP 1 960 932 B1

FIG.31I-5

PLC RCV PCB202-3

| | | |
|---|---|---|
| FIG.31J-1 | FIG.31J-2 | FIG.31J-3 |
| FIG.31J-4 | FIG.31J-5 | FIG.31J-6 |

FIG.31J

EP 1 960 932 B1

THETA 120 + REEL POLE

FIG. 31J-1

EP 1 960 932 B1

+3.3A

C80
0.1μF

U12-E

4

+

−

11

A

A

IC/74HC4051/TSSQP16

THETA 160

C143

+3.3A

0.1μF

A

U22

16

VDD

13    I/O_0        A    11    PLCR0
14    I/O_1        B    10    PLCR1
15    I/O_2        C    9     PLCR2

R51

R52

5

+

6

−

7

U12-B

C14

0.1μF

2.10K
25PPM

1.62K
25PPM

FIG.31J-2

THETA 100

THETA 140

ADC_REF

PLC_OUT

U12-C

8

10 +

9 −

R56
1.91K
25PPM

R55
3.74K
25PPM

U12-D

14

12 +

13 −

R54
1.96K
25PPM

R53
2.37K
25PPM

FIG.31J-3

FIG.31J-4

FIG.31J-5

EP 1 960 932 B1

FIG.31J-6

DSP

| FIG.31K-1 | FIG.31K-2 | FIG.31K-3 |

FIG.31K

FIG.31K-1

FIG.31K-2

CONNECTED TO DSP ADC
FOR SENSING INPUT POWER SUPPLY LEVELS

+U

R241
6.49K

+U_SENSE

C169
0.1μF

R242
1.00K

A          A

FIG.31K-3

FIG.31L

VCO

| | |
|---|---|
| FIG.31M-1 | FIG.31M-2 |
| FIG.31M-3 | |

FIG.31M

EP 1 960 932 B1

FIG.31M-1

FIG.31M-2

FIG.31M-3

EP 1 960 932 B1

PLC SCH202-3

| | |
|---|---|
| FIG.31N-1 | FIG.31N-2 |

FIG.31N

C122
0.1µF

U23-E
4
11

+3.3V

D

+VF

LED1
QEB421

R179
220R

Q5
E
B
C

UOTXD

D

JP12
0R00

3
2
1

U23-A
TSSOP14_175

JP9
0R00

JP13
0R00

5
6
7

U23-B
TSSOP14_175

JP10
0R00

JP14
0R00

12
13
14

U23-D
TSSOP14_175

JP11
0R00

FIG.31N-1

380

OPTICAL PORT

FIG.31N-2

SERIAL I/O SCH202-3

| | |
|---|---|
| FIG.310-1 | FIG.310-2 |

FIG.310

HEADER TO IO BOARD

J10

| | | | |
|---|---|---|---|
| $\overline{U1RXD}$ | 1 | 2 | $\overline{U2RXD}$ |
| $\overline{U1TXD}$ | 3 | 4 | $\overline{U2TXD}$ |
| $\overline{U1RTS}$ | 5 | 6 | $\overline{U2RTS}$ |
| $\overline{U1CTS}$ | 7 | 8 | I2C_SDA |
| | 9 | 10 | I2C_SCL |
| PGND | 11 | 12 | +V |

2x6 VER
MALE

HEADER TO POWER BOARD

J6

| | | | |
|---|---|---|---|
| PLCRH | 1 | 2 | +VA |
| PLCRL | 3 | 4 | |
| PLCXEN | 5 | 6 | SGND |
| PLCXL | 7 | 8 | |
| PLCXN | 9 | 10 | +V |
| +U | 11 | 12 | |

D

2x6 VER
MALE

C

P

# FIG.310-1

HEADER TO MODEM BOARD

+U

CARRIER DETECT TO IRQ6

J8

UORTS — 1
UOCTS — 3
I2C_SCL — 5
7

2 — I2C_SDA
4 — UORXD
6 — UOTXD
8

C

2x04.
MALE

HEADER TO DISPLAY BOARD

+3.3V

R132  10.0K 100PPM

J5

1
2
DSP_SCLK — 3
4
DSP_SD0 — 5
DSP_SPI_CS2 — 6
7
8
9
10

1X10

FIG.310-2

D

384

BDM HEADER

BDM/JTAG

FIG.31P

FIG.31Q

LEDS/SWITCHES

D[0:31]                                    D[0:31]

H8

| | | | | | |
|---|---|---|---|---|---|
| D16 | | 1 | 2 | D0 | D0 |
| D17 | D17 | 3 | 4 | D1 | D1 |
| D18 | D18 | 5 | 6 | D2 | D2 |
| D19 | D19 | 7 | 8 | D3 | D3 |
| D20 | D20 | 9 | 10 | D4 | D4 |
| D21 | D21 | 11 | 12 | D5 | D5 |
| D22 | D22 | 13 | 14 | D6 | D6 |
| D23 | D23 | 15 | 16 | D7 | D7 |
| D24 | D24 | 17 | 18 | D8 | D8 |
| D25 | D25 | 19 | 20 | D9 | D9 |
| D26 | D26 | 21 | 22 | D10 | D10 |
| D27 | D27 | 23 | 24 | D11 | D11 |
| D28 | D28 | 25 | 26 | D12 | D12 |
| D29 | D29 | 27 | 28 | D13 | D13 |
| D30 | D30 | 29 | 30 | D14 | D14 |
| D31 | D31 | 31 | 32 | D15 | D15 |

A[0:23]

| | | | |
|---|---|---|---|
| A1 | D31 | 33 | 34 | +3.3V |
| A2 | | 35 | 36 | CLKOUT |
| A3 | | 37 | 38 | TESTCS |
| A4 | | 39 | 40 | D |

2X20-RA
MALE

# FIG.31R-1

H9

| | | | |
|---|---|---|---|
| DGND | 1 | 2 | +3.3V |
| OE | 3 | 4 | |
| R/W | 5 | 6 | DACK0 |
| TAMPER_LED_ISEC | 7 | 8 | OR00 |
| CONVST | 9 | 10 | ADC_VAL_OE |
| VCO | 11 | 12 | DSP_SCLK |
| CS1 | 13 | 14 | DSP_SPI_CS1 |
| DSP_SD0 | 15 | 16 | SD0 |
| | 17 | 18 | DSP_SPI_CS1 |
| | 19 | 20 | |
| | 21 | 22 | PLCRH |
| | 23 | 24 | PLCRL |
| +VA | 25 | 26 | SGND |

HDR_2X13
MALE

TEST HEADER

# FIG.31R-2

HEADER TO IO BOARD

J10

1  2
3  4
5  6
7  8
9  10
PGND  11  12  +V

2x6 VER
MALE

POWER HEADER

H13

+V  1
PGND  2
+U  3
CGND  4

1x04

HEADER TO POWER BOARD

J6

1  2
3  4
5  6
7  8
9  10  +V
+U  11  12

2x6 VER
MALE

C    P

SERIAL I/O

FIG.32

EP 1 960 932 B1

FIG.33A-1

Cont. from
Fig.33A-1

JTAG PORT

FIG.33A-2

EP 1 960 932 B1

R44
6.49K

+U

+U_SENSE

R45
1.00K

C71
0.1μF

AGND

DSP

FIG.33A-3

POWER SUPPLY UNIT
SCH202-3

FIG.33B

EP 1 960 932 B1

FLASH MEMORY

# FIG.33C

FIG.33D

394

Waiting for final hookup

D4  D3

+3.3V

C68
0.1μF

BATT_SENSE

R109
1.00K

R49
10.0K

R48
1.00K

DGND

BATT_SENSE_ENABLE

IC
U4

H6

VCC

1

1x04
Mole

TEST/SBWTCK
RST/NMI/SBWTDIO

11
10

P1.0/TACLK/ACLK/A0
P1.1/TA0/A1
P1.2/TA1/A2
P1.3/ADC10CLK/A3/VREF−/VEREF−
P1.4/SMCLK/A4/VREF+/VEREF+/TCK
P1.5/TA0/A5/SCLK/TMS
P1.6/TA1/A6/SD0/SCL/TD1/TCLK
P1.7/A7/SD1/SDA/TD0/TD1

2
3
4
5
6
7
8
9

BATT_SENSE
BATT_SENSE_ENABLE
TAMPER_LED_1SEC
TAMPER

RESET
12C_SCL/SCI
12C_SDA

DGND

XIN/P2.6/TA1
XOUT/P2.7

13
12

32768Hz

Y2

BAT1
3.0V

VSS

DGND

14

RTC/TEMP/TAMPER/RESET
PCB202−3

DGND

FIG.33E-1

EP 1 960 932 B1

RESET output

TAMPER I/O TRANSMIT

TAMPER I/O RECEIVE

RTC/TEMP/TAMPER/RESET
PCB202-3

FIG.33E-2

EP 1 960 932 B1

8 differential amplifiers
Shifts 1.0 – 2.0 (1.0 VPP around 1.5 REF)
To 5VPP around 2.5V (MSV)

FIG.33F-1

DIFF AMPS
PCB202-3

EP 1 960 932 B1

FIG.33F-2

DIFF AMPS
PCB202-3

FIG.33G-1

FIG.33G-2

FIG.33G-3

EP 1 960 932 B1

FIG.33G-4

METER I PCB202-3

METER I PCB202–3

# FIG.33G-5

FIG.33H-1

METER V SCH202-3

EP 1 960 932 B1

METER V SCH202-3

FIG.33H-2

**PLC RCV PCB202-3**

**FIG.33I-1**

Cont. on Fig33I-2

R51
2.10K
25PPM

R52
1.62K
25PPM

5
6
+
−
7
U12-B

C14
0.1uF

R53
2.37K
25PPM

R50
1.96K
25PPM

12
13
+
−
14
U12-D

R55
3.74K
25PPM

R56
1.91K
25PPM

10
9
+
−
8
U12-C

ADC_REF

PLC_OUT

C84
150pF
NPO

C86
220PF
NPO

C88
470PF
NPO

C81
10nF
NPO

C85
2.2nF
NPO

C87
2.2nF
NPO

R63
6.65K
25PPM

R62
11.5K
25PPM

R50
3.83K
25PPM

Cont. from
Fig33I-1

3
2
+
−
1
U12-A

R50
7.15K
25PPM

ADC_REF

PLC RCV PCB202-3

FIG.33I-2

C80
0.1μF

4
+
−
11
U12-E

ADC_REF

A

A

EP 1 960 932 B1

PLC XMIT

FIG.33J

EP 1 960 932 B1

FIG.33K

OPTICAL PORT

PLC SCH202-3

# FIG.33L

EP 1 960 932 B1

HEADER TO DISPLAY BOARD

+3.3V

R132
10.0K
100PPM

J5

1
2
DSP1_SCLK        3
4
QSPI _DOUT       5
$\overline{QSP1\_CS2}$   6
7
8
9
10

1X10

SERIAL I/O SCH202-3

D

FIG.33M

EP 1 960 932 B1

Crude DAC for multiplexing switches

LED test outputs

+U

RED 220R R68
54mcd OS15

RED 220R R67
54mcd OS14

+3.3A

R15
100K

R65
2.00K

R66
2.00K

R58
1.00K

SW

S1

S2

S3

A

Q3

C

B

E

Q4

C

B

E

R13
1.00K

KVARH_LED

DGND

R14
1.00K

KWH_LED

LEDS/SWITCHES PCB202-3

FIG.33N

EP 1 960 932 B1

1X8 LCD DISPLAY
PCB220

FIG.34A

FIG.34B

1X8 LCD DISPLAY
PCB220

FIG.35

## ID HARDWARE BLOCK DIAGRAM

+4.5V → POWER SUPPLY

+12V →

POWER SUPPLY → 1.8A → FREESCALE DSP
1.8D →
3.3A →
3.3B →

POWER SUPPLY DIVIDER → 2 ANALOG SIGNALS MEASURE +V, +U

COARSE PWM → VCO → 90-100MHz
FINE PWM →

RTC WITH 12C INTERFACE → RESET
← 12C →
CLOCK OUT 1 SEC TO A TIMER INPUT

CS → SERIAL FLASH SPI WITH CS → SD
SCK →
SD →

TX    RX
OPTO PORT

## FIG.36

FIG.37

INPHASE FILTER FREQUENCY RESPONSE

FIG.38A

IMPULSE RESPONSE

FIG.38B

EP 1 960 932 B1

FIG.39

FIG.40

INPHASE FILTER FREQUENCY RESPONSE

FIG.41A

IMPULSE RESPONSE

FIG.41B

EP 1 960 932 B1

FFT Frame 1      FFT Frame 2..........      FFT Frame N

$V_{0,1}\ V_{1,1}\ V_{2,1}\ ....V_{M,1}$     $V_{0,2}\ V_{1,2}\ V_{2,2}\ ....V_{M,2}$     $V_{0,N}\ V_{1,N}\ V_{2,N}\ ....V_{M,N}$

Time

FIG.42

EP 1 960 932 B1

**EP 1 960 932 B1**

**Patent documents cited in the description**

- US 73758005 P
- US 73937505 P
- US 81390106 P
- US 43184906 A
- US 03041705 A
- US 7054770 B
- US 79583801 A
- US 6947854 B
- US 5696501 A
- EP 1379012 A
- US 20050137813 A
- US 20060036388 A